(19) Europäisches Patentamt
European Patent Office
Office européen des brevets

(11) EP 3 991 985 A1

(12) EUROPEAN PATENT APPLICATION
published in accordance with Art. 153(4) EPC

(43) Date of publication:
**04.05.2022 Bulletin 2022/18**

(21) Application number: **20831196.9**

(22) Date of filing: **26.06.2020**

(51) International Patent Classification (IPC):
***B41N 1/14*** *(2006.01)* ***B41C 1/10*** *(2006.01)*
***B41M 1/06*** *(2006.01)* ***B41N 1/08*** *(2006.01)*
***B41N 3/03*** *(2006.01)* ***G03F 7/00*** *(2006.01)*
***G03F 7/004*** *(2006.01)* ***G03F 7/028*** *(2006.01)*
***G03F 7/029*** *(2006.01)* ***G03F 7/033*** *(2006.01)*
***G03F 7/09*** *(2006.01)* ***G03F 7/11*** *(2006.01)*

(52) Cooperative Patent Classification (CPC):
**B41C 1/10; B41M 1/06; B41N 1/08; B41N 1/14; B41N 3/03; G03F 7/00; G03F 7/004; G03F 7/028; G03F 7/029; G03F 7/033; G03F 7/09; G03F 7/11**

(86) International application number:
**PCT/JP2020/025407**

(87) International publication number:
**WO 2020/262685 (30.12.2020 Gazette 2020/53)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **28.06.2019 JP 2019122490**
**30.08.2019 JP 2019158806**
**18.09.2019 JP 2019169798**

(71) Applicant: **FUJIFILM Corporation**
**Tokyo 106-8620 (JP)**

(72) Inventors:
- **ENOMOTO, Kazuaki**
**Haibara-gun, Shizuoka 421-0396 (JP)**
- **ISHIJI, Yohei**
**Haibara-gun, Shizuoka 421-0396 (JP)**
- **YANAGI, Shunsuke**
**Haibara-gun, Shizuoka 421-0396 (JP)**

(74) Representative: **HGF**
**HGF Limited**
**1 City Walk**
**Leeds LS11 9DX (GB)**

# (54) PLANOGRAPHIC PRINTING ORIGINAL PLATE, METHOD FOR PRODUCING PLANOGRAPHIC PRINTING PLATE, AND PLANOGRAPHIC PRINTING METHOD

(57) Provided is a lithographic printing plate precursor having an aluminum support, an image-recording layer, and a water-soluble overcoat layer in this order, in which the image-recording layer contains an infrared-absorbing polymethine colorant having HOMO of -5.2 eV or less, a polymerization initiator, a polymerizable compound, and a polymer, and the polymer has a constitutional unit formed of an aromatic vinyl compound and a constitutional unit formed of an acrylonitrile compound. Also provided are a method for preparing a lithographic printing plate using the lithographic printing plate precursor.

EP 3 991 985 A1

## Description

BACKGROUND OF THE INVENTION

1. Field of the Invention

The present disclosure relates to a lithographic printing plate precursor, a method for preparing a lithographic printing plate, and a lithographic printing method.

2. Description of the Related Art

Generally, a lithographic printing plate consists of a lipophilic image area that receives ink in a printing process and a hydrophilic non-image area that receives dampening water. Lithographic printing is a method exploiting the mutual repulsion of water and oil-based ink, in which the lipophilic image area and the hydrophilic non-image area of a lithographic printing plate are used as an ink-receiving portion and a dampening water-receiving portion (that is, a non-ink-receiving portion) respectively, the adhesiveness of ink is varied within the surface of the lithographic printing plate so that only the image area receives the ink, and then printing is performed by the transfer of the ink to a printing substrate such as paper.

In the related art, in order to prepare this lithographic printing plate, a lithographic printing plate precursor (also called "PS plate") has been widely used which is obtained by providing a lipophilic photosensitive resin layer (that is, an image-recording layer) on a hydrophilic support. Generally, a lithographic printing plate is obtained by a plate making method of exposing a lithographic printing plate precursor through an original picture such as a lith film, then keeping a portion of an image-recording layer that will be an image area while removing other unnecessary portions of the image-recording layer by dissolving such portions in an alkaline developer or an organic solvent, and forming a non-image area by exposing the hydrophilic surface of a support.

In response to the intensifying interest in the global environment, an environmental issue of waste liquid generated by wet treatments such as a development treatment has gathered more attention.

Regarding the environmental issue described above, in development or plate making, an attempt is made to simplify process or to remove treatments. As one of the methods for preparing lithographic printing plate in a simple way, a method called "on-press development" is being carried out. That is, in this method, after being exposed, a lithographic printing plate precursor is immediately mounted on a printer without being developed as in the related art, and an unnecessary portion of the image-recording layer is removed at an early stage of the ordinary printing step.

Examples of the lithographic printing plate precursor in the related art include those described in JP2005-103968A or JP2006-001144A.

JP2005-103968A discloses a lithographic printing plate precursor having an image-recording layer on a support, in which the image-recording layer contains (A) infrared absorber having an oxidation potential of 0.45 V (vs. SCE) or less, (B) radical generator, and (C) radically polymerizable compound and can be removed with either or both of a printing ink and dampening water.

JP2006-001144A discloses a lithographic printing method using a lithographic printing plate precursor having an image-recording layer on a support, in which the image-recording layer contains (A) infrared absorber, (B) polymerization initiator as an onium salt formed of an onium cation and a carboxylic acid anion which has an acid group, a heteroatom, and an aromatic group, (C) polymerizable compound, (D) binder polymer and makes it possible to record images by irradiation with infrared, and the method includes a step of exposing the lithographic printing plate precursor to an infrared laser in the shape of an image and a step of supplying an oil-based ink and an aqueous component to the exposed lithographic printing plate precursor on a printer without performing any development treatment so as to remove a portion not being exposed to the infrared laser from the lithographic printing plate precursor.

SUMMARY OF THE INVENTION

One embodiment according to the present disclosure relates to provide a lithographic printing plate precursor that excellently suppresses plate missing.

Another embodiment according to the present disclosure relates to provide a method for preparing a lithographic printing plate and a lithographic printing method using the aforementioned lithographic printing plate precursor.

The present disclosure includes the following aspects.

<1> A lithographic printing plate precursor having an aluminum support, an image-recording layer, and a water-soluble overcoat layer in this order,

in which the image-recording layer contains an infrared-absorbing polymethine colorant having HOMO of -5.2 eV or less, a polymerization initiator, a polymerizable compound, and a polymer, and
the polymer has a constitutional unit formed of an aromatic vinyl compound and a constitutional unit formed of an acrylonitrile compound.

<2> The lithographic printing plate precursor described in <1>, in which the polymethine colorant includes a cyanine dye that has an electron-withdrawing group or a heavy atom-containing group in at least one of aromatic rings at both terminals.
<3> The lithographic printing plate precursor described in <1> or <2>, in which HOMO of the polymethine colorant is -5.3 eV or less.
<4> The lithographic printing plate precursor described in any one of <1> to <3>, in which a thickness of the water-soluble overcoat layer is larger than a thickness of the image-recording layer.
<5> The lithographic printing plate precursor described in any one of <1> to <4>, in which the polymer in the image-recording layer includes polymer particles.
<6> The lithographic printing plate precursor described in <5>, in which the polymer particles include polymer particles having a hydrophilic group.
<7> The lithographic printing plate precursor described in <6>, in which the polymer particles have a group represented by Formula Z as the hydrophilic group.

*-Q-W-Y Formula Z

In Formula Z, Q represents a divalent linking group, W represents a divalent group having a hydrophilic structure or a divalent group having a hydrophobic structure, Y represents a monovalent group having a hydrophilic structure or a monovalent group having a hydrophobic structure, either W or Y has a hydrophilic structure, and * represents a binding site with other structures.
<8> The lithographic printing plate precursor described in <6> or <7>, in which the polymer particles have a polyalkylene oxide structure as the hydrophilic group.
<9> The lithographic printing plate precursor described in <8>, in which the polyalkylene oxide structure includes a polypropylene oxide structure.
<10> The lithographic printing plate precursor described in <8> or <9>, in which the polyalkylene oxide structure includes a polyethylene oxide structure and a polypropylene oxide structure.
<11> The lithographic printing plate precursor described in any one of <1> to <10>, in which a water contact angle on a surface of the aluminum support on a side of the image-recording layer that is determined by an airborne water droplet method is 110° or less.
<12> The lithographic printing plate precursor described in <11>, in which the water contact angle on the surface of the aluminum support on the side of the image-recording layer that is determined by the airborne water droplet method is 80° or less.
<13> The lithographic printing plate precursor described in <12>, in which the water contact angle on the surface of the aluminum support on the side of the image-recording layer that is determined by the airborne water droplet method is 50° or less.
<14> The lithographic printing plate precursor described in any one of <1> to <13>, in which a layer on the aluminum support contains a hydroxycarboxylic acid or a salt thereof.
<15> The lithographic printing plate precursor described in <14>, in which the hydroxycarboxylic acid or a salt thereof includes a compound having two or more hydroxyl groups.
<16> The lithographic printing plate precursor described in <14> or <15>, in which the hydroxycarboxylic acid or a salt thereof includes a compound having three or more hydroxyl groups.
<17> The lithographic printing plate precursor described in any one of <1> to <16>, in which the image-recording layer contains an electron-donating polymerization initiator as the polymerization initiator.
<18> The lithographic printing plate precursor described in <17>, in which HOMO of the polymethine colorant - HOMO of the electron-donating polymerization initiator is 0.70 eV or less.
<19> The lithographic printing plate precursor described in any one of <1> to <18>, in which the image-recording layer further contains a color developing agent.
<20> The lithographic printing plate precursor described in <19>, in which the color developing agent is an acid color-developing agent.
<21> The lithographic printing plate precursor described in <20>, in which the acid color-developing agent is a leuco colorant.
<22> The lithographic printing plate precursor described in <21>, in which the leuco colorant is a leuco colorant having a phthalide structure or a fluoran structure.

<23> The lithographic printing plate precursor described in <22>, in which the leuco colorant having a phthalide structure or a fluoran structure is a compound represented by any of Formula (Le-1) to Formula (Le-3).

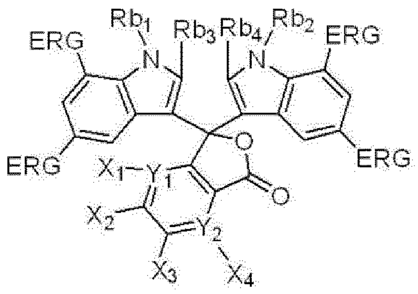

(Le - 1)

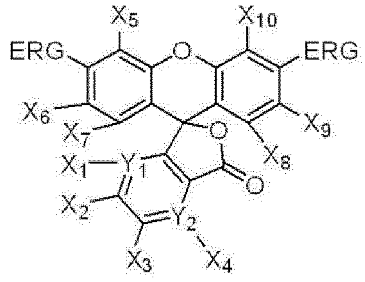

(Le - 2)

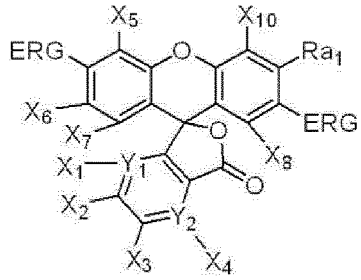

(Le - 3)

In Formula (Le-1) to Formula (Le-3), ERG each independently represents an electron donating group, $X_1$ to $X_4$ each independently represent a hydrogen atom, a halogen atom, or dialkylanilino group, $X_5$ to $X_{10}$ each independently represent a hydrogen atom, a halogen atom, or a monovalent organic group, $Y_1$ and $Y_2$ each independently represent C or N, $X_1$ does not exist in a case where $Y_1$ is N, $X_4$ does not exist in a case where $Y_2$ is N, $Ra_1$ represents a hydrogen atom, an alkyl group, or an alkoxy group, and $Rb_1$ to $Rb_4$ each independently represent an alkyl group or an aryl group.

<24> The lithographic printing plate precursor described in <22> or <23>, in which the leuco colorant having a phthalide structure or a fluoran structure is a compound represented by any of Formula (Le-4) to Formula (Le-6).

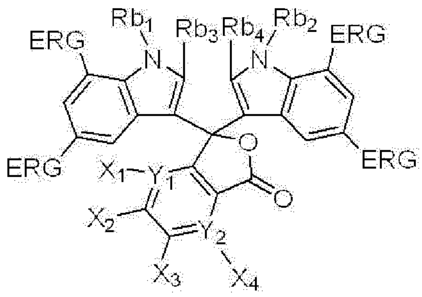

(Le - 4)

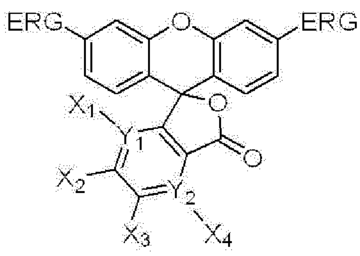

(Le - 5)

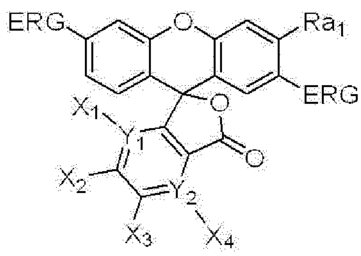

(Le - 6)

In Formula (Le-4) to Formula (Le-6), ERG each independently represents an electron donating group, $X_1$ to $X_4$ each independently represent a hydrogen atom, a halogen atom, or a dialkylanilino group, $Y_1$ and $Y_2$ each independently represent C or N, $X_1$ does not exist in a case where $Y_1$ is N, $X_4$ does not exist in a case where $Y_2$ is N, $Ra_1$ represents a hydrogen atom, an alkyl group, or an alkoxy group, and $Rb_1$ to $Rb_4$ each independently represent an alkyl group or an aryl group.

<25> The lithographic printing plate precursor described in any one of <22> to <24>, in which the leuco colorant having a phthalide structure or a fluoran structure is a compound represented by any of Formula (Le-7) to Formula (Le-9).

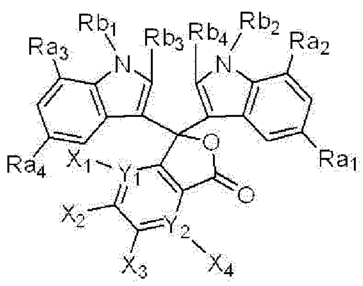

(Le - 7)

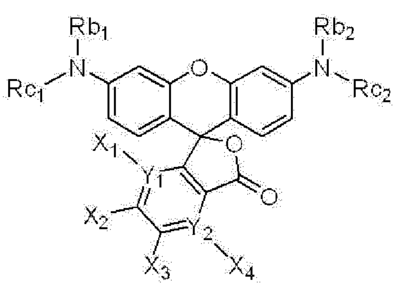

(Le - 8)

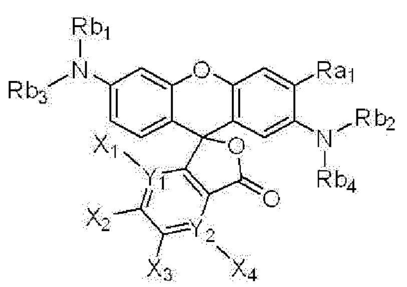

(Le - 9)

In Formula (Le-7) to Formula (Le-9), $X_1$ to $X_4$ each independently represent a hydrogen atom, a halogen atom, or a dialkylanilino group, $Y_1$ and $Y_2$ each independently represent C or N, $X_1$ does not exist in a case where $Y_1$ is N, $X_4$ does not exist in a case where $Y_2$ is N, $Ra_1$ to $Ra_4$ each independently represent a hydrogen atom, an alkyl group, or an alkoxy group, $Rb_1$ to $Rb_4$ each independently represent an alkyl group or an aryl group, and $Rc_1$ and $Rc_2$ each independently represent an aryl group.

<26> The lithographic printing plate precursor described in <25>, in which $Ra_1$ to $Ra_4$ each independently represent an alkoxy group.

<27> The lithographic printing plate precursor described in <25> or <26>, in which the leuco colorant having a phthalide structure or a fluoran structure is a compound represented by Formula (Le-5).

<28> The lithographic printing plate precursor described in <27>, in which $X_1$ to $X_4$ each represent a hydrogen atom, and $Y_1$ and $Y_2$ each represent C.

<29> The lithographic printing plate precursor described in <27> or <28>, in which $Rb_1$ and $Rb_2$ each independently represent an alkyl group.

<30> The lithographic printing plate precursor described in any one of <1> to <29>, in which the polymethine colorant has an organic anion that satisfies $\delta d \geq 16$, $16 \leq \delta p \leq 32$, and $\delta h \leq \delta p \times 0.6$ in the Hansen solubility parameters.

<31> The lithographic printing plate precursor described in any one of <1> to <30>, in which the image-recording layer contains an electron-accepting polymerization initiator, and

the electron-accepting polymerization initiator has an organic anion that satisfies $\delta d \geq 16$, $16 \leq \delta p \leq 32$, and $\delta h \leq \delta p \times 0.6$ in the Hansen solubility parameters.

<32> The lithographic printing plate precursor described in any one of <1> to <31>, in which the polymerization initiator includes an electron-accepting polymerization initiator, and the electron-accepting polymerization initiator includes a compound represented by

Formula (I).

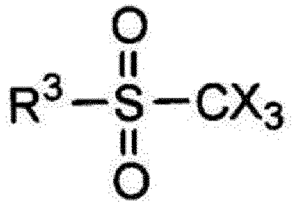 (I)

In Formula (I), X represents a halogen atom, and $R^3$ represents an aryl group.

<33> The lithographic printing plate precursor described in any one of <1> to <32>, in which the polymerizable compound includes a compound having an ethylenically unsaturated bond valence of 5.0 mmol/g or more.

<34> The lithographic printing plate precursor described in <33>, in which the compound having an ethylenically unsaturated bond valence of 5.0 mmol/g or more is a compound represented by Formula (II).

$$\text{Formula (II):} \quad X\text{-}(Y)_n$$

In Formula (II), X represents an n-valent organic group having a hydrogen bonding group, Y represents a monovalent group having 2 or more ethylenically unsaturated groups, n represents an integer of 2 or more, and molecular weight of X/(molecular weight of Y × n) is 1 or less.

<35> The lithographic printing plate precursor described in <33> or <34>, in which the compound having an ethylenically unsaturated bond valence of 5.0 mmol/g or more has at least one kind of structure selected from the group consisting of an adduct structure, a biuret structure, and an isocyanurate structure.

<36> The lithographic printing plate precursor described in any one of <1> to <35>, in which the polymerizable compound includes a compound having one or two ethylenically unsaturated groups.

<37> The lithographic printing plate precursor described in any one of <1> to <36>, in which the image-recording layer further contains a polyvinyl acetal resin.

<38> The lithographic printing plate precursor described in any one of <1> to <37>, in which the image-recording layer further contains a fluoroaliphatic group-containing copolymer.

<39> The lithographic printing plate precursor described in <38>, in which the fluoroaliphatic group-containing copolymer has a constitutional unit formed of a compound represented by any of Formula (F1) or Formula (F2).

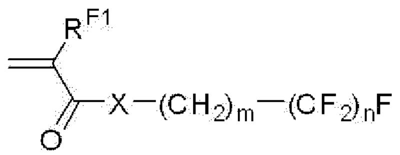

(F1)

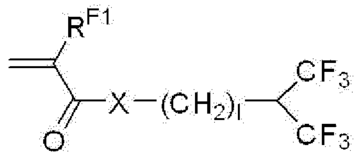

(F2)

In Formula (F1) and Formula (F2), $R^{F1}$ each independently represents a hydrogen atom or a methyl group, X each independently represents an oxygen atom, a sulfur atom, or $-N(R^{F2})-$, m represents an integer of 1 to 6, n represents an integer of 1 to 10, 1 represents an integer of 0 to 10, and $R^{F2}$ represents a hydrogen atom or an alkyl group having 1 to 4 carbon atoms.

<40> The lithographic printing plate precursor described in <39>, in which the fluoroaliphatic group-containing copolymer further has a constitutional unit formed of at least one kind of compound selected from the group consisting of poly(oxyalkylene) acrylate and poly(oxyalkylene) methacrylate.

<41> The lithographic printing plate precursor described in any one of <1> to <40>, in which the water-soluble overcoat layer contains a hydrophobic polymer.

<42> The lithographic printing plate precursor described in any one of <1> to <41>, in which the water-soluble overcoat layer contains a discoloring compound.

<43> The lithographic printing plate precursor described in <42>, in which the discoloring compound is an infrared absorber.

<44> The lithographic printing plate precursor described in <42> or <43>, in which the discoloring compound includes a decomposable compound that decomposes due to exposure to infrared.

<45> The lithographic printing plate precursor described in any one of <1> to <44>,

in which the aluminum support has an aluminum plate and an anodic oxide film of aluminum disposed on the aluminum plate,
the anodic oxide film is at a position closer to a side of the image-recording layer than the aluminum plate and has micropores extending in a depth direction from a surface of the anodic oxide film on the side of the image-recording layer,
an average diameter of the micropores within the surface of the anodic oxide film is more than 10 nm and 100 nm or less, and
in the L*a*b* color space, a value of brightness L* of the surface of the anodic oxide film on the side of the image-recording layer is 70 to 100.

<46> The lithographic printing plate precursor described in <45>, in which the micropores are each composed of a large diameter portion that extends to a position at a depth of 10 nm to 1,000 nm from the surface of the anodic oxide film and a small diameter portion that is in communication with a bottom portion of the large diameter portion and extends to a position at a depth of 20 nm to 2,000 nm from a communication position,

an average diameter of the large diameter portion within the surface of the anodic oxide film is 15 nm to 100 nm, and
an average diameter of the small diameter portion at the communication position is 13 nm or less.

<47> The lithographic printing plate precursor described in any one of <1> to <46>, which is a lithographic printing plate precursor for on-press development.

<48> A method for preparing a lithographic printing plate, including a step of exposing the lithographic printing plate precursor described in any one of <1> to <47> in the shape of an image, and
a step of supplying at least one material selected from the group consisting of a printing ink and dampening water on a printer so as to remove an image-recording layer in a non-image area.

<49> A lithographic printing method, including a step of exposing the lithographic printing plate precursor described in any one of <1> to <47> in the shape of an image,

a step of supplying at least one material selected from the group consisting of a printing ink and dampening water on a printer so as to remove the image-recording layer in a non-image area and to prepare a lithographic printing plate, and
a step of performing printing by using the obtained lithographic printing plate.

According to one embodiment of the present disclosure, it is possible to provide a lithographic printing plate precursor that excellently suppresses plate missing.
According to another embodiment of the present disclosure, it is possible to provide a method for preparing a lithographic printing plate or a lithographic printing method using the lithographic printing plate precursor.

BRIEF DESCRIPTION OF THE DRAWINGS

Fig. 1 is a schematic cross-sectional view of an embodiment of an aluminum support.
Fig. 2 is a schematic cross-sectional view of another embodiment of the aluminum support.
Fig. 3 is an example of a waveform graph of alternating current used for an electrochemical roughening treatment in a method for manufacturing an aluminum support.
Fig. 4 is a lateral view showing an example of a radial cell in an electrochemical roughening treatment using alternating current in a method for manufacturing an aluminum support.
Fig. 5 is a schematic view of an anodic oxidation treatment device used for an anodic oxidation treatment in preparing an aluminum support.

DESCRIPTION OF THE PREFERRED EMBODIMENTS

Hereinafter, the contents of the present disclosure will be specifically described. The following constituents will be described on the basis of typical embodiments of the present disclosure, but the present disclosure is not limited to such embodiments.
In the present disclosure, a numerical range expressed using "to" includes numerical values listed before and after "to" as the lower limit and the upper limit.
Furthermore, in the present disclosure, in a case where there is no description regarding whether a group (atomic group) is substituted or unsubstituted, such a group includes both a group having no substituent and a group having a substituent. For example, "alkyl group" includes not only an alkyl group having no substituent (unsubstituted alkyl group) but also an alkyl group having a substituent (substituted alkyl group).
In the present disclosure, "(meth)acryl" is a term used to explain a concept including both the acryl and methacryl, and "(meth)acryloyl" is a term used to explain a concept including both the acryloyl and methacryloyl.
In addition, the term "step" in the present disclosure means not only an independent step but also a step that cannot be clearly differentiated from other steps as long as the intended goal of the step is achieved. In the present disclosure, "% by mass" has the same definition as "% by weight", and "part by mass" has the same definition as "part by weight".
In the present disclosure, a combination of two or more preferred aspects is a more preferred aspect.
In addition, in the present disclosure, unless otherwise specified, each of the weight-average molecular weight (Mw) and number-average molecular weight (Mn) is a molecular weight that is detected using a gel permeation chromatography (GPC) analysis device using TSKgel GMHxL, TSKgel G4000HxL, and TSKgel G2000HxL (trade names, manufactured by Tosoh Corporation) as columns, tetrahydrofuran (THF) as a solvent, and a differential refractometer, and expressed in terms of polystyrene as a standard substance.
In the present disclosure, the term "lithographic printing plate precursor" refers not only to a lithographic printing plate precursor but also to a key plate precursor. In addition, the term "lithographic printing plate" refers not only to a lithographic printing plate prepared by performing operations such as exposure and development as necessary on a lithographic printing plate precursor but also to a key plate. The key plate precursor is not necessarily subjected to the operations such as exposure and development. The key plate refers to a lithographic printing plate precursor to be mounted on a plate cylinder that is not used, in a case where monochromatic or dichromatic printing is carried out on a part of paper during, for example, color newspaper printing.
Hereinafter, the on-press development type lithographic printing plate precursor, the method for preparing a lithographic printing plate, and the lithographic printing method according to the present disclosure will be specifically described.

(Lithographic printing plate precursor)

The lithographic printing plate precursor according to the present disclosure has an aluminum support, an image-recording layer, and a water-soluble overcoat layer in this order, in which the image-recording layer contains an infrared-absorbing polymethine colorant having HOMO of -5.2 eV or less, a polymerization initiator, a polymerizable compound, and a polymer, and the polymer has a constitutional unit formed of an aromatic vinyl compound and a constitutional unit formed of an acrylonitrile compound.

In addition, the lithographic printing plate precursor according to the present disclosure is a negative tone lithographic printing plate precursor and can be suitably used as a lithographic printing plate precursor for on-press development.

There is a demand for a lithographic printing plate with which printing can be performed on a large number of sheets (hereinafter, this property will be also called "printing durability").

Particularly, in recent years, as a printing ink, an ink that is cured by the irradiation with ultraviolet rays (UV) (also called ("ultraviolet-curable ink or UV ink") has been used in some cases.

Being able to dry instantly, the UV ink has high productivity. Furthermore, because the UV ink contains a small amount of solvents or contains no solvent, environmental pollution is likely to be reduced. In addition, the UV ink makes it possible to form an image without performing heat drying or by reducing the time of heat drying. Therefore, the UV ink has advantages such as being applicable to printing on a wide variety of objects and the like.

Accordingly, a lithographic printing plate precursor that can provide a lithographic printing plate exhibiting excellent printing durability even in a case where the UV ink is used is considered to be very useful in industry.

As a result of intensive studies, the inventors of the present invention have found that the lithographic printing plate precursor described in JP2005-103968A or JP2006-001144A provides a lithographic printing plate that exhibits insufficient printing durability (that is UV printing durability) particularly in a case where a UV ink is used as ink.

As a result of intensive studies, the inventors of the present invention have found that adopting the above constitution makes it possible to provide a lithographic printing plate precursor from which a lithographic printing plate excellently suppressing plate missing is obtained.

The detailed mechanism that brings about the aforementioned effect is unclear, but is assumed to be as below.

Presumably, because the image-recording layer contains a polymethine colorant having a specific oxidation potential, radical generation efficiency may increase. Furthermore, presumably, because the image-recording layer has a water-soluble overcoat layer, the oxygen blocking effect may improve polymerization efficiency. In addition, presumably, because the image-recording layer contains a polymer having a constitutional unit formed of an aromatic vinyl compound and a constitutional unit formed of an acrylonitrile compound, plate missing may be excellently suppressed, and excellent printing durability (particularly, UV printing durability) may be easily obtained.

Furthermore, presumably, having a water-soluble overcoat layer, the image-recording layer may be easily dissolved or swollen in dampening water and thus exhibit excellent on-press developability.

In a case where fibers of paper or threads of the worker's clothing adhere to the surface of a lithographic printing plate, the pressure applied to the lithographic printing plate locally increases. As a result, an image area is destroyed (a cured film is removed), ink does not stick to that portion, and printing ends as it is, which is a phenomenon called "plate missing".

In lithographic printing plate, the larger the number of sheets completely printed until "plate missing" occurs, the less likely it is that plate missing occurs.

<Image-recording layer>

The image-recording layer in the present disclosure contains an infrared-absorbing polymethine colorant having HOMO of -5.2 eV or less, a polymerization initiator, a polymerizable compound, and a polymer, and the polymer has a constitutional unit formed of an aromatic vinyl compound and a constitutional unit formed of an acrylonitrile compound. The image-recording layer in the present disclosure is preferably an on-press development type image-recording layer.

Hereinafter, each of the components contained in the image-recording layer will be specifically described.

«Infrared-absorbing polymethine colorant»

The image-recording layer contains an infrared-absorbing polymethine colorant (also called "specific polymethine colorant") having HOMO (highest occupied molecular orbital) of -5.2 eV or less.

HOMO of the specific polymethine colorant is -5.2 eV or less. From the viewpoint of UV printing durability and on-press developability, HOMO of the specific polymethine colorant is preferably -5.25 eV or less, more preferably -5.3 eV or less, even more preferably -6.0 eV or more and -5.3 eV or less, and particularly preferably -5.6 eV or more and -5.3 eV or less.

In the present disclosure, the highest occupied molecular orbital (HOMO) and the lowest unoccupied molecular orbital (LUMO) are calculated by the following methods.

First, the counteranion in the compound as a subject of calculation is ignored.

The structural optimization is carried out by DFT (B3LYP/6-31G(d)) using quantum chemical calculation software Gaussian 09.

The molecular orbital (MO) energy is calculated by DFT (B3LYP/6-31+G(d,p)/CPCM (solvent = methanol)) using the structure obtained by the structural optimization.

By the following formula, the MO energy Ebare (unit: hartree) obtained by the above MO energy calculation is converted into Escaled (unit: eV) used as the values of HOMO and LUMO in the present disclosure.

$$\text{Escaled} = 0.823168 \times 27.2114 \times \text{Ebare} - 1.07634$$

27.2114 is a simply a coefficient for converting hartree into eV, and 0.823168 and -1.07634 are adjustment coefficients. These are determined such that the calculated values of HOMO and LUMO of the compound as a calculation object match the measured values.

Examples of the specific polymethine colorant include colorants having a polymethine chain. Preferable examples thereof include a cyanine dye, a pyrylium colorant, a thiopyrylium colorant, an azulenium colorant, and the like. From the viewpoint of ease of availability, solubility in a solvent during an introduction reaction, and the like, a cyanine dye is preferable.

Furthermore, the specific polymethine colorant may be a pigment or a dye.

From the viewpoint of UV printing durability and on-press developability, the specific polymethine colorant preferably includes a cyanine dye having an electron-withdrawing group or a heavy atom-containing group in at least one of the aromatic rings at both terminals, more preferably includes a cyanine dye having a halogen atom, an alkoxycarbonyl group, or an aryloxycarbonyl group in at least one of the aromatic rings at both terminals, even more preferably includes a cyanine dye having a halogen atom in at least one of the aromatic rings at both terminals, and particularly preferably includes a cyanine dye having a chlorine atom in at least one of the aromatic rings at both terminals.

Furthermore, from the viewpoint of UV printing durability and on-press developability, the specific polymethine colorant preferably includes a cyanine dye having an electron-withdrawing group or a heavy atom-containing group in each of the aromatic rings at both terminals.

In addition, from the viewpoint of UV printing durability and on-press developability, the specific polymethine colorant preferably includes a cyanine dye having an electron-withdrawing group in at least one of the aromatic rings at both terminals.

In the present disclosure, in a case where a group corresponds to both the electron-withdrawing group and the heavy atom-containing group, the electron-withdrawing group containing a heavy atom is regarded as an electron-withdrawing group.

From the viewpoint of UV printing durability and on-press developability, the electron-withdrawing group is preferably a group that satisfies $\sigma$para $\geq$ 0.01, more preferably a group that satisfies $\sigma$para $\geq$ 0.05, even more preferably a group that satisfies $\sigma$para $\geq$ 0.20, and particularly preferably a group that satisfies $\sigma$para $\geq$ 0.30, in which $\sigma$para is a value of the Hammett substituent constant.

Examples of the group that satisfies $\sigma$para $\geq$ 0.05 include halogen atoms such as a fluorine atom (0.06), a chlorine atom (0.30), a bromine atom (0.27), and an iodine atom (0.30); carbonyl substituents such as -CHO (0.22), $-COCH_3$ (0.50), $-COC_6H_5$ (0.46), $-CONH_2$ (0.36), $-COO^-$ (0.30), -COOH (0.41),$-COOCH_3$ (0.39), and $-COOC_2H_5$ (0.45); sulfonyl or sulfinyl substituents such as $-SOCH_3$ (0.49), $-SO_2CH_3$ (0.72), $-SO_2C_6H_5$, $-SO_2CF_3$ (0.93), $-SO_2NH_2$ (0.57), $-SO_2OC_6H_5$, $-SO_3^-$ (0.09), and $-SO_3H$ (0.50); nitrogen-containing substituents such as -CN (0.01), $-N(CH_3)_3^+$ (0.82) and $-N(CF_3)_2$ (0.53); and halogen atom-containing substituents such as $-CCl_3$, $-CH_2Cl$ (0.18), $-CHCl_2$, and $-CF_3$ (0.54). The numerical value in the parentheses is the $\sigma$para value of each compound.

Specifically, suitable examples of such an electron-withdrawing group include a substituent having an unshared electron pair. Examples of the substituent having an unshared electron pair include a halogen atom, a carbonyl group-containing group, a sulfonyl group-containing group, a sulfinyl group-containing group, and an ether bond-containing group. Among these, a halogen atom or a carbonyl group-containing group is preferable, a halogen atom, an alkoxycarbonyl group, or an aryloxycarbonyl group is more preferable, a halogen atom is even more preferable, and a chlorine atom is particularly preferable.

Specific examples of the carbonyl group-containing group include an acyl group such as an acetyl group or a benzoyl group; an alkoxycarbonyl group or an aryloxycarbonyl group such as a methoxycarbonyl group or a toluyloxycarbonyl group; an amide group such as a diethylaminocarbonyl group; and a carboxy group. These may be bonded to an aromatic ring or heterocycle of the cyanine dye through a linking group having a valency of 2 or more.

In the present disclosure, "heavy atom-containing group" means a group containing an atom having an atomic

weight of 28 or more. Suitable examples of the atom having an atomic weight of 28 or more include a silicon atom (28.09), a phosphorus atom (30.97), a sulfur atom (32.07), a chlorine atom (35.45), a germanium atom (72.61), an arsenic atom (74.92), a selenium atom (78.96), a bromine atom (79.90), a tin atom (118.71), an antimony atom (121.76), a tellurium atom (127.60), and an iodine atom (126.90). The numerical value in the parentheses is the atomic weight of each atom.

Among these, from the viewpoint of safety and availability of raw materials, a group containing a silicon atom, a phosphorus atom, or a halogen atom is preferable.

It is preferable that the groups containing the above atoms having an atomic weight of 28 or more (heavy atom-containing group) act as substituents on the aromatic ring of the cyanine dye, alone or in combination with other atoms. Furthermore, such substituents may be bonded to the aromatic ring of the cyanine dye through a linking group having a valency of 2 or more.

Examples of the silicon atom-containing group include a group having an alkyl group or an aryl group on a silicon atom, such as a trimethylsilyl group, a t-butyldimethylsilyl group, and a dimethylphenylsilyl group.

Examples of the phosphorus atom-containing group include a group having an alkyl group or an aryl group on a phosphorus atom, such as a dimethylphosphino group and a diphenylphosphino group; and a phosphono group.

Examples of the sulfur atom-containing group partially overlap the examples of the aforementioned electron-withdrawing group, and include an alkylsulfonyl group or an arylsulfonyl group such as a methylsulfonyl group or a phenylsulfonyl group; an alkylsulfinyl group or an arylsulfinyl group such as an ethylsulfinyl group or a toluylsulfinyl group; a sulfuric acid group or a salt or ester derivative thereof such as a sulfo group, a sulfino group, or a sulfeno group; and an alkylthio group or an arylthio group such as a methylthio group or a phenylthio group.

Examples of the halogen atom-containing group partially overlap the examples of the aforementioned electron-withdrawing group, and include a halogen atom, a halogen-substituted alkyl group, and a halogen-substituted aryl group.

Specific examples of the specific polymethine colorant include those having HOMO of -5.2 eV or less among the following colorants.

Specific examples of the cyanine dye include the compounds described in paragraphs "0017" to "0019" of JP2001-133969A and the compounds described in paragraphs "0016" to "0021" of JP2002-023360A and paragraphs "0012" to "0037" of JP2002-040638A. As the cyanine dye, for example, the compounds described in paragraphs "0034" to "0041" of JP2002-278057A and paragraphs "0080" to "0086" of JP2008-195018A are preferable, and the compounds described in paragraphs "0035" to "0043" of JP2007-90850A and the compounds described in paragraphs "0105" to "0113" of JP2012-206495A are particularly preferable.

Furthermore, the compounds described in paragraphs "0008" and "0009" of JP1993-5005A (JP-H05-5005A) and paragraphs "0022" to "0025" of JP2001-222101A can also be preferably used.

As pigments, the compounds described in paragraphs "0072" to "0076" of JP2008-195018A are preferable.

Furthermore, as the specific polymethine colorant, a polymethine colorant that decomposes by exposure to infrared (also called "decomposable polymethine colorant") can be suitably used.

As the polymethine colorant that decomposes by exposure to infrared, those described in JP2008-544322A, WO2016/027886A, WO2017/141882A, or WO2018/043259A can also be suitably used.

One kind of specific polymethine colorant may be used alone, or two or more kinds of specific polymethine colorants may be used in combination. In addition, as the specific polymethine colorant, a pigment and a dye may be used in combination.

The content of the specific polymethine colorant in the image-recording layer with respect to the total mass of the image-recording layer is preferably 0.1% by mass to 10.0% by mass, and more preferably 0.5% by mass to 5.0% by mass.

«Polymerization initiator»

The image-recording layer in the present disclosure contains a polymerization initiator.

The polymerization initiator is not particularly limited, and examples thereof include an electron-accepting polymerization initiator, an electron-donating polymerization initiator, and the like.

[Electron-accepting polymerization initiator]

The image-recording layer preferably contains an electron-accepting polymerization initiator.

The electron-accepting polymerization initiator used in the present disclosure is a compound that generates a polymerization initiation species such as a radical or a cation by either or both of light energy and heat energy, and can be appropriately selected from known thermal polymerization initiators, compounds having a bond that can be dissociated by little energy, photopolymerization initiators, and the like.

The electron-accepting polymerization initiator is preferably a radical polymerization initiator and more preferably

an onium compound.

In addition, as the electron-accepting polymerization initiator, an infrared-ray-sensitive polymerization initiator is preferable.

One kind of electron-accepting polymerization initiator may be used alone, or two or more kinds of electron-accepting polymerization initiators may be used in combination.

Examples of the radical polymerization initiator include (a) organic halide, (b) carbonyl compound, (c) azo compound, (d) organic peroxide, (e) metallocene compound, (f) azide compound, (g) hexaarylbiimidazole compound, (i) disulfone compound, (j) oxime ester compound, and (k) onium compound.

As (a) organic halide, for example, the compounds described in paragraphs "0022" and" 0023" of JP2008-195018A are preferable.

As (b) carbonyl compound, for example, the compounds described in paragraph "0024" of JP2008-195018A are preferable.

As (c) azo compound, for example, the azo compounds described in JP1996-108621A (JP-H08-108621A) and the like can be used.

As (d) organic peroxide, for example, the compounds described in paragraph "0025" of JP2008-195018A are preferable.

As (e) metallocene compound, for example, the compounds described in paragraph "0026" of JP2008-195018A are preferable.

Examples of (f) azide compound include compounds such as 2,6-bis(4-azidobenzylidene)-4-methylcyclohexanone.

As (g) hexaarylbiimidazole compound, for example, the compounds described in paragraph "0027" of JP2008-195018A are preferable.

Examples of (i) disulfone compound include the compounds described in JP1986-166544A (JP-S61-166544A) and JP2002-328465A.

As (j) oxime ester compound, for example, the compounds described in paragraphs "0028" to "0030" of JP2008-195018A are preferable.

Among the above electron-accepting polymerization initiators, from the viewpoint of curing properties, for example, (j) oxime ester compound and (k) onium compound are preferable. Particularly, from the viewpoint of UV printing durability, an iodonium salt compound, a sulfonium salt compound, or an azinium salt compound is preferable, an iodonium salt compound or a sulfonium salt compound is more preferable, and an iodonium salt compound is even more preferable.

Specific examples of these compounds will be shown below, but the present disclosure is not limited thereto.

As the iodonium salt compound, for example, a diaryl iodonium salt compound is preferable. Particularly, a diphenyl iodonium salt compound substituted with an electron donating group such as an alkyl group or an alkoxyl group is more preferable. Furthermore, an asymmetric diphenyl iodonium salt compound is preferable. Specific examples thereof include diphenyliodonium=hexafluorophosphate, 4-methoxyphenyl-4-(2-methylpropyl)phenyliodonium=hexafluorophosphate, 4-(2-methylpropyl)phenyl-p-tolyliodonium=hexafluorophosphate, 4-hexyloxyphenyl-2,4,6-trimethoxyphenyliodonium=hexafluorophosphate, 4-hexyloxyphenyl-2,4-diethoxyphenyl iodonium=tetrafluoroborate, 4-octyloxyphenyl-2,4,6-trimethoxyphenyl iodonium=1-perfluorobutane sulfonate, 4-octyloxyphenyl-2,4,6-trimethoxyphenyliodonium=hexafluorophosphate, and bis(4-t-butylphenyl)iodonium=hexafluorophosphate.

As the sulfonium salt compound, for example, a triarylsulfonium salt compound is preferable. Particularly, a triarylsulfonium salt compound is preferable in which at least some of electron-withdrawing groups such as groups on an aromatic ring are substituted with halogen atoms, and a triarylsulfonium salt compound is more preferable in which the total number of halogen atoms as substituents on an aromatic ring is 4 or more. Specific examples thereof include triphenylsulfonium=hexafluorophosphate, triphenylsulfonium=benzoyl formate, bis(4-chlorophenyl)phenylsulfonium=benzoyl formate, bis(4-chlorophenyl)-4-methylphenylsulfonium=tetrafluoroborate, tris(4-chlorophenyl)sulfonium=3,5-bis(methoxycarbonyl)benzenesulfonate, tris(4-chlorophenyl)sulfonium=hexafluorophosphate, and tris(2,4-dichlorophenyl)sulfonium=hexafluorophosphate.

As a counteranion of the iodonium salt compound and the sulfonium salt compound, a sulfonamide anion or a sulfonimide anion is preferable, and a sulfonimide anion is more preferable.

As the sulfonamide anion, an aryl sulfonamide anion is preferable.

As the sulfonimide anion, a bisaryl sulfonimide anion is preferable.

Specific examples of the sulfonamide anion or the sulfonimide anion will be shown below, but the sulfonamide anion or the sulfonimide anion of the present disclosure is not limited thereto. In the following specific examples, Ph represents a phenyl group, Me represents a methyl group, and Et represents an ethyl group.

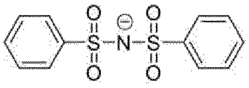
I-1

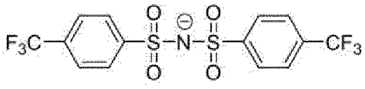
I-2

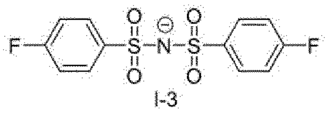
I-3

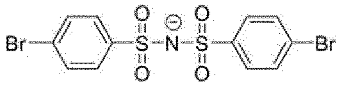
I-4

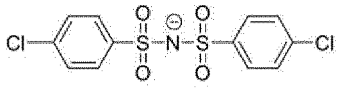
I-5

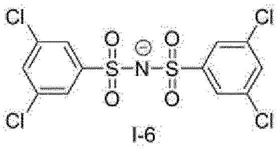
I-6

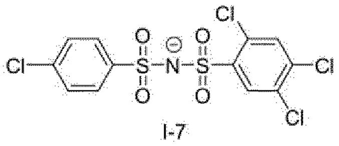
I-7

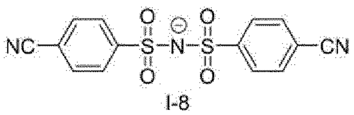
I-8

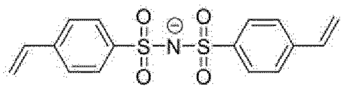
I-9

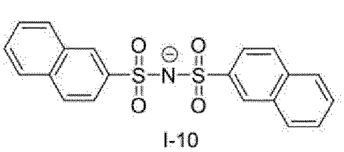
I-10

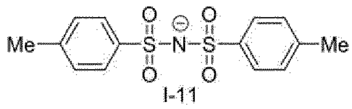
I-11

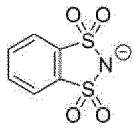
I-12

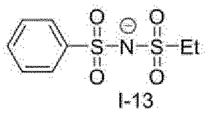
I-13

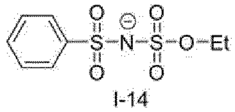
I-14

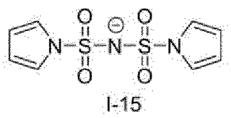
I-15

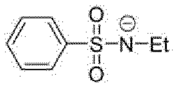
I-16

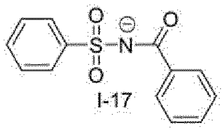
I-17

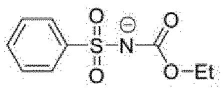
I-18

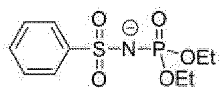
I-19

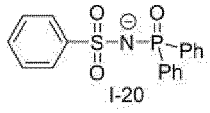
I-20

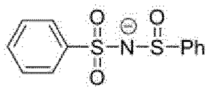
I-21

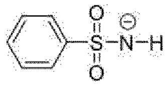
I-22

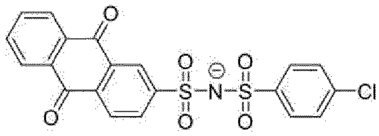
I-23

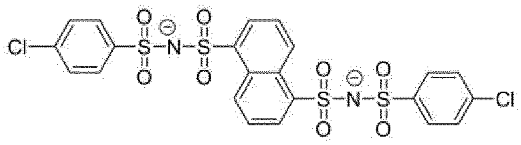
I-24

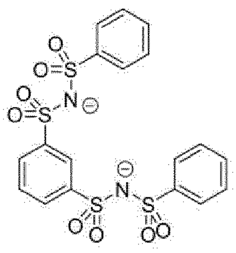
I-25

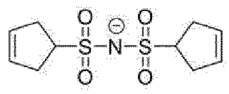
I-26

From the viewpoint of developability and UV printing durability of the lithographic printing plate to be obtained, the electron-accepting polymerization initiator may include a compound represented by Formula (I).

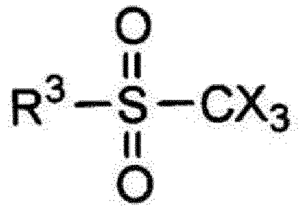

(I)

In Formula (I), X represents a halogen atom, and $R^3$ represents an aryl group.

Specifically, examples of X in Formula (I) include a fluorine atom, a chlorine atom, a bromine atom, and an iodine atom. Among these, a chlorine atom or a bromine atom is preferable because these have excellent sensitivity, and a bromine atom is particularly preferable.

Furthermore, from the viewpoint of excellent balance between sensitivity and storage stability, $R^3$ in Formula (I) is preferably an aryl group substituted with an amide group.

Specific examples of the compound represented by Formula (I) include compounds represented by the following formulas. However, the present disclosure is not limited thereto.

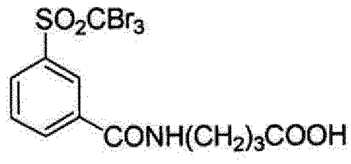 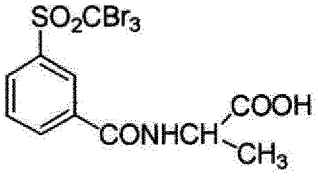 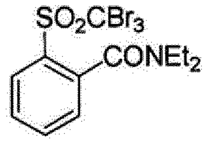

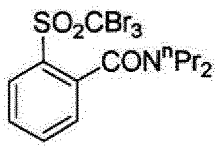 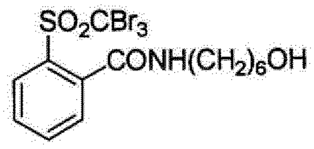 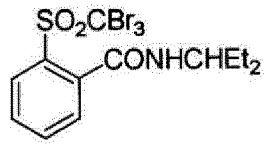

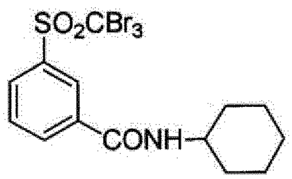 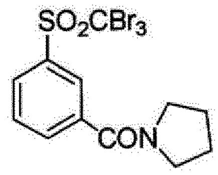 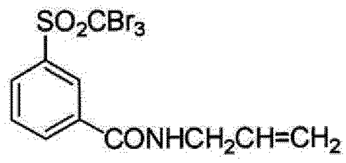

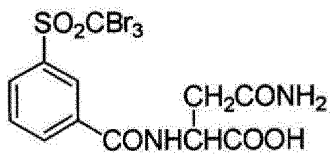 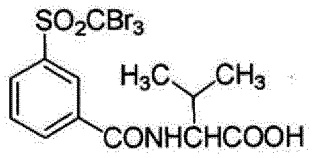 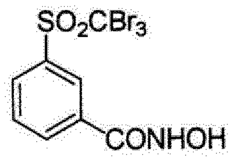

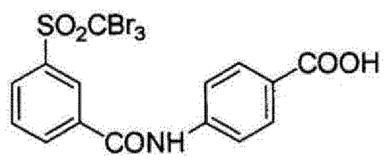 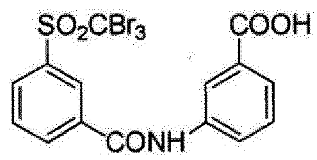 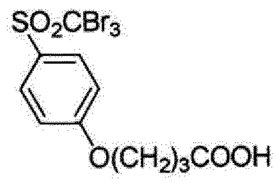

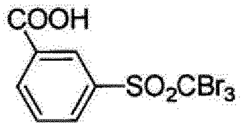 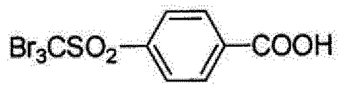 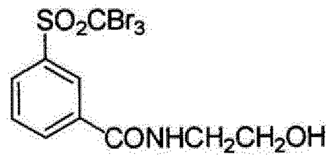

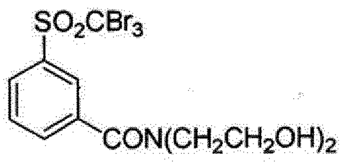
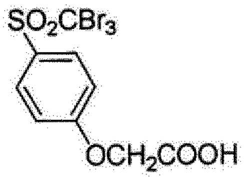
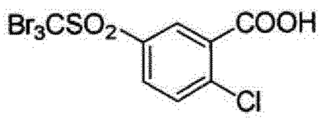

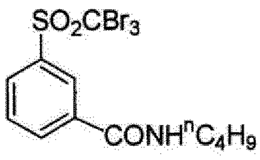
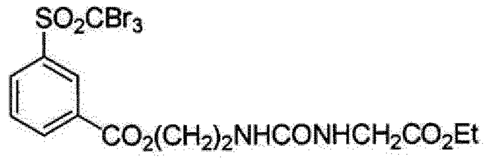

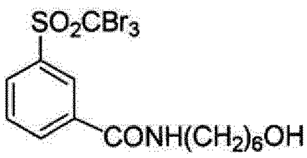
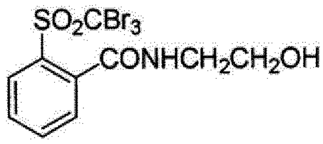

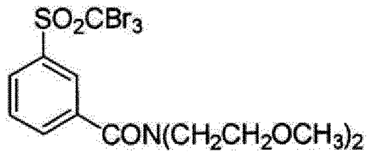
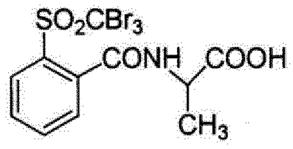

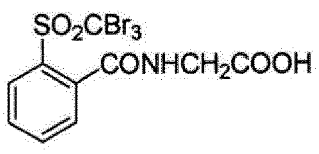
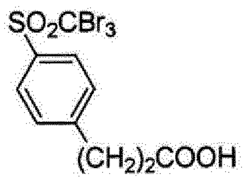
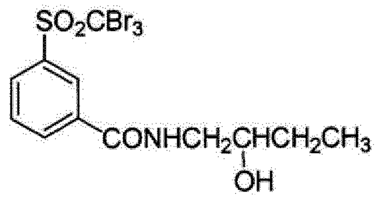

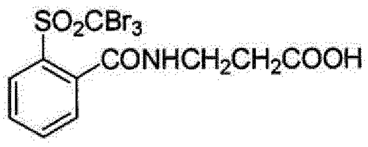
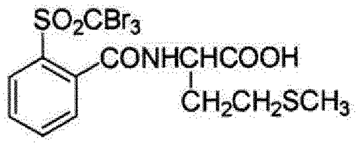

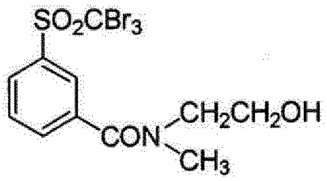
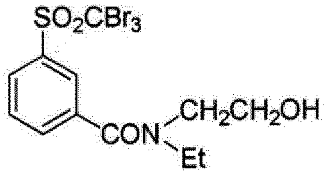
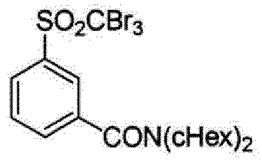

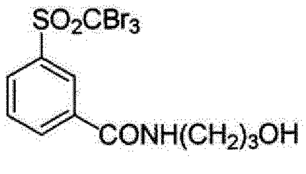
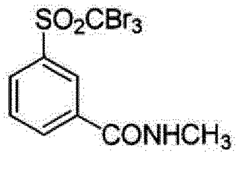
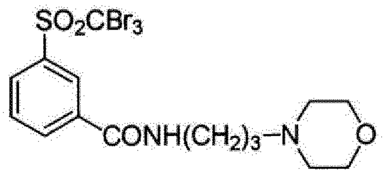

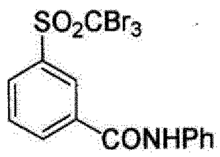
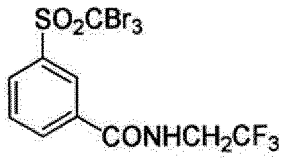
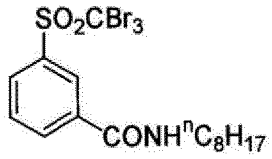

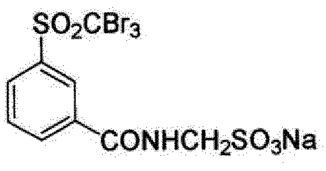
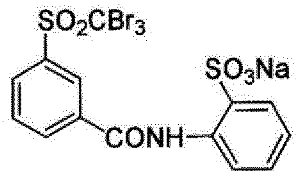
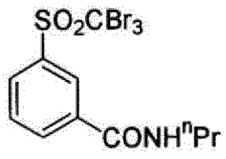

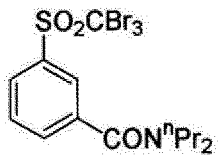
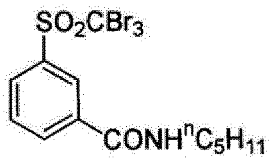
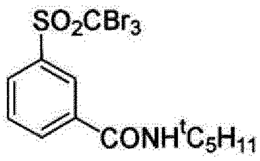

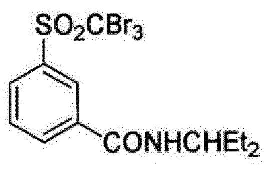
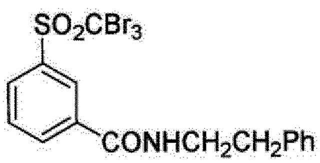
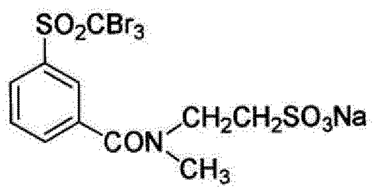

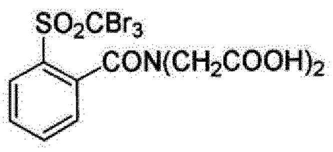
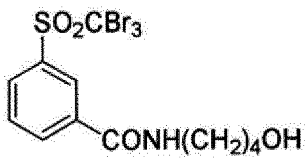

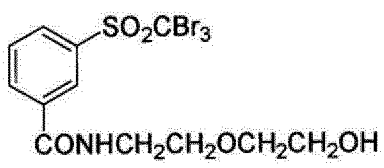
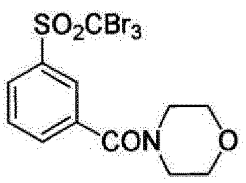
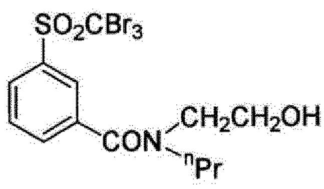

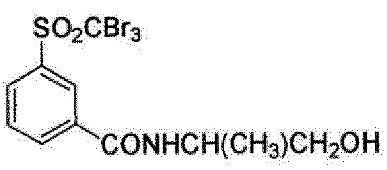
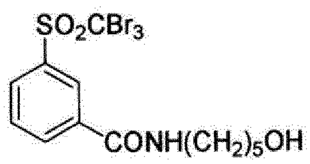

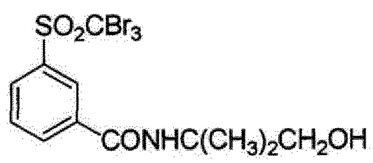
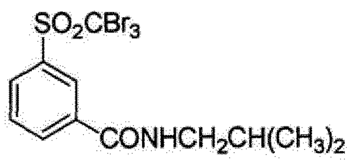

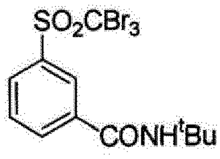
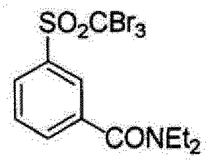
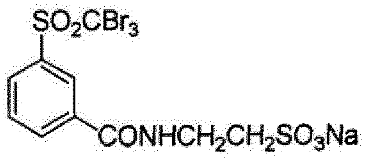

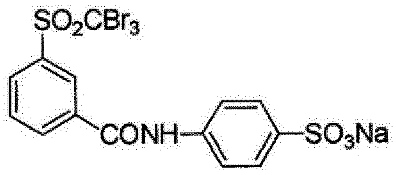
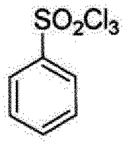
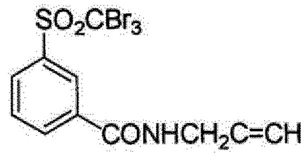

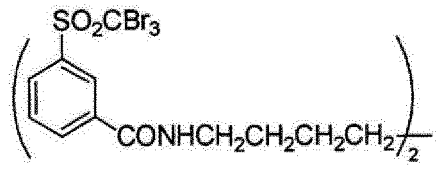
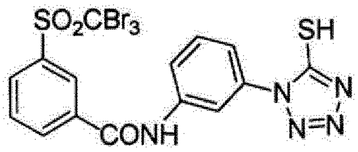

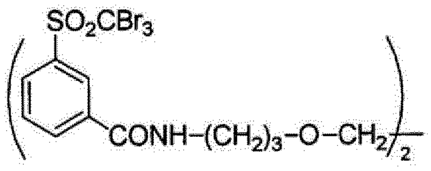
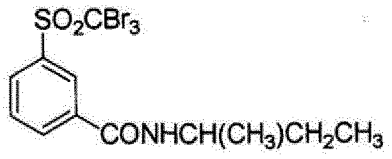

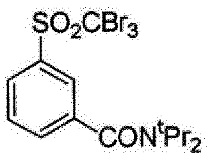
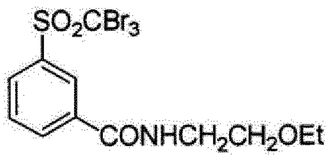
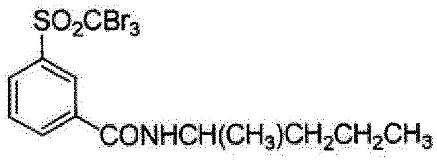

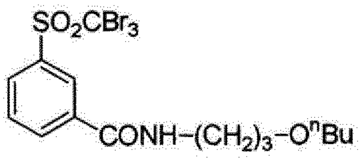
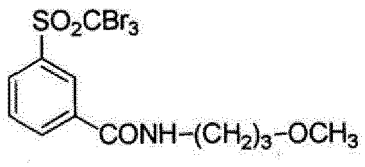

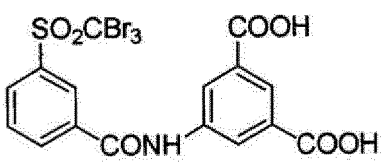
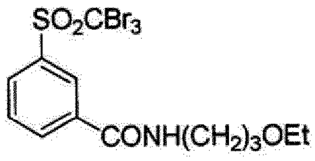

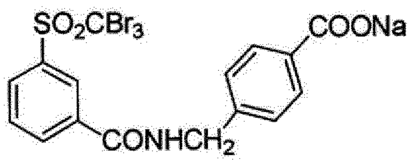
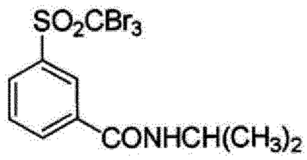

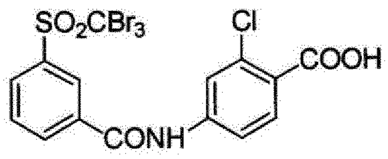
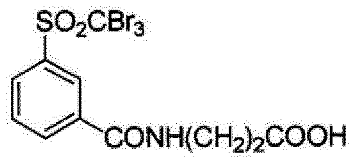

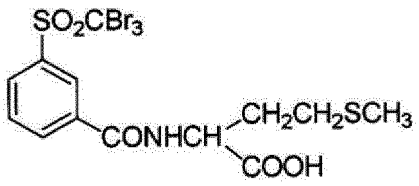
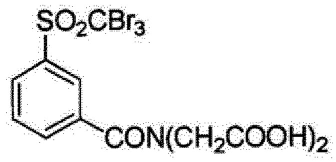

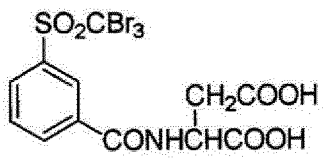
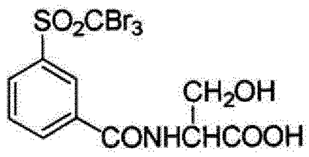
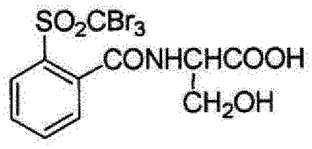

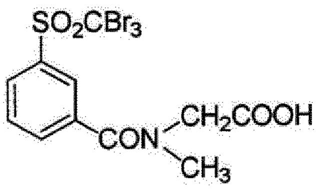
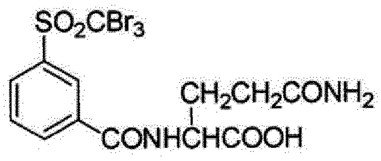
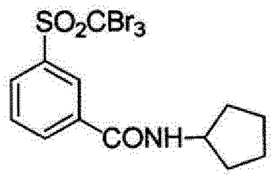

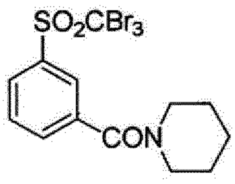
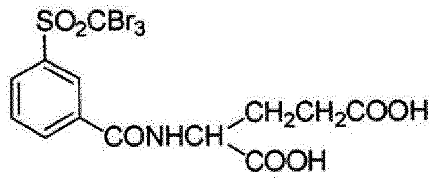

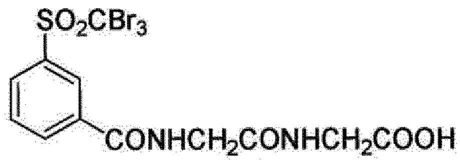
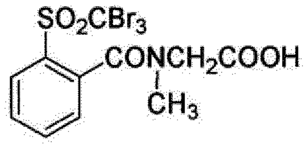

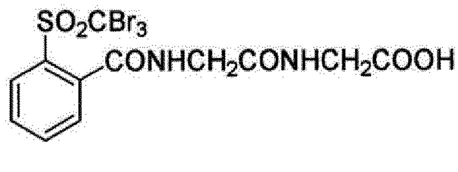
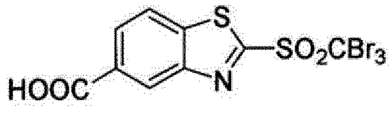

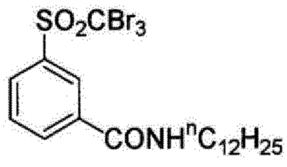
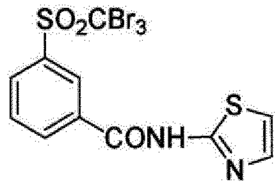
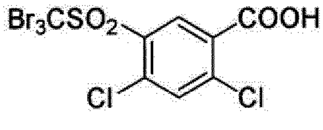

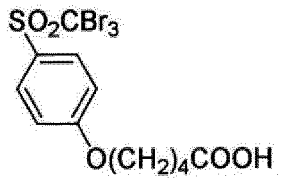

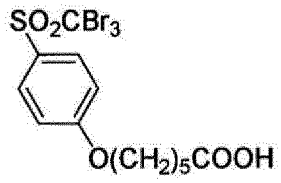

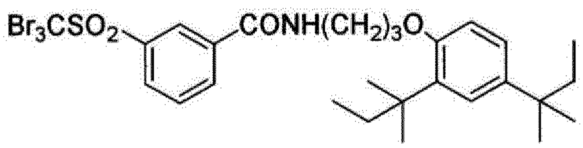

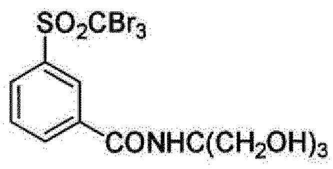

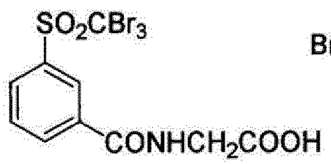

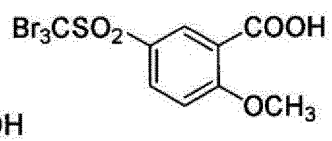

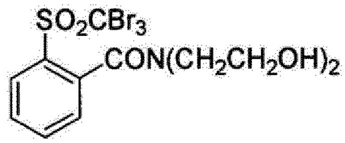

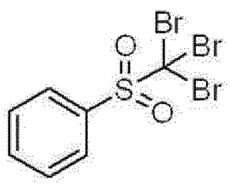

(IS-1)

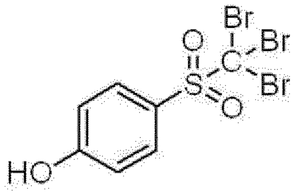

(IS-2)

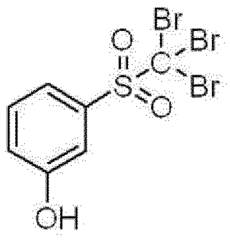

(IS-3)

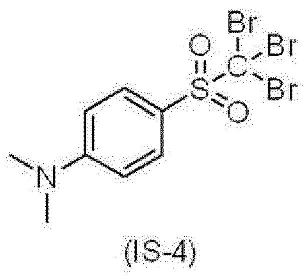

(IS-4)

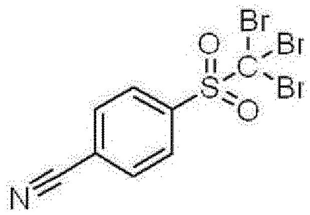

(IS-5)

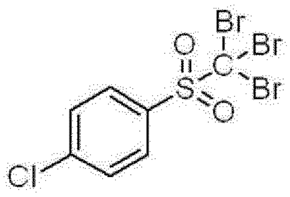

(IS-6)

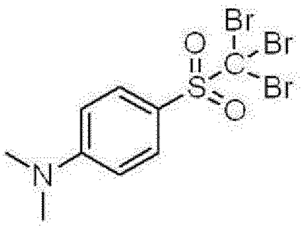

(IS-7)

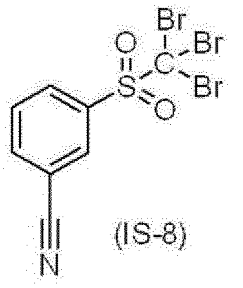

(IS-8)

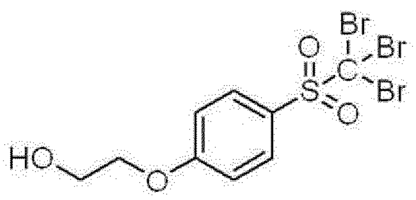

(IS-9)

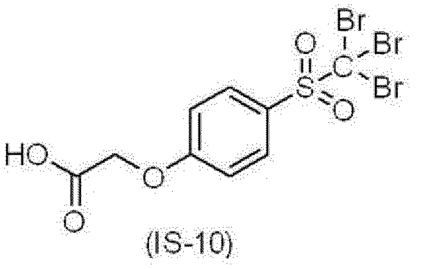

(IS-10)

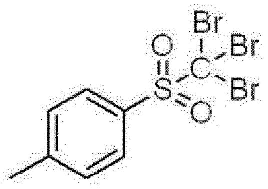

(IS-11)

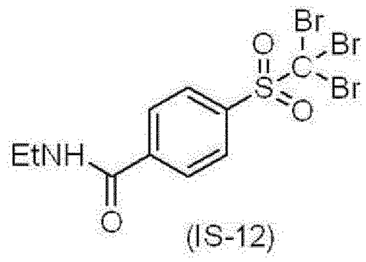

(IS-12)

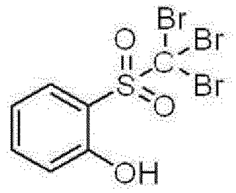

(IS-13)

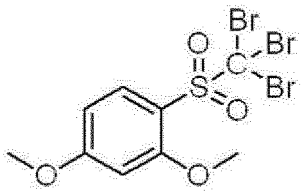

(IS-14)

From the viewpoint of on-press developability and UV printing durability, the lowest unoccupied molecular orbital (LUMO) of the electron-accepting polymerization initiator is preferably -3.00 eV or less, and more preferably -3.02 eV or less.

The lower limit of LUMO of the electron-accepting polymerization initiator is preferably -3.80 eV or more, and more preferably -3.60 eV or more.

-Content of electron-accepting polymerization initiator-

The content of the electron-accepting polymerization initiator with respect to the total mass of the image-recording layer is preferably 0.1% by mass to 50% by mass, more preferably 0.5% by mass to 30% by mass, and particularly preferably 0.8% by mass to 20% by mass.

One kind of electron-accepting polymerization initiator may be used alone, or two or more kinds of electron-accepting polymerization initiators may be used in combination.

[Electron-donating polymerization initiator (polymerization aid)]

The image-recording layer preferably contains, as a polymerization initiator, an electron-donating polymerization initiator (also called "polymerization aid"), and more preferably contains an electron-accepting polymerization initiator and an electron-donating polymerization initiator.

The electron-donating polymerization initiator in the present disclosure is a compound which donates one electron by intermolecular electron transfer to an orbit of an infrared absorber that has lost one electron in a case where electrons of the infrared absorber are excited or perform intramolecular transfer by exposure to infrared, and thus generates polymerization initiation species such as radicals.

The electron-donating polymerization initiator is preferably an electron-donating radical polymerization initiator.

From the viewpoint of improving the printing durability of the lithographic printing plate, the image-recording layer more preferably contains the electron-donating polymerization initiator that will be described below. Examples thereof include the following 5 initiators.

(i) Alkyl or arylate complex: considered to generate active radicals by oxidative cleavage of carbon-hetero bond. Specifically, a borate compound is preferable.

(ii) N-arylalkylamine compound: considered to generate active radicals by oxidation-induced cleavage of C-X bond on carbon adjacent to nitrogen. X is preferably a hydrogen atom, a carboxyl group, a trimethylsilyl group, or a benzyl group. Specifically, examples thereof include N-phenylglycines (which may or may not have a substituent on a phenyl group) and N-phenyl iminodiacetic acids (which may or may not have a substituent on a phenyl group).

(iii) Sulfur-containing compound: compound obtained by substituting nitrogen atoms of the aforementioned amines with sulfur atoms and capable of generating active radicals by the same action as that of the amines. Specific examples thereof include phenylthioacetic acids (which may or may not have a substituent on a phenyl group).

(iv) Tin-containing compound: compound obtained by substituting nitrogen atoms of the aforementioned amines

with tin atoms and capable of generating active radicals by the same action as that of the amines.
(v) Sulfinates: capable of generating active radicals by oxidation. Specifically, examples thereof include sodium aryl sulfinate.

From the viewpoint of printing durability, the image-recording layer preferably contains a borate compound among the above.
From the viewpoint of printing durability and color developability, the borate compound is preferably a tetraaryl borate compound or a monoalkyl triaryl borate compound, and more preferably a tetraaryl borate compound.
A countercation that the borate compound has is not particularly limited, but is preferably an alkali metal ion or a tetraalkyl ammonium ion and more preferably a sodium ion, a potassium ion, or a tetrabutylammonium ion.
Specifically, as the borate compound, for example, sodium tetraphenyl borate is preferable.
Specifically, as the electron-donating polymerization initiator, for example, the following B-1 to B-9 are preferable. It goes without saying that the present disclosure is not limited thereto. In the following chemical formulas, Ph represents a phenyl group, and Bu represents a n-butyl group.

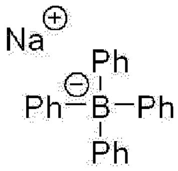
BD - 1

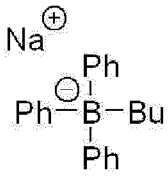
BD - 2

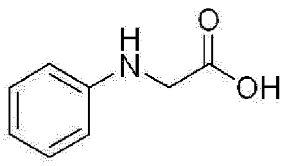
BD - 3

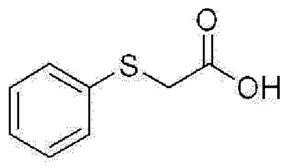
BD - 4

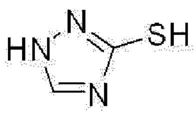
BD - 5

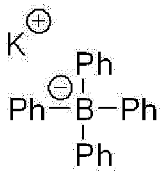
BD - 6

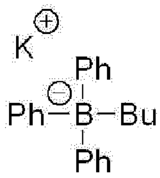
BD - 7

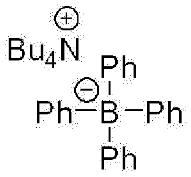
BD - 8

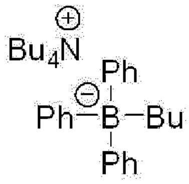
BD - 9

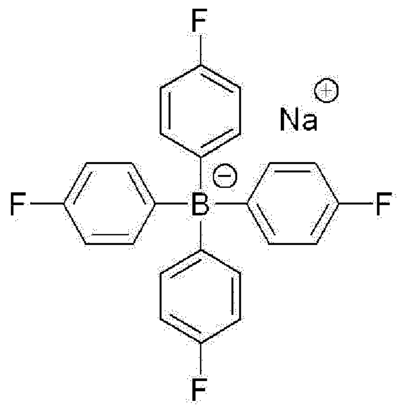
BD - 10

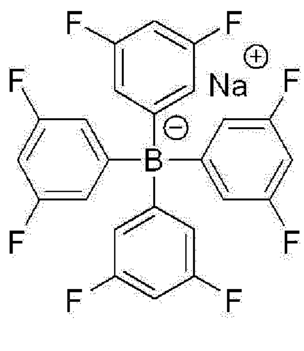
BD - 11

From the viewpoint of improving sensitivity and suppressing the occurrence of plate missing, the highest occupied molecular orbital (HOMO) of the electron-donating polymerization initiator in the present disclosure is preferably -6.00 eV or more, more preferably -5.95 eV or more, and even more preferably -5.93 eV or more.
The upper limit of HOMO is preferably -5.00 eV or less, and more preferably -5.40 eV or less.

-Content of electron-donating polymerization initiator-

The image-recording layer may contain only one kind of electron-donating polymerization initiator, or two or more kinds of electron-donating polymerization initiators may be used in combination.

From the viewpoint of sensitivity and printing durability, the content of the electron-donating polymerization initiator with respect to the total mass of the image-recording layer is preferably 0.01% by mass to 30% by mass, more preferably 0.05% by mass to 25% by mass, and even more preferably 0.1% by mass to 20% by mass.

In the present disclosure, in a case where the image-recording layer contains an onium ion and an anion of the aforementioned electron-donating polymerization initiator, the image-recording layer is regarded as containing an electron-accepting polymerization initiator and the electron-donating polymerization initiator.

One of the preferred aspects of the present disclosure is an aspect in which the aforementioned electron-accepting polymerization initiator and the aforementioned electron-donating polymerization initiator form a salt.

Specific examples thereof include an aspect in which the aforementioned onium compound is a salt formed of an onium ion and an anion of the electron-donating polymerization initiator (for example, a tetraphenyl borate anion). Furthermore, for example, an iodonium borate compound is more preferable which is a salt formed of an iodonium cation of the aforementioned iodonium salt compound (for example, a di-p-tolyl iodonium cation) and a borate anion of the aforementioned electron-donating polymerization initiator.

Specific examples of aspects in which the aforementioned electron-accepting polymerization initiator and the electron-donating polymerization initiator form a salt will be shown below. However, the present disclosure is not limited thereto.

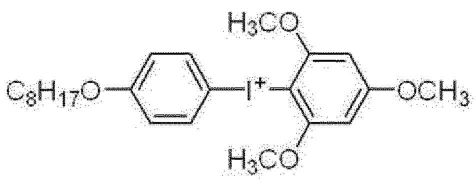

BF4-

(IA-1)

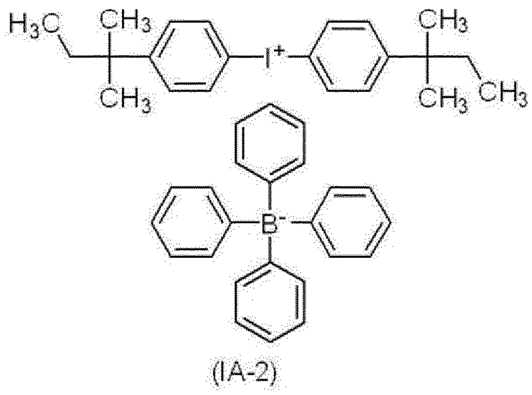

(IA-2)

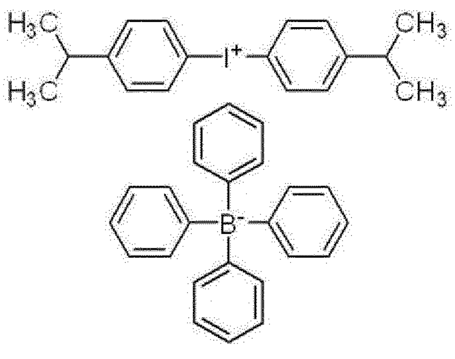

(IA-3)

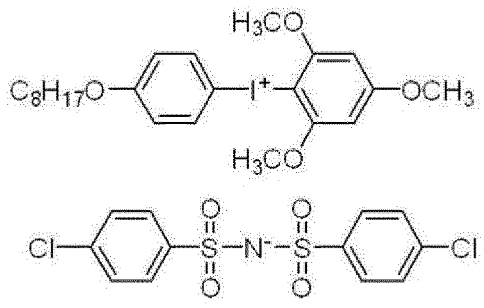

(IA-4)

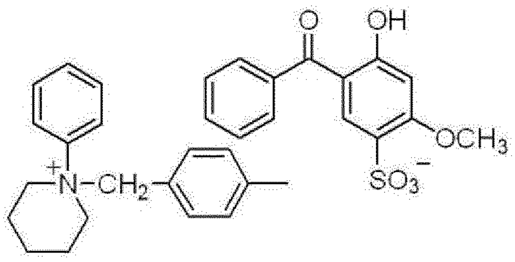

(IA-5)

In the present disclosure, in a case where the image-recording layer contains an onium ion and an anion of the aforementioned electron-donating polymerization initiator, the image-recording layer is regarded as containing an electron-accepting polymerization initiator and the electron-donating polymerization initiator.

-Relationship between electron-donating polymerization initiator and specific polymethine colorant-

From the viewpoint of improving sensitivity and suppressing UV plate missing, the image-recording layer in the present disclosure contains the electron-donating polymerization initiator and the specific polymethine colorant. HOMO of the specific polymethine colorant - HOMO of the electron-donating polymerization initiator is preferably 0.70 eV or less, and more preferably 0.70 eV to -0.10 eV.

The value of HOMO of the specific polymethine colorant - HOMO of the electron-donating polymerization initiator means a value obtained by subtracting the value of HOMO of the electron-donating polymerization initiator (eV) from the value of HOMO (eV) of the specific polymethine colorant.

The negative sign means that HOMO of the electron-donating polymerization initiator is higher than HOMO of the specific polymethine colorant.

-Preferred aspect of specific polymethine colorant and electron-accepting polymerization initiator-

From the viewpoint of improving sensitivity and suppressing the occurrence of plate missing, in a preferred aspect, the specific polymethine colorant in the present disclosure has an organic anion that satisfies $\delta d \geq 16$, $\delta p = 16$ to 32, and $\delta h \leq \delta p \times 0.6$ in the Hansen solubility parameters.

From the viewpoint of improving sensitivity and suppressing the occurrence of plate missing, in a preferred aspect, the electron-accepting polymerization initiator in the present disclosure has an organic anion that satisfies $\delta d \geq 16$, $\delta p = 16$ to 32, and $\delta h \leq \delta p \times 0.6$ in the Hansen solubility parameters.

In the present disclosure, as δd, δp, and δh in the Hansen solubility parameters, the dispersion element δd [unit: $MPa^{0.5}$] and the polarity element δp [unit: $MPa^{0.5}$] in the Hansen solubility parameters are used. The Hansen solubility parameters are obtained by dividing the solubility parameters introduced by Hildebrand into three components, a dispersion element δd, a polarity element δp, and a hydrogen bond element δh, and expressing the parameters in a three-dimensional space.

The Hansen solubility parameters are also specifically described in the document "Hansen Solubility Parameters; A Users Handbook (CRC Press, 2007)" written by Charles M. Hansen.

In the present disclosure, δd, δp, and δh of an organic anion in the Hansen solubility parameters are values estimated from the chemical structure by using the computer software "Hansen Solubility Parameters in Practice (HSPiP ver.4.1.07)".

Specifically, suitable examples of the organic anion that satisfies $\delta d \geq 16$, $\delta p = 16$ to 32, and $\delta h \leq \delta p \times 0.6$ in the Hansen solubility parameters include specific examples I-) to 1-26 of the sulfonamide anion or sulfonimide anion in the aforementioned electron-accepting polymerization initiator. It goes without saying that the organic anion is not limited thereto.

«Polymerizable compound»

The image-recording layer contains a polymerizable compound.

In the present disclosure, the polymerizable compound does not include a specific polymer (which may be in the form of particles) and a binder polymer that will be described later.

The polymerizable compound in the present disclosure may be, for example, a radically polymerizable compound or a cationically polymerizable compound. As the polymerizable compound, an addition polymerizable compound having at least one ethylenically unsaturated bond (ethylenically unsaturated compound) is preferable. The ethylenically

unsaturated compound is preferably a compound having at least one ethylenically unsaturated bond on a terminal, and more preferably a compound having two or more ethylenically unsaturated bonds on a terminal.

The chemical form of the polymerizable compound is, for example, a monomer, a prepolymer which is in other words a dimer, a trimer, or an oligomer, a mixture of these, or the like.

Examples of the monomer include unsaturated carboxylic acids (for example, acrylic acid, methacrylic acid, itaconic acid, crotonic acid, isocrotonic acid, maleic acid, and the like), and esters and amides thereof. Among these, esters of unsaturated carboxylic acids and polyhydric alcohol compounds and amides of unsaturated carboxylic acids and polyvalent amine compounds are preferable. In addition, products of an addition reaction between unsaturated carboxylic acid esters or amides having a nucleophilic substituent such as a hydroxyl group, an amino group, or a mercapto group and monofunctional or polyfunctional isocyanates or epoxies, products of a dehydrocondensation reaction between the aforementioned unsaturated carboxylic acid esters or amides and a monofunctional or polyfunctional carboxylic acid, and the like are also suitably used. Furthermore, products of an addition reaction between unsaturated carboxylic acid esters or amides having an electrophilic substituent such as an isocyanate groups or an epoxy group and monofunctional or polyfunctional alcohols, amines, or thiols, and products of a substitution reaction between unsaturated carboxylic acid esters or amides having a dissociable substituent such as a halogen atom or a tosyloxy group and monofunctional or polyfunctional alcohols, amines, or thiols are also suitable. Moreover, for example, it is also possible to use a group of compounds obtained by substituting the unsaturated carboxylic acid with an unsaturated phosphonic acid, styrene, a vinyl ether, or the like. These compounds are described in JP2006-508380A, JP2002-287344A, JP2008-256850A, JP2001-342222A, JP1997-179296A (JP-H09-179296A), JP1997-179297A (JP-H09-179297A), JP1997-179298A (JP-H09-179298A), JP2004-294935A, JP2006-243493A, JP2002-275129A, JP2003-64130A, JP2003-280187A, JP1998-333321A (JP-H10-333321A), and the like.

Specific examples of monomers of esters of polyhydric alcohol compounds and unsaturated carboxylic acids include acrylic acid esters such as ethylene glycol diacrylate, 1,3-butanediol diacrylate, tetramethylene glycol diacrylate, propylene glycol diacrylate, trimethylolpropane triacrylate, hexanediol diacrylate, tetraethylene glycol diacrylate, pentaerythritol tetraacrylate, sorbitol triacrylate, isocyanuric acid ethylene oxide (EO)-modified triacrylate, and polyester acrylate oligomers, and methacrylic acid esters such as tetramethylene glycol dimethacrylate, neopentyl glycol dimethacrylate, trimethylolpropane trimethacrylate, ethylene glycol dimethacrylate, pentaerythritol trimethacrylate, bis[p-(3-methacryloxy-2-hydroxypropoxy)phenyl] dimethyl methane, and bis[p-(methacryloxyethoxy)phenyl] dimethyl methane. In addition, specific examples of monomers of amides of polyvalent amine compounds and unsaturated carboxylic acids include methylene bisacrylamide, methylene bismethacrylamide, 1,6-hexamethylene bisacrylamide, 1,6-hexamethylene bismethacrylamide, diethylenetriamine trisacrylamide, xylylene bisacrylamide, xylylene bismethacrylamide, and the like.

In addition, urethane-based addition polymerizable compounds produced using an addition reaction between an isocyanate and a hydroxyl group are also suitable, and specific examples thereof include vinyl urethane compounds having two or more polymerizable vinyl groups in one molecule obtained by adding vinyl monomers having a hydroxyl group represented by Formula (M) to a polyisocyanate compound having two or more isocyanate groups in one molecule which is described in, for example, JP1973-041708B (JP-S48-041708B).

$$CH_2{=}C(R^{M4})COOCH_2CH(R^{M5})OH \qquad \text{Formula (M)}$$

In Formula (M), $R^{M4}$ and $R^{M5}$ each independently represent a hydrogen atom or a methyl group.

Furthermore, urethane acrylates described in JP1976-037193A (JP-S51-37193A), JP1990-32293B (JP-H02-32293B), JP1990-16765B (JP-H02-16765B), JP2003-344997A, and JP2006-65210A; urethane compounds having an ethylene oxide-based skeleton described in JP1983-49860B (JP-S58-49860B), JP1981-17654B (JP-S56-17654B), JP1987-39417B (JP-S62-39417B), JP1987-39418B (JP-S62-39418B), JP2000-250211A, and JP2007-94138A; and urethane compounds having a hydrophilic group described in US7153632B, JP1996-505958A (JP-H08-505958A), JP2007-293221A, and JP2007-293223A are also suitable.

(Specific compound A1)

In an aspect, from the viewpoint of accelerating the curing reaction of the image-recording layer by exposure and improving printing durability, the polymerizable compound may be a compound having an ethylenically unsaturated bond valence of 5.0 mmol/g or more (hereinafter, this compound will be also called specific compound A1). In the present disclosure, an ethylenically unsaturated group is also called "C=C group", and the ethylenically unsaturated bond valence is also called "C=C valence".

The ethylenically unsaturated bond valence of the specific compound A1 is preferably 5.5 mmol/g or more, and more preferably 6.0 mmol/g or more. The upper limit of the ethylenically unsaturated bond valence of the specific compound A1 is, for example, 10.0 mmol/g or less, and more preferably 8.5 mmol/g or less.

In the present disclosure, the ethylenically unsaturated bond valence of a compound having an ethylenically

unsaturated bond is determined by the following method. First, for a predetermined amount (for example, 0.2 g) of sample compound, the structure of the compound is specified using, for example, pyrolysis GC/MS, FT-IR, NMR, TOF-SIMS, and the like, and the total amount (mmol) of ethylenically unsaturated groups is determined. The determined total amount (mmol) of ethylenically unsaturated groups is divided by the amount (g) of the sample compound, thereby calculating the ethylenically unsaturated bond valence of the compound.

The specific compound A1 is preferably a compound represented by Formula (II), because such a compound satisfies the C=C valence described above.

Formula (II): X-(Y)n

In Formula (II), X represents an n-valent organic group having a hydrogen bonding group, Y represents a monovalent group having 2 or more ethylenically unsaturated groups, n represents an integer of 2 or more, and molecular weight of X/(molecular weight of Y $\times$ n) is 1 or less.

The hydrogen bonding group represented by X in Formula (II) is not particularly limited as long as it is a group capable of forming a hydrogen bond. The hydrogen bonding group may be a hydrogen bond donating group or a hydrogen bond accepting group. Examples of the hydrogen bonding group include a hydroxyl group, a carboxy group, an amino group, a carbonyl group, a sulfonyl group, a urethane group, a urea group, an imide group, an amide group, a sulfonamide group, and the like. Particularly, from the viewpoint of on-press developability and printing durability, the hydrogen bonding group preferably includes at least one kind of group selected from the group consisting of a urethane group, a urea group, an imide group, an amide group, and a sulfonamide group, more preferably includes at least one kind of group selected from the group consisting of a urethane group, a urea group, an imide group, and an amide group, even more preferably includes at least one kind of group selected from the group consisting of a urethane group, a urea group, and an imide group, and particularly preferably includes at least one kind of group selected from the group consisting of a urethane group and a urea group.

X in Formula (II) is preferably an organic group that does not have an ethylenically unsaturated bond.

Furthermore, from the viewpoint of on-press developability and printing durability, X in Formula (II) is preferably a group obtained by combining two or more kinds of structures selected from the group consisting of a mono- to n-valent aliphatic hydrocarbon group, a mono- to n-valent aromatic hydrocarbon group, a urethane bond, a urea bond, a biuret bond, and an allophanate bond, and more preferably a group obtained by combining two or more kinds of structures selected from the group consisting of a mono- to n-valent aliphatic hydrocarbon group, a mono- to n-valent aromatic hydrocarbon group, a urethane bond, a urea bond, and a biuret bond.

From the viewpoint of on-press developability and printing durability, X in Formula (II) is preferably a group obtained by removing a terminal isocyanate group from a substance prepared by multimerization of a polyfunctional isocyanate compound (including an adduct of a polyfunctional alcohol compound such as trimethylolpropane adduct), more preferably a group obtained by removing a terminal isocyanate group from a substance prepared by multimerization of a difunctional isocyanate compound (including an adduct of a polyfunctional alcohol compound), and particularly preferably a group obtained by removing a terminal isocyanate group from a substance prepared by multimerization of hexamethylene diisocyanate (including an adduct of a polyfunctional alcohol compound).

From the viewpoint of on-press developability and printing durability, the molecular weight of X in Formula (II) is preferably 100 to 1,000, more preferably 150 to 800, and particularly preferably 150 to 500.

The ethylenically unsaturated group represented by Y in Formula (II) is not particularly limited. From the viewpoint of reactivity, on-press developability, and printing durability, the ethylenically unsaturated group is preferably at least one kind of group selected from the group consisting of a vinyl phenyl group, a vinyl ester group, a vinyl ether group, an allyl group, a (meth)acryloxy group, and a (meth)acrylamide group. From the same viewpoint as above, the ethylenically unsaturated group represented by Y in Formula (II) is more preferably at least one kind of group selected from the group consisting of a vinyl phenyl group, a (meth)acryloxy group, and a (meth)acrylamide group, and even more preferably a (meth)acryloxy group. That is, from the viewpoint of on-press developability and printing durability, the ethylenically unsaturated group represented by Y in Formula (II) preferably includes a (meth)acryloxy group.

Y in Formula (II) is preferably a group having 3 or more (meth)acryloxy groups, more preferably a group having 5 or more (meth)acryloxy groups, and even more preferably a group having 5 or more and 12 or less (meth)acryloxy groups.

From the viewpoint of on-press developability and printing durability, Y in Formula (II) may have a structure represented by Formula (Y-1) or Formula (Y-2).

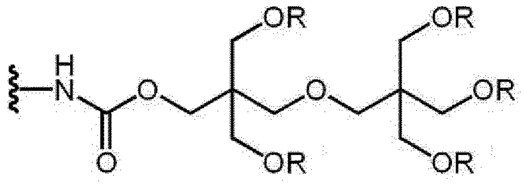

(Y-1)

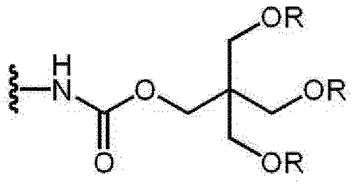

(Y-2)

In Formula (Y-1) and Formula (Y-2), R each independently represents an acryloyl group or a methacryloyl group, and the portion of the wavy line represents a binding position with other structures.

It is preferable that all Rs in Formula (Y-1) or Formula (Y-2) be the same group. Furthermore, it is preferable that all Rs in Formula (Y-1) or Formula (Y-2) be an acryloyl group.

It is preferable that all the n pieces of Y in Formula (II) be the same group.

From the viewpoint of on-press developability and printing durability, the molecular weight of Y in Formula (II) is preferably 200 or more and 1,000 or less, and more preferably 250 or more and 800 or less.

n in Formula (II) is an integer of 2 or more. From the viewpoint of on-press developability and printing durability, n is more preferably 2 or 3.

Molecular weight of X/(molecular weight of Y $\times$ n) is 1 or less. From the viewpoint of on-press developability and printing durability, the value of the expression is preferably 0.01 to 0.8, and more preferably 0.1 to 0.5.

As the structure of the specific compound A1, for example, a structure is preferable which is established by sealing a terminal isocyanate group of a multimerized substance (including an adduct) of a polyfunctional isocyanate compound with a compound having an ethylenically unsaturated group as described above. As the multimerized substance of the polyfunctional isocyanate compound, particularly, a multimerized substance of a difunctional isocyanate compound is preferable.

From the viewpoint of on-press developability and printing durability, the specific compound A1 is preferably a compound obtained by reacting a terminal isocyanate group of a multimerized substance prepared by multimerizing a polyfunctional isocyanate compound with a polyfunctional ethylenically unsaturated compound having a hydroxyl group (also called hydroxy group) on a terminal. Furthermore, from the same viewpoint as above, the specific compound A1 is more preferably a compound obtained by reacting a terminal isocyanate group of a multimerized substance prepared by multimerizing a difunctional isocyanate compound (including an adduct of a polyfunctional alcohol compound) with a polyfunctional ethylenically unsaturated compound having a hydroxyl group. Furthermore, from the same viewpoint as above, the specific compound A1 is particularly preferably a compound obtained by reacting a terminal isocyanate group of a multimerized substance prepared by multimerizing a hexamethylene diisocyanate (including an adduct of a polyfunctional alcohol compound) with a polyfunctional ethylenically unsaturated compound having a hydroxyl group.

As the polyfunctional isocyanate compound, known compounds can be used without particular limitation. This compound may be an aliphatic polyfunctional isocyanate compound or an aromatic polyfunctional isocyanate compound. As the polyfunctional isocyanate compound, specifically, for example, 1,3-bis(isocyanatomethyl) cyclohexane, isophorone diisocyanate, trimethylene diisocyanate, tetramethylene diisocyanate, pentamethylene diisocyanate, hexamethylene diisocyanate, 1,3-cyclopentane diisocyanate, 9H-fluorene-2,7-diisocyanate, 9H-fluoren-9-on-2,7-diisocyanate, 4,4'-diphenylmethane diisocyanate, 1,3-phenylene diisocyanate, tolylene-2,4-diisocyanate, tolylene-2,6-diisocyanate, 1,3-bis(isocyanatomethyl) cyclohexane, 2,2-bis(4-isocyanatophenyl) hexafluoropropane, 1,5-diisocyanatonaphthalene, a dimer or trimer (isocyanurate bond) of these polyisocyanates, and the like are preferable. Furthermore, a biuret compound obtained by reacting the above polyisocyanate compound with a known amine compound may also be used.

Furthermore, the polyfunctional ethylenically unsaturated compound having a hydroxyl group is preferably a hydroxyl group-containing ethylenically unsaturated compound having 3 or more functional groups, and more preferably a hydroxyl group-containing ethylenically unsaturated compound having 5 or more functional groups. The aforementioned hydroxyl group-containing polyfunctional ethylenically unsaturated compound is preferably a polyfunctional (meth)acrylate compound having a hydroxyl group.

From the viewpoint of on-press developability and printing durability, the specific compound A1 preferably has at least one kind of structure selected from the group consisting of an adduct structure, a biuret structure, and an isocyanurate structure. From the same viewpoint as above, the specific compound A1 more preferably has at least one kind of structure selected from the group consisting of a trimethylolpropane adduct structure, a biuret structure, and an isocyanurate structure, and particularly preferably has a trimethylolpropane adduct structure.

From the viewpoint of on-press developability and printing durability, the specific compound A1 preferably has a structure represented by any of Formula (A-1) to Formula (A-3), and more preferably has a structure represented by Formula (A-1).

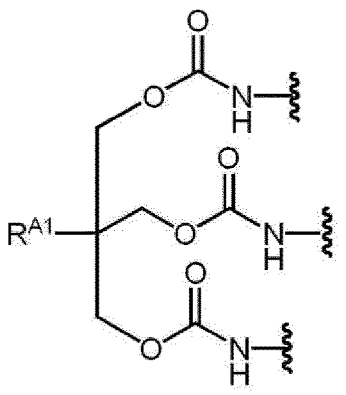

(A-1)

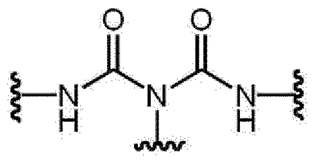

(A-2)

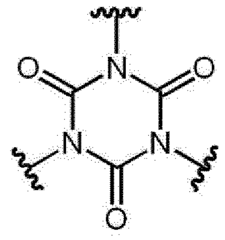

(A-3)

In Formula (A-1), $R^{A1}$ represents a hydrogen atom or an alkyl group having 1 to 8 carbon atoms, and the portion of the wavy line represents a binding position with other structures.

From the viewpoint of on-press developability and printing durability, $R^{A1}$ in Formula (A-1) is preferably a hydrogen atom or an alkyl group having 1 to 4 carbon atoms, more preferably an alkyl group having 1 to 3 carbon atoms, even more preferably a methyl group or an ethyl group, and particularly preferably an ethyl group.

From the viewpoint of on-press developability and printing durability, the specific compound A1 is preferably a (meth)acrylate compound having a urethane group, that is, a urethane (meth)acrylate oligomer.

As long as the specific compound A1 has an ethylenically unsaturated bond valence of 5.0 mmol/g or more, the specific compound A1 may be an oligomer having a polyester bond (hereinafter, also called polyester (meth)acrylate oligomer) or an oligomer having an epoxy residue (hereinafter, also called epoxy (meth)acrylate oligomer).

The epoxy residue in the epoxy (meth)acrylate oligomer is as described above.

The number of ethylenically unsaturated groups in the polyester (meth)acrylate oligomer as the specific compound A1 is preferably 3 or more, and more preferably 6 or more.

The epoxy (meth)acrylate oligomer as the specific compound A1 is preferably a compound containing a hydroxyl group. The number of ethylenically unsaturated groups in the epoxy (meth)acrylate oligomer is preferably 2 to 6, and more preferably 2 or 3. The epoxy (meth)acrylate oligomer can be obtained, for example, by reacting a compound having an epoxy group with an acrylic acid.

The molecular weight of the specific compound A1 (weight-average molecular weight in a case where the compound has molecular weight distribution) may be more than 1,000, and is preferably 1,100 to 10,000 and more preferably 1,100 to 5,000.

As the specific compound A1, a synthetic product or a commercially available product may be used.

Specific examples of the specific compound A1 include the following commercially available products. However, the specific compound A1 used in the present disclosure is not limited thereto. The number of functional groups (or the average number of functional groups) and C=C valence of the ethylenically unsaturated group are shown in each bracket.

Specific examples of the specific compound A1 include urethane (meth)acrylate oligomers such as U-10HA (number of functional groups: 10, C=C valence: 8 mmol/g) and U-15HA (number of functional groups: 15, C=C valence: 6 mmol/g) manufactured by SHIN-NAKAMURA CHEMICAL CO, LTD., UA-510H (number of functional groups: 10, C=C valence: 8 mmol/g) manufactured by KYOEISHA CHEMICAL Co., LTD., KRM8452 (number of functional groups: 10, C=C valence: 7 mmol/g) manufactured by DAICEL-ALLNEX LTD., and CN8885NS (number of functional groups: 9, C=C valence: 6 mmol/g) and CN9013NS (number of functional groups: 9, C=C valence: 6 mmol/g) manufactured by Sartomer Company Inc.

Specific examples of the specific compound A1 also include epoxy (meth)acrylate oligomers such as NK OLIGO EA-7420/PGMAc (number of functional groups: 10 to 15, C=C valence: 5 mmol/g) manufactured by SHIN-NAKAMURA CHEMICAL CO, LTD., and CN153 (C=C valence: 5 mmol/g) manufactured by Sartomer Company Inc.

Specific examples of the specific compound A1 also include polyester (meth)acrylate oligomers such as CN2267 (C=C valence: 5 mmol/g) manufactured by Sartomer Company Inc.

In a case where the polymerizable compound includes the specific compound A1, the content of the specific compound A1 with respect to the total mass of the polymerizable compound in the image-recording layer is preferably 10% by mass to 100% by mass, more preferably 50% by mass to 100% by mass, and even more preferably 80% by mass to 100% by mass.

(Specific compound A2)

In an aspect, the polymerizable compound may be a compound having one or two ethylenically unsaturated bonding groups (hereinafter, this compound will be also called specific compound A2).
Preferred aspects of the ethylenically unsaturated group contained in the specific compound A2 are the same as preferred aspects of the ethylenically unsaturated group in the specific compound A1.
Furthermore, from the viewpoint of inhibiting the deterioration of on-press developability, the specific compound A2 is preferably a compound having two ethylenically unsaturated bonding groups (that is, a difunctional polymerizable compound).
From the viewpoint of on-press developability and printing durability, the specific compound A2 is preferably a methacrylate compound, that is, a compound having a methacryloxy group.
From the viewpoint of on-press developability, the specific compound A2 preferably has an alkyleneoxy structure or a urethane bond.
The molecular weight of the specific compound A2 (weight-average molecular weight in a case where the compound has molecular weight distribution) is preferably 50 or more and less than 1,000, more preferably 200 to 900, and even more preferably 250 to 800.
Specific examples of the specific compound A2 will be shown below. However, the specific compound A2 used in the present disclosure is not limited thereto. In the following compound (2), for example, n + m = 10.

(1)

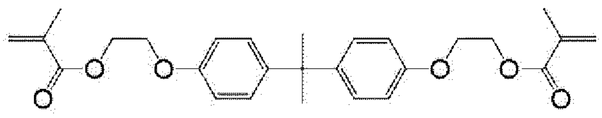

(2)

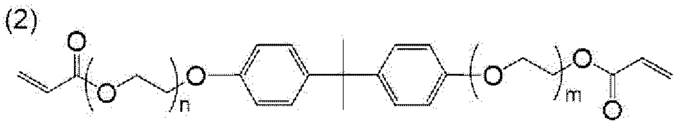

(3)

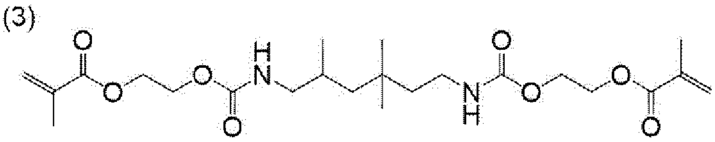

(4)

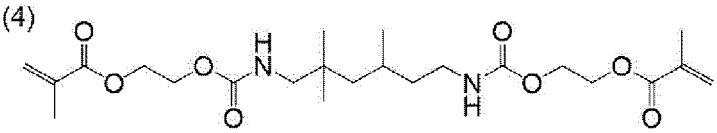

As the specific compound A2, the following commercially available products may be used. However, the specific compound A2 used in the present disclosure is not limited thereto.
Specific examples of the specific compound A2 include ethoxylated bisphenol A dimethacrylate such as BPE-80N (the above compound (1)), BPE-100, BPE-200, and BPE-500 manufactured by SHIN-NAKAMURA CHEMICAL CO, LTD., and CN104 (the above compound (1)) manufactured by Sartomer Company Inc.
Specific examples of the specific compound A2 include ethoxylated bisphenol A diacrylates such as A-BPE-10 (the above compound (2)) and A-BPE-4 manufactured by SHIN-NAKAMURA CHEMICAL CO, LTD.
Furthermore, specific examples of the specific compound A2 include difunctional methacrylate such as FST 510 manufactured by AZ Electronics.
"FST 510" described above is a product of a reaction between 1 mol of 2,2,4-trimethylhexamethylene diisocyanate and 2 mol of hydroxyethyl methacrylate, which is an 82% by mass methyl ethyl ketone solution of the compound (3).
In a case where the polymerizable compound includes the specific compound A2, the content of the specific compound A2 with respect to the total mass of the specific compound B in the image-recording layer is preferably 10% by mass to 100% by mass, more preferably 50% by mass to 100% by mass, and even more preferably 80% by mass to 100% by mass.
The details of how to use the polymerizable compound, such as the structure of the compound, whether the

compound is used alone or used in combination with other compounds, and the amount of the compound to be added, can be randomly set.

The content of the polymerizable compound with respect to the total mass of the image-recording layer is preferably 5% by mass to 75% by mass, more preferably 10% by mass to 70% by mass, and particularly preferably 15% by mass to 60% by mass.

«Polymer»

The polymer contained in the image-recording layer in the lithographic printing plate precursor according to the present disclosure has a constitutional unit formed of an aromatic vinyl compound and a constitutional unit formed of an acrylonitrile compound (hereinafter, this polymer will be also called specific polymer). From the viewpoint of UV printing durability and on-press developability, the specific polymer in the image-recording layer in the lithographic printing plate precursor according to the present disclosure preferably includes polymer particles. That is, the specific polymer is preferably in the form of particles.

[Constitutional unit formed of aromatic vinyl compound]

The specific polymer contained in the image-recording layer in the lithographic printing plate precursor according to the present disclosure has a constitutional unit formed of an aromatic vinyl compound.

The aromatic vinyl compound may be any compound having a structure in which a vinyl group is bonded to an aromatic ring. Examples of the aromatic vinyl compound include a styrene compound, a vinylnaphthalene compound, and the like. Among these, a styrene compound is preferable, and styrene is more preferable.

Examples of the styrene compound include styrene, p-methylstyrene, p-methoxystyrene, β-methylstyrene, p-methyl-β-methylstyrene, α-methyl styrene, p-methoxy-β-methylstyrene, and the like. Among these, for example, styrene is preferable.

Examples of the vinylnaphthalene compound include 1-vinylnaphthalene, methyl-1-vinylnaphthalene, β-methyl-1-vinylnaphthalene, 4-methyl-1-vinylnaphthalene, 4-methoxy-1-vinylnaphthalene, and the like. Among these, for example, 1-vinylnaphthalene is preferable.

As the constitutional unit formed of an aromatic vinyl compound, for example, a constitutional unit represented by Formula A1 is preferable.

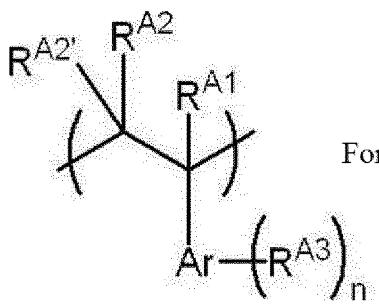

Formula A1

In Formula A1, $R^{A1}$, $R^{A2}$, and $R^{A2'}$ each independently represent a hydrogen atom or an alkyl group, Ar represents an aromatic ring group, $R^{A3}$ represents a substituent, and n represents an integer equal to or less than the maximum number of substituents of Ar.

In Formula A1, $R^{A1}$, $R^{A2}$, and $R^{A2'}$ preferably each independently represent a hydrogen atom or an alkyl group having 1 to 4 carbon atoms, more preferably each independently represent a hydrogen atom or a methyl group, and even more preferably both represent a hydrogen atom.

In Formula A1, Ar is preferably a benzene ring or a naphthalene ring, and more preferably a benzene ring.

In Formula A1, $R^{A3}$ is preferably an alkyl group or an alkoxy group, more preferably an alkyl group having 1 to 4 carbon atoms or an alkoxy group having 1 to 4 carbon atoms, and even more preferably a methyl group or a methoxy group.

In a case where there is a plurality of $R^{A3}$'s in Formula A1, the plurality of $R^{A3}$'s may be the same as or different from each other.

In Formula A1, n is preferably an integer of 0 to 2, more preferably 0 or 1, and even more preferably 0.

In the specific polymer, the content of the constitutional unit formed of an aromatic vinyl compound with respect to the total mass of the polymer is preferably 10% by mass to 90% by mass, more preferably 20% by mass to 80% by mass, even more preferably 35% by mass to 75% by mass, and particularly preferably 30% by mass to 60% by mass.

[Constitutional unit formed of acrylonitrile compound]

The specific polymer has a constitutional unit formed of an acrylonitrile compound.

Examples of the acrylonitrile compound include (meth)acrylonitrile and the like. Among these, for example, acrylonitrile is preferable.

Preferable examples of the constitutional unit formed of an acrylonitrile compound include a constitutional unit represented by Formula B1.

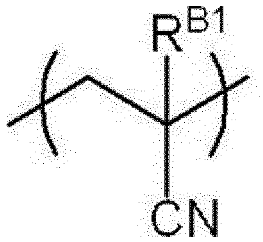

Formula B1

In Formula B1, $R^{B1}$ represents a hydrogen atom or an alkyl group.

In Formula B1, $R^{B1}$ is preferably a hydrogen atom or an alkyl group having 1 to 4 carbon atoms, more preferably a hydrogen atom or a methyl group, and even more preferably a hydrogen atom.

In the specific polymer, the content of the constitutional unit formed of an acrylonitrile compound with respect to the total mass of the polymer is preferably 10% by mass to 90% by mass, more preferably 20% by mass to 80% by mass, even more preferably 20% by mass to 70% by mass, and particularly preferably 30% by mass to 60% by mass.

-Constitutional unit formed of N-vinyl heterocyclic compound-

From the viewpoint of printing durability and chemical resistance, it is preferable that the specific polymer further have a constitutional unit formed of N-vinyl heterocyclic compound.

Examples of the N-vinyl heterocyclic compound include N-vinylpyrrolidone, N-vinylcarbazole, N-vinylpyrrole, N-vinylphenothiazine, N-vinylsuccinic acid imide, N-vinylphthalimide, N-vinylcaprolactam, and N-vinylimidazole. Among these, N-vinylpyrrolidone is preferable.

As the constitutional unit formed of a N-vinyl heterocyclic compound, for example, a constitutional unit represented by Formula C1 is preferable.

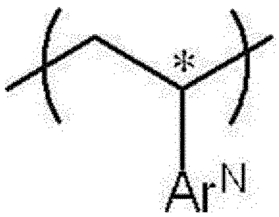

Formula C1

In Formula C1, $Ar^N$ represents a nitrogen atom-containing heterocyclic structure, and the nitrogen atom in $Ar^N$ is bonded to the carbon atom represented by *.

In Formula C1, the heterocyclic structure represented by $Ar^N$ is preferably a pyrrolidone ring, a carbazole ring, a pyrrole ring, a phenothiazine ring, a succinimide ring, a phthalimide ring, a caprolactam ring, or an imidazole ring, and more preferably a pyrrolidone ring.

Furthermore, the heterocyclic structure represented by $Ar^N$ may have a known substituent.

In the specific polymer, the content of the constitutional unit formed of a N-vinyl heterocyclic compound with respect to the total mass of the polymer is preferably 5% by mass to 40% by mass, and more preferably 10% by mass to 30% by mass.

-Ethylenically unsaturated group-containing constitutional unit-

The specific polymer may further have an ethylenically unsaturated group-containing constitutional unit.

The ethylenically unsaturated group is not particularly limited, and examples thereof include a vinyl group, an allyl group, a vinylphenyl group, a (meth)acrylamide group, a (meth)acryloyloxy group, and the like. From the viewpoint of reactivity, the ethylenically unsaturated group is preferably a (meth)acryloyloxy group.

The ethylenically unsaturated group-containing constitutional unit can be introduced into the polymer by a polymer reaction or copolymerization. Specifically, this constitutional unit can be introduced into the resin, for example, by a method of reacting a compound (such as glycidyl methacrylate) having an epoxy group or an ethylenically unsaturated group with a polymer into which a constitutional unit having a carboxy group such as methacrylic acid is introduced, a method of reacting a compound (such as 2-isocyanatoethyl methacrylate) having an isocyanate group and an ethylenically unsaturated group with a polymer into which a constitutional unit having an active hydrogen-containing group such as a hydroxyl group is introduced, and the like.

Furthermore, the ethylenically unsaturated group-containing constitutional unit may be introduced into the polymer by a method of reacting a compound having a carboxy group and an ethylenically unsaturated group with a polymer into which a constitutional unit having an epoxy group such as glycidyl (meth)acrylate is introduced.

In addition, the ethylenically unsaturated group-containing constitutional unit may be introduced into the polymer, for example, by using a monomer having a partial structure represented by Formula d1 or Formula d2. Specifically, for example, after polymerization is performed using at least the aforementioned monomer, an ethylenically unsaturated group is formed in the partial structure represented by Formula d1 or Formula d2 by a dissociation reaction using a base compound so that the ethylenically unsaturated group-containing constitutional unit is introduced into the polymer.

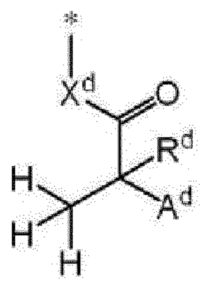

Formula d1

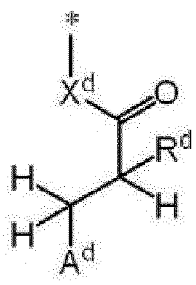

Formula d2

In Formula d1 and Formula d2, $R^d$ represents a hydrogen atom or an alkyl group, $A^d$ represents a halogen atom, $X^d$ represents -O- or $-NR^N-$, $R^N$ represents a hydrogen atom or an alkyl group, and * represents a binding site with other structures.

In Formula d1 and Formula d2, $R^d$ is preferably a hydrogen atom or a methyl group.

In Formula d1 and Formula d2, $A^d$ is preferably a chlorine atom, a bromine atom, or an iodine atom.

In Formula d1 and Formula d2, $X^d$ is preferably -O-. In a case where $X^d$ represents -NRN-, $R^N$ is preferably a hydrogen atom or an alkyl group having 1 to 4 carbon atoms, and more preferably a hydrogen atom.

Examples of the ethylenically unsaturated group-containing constitutional unit include a constitutional unit represented by Formula D1.

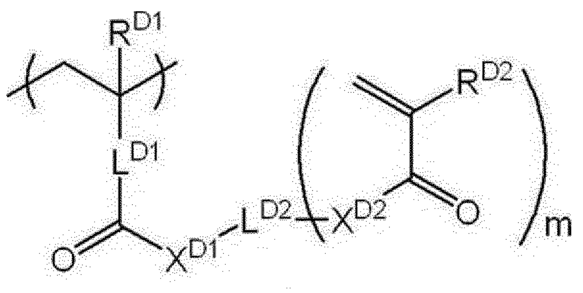

Formula D1

In Formula D1, $L^{D1}$ represents a single bond or a divalent linking group, $L^{D2}$ represents an (m + 1)-valent linking group, $X^{D1}$ and $X^{D2}$ each independently represent -O- or $-NR^N-$, $R^N$ represents a hydrogen atom or an alkyl group, $R^{D1}$ and $R^{D2}$ each independently represent a hydrogen atom or a methyl group, and m represents an integer of 1 or more.

In Formula D1, $L^{D1}$ is preferably a single bond. In a case where $L^{D1}$ represents a divalent linking group, an alkylene group, an arylene group, or a divalent group in which two or more of these are bonded is preferable, and an alkylene group having 2 to 10 carbon atoms or a phenylene group is more preferable.

In Formula D1, $L^{D2}$ is preferably a group represented by any of Formula D2 to Formula D6.

In Formula D1, $X^{D1}$ and $X^{D2}$ preferably both represent -O-. In a case where at least one of $X^{D1}$ or $X^{D2}$ represents

$-NR^N-$, $R^N$ is preferably a hydrogen atom or an alkyl group having 1 to 4 carbon atoms, and more preferably a hydrogen atom.

In Formula D1, $R^{D1}$ is preferably a methyl group.

In Formula D1, at least one of m pieces of $R^{D2}$ is preferably a methyl group.

In Formula D1, m is preferably an integer of 1 to 4, more preferably 1 or 2, and even more preferably 1.

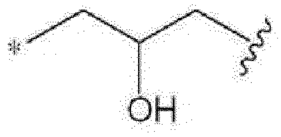

Formula D2

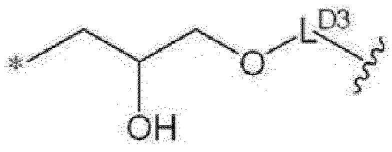

Formula D3

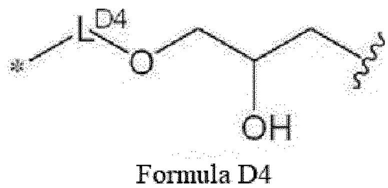

Formula D4

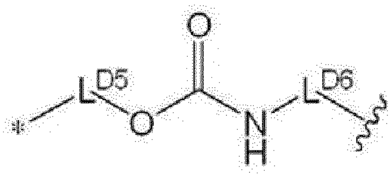

Formula D5

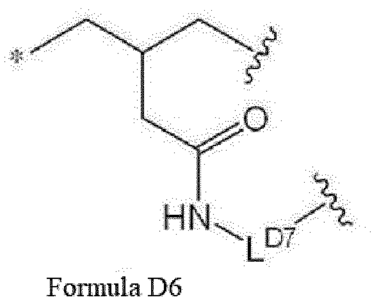

Formula D6

In Formula D2 to Formula D6, $L^{D3}$ to $L^{D7}$ each represent a divalent linking group, $L^{D5}$ and $L^{D6}$ may be different from each other, * represents the binding site with $X^{D1}$ in Formula D1, and the portion of the wavy line represents a binding site with $X^{D2}$ in Formula D1.

In Formula D3, $L^{D3}$ is preferably an alkylene group, an arylene group, or a group in which two or more of these are bonded, and more preferably an alkylene group having 1 to 10 carbon atoms, a phenylene group, or a group in which two or more of these are bonded.

In Formula D4, $L^{D4}$ is preferably an alkylene group, an arylene group, or a group in which two or more of these are bonded, and more preferably an alkylene group having 1 to 10 carbon atoms, a phenylene group, or a group in which two or more of these are bonded.

In Formula D5, $L^{D5}$ is preferably an alkylene group, an arylene group, or a group in which two or more of these are bonded, and more preferably an alkylene group having 1 to 10 carbon atoms, a phenylene group, or a group in which two or more of these are bonded.

In Formula D5, $L^{D6}$ is preferably an alkylene group, an arylene group, or a group in which two or more of these are bonded, and more preferably an alkylene group having 1 to 10 carbon atoms, a phenylene group, or a group in which two or more of these are bonded.

In Formula D6, $L^{D7}$ is preferably an alkylene group, an arylene group, or a group in which two or more of these are bonded, and more preferably an alkylene group having 1 to 10 carbon atoms, a phenylene group, or a group in which two or more of these are bonded.

Specific examples of the ethylenically unsaturated group-containing constitutional unit will be shown below. However, the ethylenically unsaturated group-containing constitutional unit contained in the specific polymer is not limited thereto. In the following specific examples, R each independently represents a hydrogen atom or a methyl group.

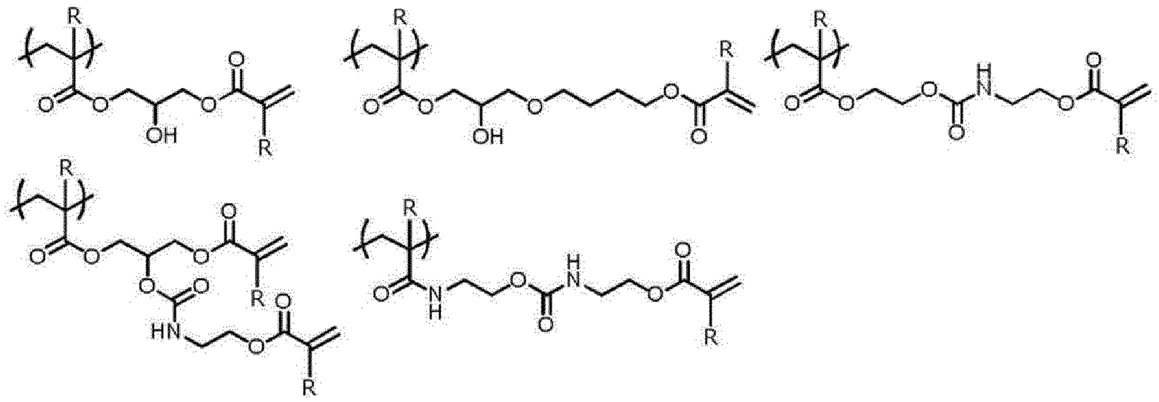

In the specific polymer, the content of the ethylenically unsaturated group-containing constitutional unit with respect to the total mass of the polymer is preferably 10% by mass to 70% by mass, and more preferably 20% by mass to 50% by mass.

-Acid group-containing constitutional unit-

The specific polymer may contain an acidic group-containing constitutional unit. From the viewpoint of on-press developability and ink receptivity, it is preferable that the specific polymer do not contain an acidic group-containing constitutional unit.

Specifically, in the specific polymer, the content of the acidic group-containing constitutional unit is preferably 40% by mass or less, more preferably 35% by mass or less, and even more preferably 30% by mass or less. The lower limit of the content of the acid group-containing constitutional unit is not particularly limited, and may be 0% by mass.

The acid value of the specific polymer is preferably 200 mg KOH/g or less, more preferably 180 mg KOH/g or less, and even more preferably 150 mg KOH/g or less. The lower limit of the acid value is not particularly limited, and may be 0 mg KOH/g.

In the present disclosure, the acid value is determined by the measurement method based on JIS K0070: 1992.

-Hydrophobic group-containing constitutional unit-

From the viewpoint of ink receptivity, the specific polymer may contain a hydrophobic group-containing constitutional unit.

Examples of the hydrophobic group include an alkyl group, an aryl group, an aralkyl group, and the like.

As the hydrophobic group-containing constitutional unit, a constitutional unit formed of an alkyl (meth)acrylate compound, an aryl (meth)acrylate compound, or an aralkyl (meth)acrylate compound is preferable, and a constitutional unit formed of an alkyl (meth)acrylate compound is more preferable.

The alkyl group in the alkyl (meth)acrylate compound preferably has 1 to 10 carbon atoms. The alkyl group may be linear or branched or may have a cyclic structure. Examples of the alkyl (meth)acrylate compound include methyl (meth)acrylate, ethyl (meth)acrylate, propyl (meth)acrylate, cyclohexyl (meth)acrylate, 2-ethylhexyl (meth)acrylate, dicyclopentanyl (meth)acrylate, and the like.

The aryl group in the aryl (meth)acrylate compound preferably has 6 to 20 carbon atoms. The aryl group is more preferably a phenyl group. The aryl group may further have a known substituent. Preferable examples of the aryl (meth)acrylate compound include phenyl (meth)acrylate.

The alkyl group in the aralkyl (meth)acrylate compound preferably has 1 to 10 carbon atoms. The alkyl group may be linear or branched or may have a cyclic structure. The aryl group in the aralkyl (meth)acrylate compound preferably has 6 to 20 carbon atoms. The aryl group is more preferably a phenyl group. Preferable examples of the aralkyl (meth)acrylate compound include benzyl (meth)acrylate.

In the specific polymer, the content of the hydrophobic group-containing constitutional unit with respect to the total mass of the polymer is preferably 5% by mass to 50% by mass, and more preferably 10% by mass to 30% by mass.

-Other constitutional units-

The specific polymer may further contain other constitutional units. The specific polymer can contain, as those other constitutional units, constitutional units other than the constitutional units described above without particular limitations. Examples thereof include constitutional units formed of an acrylamide compound, a vinyl ether compound, and

the like.

Examples of the acrylamide compound include (meth)acrylamide, N-methyl (meth)acrylamide, N-ethyl (meth)acrylamide, N-propyl (meth)acrylamide, N-butyl (meth)acrylamide, N,N'-dimethyl (meth)acrylamide, N,N'-diethyl (meth)acrylamide, N-hydroxyethyl (meth)acrylamide, N-hydroxypropyl (meth)acrylamide, N-hydroxybutyl (meth)acrylamide, and the like.

Examples of the vinyl ether compound include methyl vinyl ether, ethyl vinyl ether, propyl vinyl ether, n-butyl vinyl ether, tert-butyl vinyl ether, 2-ethylhexyl vinyl ether, n-nonyl vinyl ether, lauryl vinyl ether, cyclohexyl vinyl ether, cyclohexyl methyl vinyl ether, 4-methylcyclohexyl methyl vinyl ether, benzyl vinyl ether, dicyclopentenyl vinyl ether, 2-dicyclopentenoxyethyl vinyl ether, methoxyethyl vinyl ether, ethoxyethyl vinyl ether, butoxyethyl vinyl ether, methoxyethoxyethyl vinyl ether, ethoxyethoxyethyl vinyl ether, methoxypolyethylene glycol vinyl ether, tetrahydrofurfuryl vinyl ether, 2-hydroxyethyl vinyl ether, 2-hydroxypropyl vinyl ether, 4-hydroxybutyl vinyl ether, 4-hydroxymethylcyclohexylmethyl vinyl ether, diethylene glycol monovinyl ether, polyethylene glycol vinyl ether, chloroethyl vinyl ether, chlorobutyl vinyl ether, chloroethoxyethyl vinyl ether, phenylethyl vinyl ether, phenoxypolyethylene glycol vinyl ether, and the like.

In the specific polymer, the content of those other constitutional units with respect to the total mass of the specific polymer is preferably 5% by mass to 50% by mass, and more preferably 10% by mass to 30% by mass.

In a case where the specific polymer in the image-recording layer includes polymer particles, from the viewpoint of UV printing durability and on-press developability, the polymer particles preferably have a hydrophilic group.

The hydrophilic group is not particularly limited as long as it has a hydrophilic structure. Examples of the hydrophilic group include an acid group such as a carboxy group, a hydroxyl group, an amino group, a cyano group, a polyalkylene oxide structure, and the like.

Among hydrophilic groups, from the viewpoint of UV printing durability and on-press developability, a group having a polyalkylene oxide structure, a group having a polyester structure, or a sulfonic acid group is preferable, a group having a polyalkylene oxide structure or a sulfonic acid group is more preferable, and a group having a polyalkylene oxide structure is even more preferable.

Furthermore, the polymer contained in the polymer particles is preferably an addition polymerization-type resin. From the viewpoint of UV printing durability and on-press developability, the polymer contained in the polymer particles preferably has a constitutional unit formed of an aromatic vinyl compound and a constitutional unit having a cyano group. The polymer is more preferably an addition polymerization-type resin having a constitutional unit formed of an aromatic vinyl compound and a constitutional unit formed of an acrylonitrile compound.

The constitutional unit formed of an aromatic vinyl compound and the constitutional unit formed of an acrylonitrile compound have the same definition as the constitutional unit formed of an aromatic vinyl compound and the constitutional unit formed of an acrylonitrile compound described above, and preferred aspects thereof are also the same.

From the viewpoint of on-press developability, the polyalkylene oxide structure is preferably a polyethylene oxide structure, a polypropylene oxide structure, or a poly(ethylene oxide/propylene oxide) structure.

Furthermore, from the viewpoint of on-press developability and suppressing development residues during on-press development, the polymer particles preferably have, as a polyalkylene oxide structure, a polypropylene oxide structure, and more preferably have a polyethylene oxide structure and a polypropylene oxide structure, among hydrophilic groups.

From the viewpoint of on-press developability, the number of alkylene oxide structures in the polyalkylene oxide structure is preferably 2 or more, more preferably 5 or more, even more preferably 5 to 200, and particularly preferably 8 to 150.

Furthermore, from the viewpoint of on-press developability, the polymer particles preferably contain, as a hydrophilic group, a group represented by Formula Z, and more preferably contain a polymer having a group represented by Formula Z. The polymer particles are even more preferably an addition polymerization-type resin having a constitutional unit having a group represented by Formula Z.

-Q-W-Y Formula Z

In Formula Z, Q represents a divalent linking group, W represents a divalent group having a hydrophilic structure or a divalent group having a hydrophobic structure, Y represents a monovalent group having a hydrophilic structure or a monovalent group having a hydrophobic structure, and either W or Y has a hydrophilic structure.

Q is preferably a divalent linking group having 1 to 20 carbon atoms, and more preferably a divalent linking group having 1 to 10 carbon atoms.

Furthermore, Q is preferably an alkylene group, an arylene group, an ester bond, an amide bond, or a group formed by combining two or more of these, and more preferably a phenylene group, an ester bond, or an amide bond.

The divalent group having a hydrophilic structure represented by W is preferably a polyalkyleneoxy group or a group in which $-CH_2CH_2NR^W-$ is bonded to one terminal of a polyalkyleneoxy group. $R^W$ represents a hydrogen atom or an alkyl group.

The divalent group having a hydrophobic structure represented by W is preferably $-R^{WA}-$, $-O-R^{WA}-O-$, $-R^{W}N-R^{WA}-NR^{W}-$, $-OOC-R^{WA}-O-$, or $-OOC-R^{WA}-O-$. $R^{WA}$ each independently represents a linear, branched, or cyclic alkylene group having 6 to 120 carbon atoms, a haloalkylene group having 6 to 120 carbon atoms, an arylene group having 6 to 120 carbon atoms, an alkarylene group having 6 to 120 carbon atoms (divalent group formed by removing one hydrogen atom from an alkylaryl group), or an aralkylene group having 6 to 120 carbon atoms.

The monovalent group having a hydrophilic structure represented by Y in Formula Z is preferably OH, COOH, a polyalkyleneoxy group having a hydrogen atom or an alkyl group on a terminal, or a group in which $-CH_2CH_2N(R^W)-$ is bonded to one terminal of a polyalkyleneoxy group having a hydrogen atom or an alkyl group on the other terminal.

The monovalent group having a hydrophobic structure represented by Y in Formula Z is preferably a linear, branched, or cyclic alkyl group having 6 to 120 carbon atoms, a haloalkyl group having 6 to 120 carbon atoms, an aryl group having 6 to 120 carbon atoms, an alkaryl group (alkyl aryl group) having 6 to 120 carbon atoms, an aralkyl group having 6 to 120 carbon atoms, $OR^{WB}$, $COOR^{WB}$, or $OOCR^{WB}$. $R^{WB}$ represents an alkyl group having 6 to 20 carbon atoms.

From the viewpoint of UV printing durability and on-press developability, in the polymer particles having a group represented by formula Z, W is more preferably a divalent group having a hydrophilic structure, Q is more preferably a phenylene group, an ester bond, or an amide bond, W is more preferably a polyalkyleneoxy group, and Y is more preferably a polyalkyleneoxy group having a hydrogen atom or an alkyl group on a terminal.

From the viewpoint of UV printing durability and on-press developability, the polymer particles are preferably a polymer having a constitutional unit represented by Formula (D).

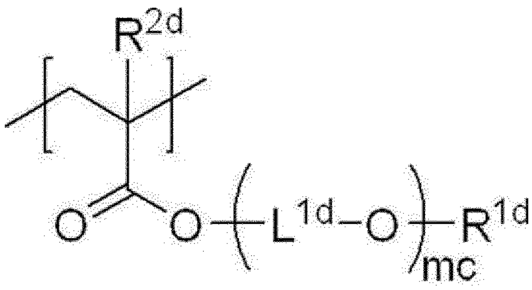

( D )

In Formula D, $L^{1d}$ represents an ethylene group or a propylene group, $R^{1d}$ represents a hydrogen atom, an alkyl group, or an aryl group, $R^{2d}$ represents a hydrogen atom or a methyl group, and mc represents an integer of 2 to 200.

$L^{1d}$ is preferably an ethylene group or a 1,2-propylene group.

$R^{1d}$ is preferably a hydrogen atom, an alkyl group having 1 to 4 carbon atoms, or a phenyl group, more preferably a hydrogen atom or an alkyl group having 1 to 4 carbon atoms, and even more preferably a hydrogen atom or a methyl group.

mc is preferably an integer of 2 to 200, more preferably an integer of 2 to 100, and even more preferably an integer of 2 to 50.

Specifically, preferable examples of the aforementioned hydrophilic group include the following hydrophilic group-containing constitutional units. However, it goes without saying that the hydrophilic group is not limited thereto.

nc represents an integer of 2 or more, and is preferably an integer of 2 to 200.

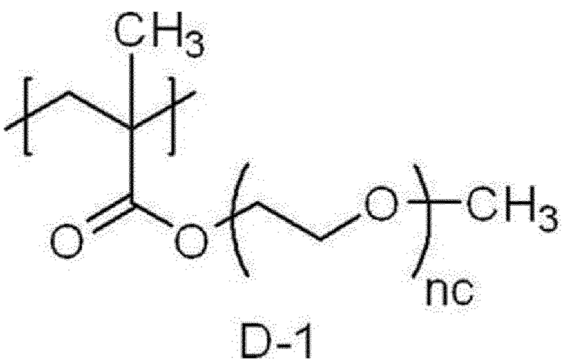

D-1

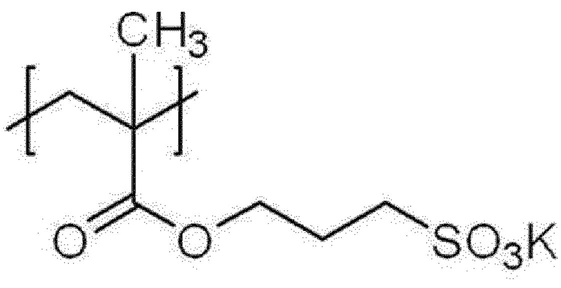

D-2

From the viewpoint of on-press developability, the content of the hydrophilic group-containing constitutional unit with respect to the total mass of the polymer contained in the polymer particles is preferably 1% by mass or more and less than 20% by mass, more preferably 1% by mass to 18% by mass, and particularly preferably 2% by mass to 15% by mass.

One kind of hydrophilic group-containing constitutional unit may be used alone, or two or more kinds of hydrophilic group-containing constitutional units may be used.

The weight-average molecular weight (Mw) of the polymer contained in the polymer particles is not particularly limited, but is preferably 2,000 or more, more preferably 5,000 or more, and even more preferably 10,000 to 2,000,000.

From the viewpoint of UV printing durability, the content of the polymer contained in the polymer particles with respect to the total mass of the polymer particles is preferably 50% by mass or more, more preferably 60% by mass or more, and particularly preferably 70% by mass to 100% by mass. The polymer particles may contain only one kind of polymer or two or more kinds of polymers.

The polymer particles may include particles selected from the group consisting of thermoplastic polymer particles, thermally reactive polymer particles, polymer particles having a polymerizable group, microcapsules encapsulating a hydrophobic compound, and microgel (crosslinked polymer particles). Among these, from the viewpoint of UV printing durability, polymer particles having a polymerizable group or microgel is preferable. In a particularly preferable embodiment, the polymer particles have at least one ethylenically unsaturated polymerizable group. The presence of such polymer particles brings about effects of improving the printing durability of an exposed portion and improving the on-press developability of a non-exposed portion.

Furthermore, the polymer particles are preferably thermoplastic polymer particles.

As the thermoplastic polymer particles, the thermoplastic polymer particles described in Research Disclosure No. 33303 published in January 1992, JP1997-123387A (JP-H09-123387A), JP1997-131850A (JP-H09-131850A), JP1997-171249A (JP-H09-171249A), JP1997-171250A (JP-H09-171250A), EP931647B, and the like are preferable.

Specific examples of polymers constituting the thermoplastic polymer particles include homopolymers or copolymers of monomers of ethylene, styrene, vinyl chloride, methyl acrylate, ethyl acrylate, methyl methacrylate, ethyl methacrylate, vinylidene chloride, acrylonitrile, vinylcarbazole, acrylates or methacrylates having polyalkylene structures, and the like and mixtures of these. For example, copolymers having polystyrene, styrene, and acrylonitrile or polymethyl methacrylate are preferable. The average particle diameter of the thermoplastic polymer particle is preferably 0.01 μm to 3.0 μm.

Examples of the thermally reactive polymer particles include polymer particles having a thermally reactive group. The thermally reactive polymer particles form a hydrophobilized region through crosslinking by a thermal reaction and the accompanying change in functional groups.

The thermally reactive group in the polymer particles having a thermally reactive group may be a functional group that causes any reaction as long as chemical bonds are formed. The thermally reactive group is preferably a polymerizable group. As the polymerizable group, for example, an ethylenically unsaturated group that causes a radical polymerization reaction (for example, an acryloyl group, a methacryloyl group, a vinyl group, an allyl group, and the like), a cationically polymerizable group (for example, a vinyl group, a vinyloxy group, an epoxy group, an oxetanyl group, and the like), an isocyanate group or a blocked isocyanate group that causes an addition reaction, an epoxy group, a vinyloxy group, an active hydrogen atom-containing functional group that is a reaction partner thereof (for example, an amino group, a hydroxyl group, a carboxy group, and the like), a carboxy group that causes a condensation reaction, a hydroxyl group or an amino group that is a reaction partner of the carboxy group, an acid anhydride that causes a ring-opening addition reaction, an amino group or a hydroxyl group which is a reaction partner of the acid anhydride, and the like are preferable.

Examples of the microcapsules include microcapsules encapsulating at least some of the constituent components of the image-recording layer as described in JP2001-277740A and JP2001-277742A. The constituent components of the image-recording layer can also be incorporated into the exterior of the microcapsules. In a preferred aspect, the image-recording layer containing microcapsules is constituted so that hydrophobic constituent components are encapsulated in the microcapsules and hydrophilic constituent components are incorporated into the exterior of the microcapsules.

The microgel (crosslinked polymer particles) can contain some of the constituent components of the image-recording layer, in at least one of the surface or the interior of the microgel. From the viewpoint of sensitivity of the lithographic printing plate precursor to be obtained and printing durability of the lithographic printing plate to be obtained, reactive microgel having a radically polymerizable group on the surface thereof is particularly preferable.

In order to encapsulate the constituent components of the image-recording layer in microcapsules or microgel, known methods can be used.

As the polymer particles, from the viewpoint of printing durability, antifouling properties, and storage stability of the lithographic printing plate to be obtained, polymer particles are preferable which are obtained by a reaction between a polyvalent isocyanate compound that is an adduct of a polyhydric phenol compound having two or more hydroxyl

groups in a molecule and isophorone diisocyanate and a compound having active hydrogen.

As the polyhydric phenol compound, a compound having a plurality of benzene rings having a phenolic hydroxyl group is preferable.

As the compound having active hydrogen, a polyol compound or a polyamine compound is preferable, a polyol compound is more preferable, and at least one kind of compound selected from the group consisting of propylene glycol, glycerin, and trimethylol propane is even more preferable.

As resin particles obtained by the reaction between a polyvalent isocyanate compound that is an adduct of a polyhydric phenol compound having two or more hydroxyl groups in a molecule and isophorone diisocyanate and a compound having active hydrogen, for example, the polymer particles described in paragraphs "0032" to "0095" of JP2012-206495A are preferable.

Furthermore, from the viewpoint of printing durability and solvent resistance of the lithographic printing plate to be obtained, the polymer particles preferably have a hydrophobic main chain and include both i) constitutional unit having a pendant cyano group directly bonded to the hydrophobic main chain and ii) constitutional unit having a pendant group including a hydrophilic polyalkylene oxide segment.

As the hydrophobic main chain, for example, an acrylic resin chain is preferable.

As the pendant cyano group, for example, $-[CH_2CH(C{\equiv}N)-]$ or $-[CHC(CH_3)(C{\equiv}N)-]$ is preferable.

In addition, the constitutional unit having the pendant cyano group can be easily derived from an ethylenically unsaturated monomer, for example, acrylonitrile, or methacrylonitrile, or a combination of these.

Furthermore, as an alkylene oxide in the hydrophilic polyalkylene oxide segment, ethylene oxide or a propylene oxide is preferable, and ethylene oxide is more preferable.

The number of repeating alkylene oxide structures in the hydrophilic polyalkylene oxide segment is preferably 10 to 100, more preferably 25 to 75, and even more preferably 40 to 50.

As the resin particles having a hydrophobic main chain and including both i) constitutional unit having the pendant cyano group directly bonded to the hydrophobic main chain and ii) constitutional unit having a pendant group including the hydrophilic polyalkylene oxide segment, for example, the particles described in paragraphs "0039" to "0068" of JP2008-503365A are preferable.

From the viewpoint of printing durability, the specific polymer preferably includes polymer particles having a polymerizable group, and more preferably includes polymer particles having a polymerizable group on the particle surface.

The polymerizable group may be a cationically polymerizable group or a radically polymerizable group. From the viewpoint of reactivity, the polymerizable group is preferably a radically polymerizable group.

The polymerizable group is not particularly limited as long as it is a polymerizable group. From the viewpoint of reactivity, an ethylenically unsaturated group is preferable, a vinylphenyl group (styryl group), a (meth)acryloxy group, or a (meth)acrylamide group is more preferable, and a (meth)acryloxy group is particularly preferable.

In addition, the polymer in the polymer particles having a polymerizable group preferably has a constitutional unit having a polymerizable group.

The polymerizable group may be introduced into the surface of the polymer particles by a polymer reaction.

The average particle diameter of the polymer particles is preferably 0.01 μm to 3.0 μm, more preferably 0.03 μm to 2.0 μm, and even more preferably 0.10 μm to 1.0 μm. In a case where the average particle diameter of the polymer particles is in this range, excellent resolution and excellent temporal stability are obtained. The average particle diameter of the polymer particles is the average primary particle diameter.

In the present disclosure, the average primary particle diameter of the polymer particles is measured using a light scattering method or by capturing an electron micrograph of the polymer particles, measuring the particle diameter of a total of 5,000 polymer particles in the photograph, and calculating the average thereof. For non-spherical particles, the value of particle diameter of spherical particles having the same area as the area of the particles on the photograph is adopted as the particle diameter.

Note that unless otherwise specified, the average particle diameter in the present disclosure means a volume average particle diameter.

-Content-

The image-recording layer may contain only one kind of specific polymer or two or more kinds of specific polymers.

The image-recording layer may contain, as the specific polymer, only one kind of polymer particles or two or more kinds of polymer particles.

From the viewpoint of on-press developability and UV printing durability, the content of the specific polymer in the image-recording layer with respect to the total mass of the image-recording layer is preferably 5% by mass to 90% by mass, more preferably 10% by mass to 90% by mass, even more preferably 20% by mass to 90% by mass, and particularly preferably 50% by mass to 90% by mass.

Furthermore, from the viewpoint of on-press developability and UV printing durability, the content of the polymer particles in the image-recording layer with respect to the total mass of components having a molecular weight of 3,000 or more in the image-recording layer is preferably 20% by mass to 100% by mass, more preferably 35% by mass to 100% by mass, even more preferably 50% by mass to 100% by mass, and particularly preferably 80% by mass to 100% by mass.

-Method for manufacturing specific polymer-

The method for manufacturing the specific polymer contained in the image-recording layer is not particularly limited. The specific polymer can be manufactured by known methods.

For example, the specific polymer is obtained by polymerizing a styrene compound, an acrylonitrile compound, and at least one kind of optional compound selected from the group consisting of the aforementioned N-vinyl heterocyclic compound, a compound used for forming the aforementioned ethylenically unsaturated group-containing constitutional unit, a compound used for forming the aforementioned acidic group-containing constitutional unit, a compound used for forming the aforementioned hydrophobic group-containing constitutional unit, and a compound used for forming the aforementioned other constitutional units by known methods.

The weight-average molecular weight of the specific polymer is preferably 3,000 to 300,000, and more preferably 5,000 to 100,000.

-Specific examples-

Specific examples of the specific polymer will be shown below, but the specific polymer used in the lithographic printing plate precursor according to the present disclosure is not limited thereto.

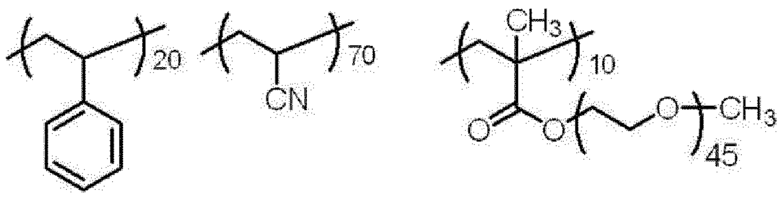

R-1

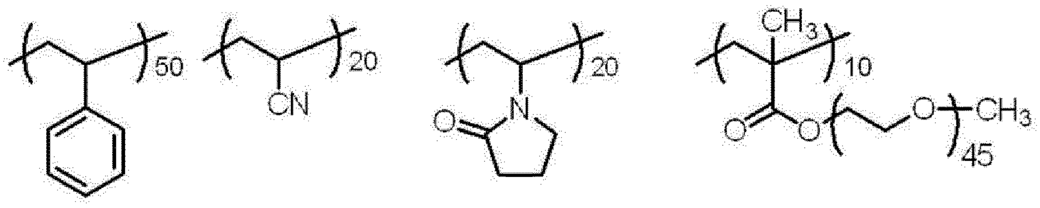

R-2

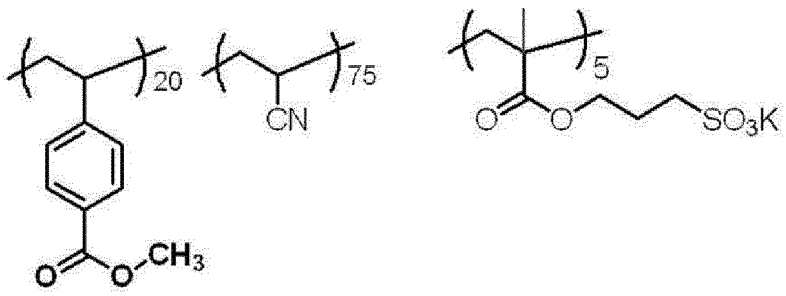

R-3

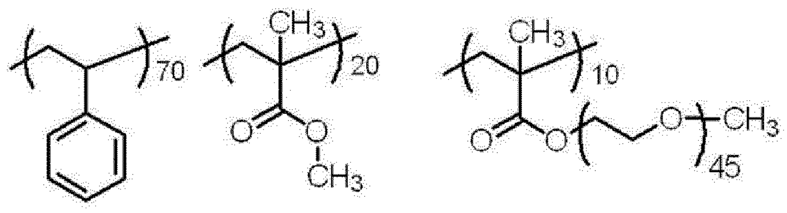

R-4

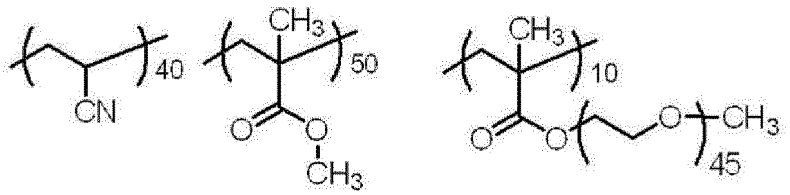

R-5

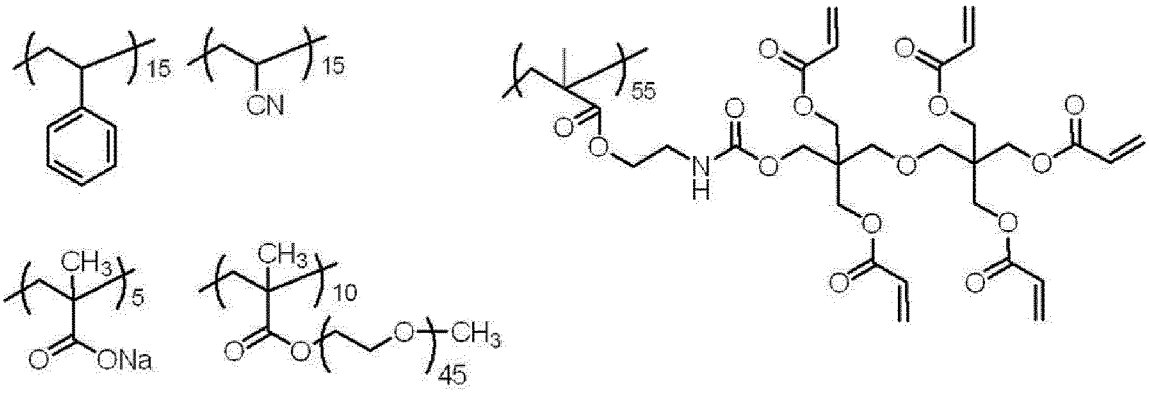

R-6

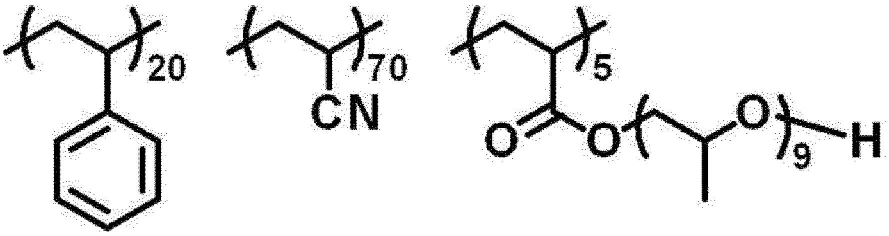

R-7

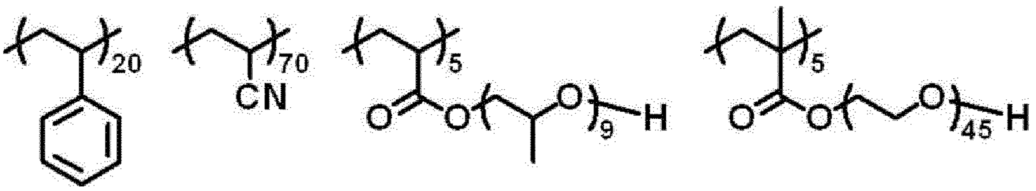

R-8

«Binder polymer»

The image-recording layer may contain a binder polymer. In an aspect, from the viewpoint of on-press developability and UV printing durability, it is also preferable that the image-recording layer do not contain a binder polymer.

The binder polymer is not included in the specific polymer described above.

The binder polymer is a polymer that is not in the form of particles. That is, the binder polymer does not correspond to the polymer particles described above.

The binder polymer is preferably a (meth)acrylic resin, a polyvinyl acetal resin, or a polyurethane resin.

Among these, as the binder polymer, known binder polymers that can be used in an image-recording layer in lithographic printing plate precursors can be suitably used. As an example, a binder polymer that is used for an on-press development-type lithographic printing plate precursor (hereinafter, also called binder polymer for on-press development) will be specifically described.

As the binder polymer for on-press development, a binder polymer having an alkylene oxide chain is preferable. The binder polymer having an alkylene oxide chain may have a poly(alkylene oxide) moiety in a main chain or side chain. In addition, the binder polymer may be a graft polymer having poly(alkylene oxide) in a side chain or a block copolymer of a block constituted with a poly(alkylene oxide)-containing repeating unit and a block constituted with an (alkylene oxide)-free repeating unit.

As a binder polymer having a poly(alkylene oxide) moiety in the main chain, a polyurethane resin is preferable. In a case where the binder polymer has a poly(alkylene oxide) moiety in the side chain, examples of polymers as the main chain include a (meth)acrylic resin, a polyvinyl acetal resin, a polyurethane resin, a polyurea resin, a polyimide resin, a polyamide resin, an epoxy resin, a polystyrene resin, a novolac-type phenol resin, a polyester resin, synthetic rubber, and natural rubber. Among these, a (meth)acrylic resin is particularly preferable.

In addition, as the binder polymer, for example, a polymer compound is also preferable which has a polyfunctional thiol having 6 or more and 10 or less functional groups as a nucleus and a polymer chain that is bonded to the nucleus by a sulfide bond and has a polymerizable group (hereinafter, this compound will be also called star-shaped polymer compound). As the star-shaped polymer compound, for example, the compounds described in JP2012-148555A can be preferably used.

Examples of the star-shaped polymer compound include the compound described in JP2008-195018A that has a polymerizable group such as an ethylenically unsaturated bond for improving the film hardness of an image area in a main chain or side chain and preferably in a side chain. The polymerizable group forms a crosslink between polymer molecules, which facilitates curing.

As the polymerizable group, an ethylenically unsaturated group such as a (meth)acryloyl group, a vinyl group, an allyl group, or a styryl group, an epoxy group, or the like is preferable, a (meth)acryloyl group, a vinyl group, or a styryl group is more preferable from the viewpoint of polymerization reactivity, and a (meth)acryloyl group is particularly preferable. These groups can be introduced into the polymer by a polymer reaction or copolymerization. For example, it is possible to use a reaction between a polymer having a carboxy group in a side chain and glycidyl methacrylate or a reaction between a polymer having an epoxy group and an ethylenically unsaturated group-containing carboxylic acid such as methacrylic acid. These groups may be used in combination.

In an aspect, from the viewpoint of inhibiting on-press developability from deteriorating over time, the glass transition temperature (Tg) of the binder polymers is preferably 50°C or higher, more preferably 70°C or higher, even more preferably 80°C or higher, and particularly preferably 90°C or higher.

Furthermore, from the viewpoint of ease of permeation of water into the image-recording layer, the upper limit of the glass transition temperature of the binder polymer is preferably 200°C, and more preferably 120°C or lower.

From the viewpoint of further inhibiting on-press developability from deteriorating over time, as the binder polymer having the above glass transition temperature, a polyvinyl acetal resin is preferable.

The polyvinyl acetal resin is a resin obtained by acetalizing hydroxyl groups of polyvinyl alcohol with an aldehyde.

Particularly, polyvinyl butyral is preferable which is obtained by acetalizing (that is, butyralizing) hydroxyl groups of polyvinyl alcohol with butyraldehyde.

As the polyvinyl acetal resin, a compound having a constitutional unit represented by the following (a) is preferable which is obtained by acetalizing hydroxyl groups of polyvinyl alcohol with an aldehyde.

(a)

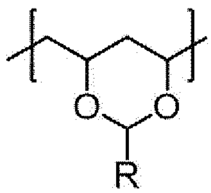

R represents a residue of aldehyde used for acetalization.

Examples of R include a hydrogen atom, an alkyl group, and an ethylenically unsaturated group which will be described later.

The content of the constitutional unit represented by (a) (also described as the amount of ethylene groups in the main chain contained in the constitutional unit represented by (a), which is also called degree of acetalization) with respect to the total content of constitutional units of the polyvinyl acetal resin (total amount of ethylene groups in the main chain) is preferably 50 mol% to 90 mol%, more preferably 55 mol% to 85 mol%, and even more preferably 55 mol% to 80 mol%.

The degree of acetalization is a value obtained by dividing the amount of ethylene groups to which acetal groups are bonded (amount of ethylene groups in the main chain contained in the constitutional unit represented by (a)) by the total amount of ethylene groups in the main chain and expressing the thus obtained molar fraction as a percentage.

The same shall be applied to the content of each constitutional unit of the polyvinyl acetal resin which will be described later.

From the viewpoint of improving printing durability, the polyvinyl acetal preferably has an ethylenically unsaturated group.

From the viewpoint of improving printing durability, the polyvinyl acetal resin preferably has an ethylenically unsaturated group.

The ethylenically unsaturated group that the polyvinyl acetal resin has is not particularly limited. From the viewpoint of reactivity, on-press developability, and printing durability, the ethylenically unsaturated group is preferably at least one kind of group selected from the group consisting of a vinyl phenyl group (styryl group), a vinyl ester group, a vinyl ether group, an allyl group, a (meth)acryloxy group, and a (meth)acrylamide group. Among these, a vinyl group, an allyl group, a (meth)acryloxy group, and the like are more preferable.

From the viewpoint of improving printing durability, the polyvinyl acetal preferably has an ethylenically unsaturated group-containing constitutional unit.

The ethylenically unsaturated group-containing constitutional unit may be the aforementioned constitutional unit having an acetal ring or a constitutional unit other than the constitutional unit having an acetal ring.

Particularly, from the viewpoint of increasing crosslink density during exposure, the polyvinyl acetal resin is preferably a compound in which an ethylenically unsaturated group is introduced into an acetal ring. That is, it is preferable that the constitutional unit represented by (a) have an ethylenically unsaturated group as R.

In a case where the ethylenically unsaturated group-containing constitutional unit is a constitutional unit other than the constitutional unit having an acetal ring, for example, the ethylenically unsaturated group-containing constitutional unit may be a constitutional unit having an acrylate group, specifically, a constitutional unit represented by (d).

(d)

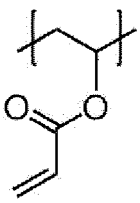

In a case where the ethylenically unsaturated group-containing constitutional unit is a constitutional unit other than the constitutional unit having an acetal ring, the content of the ethylenically unsaturated group-containing constitutional unit (also called amount of acrylate groups) with respect to the total content of constitutional units of the polyvinyl acetal resin is preferably 1 mol% to 15 mol%, and more preferably 1 mol% to 10 mol%.

From the viewpoint of on-press developability, the polyvinyl acetal resin preferably further has a hydroxyl group-containing constitutional unit. That is, the polyvinyl acetal resin preferably contains a constitutional unit derived from vinyl alcohol.

Examples of the hydroxyl group-containing constitutional unit include a constitutional unit represented by (b).

(b)

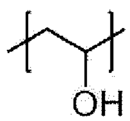

From the viewpoint of on-press developability, the content of the constitutional unit represented by (b) (also called amount of hydroxyl groups) with respect to the total content of constitutional units of the polyvinyl acetal resin is preferably 5 mol% to 50 mol%, more preferably 10 mol% to 40 mol%, and even more preferably 20 mol% to 40 mol%.

The polyvinyl acetal resin may further have other constitutional units.

Examples of those other constitutional units include a constitutional unit having an acetyl group, specifically, a constitutional unit represented by (c).

(c)

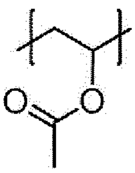

The content of the constitutional unit represented by (c) (also called amount of acetyl groups) with respect to the total content of constitutional units of the polyvinyl acetal resin is preferably 0.5 mol% to 10 mol%, more preferably 0.5 mol% to 8 mol%, and even more preferably 1 mol% to 3 mol%.

The degree of acetalization, the amount of acrylate groups, the amount of hydroxyl groups, and the amount of acetyl groups can be determined as follows.

That is, by $^{1}H$ NMR spectroscopy, the content expressed as mol% is calculated from the ratio of peak surface area of protons of a methyl or methylene moiety of acetal, a methyl moiety of an acrylate group, and a methyl moiety of a hydroxyl group and an acetyl group.

The weight-average molecular weight of the polyvinyl acetal resin is preferably 18,000 to 150,000.

The solubility parameter (also called SP value) of the polyvinyl acetal resin is preferably 17.5 $MPa^{0.5}$ to 20.0 $MPa^{0.5}$, and more preferably 18.0 $MPa^{0.5}$ to 19.5 $MPa^{0.5}$.

In the present disclosure, as "solubility parameter, (unit: ($MPa^{0.5}$)", the Hansen solubility parameters described above are used.

Specific examples of the polyvinyl acetal resin are shown in the following [P-1 to P-3]. However, the polyvinyl acetal resin used in the present disclosure is not limited thereto.

In the following structures, "l" is 50 mol% to 90 mol%, "m" is 0.5 mol% to 10 mol%, "n" is 5 mol% to 50 mol%, and "o" is 1 mol% to 15 mol%.

P-1

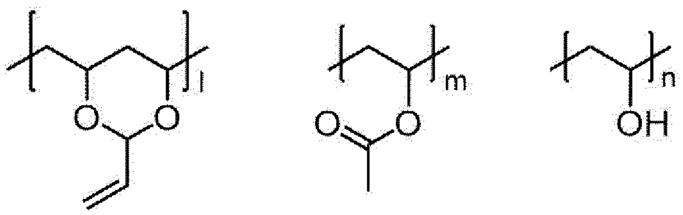

P-2

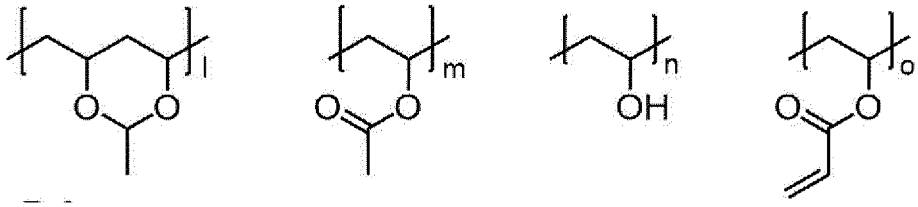

P-3

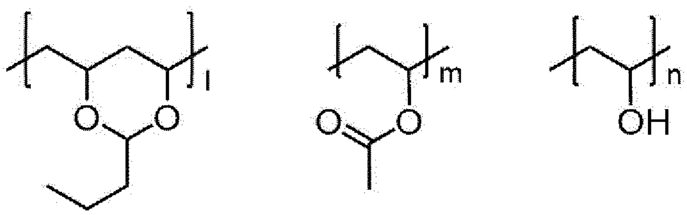

As the polyvinyl acetal resin, commercially available products can be used.

Examples of commercially available products of polyvinyl acetal resin include S-LEC BL series (specifically, S-LEC BL-10, BL-1, BL-5Z, BL-7Z, and the like), S-LEC BM series (specifically, S-LEC BM-1, BM-S(Z), BM-5, and the like), S-LEC BH series (specifically, S-LEC BH-S, BH-6, and BH-3(Z)), S-LEC BX series (S-LEC BX-L, BX-1, BX-5, and the like), and S-LEC KS series (S-LEC KS-10 and the like) manufactured by SEKISUI CHEMICAL CO., LTD.
The molecular weight of the binder polymer that is a weight-average molecular weight (Mw) expressed in terms of polystyrene by GPC is preferably 2,000 or more, more preferably 5,000 or more, and even more preferably 10,000 to 300,000.
If necessary, a hydrophilic polymer such as polyacrylic acid or polyvinyl alcohol described in JP2008-195018A can be used in combination. In addition, a lipophilic polymer and a hydrophilic polymer can be used in combination.

-Content-

In the image-recording layer, one kind of binder polymer may be used alone, or two or more kinds of binder polymers may be used in combination.
The amount of the binder polymer to be incorporated into the image-recording layer can be randomly set. From the viewpoint of on-press developability and UV printing durability, the content of the binder polymer is preferably 0% by mass or more than 0% by mass and 35% by mass or less with respect to the total mass of the image-recording layer, more preferably 0% by mass or more than 0% by mass and 20% by mass or less with respect to the total mass of the image-recording layer, even more preferably 0% by mass or more than 0% by mass and 10% by mass or less with respect to the total mass of the image-recording layer, particularly preferably 0% by mass or more than 0% by mass and 5% by mass or less with respect to the total mass of the image-recording layer, and most preferably 0% by mass.

«Color developing agent>>

From the viewpoint of visibility, the image-recording layer preferably contains a color developing agent, and more preferably contains an acid color-developing agent. Furthermore, the color developing agent preferably includes a leuco compound.
"Color developing agent" used in the present disclosure means a compound that has a property of developing or removing color by a stimulus such as light or an acid and thus changing the color of the image-recording layer. Furthermore, "acid color-developing agent" means a compound having a property of developing or removing color by being heated in a state of accepting an electron accepting compound (for example, a proton of an acid or the like) and thus changing the color of the image-recording layer. The acid color-developing agent is particularly preferably a colorless compound which has a partial skeleton such as lactone, lactam, sultone, spiropyran, an ester, or an amide and allows such a partial skeleton to rapidly open the ring or to be cleaved when coming into contact with an electron accepting compound.
Examples of such an acid color-developing agent include phthalides such as 3,3-bis(4-dimethylaminophenyl)-6-dimethylaminophthalide (called "crystal violet lactone"), 3,3-bis(4-dimethylaminophenyl)phthalide, 3-(4-dimethylaminophenyl)-3-(4-diethylamino-2-methylphenyl)-6-dimethylaminophthalide, 3-(4-dimethylaminophenyl)-3-(1,2-dimethylindol-3-yl) phthalide, 3-(4-dimethylaminophenyl)-3-(2-methylindole-3-yl)phthalide, 3,3-bis(1,2-dimethylindol-3-yl)-5-dimethylaminophthalide, 3,3-bis(1,2-dimethylindol-3-yl)-6-dimethylaminophthalide, 3,3-bis(9-ethylcarbazol-3-yl)-6-dimethylaminophthalide, 3,3-bis(2-phenylindol-3-yl)-6-dimethylaminophthalide, 3-(4-dimethylaminophenyl)-3-(1-methylpyrrol-3-yl)-6-dimethylaminophthalide, 3,3-bis[1,1-bis(4-dimethylaminophenyl)ethylen-2-yl]-4,5,6,7-tetrachlorophthalide, 3,3-bis[1,1-bis(4-pyrrolidinophenyl)ethylen-2-yl]-4,5,6,7-tetrabromophthalide, 3,3-bis[1-(4-dimethylaminophenyl)-1-(4-methoxyphenyl)ethylen-2-yl]-4,5,6,7-tetrachlorophth alide, 3,3-bis[1-(4-pyrrolidinophenyl)-1-(4-methoxyphenyl)ethylen-2-yl]-4,5,6,7-tetrachlorophthalid e, 3-[1,1-di(1-ethyl-2-methylindol-3-yl)ethylen-2-yl]-3-(4-diethylaminophenyl)phthalide, 3-[1,1-di(1-ethyl-2-methylindol-3-yl)ethylen-2-yl]-3-(4-N-ethyl-N-phenylaminophenyl)phthali de, 3-(2-ethoxy-4-diethylaminophenyl)-3-(1-n-octyl-2-methylindol-3-yl)-phthalide, 3,3-bis(1-n-octyl-2-methylindol-3-yl)-phthalide, and 3-(2-methyl-4-diethylaminophenyl)-3-(1-n-octyl-2-methylindol-3-yl)-phthalide, 4,4-bis-dimethylaminobenzhydrinbenzyl ether, N-halophenyl-leucoauramine, N-2,4,5-trichlorophenylleucoauramine, rhodamine-B-anilinolactam, rhodamine-(4-nitroanilino)lactam, rhodamine-B-(4-chloroanilino)lactam, 3,7-bis(diethylamino)-10-benzoylphenoxazine, benzoyl leucomethylene blue, 4-nitrobenzoyl methylene blue, fluorans such as 3,6-dimethoxyfluoran, 3-dimethylamino-7-methoxyfluoran, 3-diethylamino-6-methoxyfluoran, 3-diethylamino-7-methoxyfluoran, 3-diethylamino-7-chlorofluoran, 3-diethylamino-6-methyl-7-chlorofluoran, 3-diethylamino-6,7-dimethylfluoran, 3-N-cyclohexyl-N-n-butylamino-7-methylfluoran, 3-diethylamino-7-dibenzylaminofluoran, 3-diethylamino-7-octylaminofluoran, 3-diethylamino-7-di-n-hexylaminofluoran, 3-diethylamino-7-anilinofluoran, 3-diethylamino-7-(2'-fluorophenylamino)fluoran, 3-diethylamino-7-(2'-chlorophenylamino)fluoran, 3-diethylamino-7-(3'-chlorophenylamino)fluoran, 3-diethylamino-7-(2',3'-dichlorophenylamino)fluoran, 3-diethylamino-7-(3'-trifluoromethylphenylamino)fluoran, 3-di-n-butylamino-7-(2' -fluorophenylamino)fluoran, 3-di-n-butylamino-7-(2'-chlorophenylamino)fluoran, 3-N-isopentyl-N-ethylamino-7-(2'-chlorophenylamino)fluoran, 3-N-n-hexyl-N-ethylamino-7-(2'-chlorophenylamino)fluoran, 3-diethylamino-6-chloro-7-anilinofluoran, 3-di-n-butylamino-6-chloro-7-anilinofluoran, 3-diethylamino-6-methoxy-7-anilinofluoran, 3-di-n-butylamino-6-ethoxy-7-anilinofluoran, 3-pyrrolidino-6-methyl-7-anilinofluoran, 3-piperidino-6-methyl-7-anilinofluoran, 3-morpholino-6-methyl-7-anilinofluoran, 3-dimethylamino-6-methyl-7-anilinofluoran, 3-diethylamino-6-methyl-7-anilinofluoran, 3-di-n-butylamino-6-methyl-7-anilinofluoran, 3-di-n-pentylamino-6-methyl-7-anilinofluoran, 3-N-ethyl-N-methylamino-6-methyl-7-anilinofluoran, 3-N-n-propyl-N-methylamino-6-methyl-7-anilinofluoran, 3-N-n-propyl-N-ethylamino-6-methyl-7-anilinofluoran, 3-N-n-butyl-N-methylamino-6-methyl-7-anilinofluoran, 3-N-n-butyl-N-ethylamino-6-methyl-7-anilinofluoran, 3-N-isobutyl-N-methylamino-6-methyl-7-anilinofluoran, 3-N-isobutyl-N-ethylamino-6-methyl-7-anilinofluoran, 3-N-isopentyl-N-ethylamino-6-methyl-7-anilinofluoran, 3-N-n-hexyl-N-methylamino-6-methyl-7-anilinofluoran, 3-N-cyclohexyl-N-ethylamino-6-methyl-7-anilinofluoran, 3-N-cyclohexyl-N-n-propylamino-6-methyl-7-anilinofluoran, 3-N-cyclohexyl-N-n-butylamino-6-methyl-7-anilinofluoran, 3-N-cyclohexyl-N-n-hexylamino-6-methyl-7-anilinofluoran, 3-N-cyclohexyl-N-n-octylamino-6-methyl-7-anilinofluoran, 3-N-(2'-methoxyethyl)-N-methylamino-6-methyl-7-anilinofluoran, 3-N-(2'-methoxyethyl)-N-ethylamino-6-methyl-7-anilinofluoran, 3-N-(2'-methoxyethyl)-N-isobutylamino-6-methyl-7-anilinofluoran, 3-N-(2'-ethoxyethyl)-N-methylamino-6-methyl-7-anilinofluoran, 3-N-(2'-ethoxyethyl)-N-ethylamino-6-methyl-7-anilinofluoran, 3-N-(3' -methoxypropyl)-N-methylamino-6-methyl-7-anilinofluoran, 3-N-(3'-methoxypropyl)-N-ethylamino-6-methyl-7-anilinofluoran, 3-N-(3'-ethoxypropyl)-N-methylamino-6-methyl-7-anilinofluoran, 3-N-(3'-ethoxypropyl)-N-ethylamino-6-methyl-7-anilinofluoran, 3-N-(2'-tetrahydrofurfuryl)-N-ethylamino-6-methyl-7-anilinofluoran, 3-N-(4'-methylphenyl)-N-ethylamino-6-methyl-7-anilinofluoran, 3-diethylamino-6-ethyl-7-anilinofluoran, 3-diethylamino-6-methyl-7-(3'-methylphenylamino)fluoran, 3-diethylamino-6-methyl-7-(2',6'-dimethylphenylamino)fluoran, 3-di-n-butylamino-6-methyl-7-(2',6'-dimethylphenylamino)fluoran, 3-di-n-butylamino-7-(2',6'-dimethylphenylamino)fluoran, 2,2-bis[4'-(3-N-cyclohexyl-N-methylamino-6-methylfluoran)-7-ylaminophenyl]propane, 3-[4'-(4-phenylaminophenyl)aminophenyl]amino-6-methyl-7-chlorofluoran, and 3-[4'-(dimethylaminophenyl)]amino-5,7-dimethylfluoran, phthalides such as 3-(2-methyl-4-diethylaminophenyl)-3-(1-ethyl-2-methylindol-3-yl)-4-azaphthalide, 3-(2-n-propoxycarbonylamino-4-di-n-propylaminophenyl)-3-(1-ethyl-2-methylindol-3-yl)-4-a zaphthalide, 3-(2-methylamino-4-di-n-propylaminophenyl)-3-(1-ethyl-2-methylindol-3-yl)-4-azaphthalide, 3-(2-methyl-4-di-n-hexylaminophenyl)-3-(1-n-octyl-2-methylindol-3-yl)-4,7-diazaphthalide, 3,3-bis(2-ethoxy-4-diethylaminophenyl)-4-azaphthalide, 3,3-bis(1-n-octyl-2-methylindol-3-yl)-4-azaphthalide, 3-(2-ethoxy-4-diethylaminophenyl)-3-(1-ethyl-2-methylindol-3-yl)-4-azaphthalide, 3-(2-ethoxy-4-diethylaminophenyl)-3-(1-octyl-2-methylindol-3-yl)-4 or 7-azaphthalide, 3-(2-ethoxy-4-diethylaminophenyl)-3-(1-ethyl-2-methylindol-3-yl)-4 or 7-azaphthalide, 3-(2-hexyloxy-4-diethylaminophenyl)-3-(1-ethyl-2-methylindol-3-yl)-4 or 7-azaphthalide, 3-(2-ethoxy-4-diethylaminophenyl)-3-(1-ethyl-2-phenylindol-3-yl)-4 or 7-azaphthalide, 3-(2-butoxy-4-diethylaminophenyl)-3-(1-ethyl-2-phenylindol-3-yl)-4 or 7-azaphthalide 3-methyl-spiro-dinaphthopyran, 3-ethyl-spiro-dinaphthopyran, 3-phenyl-spiro-dinaphthopyran, 3-benzyl-spiro-dinaphthopyran, 3-methyl-naphtho-(3-methoxybenzo)spiropyran, 3-propyl-spiro-dibenzopyran-3,6-bis(dimethylamino)fluorene-9-spiro-3'-(6'-dimethylamino)p hthalide, and 3,6-bis(diethylamino)fluorene-9-spiro-3'-(6'-dimethylamino) phthalide, 2'-anilino-6'-(N-ethyl-N-isopentyl)amino-3'-methylspiro[isobenzofuran-1(3H),9'-(9H)xanthe n-3-one, 2'-anilino-6'-(N-ethyl-N-(4-methylphenyl))amino-3'-methylspiro[isobenzofuran-1(3H),9'-(9H )xanthen]-3-one, 3'-N,N-dibenzylamino-6'-N,N-diethylaminospiro[isobenzofuran-1(3H),9'-(9H)xanthen]-3-on e, 2'-(N-methyl-N-phenyl)amino-6'-(N-ethyl-N-(4-methylphenyl))aminospiro[isobenzofuran-1( 3H),9'-(9H)xanthen]-3-one, and the like.

Particularly, from the viewpoint of color developability, the color developing agent in the present disclosure is preferably at least one kind of compound selected from the group consisting of a spiropyran compound, a spirooxazine compound, a spirolactone compound, and a spirolactam compound.

From the viewpoint of visibility, the hue of the colorant after color development is preferably green, blue, or black.

Furthermore, from the viewpoint of color developability and visibility of exposed portions, the acid color-developing agent is preferably a leuco colorant.

The leuco colorant is not particularly limited as long as it is a colorant having a leuco structure. The leuco colorant preferably has a spiro structure, and more preferably has a spirolactone ring structure.

From the viewpoint of color developability and visibility of exposed portions, the leuco colorant preferably has a phthalide structure or a fluoran structure.

Furthermore, from the viewpoint of color developability and visibility of exposed portions, the leuco colorant having the phthalide structure or the fluoran structure is preferably a compound represented by any of Formula (Le-1) to Formula (Le-3), and more preferably a compound represented by Formula (Le-2).

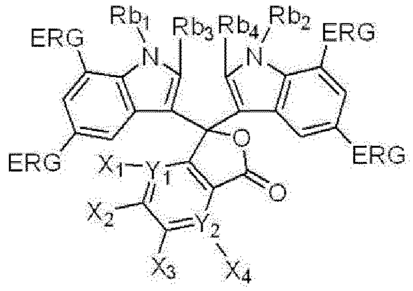

(Le-1)

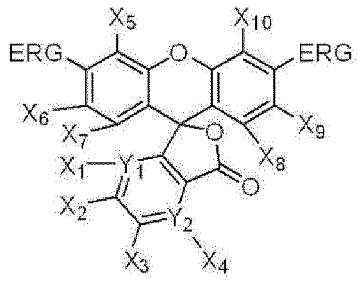

(Le-2)

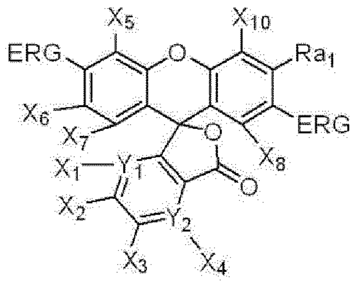

(Le-3)

In Formula (Le-1) to Formula (Le-3), ERG each independently represents an electron donating group, $X_1$ to $X_4$ each independently represent a hydrogen atom, a halogen atom, or dialkylanilino group, $X_5$ to $X_{10}$ each independently represent a hydrogen atom, a halogen atom, or a monovalent organic group, $Y_1$ and $Y_2$ each independently represent C or N, $X_1$ does not exist in a case where $Y_1$ is N, $X_4$ does not exist in a case where $Y_2$ is N, $Ra_1$ represents a hydrogen atom, an alkyl group, or an alkoxy group, and $Rb_1$ to $Rb_4$ each independently represent an alkyl group or an aryl group.

As the electron donating group represented by ERG in Formula (Le-1) to Formula (Le-3), from the viewpoint of color developability and visibility of exposed portions, an amino group, an alkylamino group, an arylamino group, a dialkylamino group, a monoalkyl monoarylamino group, a diarylamino group, an alkoxy group, an aryloxy group or an alkyl group is preferable, an amino group, alkylamino group, arylamino group, dialkylamino group, monoalkyl monoarylamino group, diarylamino group, alkoxy group, or an aryloxy group is more preferable, a monoalkyl monoarylamino group or a diarylamino group is even more preferable, and a monoalkyl monoarylamino group is particularly preferable.

From the viewpoint of color developability and visibility of exposed portions, $X_1$ to $X_4$ in Formula (Le-1) to Formula (Le-3) preferably each independently represent a hydrogen atom or a chlorine atom, and more preferably each independently represent a hydrogen atom.

From the viewpoint of color developability and visibility of exposed portions, $X_5$ to $X_{10}$ in Formula (Le-2) or Formula (Le-3) preferably each independently represent a hydrogen atom, a halogen atom, an alkyl group, an aryl group, an amino group, an alkylamino group, an arylamino group, a dialkylamino group, a monoalkyl monoarylamino group, a diarylamino group, a hydroxyl group, an alkoxy group, an aryloxy group, an acyl group, an alkoxycarbonyl group, an aryloxycarbonyl group, or an cyano group, more preferably each independently represent a hydrogen atom, a halogen atom, an alkyl group, an aryl group, an alkoxy group, or an aryloxy group, even more preferably each independently represent a hydrogen atom, a halogen atom, an alkyl group, or an aryl group, and particularly preferably each independently represent a hydrogen atom.

From the viewpoint of color developability and visibility of exposed portions, it is preferable that at least one of $Y_1$ or $Y_2$ in Formula (Le-1) to Formula (Le-3) be C, and it is more preferable that both of Yi and $Y_2$ be C.

From the viewpoint of color developability and visibility of exposed portions, $Ra_1$ in Formula (Le-1) to Formula (Le-3) is preferably an alkyl group or an alkoxy group, more preferably an alkoxy group, and particularly preferably a methoxy group.

From the viewpoint of color developability and visibility of exposed portions, $Rb_1$ to $Rb_4$ in Formula (Le-1) to Formula (Le-3) preferably each independently represent a hydrogen atom or an alkyl group, more preferably each independently represent an alkyl group, and particularly preferably each independently represent a methyl group.

Furthermore, from the viewpoint of color developability and visibility of exposed portions, the leuco colorant having a phthalide structure or a fluoran structure is more preferably a compound represented by any of Formula (Le-4) to Formula (Le-6), and even more preferably a compound represented by Formula (Le-5).

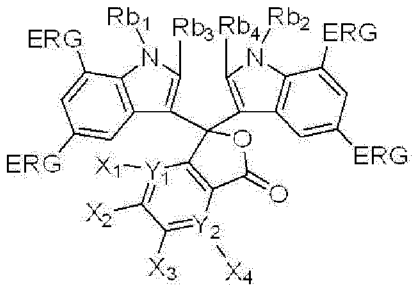

(Le - 4)

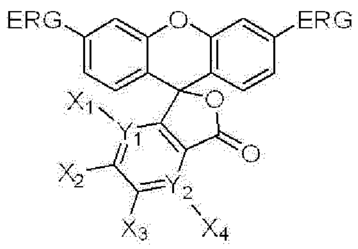

(Le - 5)

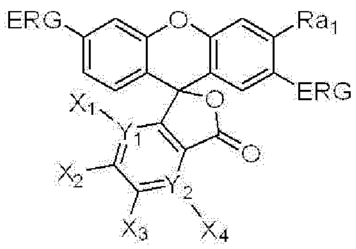

(Le - 6)

In Formula (Le-4) to Formula (Le-6), ERG each independently represents an electron donating group, $X_1$ to $X_4$ each independently represent a hydrogen atom, a halogen atom, or a dialkylanilino group, $Y_1$ and $Y_2$ each independently represent C or N, $X_1$ does not exist in a case where $Y_1$ is N, $X_4$ does not exist in a case where $Y_2$ is N, $Ra_1$ represents a hydrogen atom, an alkyl group, or an alkoxy group, and $Rb_1$ to $Rb_4$ each independently represent an alkyl group or an aryl group.

ERG, $X_1$ to $X_4$, $Y_1$, $Y_2$, Rai, and $Rb_1$ to $Rb_4$ in Formula (Le-4) to Formula (Le-6) have the same definitions as ERG, $X_1$ to $X_4$, $Y_1$, $Y_2$, Rai, and $Rb_1$ to $Rb_4$ in Formula (Le-1) to Formula (Le-3) respectively, and preferred aspects thereof are also the same.

Furthermore, from the viewpoint of color developability and visibility of exposed portions, the leuco colorant having a phthalide structure or a fluoran structure is even more preferably a compound represented by any of Formula (Le-7) to Formula (Le-9), and particularly preferably a compound represented by Formula (Le-8).

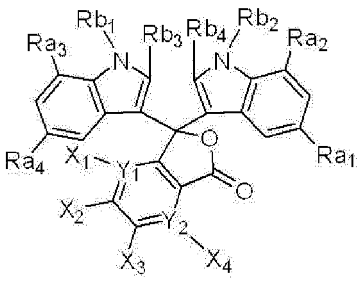

(Le - 7)

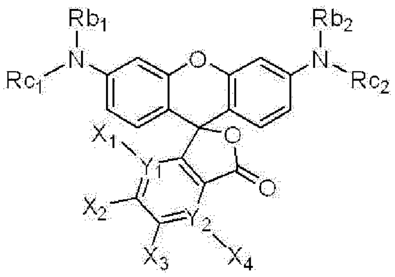

(Le - 8)

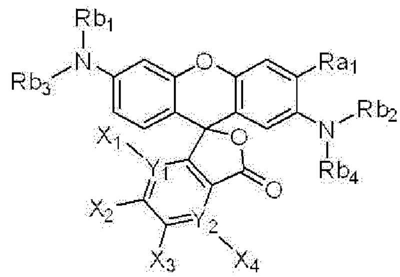

(Le - 9)

In Formula (Le-7) to Formula (Le-9), $X_1$ to $X_4$ each independently represent a hydrogen atom, a halogen atom, or a dialkylanilino group, $Y_1$ and $Y_2$ each independently represent C or N, $X_1$ does not exist in a case where $Y_1$ is N, $X_4$ does not exist in a case where $Y_2$ is N, $Ra_1$ to $Ra_4$ each independently represent a hydrogen atom, an alkyl group, or an alkoxy group, $Rb_1$ to $Rb_4$ each independently represent an alkyl group or an aryl group, and $Rc_1$ and $Rc_2$ each independently represent an aryl group.

$X_1$ to $X_4$, $Y_1$, and $Y_2$ in Formula (Le-7) to Formula (Le-9) have the same definition as $X_1$ to $X_4$, $Y_1$, and $Y_2$ in Formula (Le-1) to Formula (Le-3) respectively, and preferred aspects thereof are also the same.

From the viewpoint of color developability and visibility of exposed portions, $Ra_1$ to $Ra_4$ in Formula (Le-7) to Formula (Le-9) preferably each independently represent an alkyl group or an alkoxy group, more preferably each independently represent an alkoxy group, and particularly preferably each independently represent a methoxy group.

From the viewpoint of color developability and visibility of exposed portions, $Rb_1$ to $Rb_4$ in Formula (Le-7) to Formula (Le-9) preferably each independently represent a hydrogen atom, an alkyl group, or an aryl group substituted with an alkoxy group, more preferably each independently represent an alkyl group, and particularly preferably each independently represent a methyl group.

From the viewpoint of color developability and visibility of exposed portions, $Rc_1$ and $Rc_2$ in Formula (Le-7) to Formula (Le-9) preferably each independently represent a phenyl group or an alkylphenyl group, and more preferably each independently represent a phenyl group.

In Formula (Le-8), from the viewpoint of color developability and visibility of exposed portions, $X_1$ to $X_4$ preferably each represent a hydrogen atom, and $Y_1$ and $Y_2$ preferably each represent C.

Furthermore, from the viewpoint of color developability and visibility of exposed portions, in Formula (Le-8), $Rb_1$ and $Rb_2$ preferably each independently represent an alkyl group or an aryl group substituted with an alkoxy group.

The alkyl group in Formula (Le-1) to Formula (Le-9) may be linear or branched or may have a ring structure.

The number of carbon atoms in the alkyl group in Formula (Le-1) to Formula (Le-9) is preferably 1 to 20, more preferably 1 to 8, even more preferably 1 to 4, and particularly preferably 1 or 2.

The number of carbon atoms in the aryl group in Formula (Le-1) to Formula (Le-9) is preferably 6 to 20, more preferably 6 to 10, and particularly preferably 6 to 8.

Each of the groups in Formula (Le-1) to Formula (Le-9), such as a monovalent organic group, an alkyl group, an aryl group, a dialkylanilino group, an alkylamino group, and an alkoxy group, may have a substituent. Examples of the substituent include an alkyl group, an aryl group, a halogen atom, an amino group, an alkylamino group, an arylamino group, a dialkylamino group, a monoalkyl monoarylamino group, a diarylamino group, a hydroxyl group, an alkoxy group, an aryloxy group, an acyl group, an alkoxycarbonyl group, an aryloxycarbonyl group, a cyano group, and the like. These substituents may be further substituted with these substituents.

Examples of the leuco colorant having the phthalide structure or the fluoran structure that are suitably used include the following compounds.

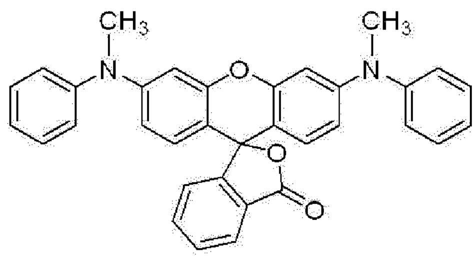

S - 1

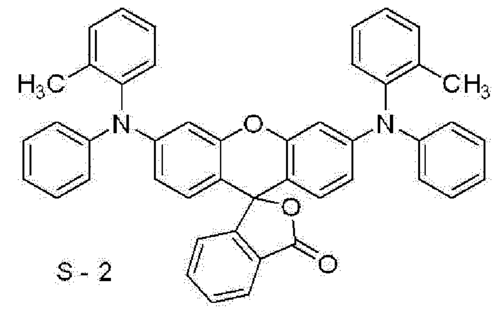

S - 2

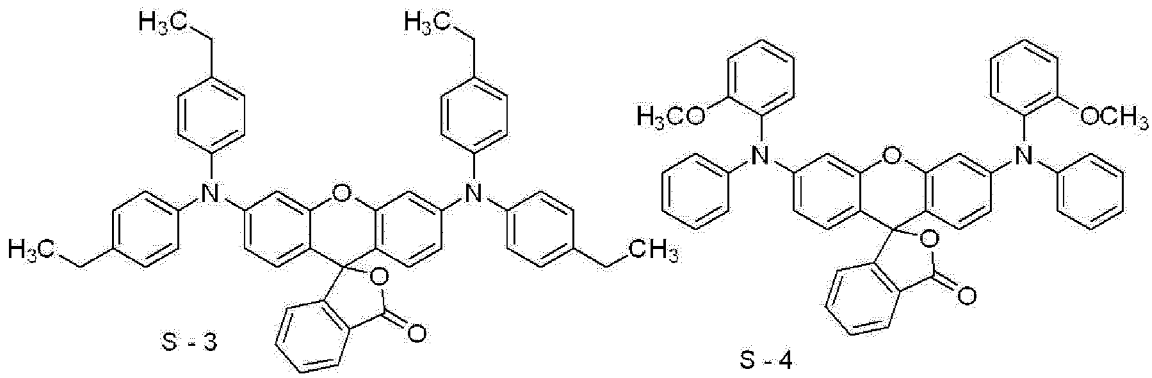

S - 3

S - 4

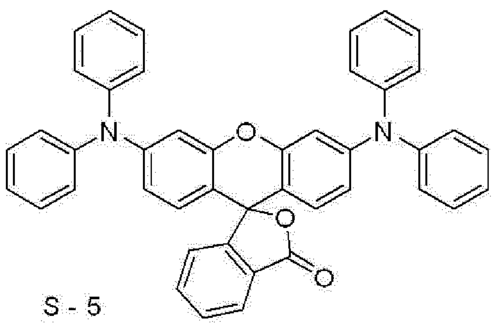

S - 5

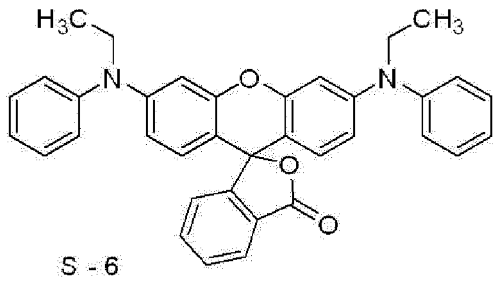

S - 6

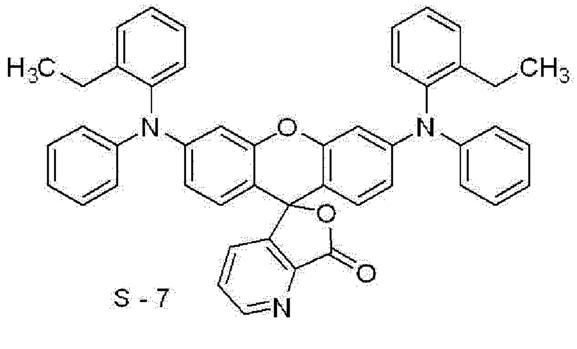

S - 7

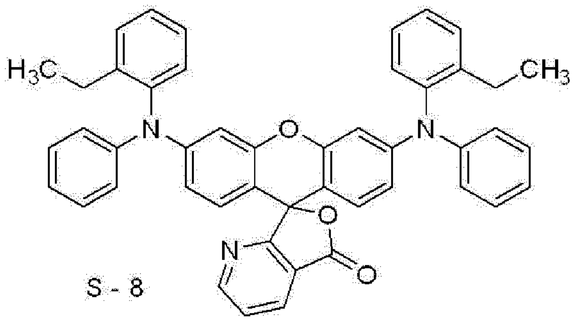

S - 8

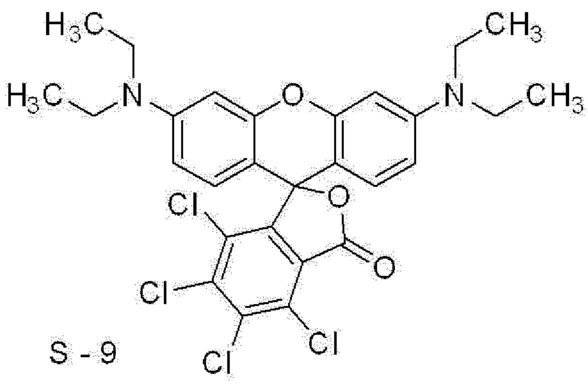

S - 9

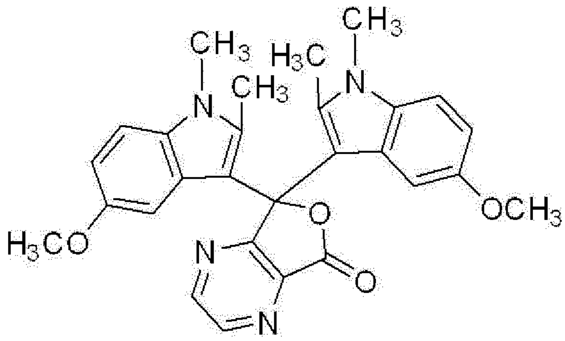

S - 10

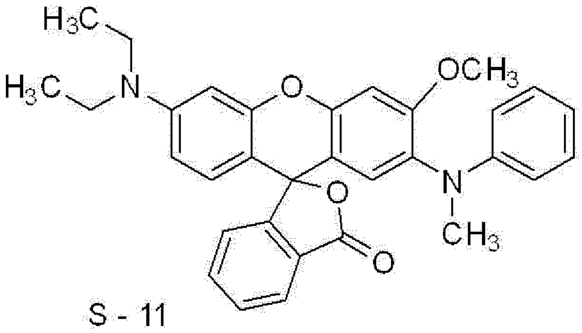

S - 11

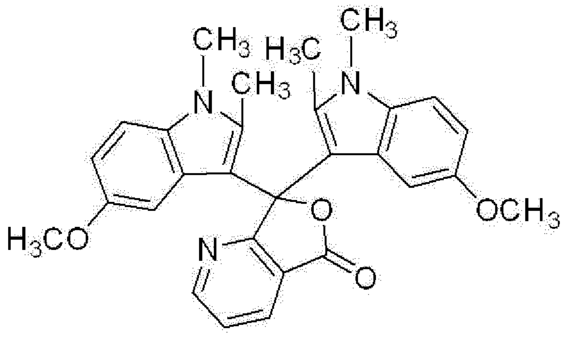

S - 12

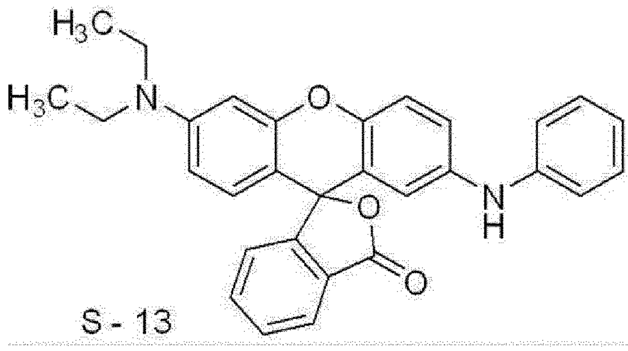

S - 13

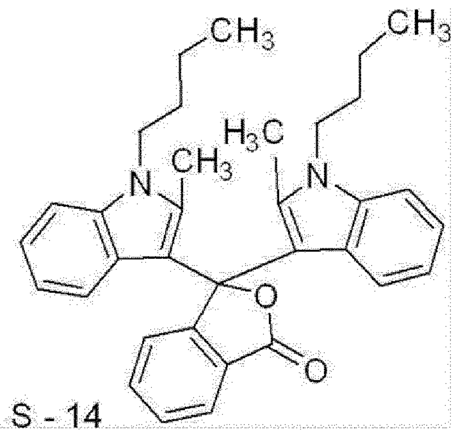

S - 14

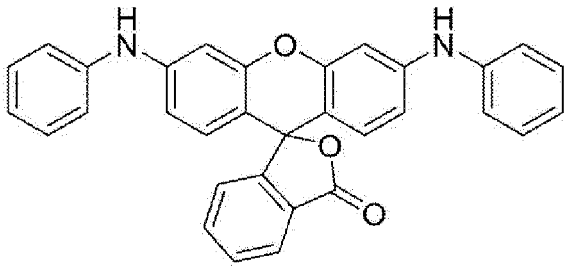

S - 15

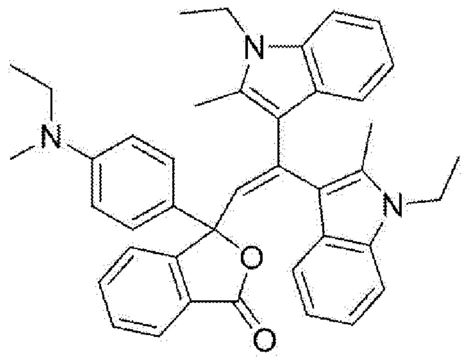

S - 16

As the acid color-developing agent, commercially available products can be used. Examples thereof include ETAC, RED500, RED520, CVL, S-205, BLACK305, BLACK400, BLACK100, BLACK500, H-7001, GREEN300, NIRBLACK78, BLUE220, H-3035, BLUE203, ATP, H-1046, and H-2114 (all manufactured by Fukui Yamada Chemical Co., Ltd.), ORANGE-DCF, Vermilion-DCF, PINK-DCF, RED-DCF, BLMB, CVL, GREEN-DCF, and TH-107 (all manufactured by Hodogaya Chemical Co., Ltd.), ODB, ODB-2, ODB-4, ODB-250, ODB-BlackXV, Blue-63, Blue-502, GN-169, GN-2, Green-118, Red-40, and Red-8 (all manufactured by Yamamoto Chemicals, Inc.), crystal violet lactone (manufactured by Tokyo Chemical Industry Co., Ltd.), and the like. Among these commercially available products, ETAC, S-205, BLACK305, BLACK400, BLACK100, BLACK500, H-7001, GREEN300, NIRBLACK78, H-3035, ATP, H-1046, H-2114, GREEN-DCF, Blue-63, GN-169, and crystal violet lactone are preferable because these form a film having excellent visible light absorbance.

One kind of each of these color developing agents may be used alone. Alternatively, two or more kinds of components can be used in combination.

The content of the color developing agent with respect to the total mass of the image-recording layer is preferably 0.5% by mass to 10% by mass, and more preferably 1% by mass to 5% by mass.

«Chain transfer agent»

The image-recording layer in the present disclosure may contain a chain transfer agent. The chain transfer agent contributes to the improvement of printing durability of the lithographic printing plate.

As the chain transfer agent, a thiol compound is preferable, a thiol having 7 or more carbon atoms is more preferable from the viewpoint of boiling point (low volatility), and a compound having a mercapto group on an aromatic ring (aromatic thiol compound) is even more preferable. The thiol compound is preferably a monofunctional thiol compound.

Specific examples of the chain transfer agent include the following compounds.

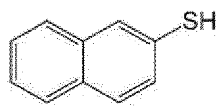

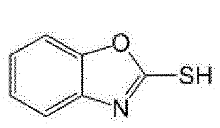

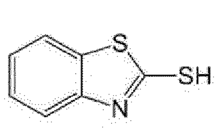

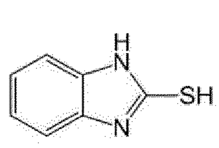

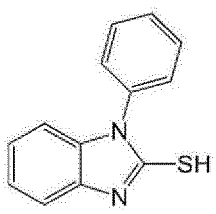

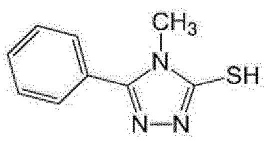

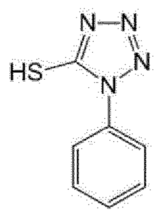

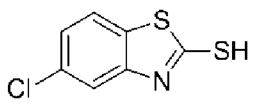
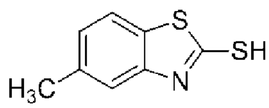
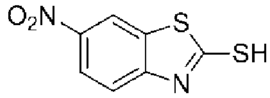
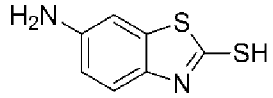
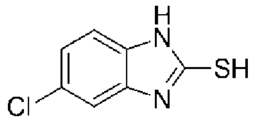
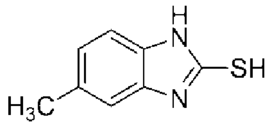
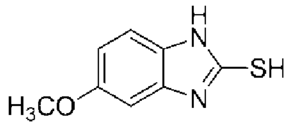
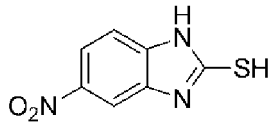
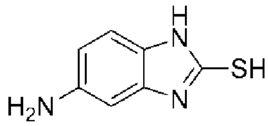
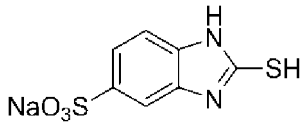
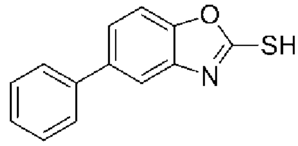
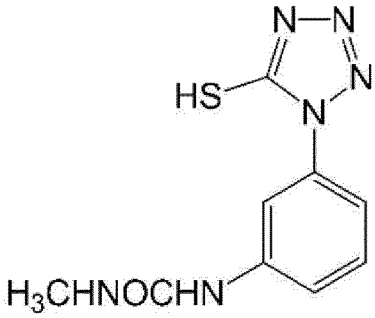
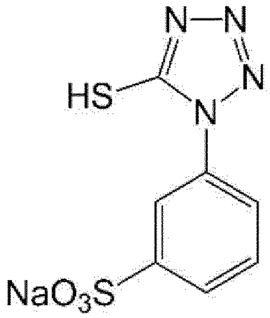

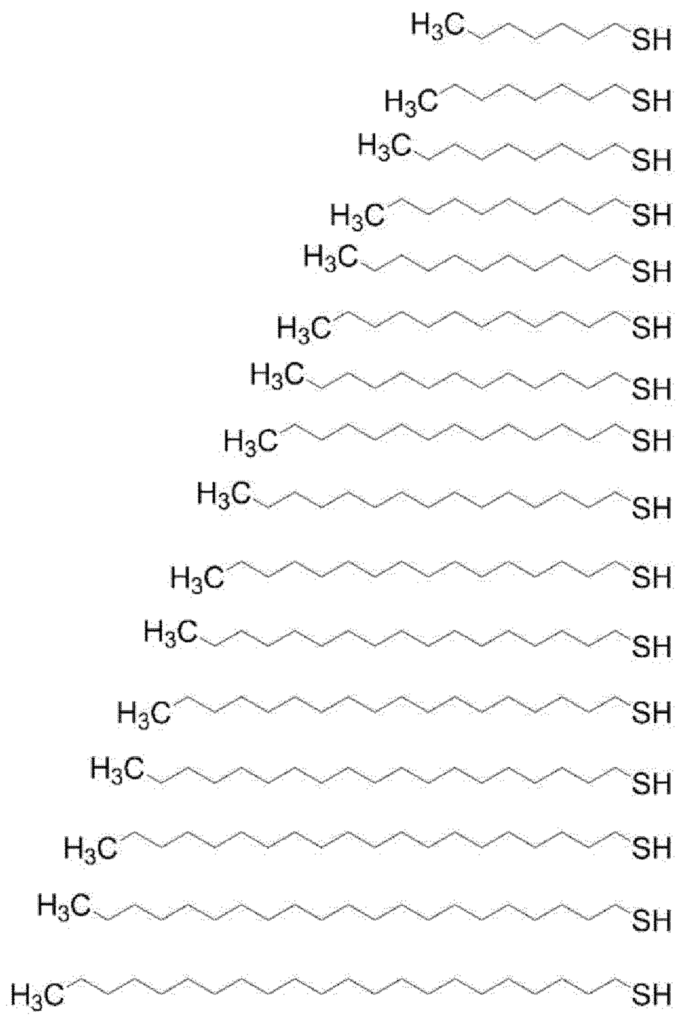

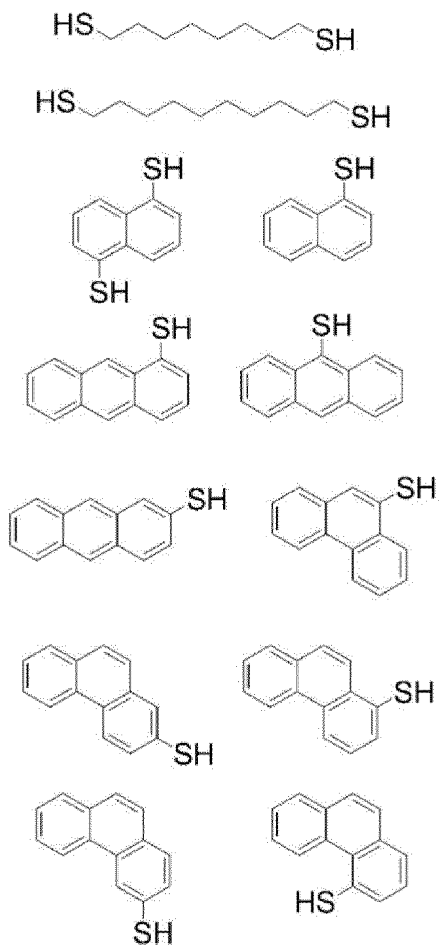

The image-recording layer may contain only one kind of chain transfer agent, or two or more kinds of chain transfer agents may be used in combination.

The content of the chain transfer agent with respect to the total mass of the image-recording layer is preferably 0.01% by mass to 50% by mass, more preferably 0.05% by mass to 40% by mass, and even more preferably 0.1% by mass to 30% by mass.

«Low-molecular-weight hydrophilic compound»

In order to suppress the deterioration of printing durability and improve on-press developability, the image-recording layer may contain a low-molecular-weight hydrophilic compound. The low-molecular-weight hydrophilic compound is preferably a compound having a molecular weight less than 1,000, more preferably a compound having a molecular weight less than 800, and even more preferably a compound having a molecular weight less than 500.

Examples of the low-molecular-weight hydrophilic compound include water-soluble organic compounds including glycols such as ethylene glycol, diethylene glycol, triethylene glycol, propylene glycol, dipropylene glycol, and tripropylene glycol, ether or ester derivatives of these glycols, polyols such as glycerin, pentaerythritol, and tris(2-hydroxyethyl)isocyanurate, organic amines and salts thereof such as triethanolamine, diethanolamine, and monoethanolamine, organic sulfonic acids and salts thereof such as alkyl sulfonate, toluene sulfonate, and benzene sulfonate, organic sulfamic acids and salts thereof such as alkylsulfamate, organic sulfuric acids and salts thereof such as alkyl sulfate and alkyl ether sulfate, organic phosphonic acids and salts thereof such as phenyl phosphate, organic carboxylic acids and salts thereof such as tartaric acid, oxalic acid, citric acid, malic acid, lactic acid, gluconic acid, and amino acid, betaines, and the like.

As the low-molecular-weight hydrophilic compound, at least one compound selected from polyols, organic sulfates, organic sulfonates, and betaines is preferably incorporated into the image-recording layer.

Specific examples of the organic sulfonates include alkyl sulfonates such as sodium n-butyl sulfonate, sodium

n-hexyl sulfonate, sodium 2-ethylhexyl sulfonate, sodium cyclohexyl sulfonate, and sodium n-octyl sulfonate; alkyl sulfonates having an ethylene oxide chain such as sodium 5,8,11-trioxapentadecane-1-sulfonate, sodium 5,8,11-trioxaheptadecane-1-sulfonate, sodium 13-ethyl-5,8,11-trioxaheptadecane-1-sulfonate, and sodium 5,8,11,14-tetraoxatetracosane-1-sulfonate; aryl sulfonates such as sodium benzenesulfonate, sodium p-toluenesulfonate, sodium p-hydroxybenzene sulfonate, sodium p-styrene sulfonate, sodium dimethyl isophthalate-5-sulfonate, sodium 1-naphthyl sulfonate, sodium 4-hydroxynaphthyl sulfonate, disodium 1,5-naphthalene disulfonate, and trisodium 1,3,6-naphthalene trisulfonate, the compounds described in paragraphs "0026" to "0031" of JP2007-276454A and paragraphs "0020" to "0047" of JP-2009-154525A, and the like. The salt may be a potassium salt or a lithium salt.

Examples of the organic sulfates include sulfates of alkyl, alkenyl, alkynyl, aryl, or heterocyclic monoether of polyethylene oxide. The number of ethylene oxide units is preferably 1 to 4, and the salt is preferably a sodium salt, a potassium salt, or a lithium salt. Specific examples thereof include the compounds described in paragraphs "0034" to "0038" of JP2007-276454A.

As the betaines, compounds in which a nitrogen atom is substituted with a hydrocarbon substituent having 1 to 5 carbon atoms are preferable. Specifically, examples thereof include trimethylammonium acetate, dimethylpropylammonium acetate, 3-hydroxy-4-trimethylammoniobutyrate, 4-(1-pyridinio)butyrate, 1-hydroxyethyl-1 -imidazolioacetate, trimethylammonium methanesulfonate, dimethylpropylammonium methanesulfonate, 3-trimethylammonio-1-propanesulfonate, 3-(1-pyridinio)-1-propanesulfonate, and the like.

The low-molecular-weight hydrophilic compound substantially does not perform a surface activation action because this compound has a small structure of a hydrophobic portion. Therefore, this compound prevents dampening water from permeating the exposed portion of the image-recording layer (image area) and deteriorating hydrophobicity or film hardness of the image area. Accordingly, the image-recording layer can maintain excellent ink receiving properties and printing durability.

The content of the low-molecular-weight hydrophilic compound with respect to the total mass of the image-recording layer is preferably 0.5% by mass to 20% by mass, more preferably 1% by mass to 15% by mass, and even more preferably 2% by mass to 10% by mass. In a case where the content is within this range, excellent on-press developability and printing durability can be obtained.

One kind of low-molecular-weight hydrophilic compound may be used alone, or two or more kinds of low-molecular-weight hydrophilic compounds may be used by being mixed together.

«Oil sensitizing agent»

In order to improve receptivity, the image-recording layer may contain an oil sensitizing agent such as a phosphonium compound, a nitrogen-containing low-molecular-weight compound, or an ammonium group-containing polymer. Particularly, in a case where an inorganic lamellar compound is incorporated into a protective layer, these compounds function as a surface coating agent for the inorganic lamellar compound and can inhibit the receptivity deterioration caused in the middle of printing by the inorganic lamellar compound.

As the oil sensitizing agent, it is preferable to use a phosphonium compound, a nitrogen-containing low-molecular-weight compound, and an ammonium group-containing polymer in combination, and it is more preferable to use a phosphonium compound, quaternary ammonium salts, and an ammonium group-containing polymer in combination.

Examples of the phosphonium compound include the phosphonium compounds described in JP2006-297907A and JP2007-50660A. Specific examples thereof include tetrabutylphosphonium iodide, butyltriphenylphosphonium bromide, tetraphenylphosphonium bromide, 1,4-bis(triphenylphosphonio)butane=di(hexafluorophosphate), 1,7-bis(triphenylphosphonio)heptane=sulfate, 1,9-bis(triphenylphosphonio)nonane=naphthalene-2,7-disulfonate, and the like.

Examples of the nitrogen-containing low-molecular-weight compound include amine salts and quaternary ammonium salts. In addition, examples thereof also include imidazolinium salts, benzimidazolinium salts, pyridinium salts, and quinolinium salts. Among these, quaternary ammonium salts and pyridinium salts are preferable. Specific examples thereof include tetramethylammonium=hexafluorophosphate, tetrabutylammonium=hexafluorophosphate, dodecyltrimethylammonium=p-toluene sulfonate, benzyltriethylammonium=hexafluorophosphate, benzyldimethyloctylammonium=hexafluorophosphate, benzyldimethyldodecylammonium=hexafluorophosphate, compounds described in paragraphs "0021" to "0037" of JP2008-284858A and paragraphs "0030" to "0057" of JP2009-90645A, and the like.

The ammonium group-containing polymer may have an ammonium group in the structure. As such a polymer, a polymer is preferable in which the content of (meth)acrylate having an ammonium group in a side chain as a copolymerization component is 5 mol% to 80 mol%. Specific examples thereof include the polymers described in paragraphs "0089" to "0105" of JP2009-208458A.

The reduced specific viscosity (unit: ml/g) of an ammonium group-containing polymer determined according to the measurement method described in JP2009-208458A is preferably in a range of 5 to 120, more preferably in a range of 10 to 110, and particularly preferably in a range of 15 to 100. In a case where the reduced specific viscosity is converted into a weight-average molecular weight (Mw), the weight-average molecular weight is preferably 10,000 to 1,500,000,

more preferably 17,000 to 140,000, and particularly preferably 20,000 to 130,000.

Specific examples of the ammonium group-containing polymer will be shown below.

(1) 2-(Trimethylammonio)ethylmethacrylate=p-toluenesulfonate/3,6-dioxaheptylmethacrylate copolymer (molar ratio: 10/90, Mw: 45,000)
(2) 2-(Trimethylammonio)ethylmethacrylate=hexafluorophosphate/3,6-dioxaheptylmethacrylate copolymer (molar ratio: 20/80, Mw: 60,000)
(3) 2-(Ethyldimethylammonio)ethylmethacrylate=p-toluenesulfonate/hexylmethacrylate copolymer (molar ratio: 30/70, Mw: 45,000)
(4) 2-(Trimethylammonio)ethylmethacrylate=hexafluorophosphate/2-ethylhexylmethacrylate copolymer (molar ratio: 20/80, Mw: 60,000)
(5) 2-(Trimethylammonio)ethylmethacrylate=methylsulfate/hexylmethacrylate copolymer (molar ratio: 40/60, Mw: 70,000)
(6) 2-(Butyldimethylammonio)ethylmethacrylate=hexafluorophosphate/3,6-dioxaheptylmethacryl ate copolymer (molar ratio: 25/75, Mw: 65,000)
(7) 2-(Butyldimethylammonio)ethylacrylate=hexafluorophosphate/3,6-dioxaheptylmethacrylate copolymer (molar ratio: 20/80, Mw: 65,000)
(8) 2-(Butyldimethylammonio)ethylmethacrylate=13-ethyl-5,8,11-trioxa-1-heptadecanesulfonate/ 3,6-dioxaheptylmethacrylate copolymer (molar ratio: 20/80, Mw: 75,000)
(9) 2-(Butyldimethylammonio)ethylmethacrylate=hexafluorophosphate/3,6-dioxaheptylmethacryl ate/2-hydroxy-3-methacryloyloxypropylmethacrylate copolymer (molar ratio: 15/80/5, Mw: 65,000)

The content of the oil sensitizing agent with respect to the total mass of the image-recording layer is preferably 0.01% by mass to 30.0% by mass, more preferably 0.1% by mass to 15.0% by mass, and even more preferably 1% by mass to 10% by mass.

«Fluorine-containing copolymer»

The image-recording layer in the present disclosure preferably contains a fluorine-containing copolymer, and more preferably contains a fluorine-containing copolymer having a constitutional unit formed of a fluorine-containing monomer. Among fluorine-containing copolymers, a fluoroaliphatic group-containing copolymer is preferable.

In a case where the fluorine-containing copolymer (preferably a fluoroaliphatic group-containing copolymer) is used, it is possible to inhibit surface abnormalities resulting from foaming during the formation of the image-recording layer and to improve the condition of the coating surface, and the formed image-recording layer has higher ink receptivity.

In addition, the image-recording layer containing the fluorine-containing copolymer (preferably a fluoroaliphatic group-containing copolymer) has high gradation and highly sensitive, for example, to laser light. Therefore, the obtained lithographic printing plate exhibits excellent fogging properties by scattered light, reflected light, and the like and has excellent printing durability.

The fluoroaliphatic group-containing copolymer preferably has a constitutional unit formed of a fluoroaliphatic group-containing monomer. Particularly, the fluoroaliphatic group-containing copolymer preferably has a constitutional unit formed of a compound represented by any of Formula (F1) and Formula (F2).

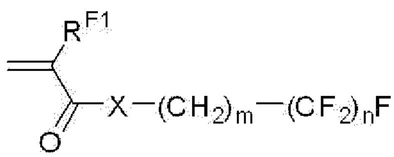

(F1)

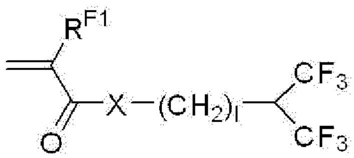

(F2)

In Formulas (F1) and (F2), $R^{F1}$ each independently represents a hydrogen atom or a methyl group, X each independently represents an oxygen atom, a sulfur atom, or -N($R^{F2}$)-, m represents an integer of 1 to 6, n represents an integer of 1 to 10, l represents an integer of 0 to 10, and $R^{F2}$ represents a hydrogen atom or an alkyl group having 1 to 4 carbon atoms.

The alkyl group having 1 to 4 carbon atoms represented by $R^{F2}$ in Formulas (F1) and (F2) is preferably a methyl group, an ethyl group, a n-propyl group, or a n-butyl group, and more preferably a hydrogen atom or a methyl group.

X in Formulas (F1) and (F2) is preferably an oxygen atom.

m in Formula (F1) is preferably 1 or 2, and more preferably 2.

n in Formula (F1) is preferably 2, 4, 6, 8, or 10, and more preferably 4 or 6.

1 in Formula (F1) is preferably 0.

Specific examples of the compound represented by any of Formula (F1) or Formula (F2) will be shown below, but the compound represented by any of Formula (F1) or Formula (F2) is not limited thereto.

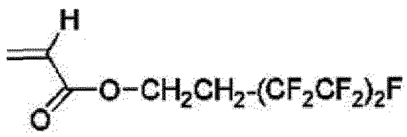

F-1

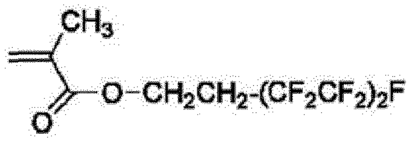

F-2

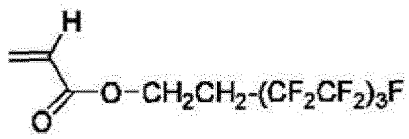

F-3

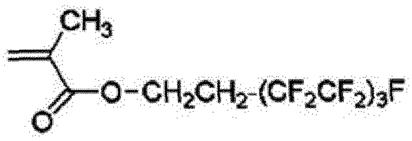

F-4

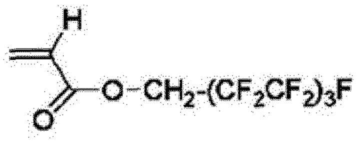

F-5

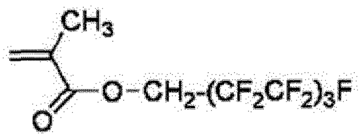

F-6

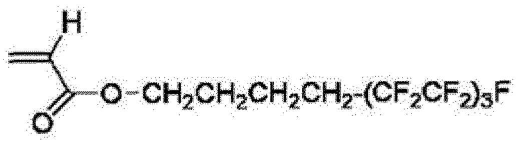

F-7

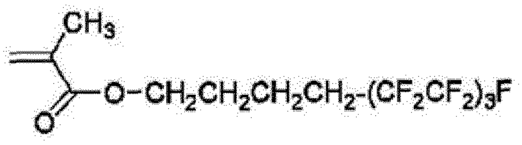

F-8

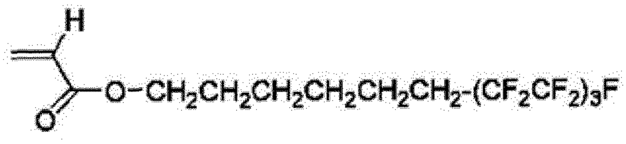 F-9

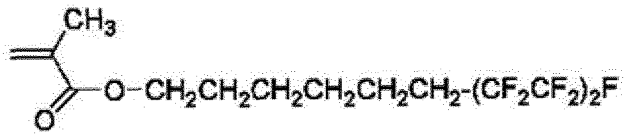 F-10

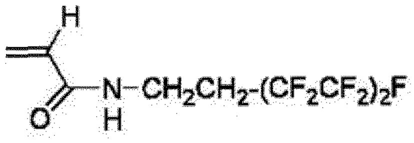 F-11

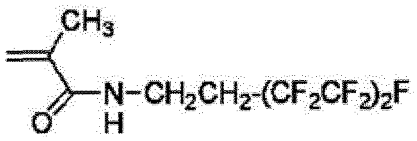 F-12

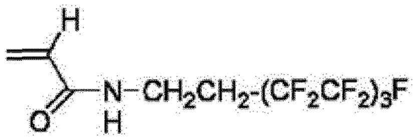 F-13

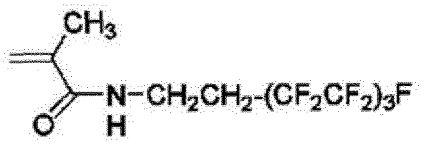 F-14

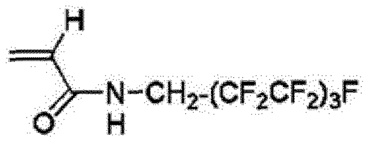 F-15

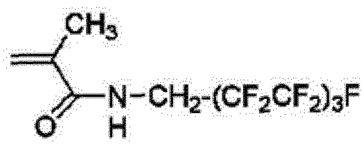 F-16

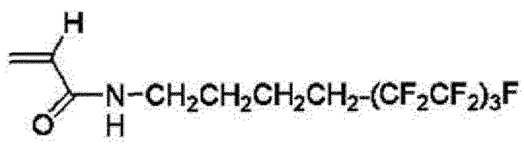 F-17

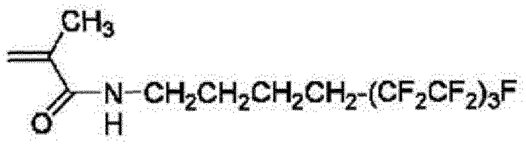

F-18

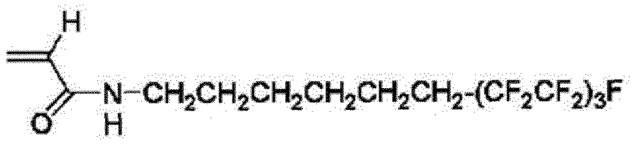

F-19

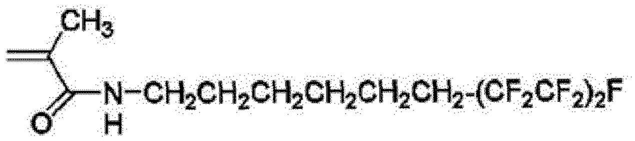

F-20

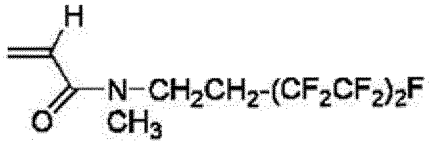

F-21

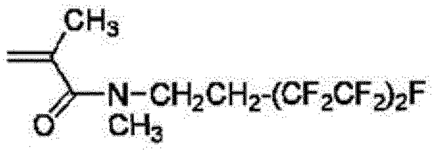

F-22

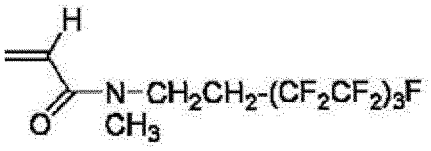

F-23

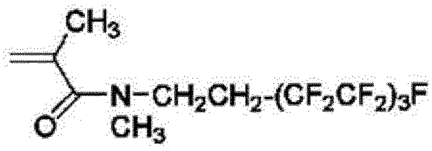

F-24

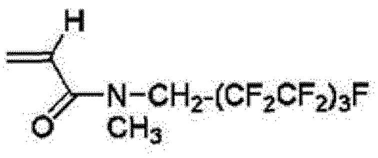

F-25

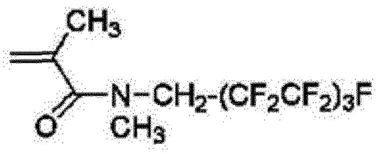

F-26

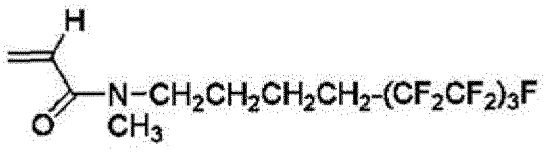

F-27

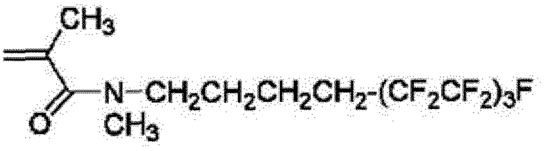

F-28

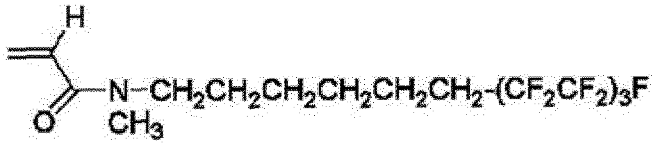

F-29

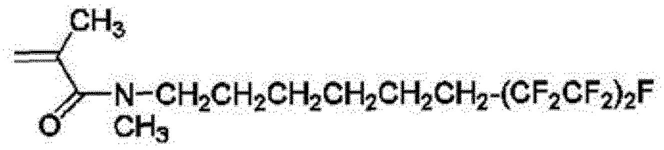

F-30

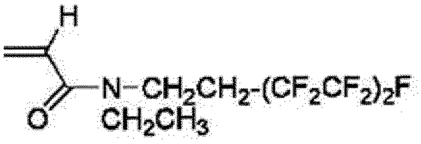

F-31

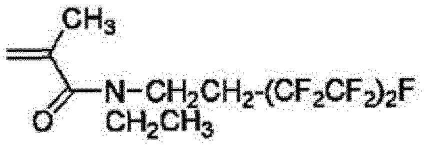

F-32

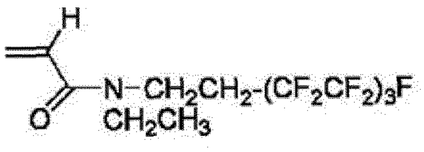

F-33

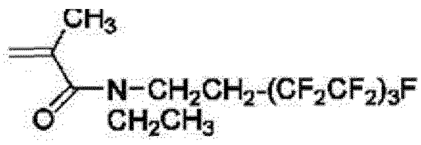

F-34

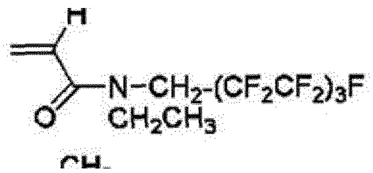

F-35

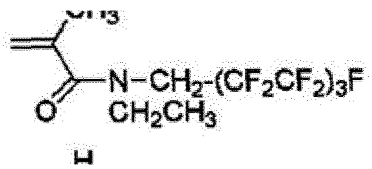

F-36

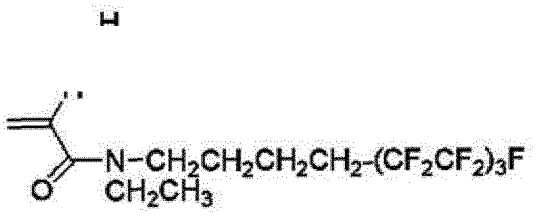

F37

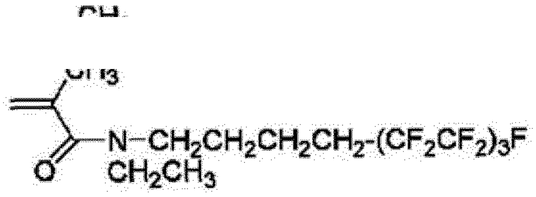

F38

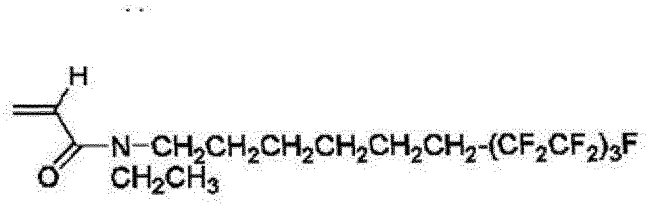

F-39

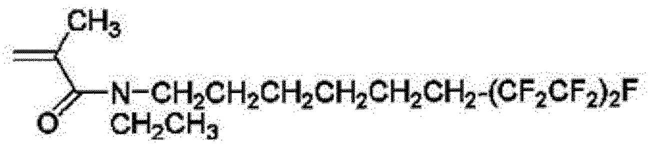

F-40

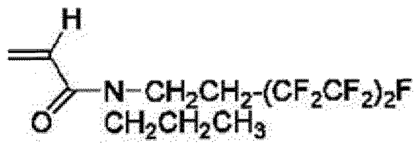

F-41

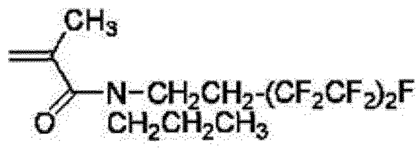

F-42

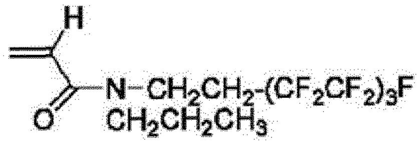

F-43

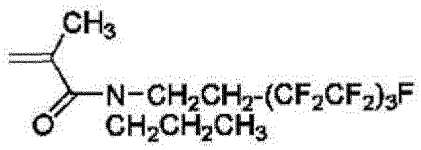

F-44

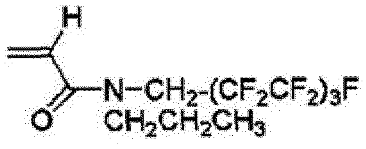

F-45

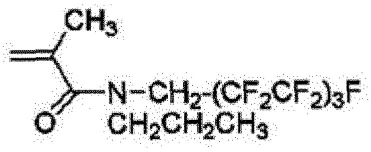

F-46

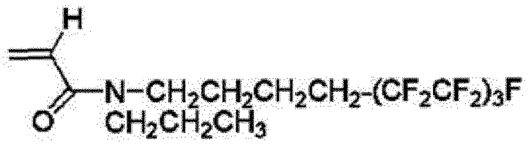

F-47

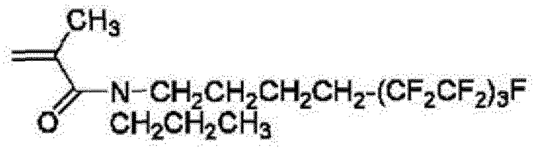

F-48

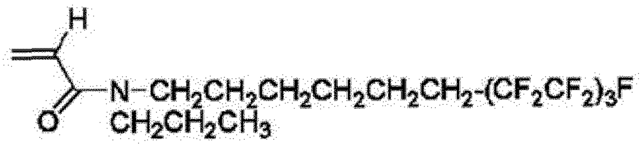

F-49

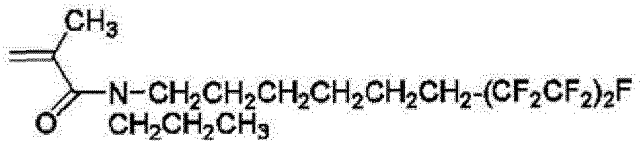

F-50

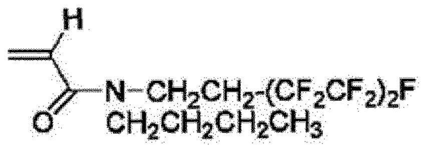

F-51

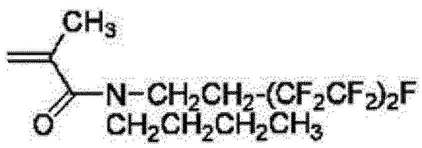

F-52

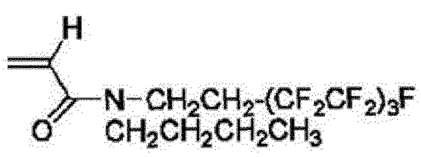

F-53

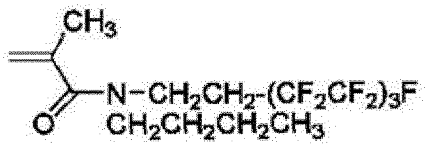
F-54

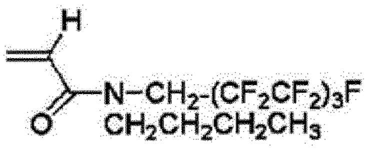
F-55

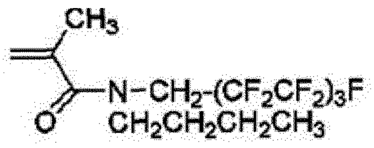
F-56

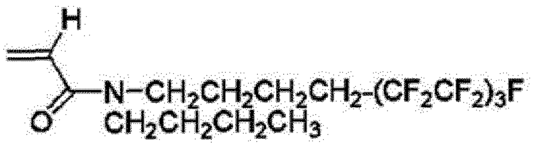
F-57

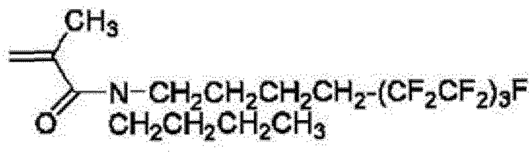
F-58

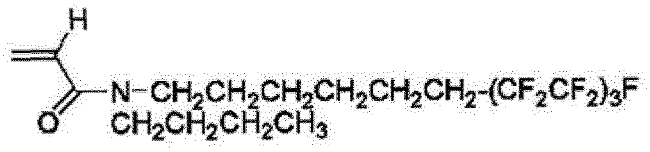
F-59

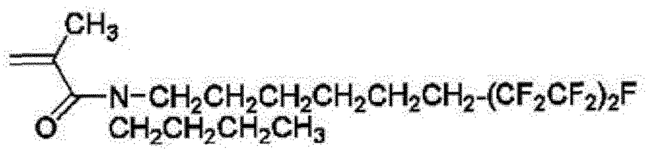
F-60

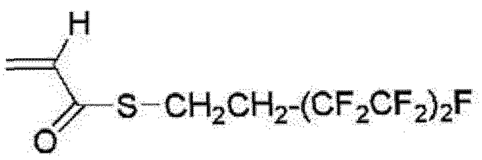
F-61

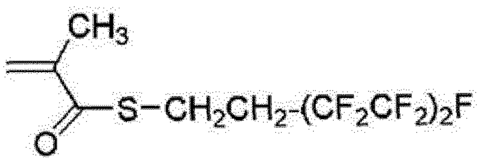
F-62

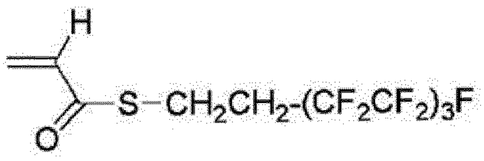

F-63

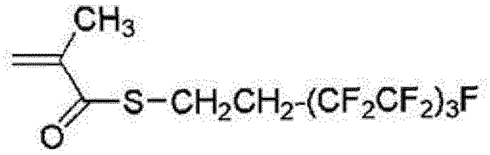

F-64

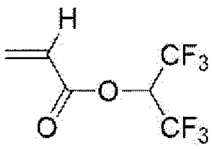

F-65

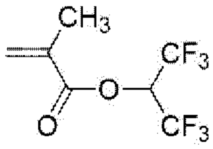

F-66

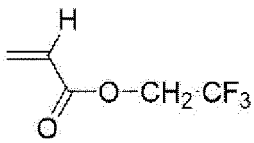

F-67

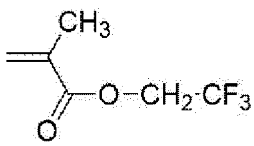

F-68

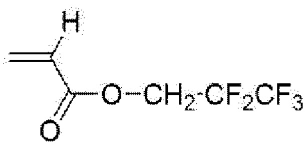

F-69

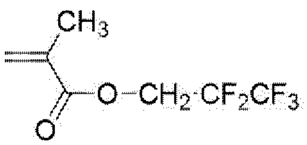

F-70

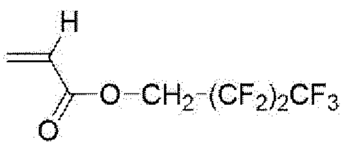

F-71

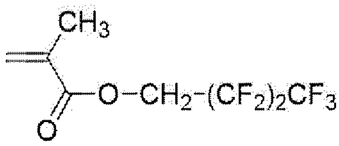
F-72

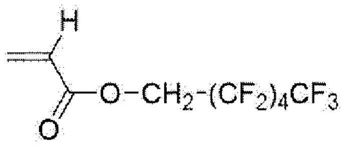
F-73

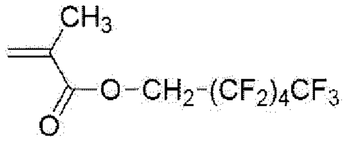
F-74

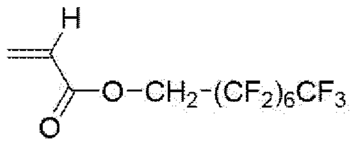
F-75

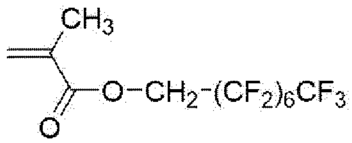
F-76

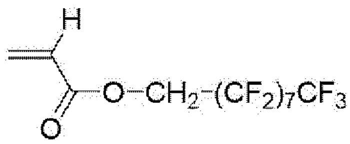
F-77

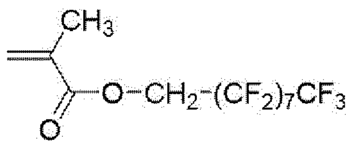
F-78

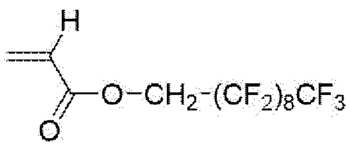
F-79

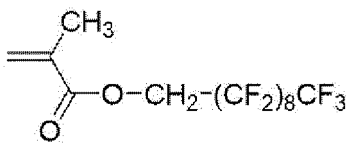
F-80

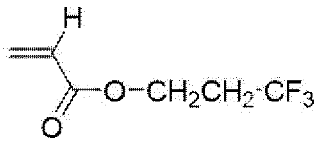

F-81

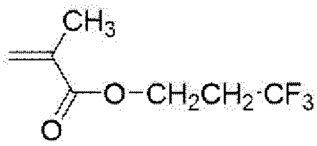

F-82

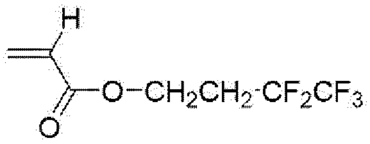

F-83

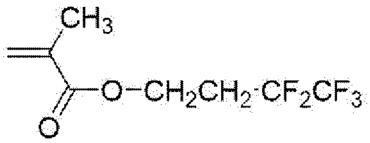

F-84

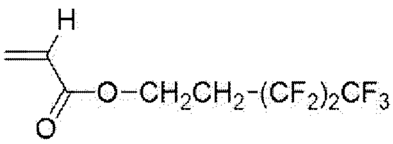

F-85

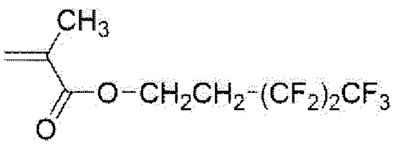

F-86

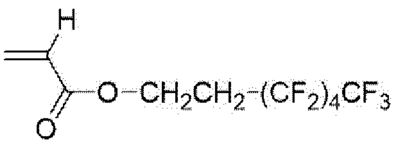

F-87

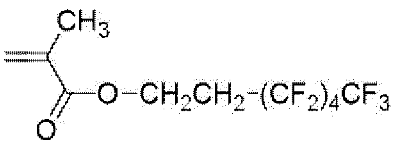

F-88

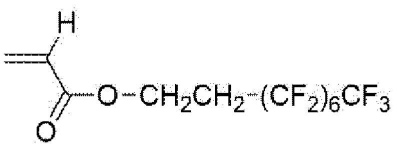

F-89

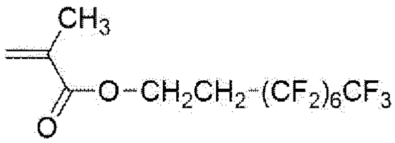

F-90

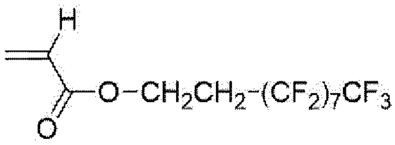

F-91

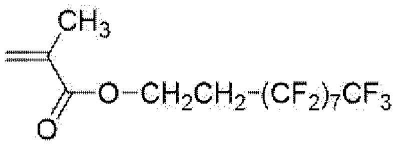

F-92

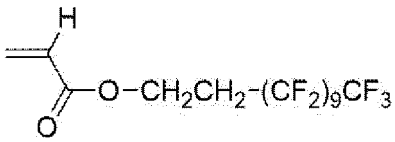

F-93

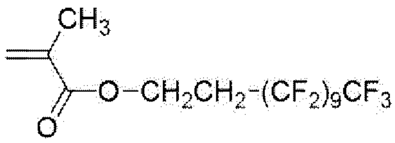

F-94

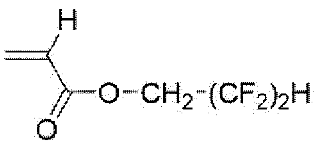

F-95

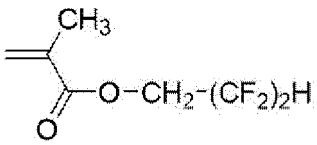

F-96

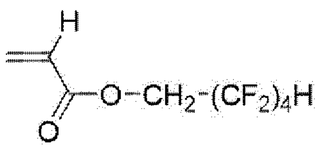

F-97

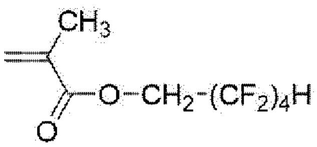

F-98

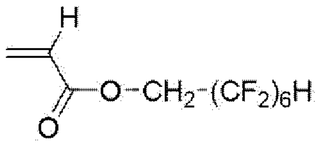

F-99

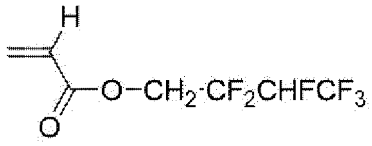

F-100

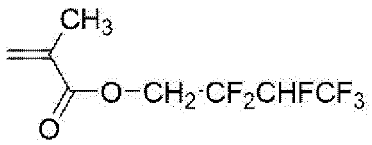

F-101

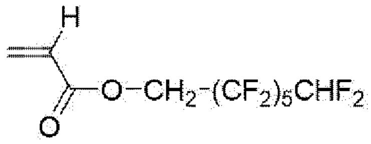

F-102

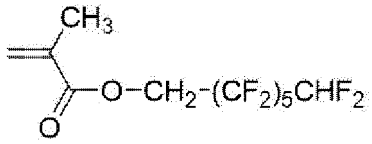

F-103

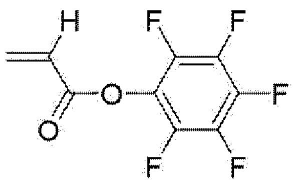

F-104

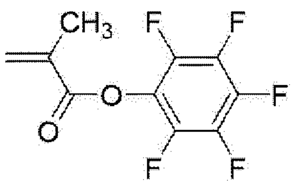

F-105

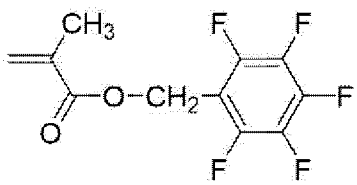

F-106

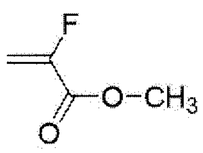

F-107

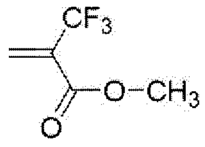

F-108

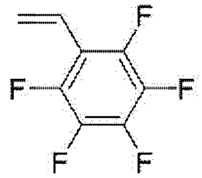

F-109

It is preferable that the fluorine-containing copolymer further has a constitutional unit formed of at least one kind of compound selected from the group consisting of poly(oxyalkylene) acrylate and a poly(oxyalkylene) methacrylate, in addition to the constitutional unit formed of a fluorine-containing monomer.

Furthermore, the fluoroaliphatic group-containing copolymer preferably further has a constitutional unit formed of at least one kind of compound selected from the group consisting of poly(oxyalkylene) acrylate and a poly(oxyalkylene) methacrylate, in addition to the constitutional unit formed of a compound represented by any of Formula (F1) and Formula (F2).

The polyoxyalkylene group in the poly(oxyalkylene) acrylate and poly(oxyalkylene) methacrylate can be represented by $-(OR^{F3})_x-$. $R^{F3}$ represents an alkyl group, and x represents an integer of 2 or more. $R^{F3}$ is preferably a linear or branched alkylene group having 2 to 4 carbon atoms. As the linear or branched alkylene group having 2 to 4 carbon atoms, $-CH_2CH_2-$, $-CH_2CH_2CH_2-$, $-CH(CH_3)CH_2-$, or $-CH(CH_3)CH(CH_3)-$ is preferable. x is preferably an integer of 2 to 100.

In the polyoxyalkylene groups, x pieces of "$OR^{F3}$" may be the same as or different from each other. That is, the polyoxyalkylene group may be composed of two or more kinds of "$OR^{F3}$" that are regularly or irregularly bonded to each other. For example, the polyoxyalkylene group may be composed of a linear or branched oxypropylene unit and an oxyethylene unit that are regularly or irregularly bonded to each other. More specifically, the polyoxyalkylene group may be composed of a block of a linear or branched oxypropylene unit and a block of an oxyethylene unit that are bonded to each other.

The polyoxyalkylene group may have one or more linking groups (for example, -CONH-Ph-NHCO-, -S-, and the like, in which Ph represents a phenylene group).

The molecular weight of the polyoxyalkylene group is preferably 250 to 3,000.

As the poly(oxyalkylene) acrylate and the poly(oxyalkylene) methacrylate described above, commercially available products or synthetic products may be used.

The poly(oxyalkylene) acrylate and the poly(oxyalkylene) methacrylate can be synthesized, for example, by reacting a hydroxypoly(oxyalkylene) compound with acrylic acid, methacrylic acid, acryloyl chloride, methacryloyl chloride, acrylic acid anhydride, or the like by known methods.

As the aforementioned hydroxypoly(oxyalkylene) compound, commercially available products may be used. Examples thereof include ADEKA (registered trademark) PLURONIC manufactured by ADEKA Corporation, ADEKA polyether manufactured by ADEKA Corporation, Carbowax (registered trademark) manufactured by Union Carbide Corporation, Triton manufactured by The Dow Chemical Company., PEG manufactured by DKS Co. Ltd., and the like.

As the poly(oxyalkylene) acrylate and the poly(oxyalkylene) methacrylate, poly(oxyalkylene) diacrylate or the like synthesized by known methods may also be used.

«Other components»

As other components, a surfactant, a polymerization inhibitor, a higher fatty acid derivative, a plasticizer, inorganic particles, an inorganic lamellar compound, and the like can be incorporated into the image-recording layer. Specifically, the description in paragraphs "0114" to "0159" of JP2008-284817A can be referred to.

-Formation of image-recording layer-

The image-recording layer in the lithographic printing plate precursor according to the present disclosure can be formed, for example, by preparing a coating solution by dispersing or dissolving the necessary components described above in a known solvent, coating a support with the coating solution by a known method such as bar coating, and drying the coating solution, as described in paragraphs "0142" and "0143" of JP2008-195018A. The coating amount (solid

content) of the image-recording layer after coating and drying varies with uses, but is preferably 0.3 $g/m^2$ to 3.0 $g/m^2$. In a case where the coating amount is in this range, excellent sensitivity and excellent film characteristics of the image-recording layer are obtained.

As the solvent, known solvents can be used. Specific examples thereof include water, acetone, methyl ethyl ketone (2-butanone), cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetylacetone, cyclohexanone, diacetone alcohol, ethylene glycol monomethyl ether acetate, ethylene glycol ethyl ether acetate, ethylene glycol monoisopropyl ether, ethylene glycol monobutyl ether acetate, 1-methoxy-2-propanol, 3-methoxy-1-propanol, methoxy methoxyethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate, 3-methoxypropyl acetate, N,N-dimethylformamide, dimethyl sulfoxide, γ-butyrolactone, methyl lactate, ethyl lactate, and the like. One kind of solvent may be used alone, or two or more kinds of the solvents may be used in combination. The concentration of solid contents in the coating solution is preferably about 1% by mass to 50% by mass.

The coating amount (solid content) of the image-recording layer after coating and drying varies with uses. However, from the viewpoint of obtaining excellent sensitivity and excellent film characteristics of the image-recording layer, the coating amount is preferably about 0.3 $g/m^2$ to 3.0 $g/m^2$.

<Overcoat layer>

The lithographic printing plate precursor according to the present disclosure may have an overcoat layer (hereinafter, also called "protective layer") on the image-recording layer.

The film thickness of the overcoat layer is preferably greater than the film thickness of the image-recording layer.

The overcoat layer has a function of suppressing the reaction inhibiting image formation by blocking oxygen and a function of preventing the damage of the image-recording layer and preventing ablation during exposure to high-illuminance lasers.

The overcoat layer having such characteristics is described, for example, in US3458311A and JP1980-49729B (JP-S55-49729B). As polymers with low oxygen permeability that are used in the overcoat layer, any of water-soluble polymers and water-insoluble polymers can be appropriately selected. If necessary, two or more kinds of such polymers can be used by being mixed together. From the viewpoint of on-press developability, the polymers with low oxygen permeability preferably include a water-soluble polymer.

«Water-soluble polymer»

In the present disclosure, a water-soluble polymer refers to a polymer that dissolves 1 g or more in 100 g of pure water at 70°C and is not precipitated even though a solution of 1 g of the polymer in 100 g of pure water at 70°C is cooled to 25°C.

Preferable examples of the water-soluble polymer contained in the overcoat layer include polyvinyl alcohol, modified polyvinyl alcohol, polyvinylpyrrolidone, a water-soluble cellulose derivative, polyethylene glycol, poly(meth)acrylonitrile, and the like.

As the modified polyvinyl alcohol, acid-modified polyvinyl alcohol having a carboxy group or a sulfo group is preferably used. Specific examples thereof include modified polyvinyl alcohols described in JP2005-250216A and JP2006-259137A.

From the viewpoint of UV printing durability and on-press developability, the water-soluble polymer preferably includes at least one kind of compound selected from the group consisting of polyvinyl alcohol, polyvinylpyrrolidone, a water-soluble cellulose derivative, and polyethylene glycol, more preferably includes at least one kind of compound selected from the group consisting of polyvinyl alcohol, a water-soluble cellulose derivative, and polyethylene glycol, even more preferably includes polyvinyl alcohol, and particularly preferably include polyvinyl alcohol having a saponification degree of 50% or higher.

The saponification degree is preferably 60% or higher, more preferably 70% or higher, and even more preferably 85% or higher. The upper limit thereof of the saponification degree is not particularly limited, and may be 100% or less.

The saponification degree is measured according to the method described in JIS K 6726: 1994.

As an aspect of the overcoat layer, for example, an aspect in which the overcoat layer contains polyvinyl alcohol and polyethylene glycol is also preferable.

In a case where the overcoat layer in the present disclosure contains a water-soluble polymer, the content of the water-soluble polymer with respect to the total mass of the overcoat layer is preferably 30% by mass to 100% by mass, more preferably 40% by mass to 100% by mass, and even more preferably 50% by mass to 100% by mass.

«Inorganic lamellar compound»

In order to improve oxygen barrier properties, the overcoat layer may contain an inorganic lamellar compound. The inorganic lamellar compound refers to particles in the form of a thin flat plate, and examples thereof include mica groups such as natural mica and synthetic mica, talc represented by Formula 3MgO·4SiO·H2O, taeniolite, montmorillonite, saponite, hectorite, zirconium phosphate, and the like.

As the inorganic lamellar compound, a mica compound is preferably used. Examples of the mica compound include mica groups such as natural mica and synthetic mica represented by Formula: $A(B, C)_{2-5}D_4O_{10}(OH, F, O)_2$ [here, A represents any of K, Na, and Ca, B and C represent any of Fe (II), Fe (III), Mn, Al, Mg, and V, and D represents Si or Al.].

In the mica groups, examples of natural mica include white mica, soda mica, gold mica, black mica, and lepidolite. Examples of synthetic mica include non-swelling mica such as fluorophlogopite $KMg_3(AlSi_3O_{10})F_2$, potassium tetrasilic mica $KMg_{2.5}(Si_4O_{10})F_2$, and, Na tetrasilylic mica $NaMg_{2.5}(Si_4O_{10})F_2$, swelling mica such as Na or Li taeniolite $(Na, Li)Mg_2Li(Si_4O_{10})F2$, montmorillonite-based Na or Li hectorite $(Na, Li)_{1/8}Mg_{2/5}Li_{1/8}(Si_4O_{10})F_2$, and the like. Furthermore, synthetic smectite is also useful.

Among the aforementioned mica compounds, fluorine-based swelling mica is particularly useful. That is, swelling synthetic mica has a laminate structure consisting of unit crystal lattice layers having a thickness in a range of approximately 10Å to 15Å (1Å is equal to 0.1 nm), and metal atoms in lattices are more actively substituted than in any other clay minerals. As a result, positive charges are deficient in the lattice layers, and positive ions such as $Li^+$, $Na^+$, $Ca^{2+}$, and $Mg^{2+}$ are adsorbed between the layers in order to compensate for the deficiency. Positive ions interposed between the layers are referred to as exchangeable positive ions and are exchangeable with various positive ions. Particularly, in a case where the positive ions between the layers are $Li^+$ and $Na^+$, the ionic radii are small, and thus the bonds between lamellar crystal lattices are weak, and mica is significantly swollen by water. In a case where shear is applied in this state, mica easily cleavages and forms a stable sol in water. Swelling synthetic mica is particularly preferably used because it clearly exhibits such a tendency.

From the viewpoint of diffusion control, regarding the shapes of the mica compounds, the thickness is preferably thin, and the planar size is preferably large as long as the smoothness and actinic ray-transmitting property of coated surfaces are not impaired. Therefore, the aspect ratio is preferably 20 or higher, more preferably 100 or higher, and particularly preferably 200 or higher. The aspect ratio is the ratio of the long diameter to the thickness of a particle and can be measured from projection views obtained from the microphotograph of the particle. The higher the aspect ratio is, the stronger the obtained effect is.

Regarding the particle diameter of the mica compound, the average long diameter thereof is preferably 0.3 μm to 20 μm, more preferably 0.5 μm to 10 μm, and particularly preferably 1 μm to 5 μm. The average thickness of the particles is preferably 0.1 μm or less, more preferably 0.05 μm or less, and particularly preferably 0.01 μm or less. Specifically, for example, in the case of swelling synthetic mica which is a typical compound, an aspect is preferable in which the compound has a thickness of about 1 nm to 50 nm and a surface size (long diameter) of about 1 μm to 20 μm.

The content of the inorganic lamellar compound with respect to the total solid content of the overcoat layer is preferably 1% by mass to 60% by mass, and more preferably 3% by mass to 50% by mass. Even in a case where two or more kinds of inorganic lamellar compounds are used in combination, the total amount of the inorganic lamellar compounds preferably equals the content described above. In a case where the content is within the above range, the oxygen barrier properties are improved, and excellent sensitivity is obtained. In addition, the deterioration of receptivity can be prevented.

«Hydrophobic polymer»

The overcoat layer may contain a hydrophobic polymer.

The hydrophobic polymer refers to a polymer that dissolves less than 5 g or does not dissolve in 100 g of pure water at 125°C.

Examples of the hydrophobic polymer include polyethylene, polystyrene, polyvinyl chloride, polyvinylidene chloride, polyalkyl (meth)acrylate ester (for example, polymethyl (meth)acrylate, polyethyl (meth)acrylate, polybutyl (meth)acrylate, and the like), a copolymer obtained by combining raw material monomers of these resins, and the like.

The hydrophobic polymer preferably includes a polyvinylidene chloride resin.

Furthermore, the hydrophobic polymer preferably includes a styrene-acrylic copolymer (also called styrene acrylic resin).

From the viewpoint of on-press developability, the hydrophobic polymer is preferably hydrophobic polymer particles.

One kind of hydrophobic polymer may be used alone, or two or more kinds of hydrophobic polymers may be used in combination.

In a case where the overcoat layer contains a hydrophobic polymer, the content of the hydrophobic polymer with respect to the total mass of the overcoat layer is preferably 1% by mass to 80% by mass, and more preferably 5% by mass to 50% by mass.

In the present disclosure, the proportion of the area of the hydrophobic polymer occupying the surface of the overcoat layer is preferably 30 area% or higher, more preferably 40 area% or higher, and even more preferably 50 area% or higher.

The upper limit of the proportion of the area of the hydrophobic polymer occupying the surface of the overcoat layer is, for example, 90 area%.

The proportion of the area of the hydrophobic polymer occupying the surface of the overcoat layer can be measured as follows.

By using PHI nano TOFII time-of-flight secondary ion mass spectrometer (TOF-SIMS) manufactured by ULVAC-PHI, INCORPORATED., the surface of the overcoat layer is irradiated with Bi ion beams (primary ions) at an acceleration voltage of 30 kV, and the peak of ions (secondary ions) corresponding to a hydrophobic portion (that is, a region formed of the hydrophobic polymer) that are emitted from the surface is measured so that the hydrophobic portion is mapped. By measuring the area of the hydrophobic portion in an area of 1 $\mu m^2$, the proportion of the area occupied by the hydrophobic portion is determined and adopted as "proportion of the area of the hydrophobic polymer occupying the surface of the overcoat layer".

For example, in a case where the hydrophobic polymer is an acrylic resin, the proportion is measured using the peak of $C_6H_{13}O^-$. Furthermore, in a case where the hydrophobic polymer is polyvinylidene chloride, the proportion is measured using the peak of $C_2H_2Cl^+$.

The proportion of occupied area can be adjusted by the amount of the hydrophobic polymer added or the like.

<<Discoloring compound>>

From the viewpoint of improving visibility of exposed portions, the overcoat layer may contain a discoloring compound.

In a case where the overcoat layer contains the discoloring compound, a brightness change ΔL in the lithographic printing plate precursor that will be described later can be easily set to 2.0 or more.

From the viewpoint of improving visibility of exposed portions, in a case where the lithographic printing plate precursor according to the present disclosure is exposed to infrared with a wavelength of 830 nm at an energy density of 110 $mJ/cm^2$, a brightness change ΔL between the brightness of the precursor before exposure and the brightness of the precursor after exposure is preferably 2.0 or more.

The brightness change ΔL is more preferably 3.0 or more, even more preferably 5.0 or more, particularly preferably 8.0 or more, and most preferably 10.0 or more.

An upper limit of the brightness change ΔL is, for example, 20.0.

The brightness change ΔL is measured by the following method.

In Luxel PLATESETTER T-9800 manufactured by FUJIFILM Graphic Systems that is equipped with an infrared semiconductor laser with a wavelength of 830 nm, the lithographic printing plate precursor is exposed under the conditions of output of 99.5%, outer drum rotation speed of 220 rpm, and resolution of 2,400 dpi (dots per inch, 1 inch = 25.4 mm (energy density of 110 $mJ/cm^2$). The exposure is performed in an environment of 25°C and 50%RH.

The brightness change of the lithographic printing plate precursor before and after exposure is measured.

The brightness change is measured using a spectrocolorimeter eXact manufactured by X-Rite, Incorporated. By using the L* value (brightness) in the L*a*b* color space, the absolute value of a difference between the L* value of the image-recording layer after the exposure and the L* value of the image-recording layer before the exposure is adopted as the brightness change ΔL.

In the present disclosure, "discoloring compound" refers to a compound which undergoes change in absorption in the visible light region (wavelength: 400 nm or more and less than 750 nm) due to the exposure to infrared. That is, in the present disclosure, "discoloring" means that the absorption in the visible light region (wavelength: 400 nm or more and less than 750 nm) changes due to the exposure to infrared.

Specifically, examples of the discoloring compound in the present disclosure include (1) compound that absorbs more light in the visible light region due to the exposure to infrared than before the exposure to infrared, (2) compound that is made capable of absorbing light in the visible light region due to the exposure to infrared, and (3) compound that is made incapable of absorbing light in the visible light region due to the exposure to infrared.

The infrared in the present disclosure is a ray having a wavelength of 750 nm to 1 mm, and preferably a ray having a wavelength of 750 nm to 1,400 nm.

The discoloring compound preferably includes a compound that develops color due to the exposure to infrared.

Furthermore, the discoloring compound is preferably an infrared absorber. The aforementioned specific polymethine colorant may be used as an infrared absorber.

In addition, the discoloring compound preferably includes a decomposable compound that decomposes due to the exposure to infrared, and particularly preferably includes a decomposable compound that decomposes by either or both of heat and electron transfer due to the exposure to infrared.

More specifically, the discoloring compound in the present disclosure is preferably a compound that decomposes due to the exposure to infrared (more preferably, decomposes by either or both of heat or electron transfer due to the exposure to infrared) and absorbs more light in the visible light region than before the exposure to infrared or is made capable of absorbing light of longer wavelengths and thus capable of absorbing light in the visible light region.

"Decomposes by electron transfer" mentioned herein means that electrons of the discoloring compound excited to the lowest unoccupied molecular orbital (LUMO) from the highest occupied molecular orbital (HOMO) by the exposure to infrared move to electron accepting groups (groups having potential close to LUMO) in a molecule by means of intramolecular electron transfer and thus result in decomposition.

Hereinafter, as an example of the discoloring compound, a decomposable compound will be described.

There are no limitations on the decomposable compound as long as it absorbs at least a part of light in the infrared wavelength region (wavelength region of 750 nm to 1 mm, preferably a wavelength region of 750 nm to 1,400 nm) and decomposes. The decomposable compound is preferably a compound having maximum absorption wavelength in a wavelength region of 750 nm to 1,400 nm.

More specifically, the decomposable compound is preferably a compound that decomposes due to the exposure to infrared and generates a compound having maximum absorption wavelength in a wavelength region of 500 nm to 600 nm.

From the viewpoint of improving visibility of exposed portions, the decomposable compound is preferably a cyanine dye having a group that decomposes by the exposure to infrared (specifically, $R^1$ in Formula 1-1 to Formula 1-7).

From the viewpoint of improving visibility of exposed portions, the decomposable compound is more preferably a compound represented by Formula 1-1.

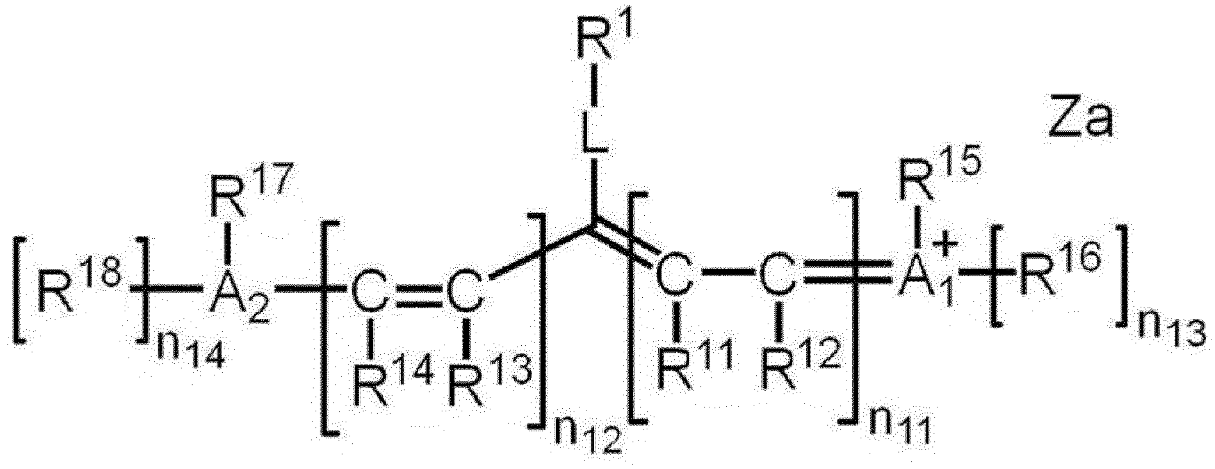

Formula 1-1

In Formula 1-1, $R^1$ represents a group that is represented by any of Formula 2 to Formula 4, $R^{11}$ to $R^{18}$ each independently represent a hydrogen atom, a halogen atom, $-R^a$, $-OR^b$, $-SR^c$, or $-NR^dR^e$, $R^a$ to $R^e$ each independently represent a hydrocarbon group, $A_1$, $A_2$, and a plurality of $R_{11}$ to $R_{18}$ may be linked to each other to form a monocyclic or polycyclic ring, $A_1$ and $A_2$ each independently represent an oxygen atom, a sulfur atom, or a nitrogen atom, $n_{11}$ and $n_{12}$ each independently represent an integer of 0 to 5, the sum of $n_{11}$ and $n_{12}$ is 2 or more, $n_{13}$ and $n_{14}$ each independently represent 0 or 1, L represents an oxygen atom, a sulfur atom, or $-NR^{10}-$, $R^{10}$ represents a hydrogen atom, an alkyl group, or an aryl group, and Za represents a counterion that neutralizes charge.

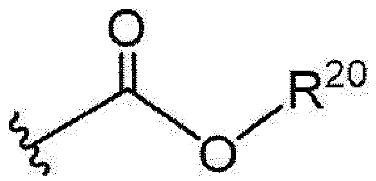

Formula 2

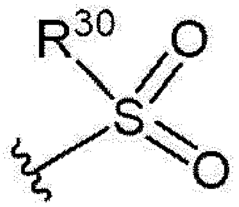

Formula 3

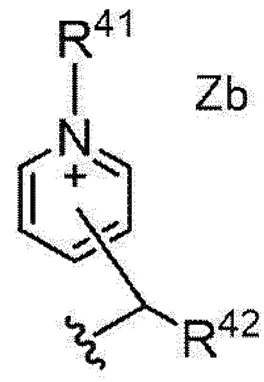

Formula 4

In Formula 2 to Formula 4, $R^{20}$, $R^{30}$, $R^{41}$, and $R^{42}$ each independently represent an alkyl group or an aryl group, Zb represents a counterion that neutralizes charge, the wavy line represents a binding site with the group represented by L in Formula 1-1.

In a case where the compound represented by Formula 1-1 is exposed to infrared, the $R^1$-L bond is cleaved, L turns into =O, =S, or =$NR^{10}$, and the compound is discolored.

In Formula 1-1, $R^1$ represents a group represented by any of Formula 2 to Formula 4.

Hereinafter, each of the group represented by Formula 2, the group represented by Formula 3, and the group represented by Formula 4 will be described.

In Formula 2, $R^{20}$ represents an alkyl group or an aryl group, and the portion of the wavy line represents a binding site with the group represented by L in Formula 1-1.

As the alkyl group represented by $R^{20}$, an alkyl group having 1 to 30 carbon atoms is preferable, an alkyl group having 1 to 15 carbon atoms is more preferable, and an alkyl group having 1 to 10 carbon atoms is even more preferable.

The alkyl group may be linear or branched, or may have a ring structure.

The aryl group represented by $R^{20}$ is preferably an aryl group having 6 to 30 carbon atoms, more preferably an aryl group having 6 to 20 carbon atoms, and even more preferably an aryl group having 6 to 12 carbon atoms.

From the viewpoint of color developability, $R^{20}$ is preferably an alkyl group.

From the viewpoint of decomposition properties and color developability, the alkyl group represented by $R^{20}$ is preferably a secondary alkyl group or a tertiary alkyl group, and more preferably a tertiary alkyl group.

Furthermore, from the viewpoint of decomposition properties and color developability, the alkyl group represented by $R^{20}$ is preferably an alkyl group having 1 to 8 carbon atoms, more preferably a branched alkyl group having 3 to 10 carbon atoms, even more preferably a branched alkyl group having 3 to 6 carbon atoms, particularly preferably an isopropyl group or a tert-butyl group, and most preferably a tert-butyl group.

The alkyl group represented by $R^{20}$ may be a substituted alkyl group substituted with a halogen atom (for example, a chloro group) or the like.

Specific examples of the group represented by Formula 2 will be shown below. However, the present disclosure is not limited thereto. In the following structural formulas, • represents a binding site with the group represented by L in Formula 1-1.

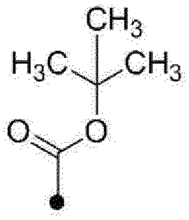
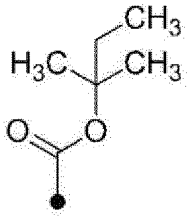
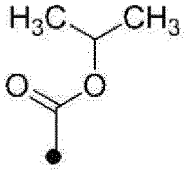
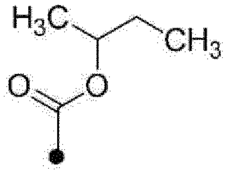
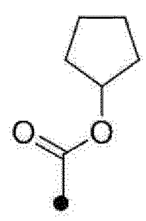

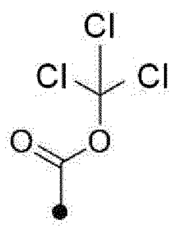

In Formula 3, $R^{30}$ represents an alkyl group or an aryl group, and the portion of the wavy line represents a binding site with the group represented by L in Formula 1-1.

The alkyl group and aryl group represented by $R^{30}$ are the same as the alkyl group and aryl group represented by $R^{20}$ in Formula 2, and the preferred aspects thereof are also the same.

From the viewpoint of decomposition properties and color developability, the alkyl group represented by $R^{30}$ is preferably a secondary alkyl group or a tertiary alkyl group, and more preferably a tertiary alkyl group.

Furthermore, from the viewpoint of decomposition properties and color developability, the alkyl group represented by $R^{30}$ is preferably an alkyl group having 1 to 8 carbon atoms, more preferably a branched alkyl group having 3 to 10 carbon atoms, even more preferably a branched alkyl group having 3 to 6 carbon atoms, particularly preferably an isopropyl group or a tert-butyl group, and most preferably a tert-butyl group.

In addition, from the viewpoint of decomposition properties and color developability, the alkyl group represented by $R^{30}$ is preferably a substituted alkyl group, more preferably a fluoro-substituted alkyl group, even more preferably a perfluoroalkyl group, and particularly preferably a trifluoromethyl group.

From the viewpoint of decomposition properties and color developability, the aryl group represented by $R^{30}$ is preferably a substituted aryl group. Examples of the substituent include an alkyl group (preferably an alkyl group having 1 to 4 carbon atoms), an alkoxy group (preferably an alkoxy group having 1 to 4 carbon atoms), and the like.

Specific examples of the group represented by Formula 3 will be shown below. However, the present disclosure is not limited thereto. In the following structural formulas, • represents a binding site with the group represented by L in Formula 1-1.

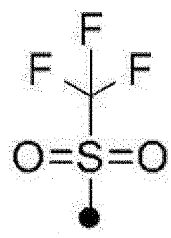

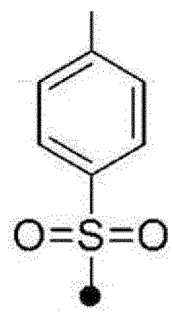

In Formula 4, $R^{41}$ and $R^{42}$ each independently represent an alkyl group or an aryl group, Zb represents a counterion that neutralizes charge, and the portion of the wavy line represents a binding site with the group represented by L in Formula 1-1.

The alkyl group and aryl group represented by $R^{41}$ or $R^{42}$ are the same as the alkyl group and aryl group represented by $R^{20}$ in Formula 2, and preferred aspects thereof are also the same.

From the viewpoint of decomposition properties and color developability, $R^{41}$ is preferably an alkyl group.

From the viewpoint of decomposition properties and color developability, $R^{42}$ is preferably an alkyl group.

From the viewpoint of decomposition properties and color developability, the alkyl group represented by $R^{41}$ is preferably an alkyl group having 1 to 8 carbon atoms, more preferably an alkyl group having 1 to 4 carbon atoms, and particularly preferably a methyl group.

From the viewpoint of decomposition properties and color developability, the alkyl group represented by $R^{42}$ is preferably a secondary alkyl group or a tertiary alkyl group, and more preferably a tertiary alkyl group.

Furthermore, from the viewpoint of decomposition properties and color developability, the alkyl group represented by $R^{42}$ is preferably an alkyl group having 1 to 8 carbon atoms, more preferably a branched alkyl group having 3 to 10 carbon atoms, even more preferably a branched alkyl group having 3 to 6 carbon atoms, particularly preferably an isopropyl group or a tert-butyl group, and most preferably a tert-butyl group.

Zb in Formula 4 has no limitations as long as it is a counterion that neutralizes charge, and may be included in Za in Formula 1-1 in the entirety of the compound.

Zb is preferably a sulfonate ion, a carboxylate ion, a tetrafluoroborate ion, a hexafluorophosphate ion, a p-toluenesulfonate ion, or a perchlorate ion, and more preferably a tetrafluoroborate ion.

Specific examples of the group represented by Formula 4 will be shown below. However, the present disclosure is not limited thereto. In the following structural formulas, • represents a binding site with the group represented by L in Formula 1-1.

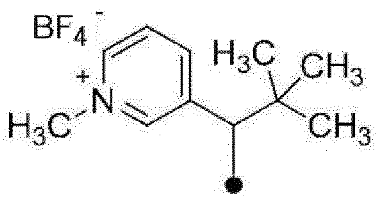

L in Formula 1-1 is preferably an oxygen atom or $-NR^{10}-$, and particularly preferably an oxygen atom.

Furthermore, $R^{10}$ in $-NR^{10}-$ is preferably an alkyl group. The alkyl group represented by $R^{10}$ is preferably an alkyl group having 1 to 10 carbon atoms. The alkyl group represented by $R^{10}$ may be linear or branched, or may have a ring structure.

Among the alkyl groups, a methyl group or a cyclohexyl group is preferable.

In a case where $R^{10}$ in $-NR^{10}-$ represents an aryl group, the aryl group is preferably an aryl group having 6 to 30 carbon atoms, more preferably an aryl group having 6 to 20 carbon atoms, and even more preferably an aryl group having 6 to 12 carbon atoms. These aryl groups may have a substituent.

In Formula 1-1, $R^{11}$ to $R^{18}$ preferably each independently represent a hydrogen atom, $-R^a$, $-OR^b$, $-SR^c$, or $-NR^dR^e$.

The hydrocarbon group represented by $R^a$ to $R^e$ is preferably a hydrocarbon group having 1 to 30 carbon atoms, more preferably a hydrocarbon group having 1 to 15 carbon atoms, and even more preferably a hydrocarbon group having 1 to 10 carbon atoms.

The hydrocarbon group may be linear or branched or may have a ring structure.

As the hydrocarbon group, an alkyl group is particularly preferable.

The aforementioned alkyl group is preferably an alkyl group having 1 to 30 carbon atoms, more preferably an alkyl group having 1 to 15 carbon atoms, and even more preferably an alkyl group having 1 to 10 carbon atoms.

The alkyl group may be linear or branched, or may have a ring structure.

Specific examples of the alkyl group include a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eicosyl group, an isopropyl group, an isobutyl group, an s-butyl group, a tert-butyl group, an isopentyl group, a neopentyl group, a 1-methylbutyl group, an isohexyl group, a 2-ethylhexyl group, a 2-methylhexyl group, a cyclohexyl group, a cyclopentyl group, and a 2-norbornyl group.

Among these alkyl groups, a methyl group, an ethyl group, a propyl group, or a butyl group is preferable.

The above alkyl group may have a substituent.

Examples of the substituent include an alkoxy group, an aryloxy group, an amino group, an alkylthio group, an arylthio group, a halogen atom, a carboxy group, a carboxylate group, a sulfo group, a sulfonate group, an alkyloxycarbonyl group, an aryloxycarbonyl group, groups obtained by combining these, and the like.

$R^{11}$ to $R^{14}$ in Formula 1-1 preferably each independently represent a hydrogen atom or $-R^a$ (that is, a hydrocarbon group), more preferably each independently represent a hydrogen atom or an alkyl group, and even more preferably each independently represent a hydrogen atom except in the cases described below.

Particularly, each of $R^{11}$ and $R^{13}$ bonded to the carbon atom that is bonded to the carbon atom to which L is bonded is preferably an alkyl group. It is more preferable that $R^{11}$ and $R^{13}$ be linked to each other to form a ring. The ring to be formed in this way may be a monocyclic or polycyclic ring. Specifically, examples of the ring to be formed include a monocyclic ring such as a cyclopentene ring, a cyclopentadiene ring, a cyclohexene ring, or a cyclohexadiene ring, and a polycyclic ring such as an indene ring or an indole ring.

Furthermore, it is preferable that $R^{12}$ bonded to the carbon atom to which $A_1^+$ is bonded be linked to $R^{15}$ or $R^{16}$ (preferably $R^{16}$) to form a ring, and $R^{14}$ bonded to the carbon atom to which $A_2$ is bonded be linked to $R^{17}$ or $R^{18}$ (preferably $R^{18}$) to form a ring.

In Formula 1-1, $n_{13}$ is preferably 1, and $R^{16}$ is preferably $-R^a$ (that is, a hydrocarbon group).

Furthermore, it is preferable that $R^{16}$ be linked to $R^{12}$ bonded to the carbon atom to which $A_1^+$ is bonded, so as to form a ring. As the ring to be formed, an indolium ring, a pyrylium ring, a thiopyrylium ring, a benzoxazoline ring, or a benzimidazoline ring is preferable, and an indolium ring is more preferable from the viewpoint of improving visibility of exposed portions. These rings may further have a substituent.

In Formula 1-1, $n_{14}$ is preferably 1, and $R^{18}$ is preferably $-R^a$ (that is, a hydrocarbon group).

Furthermore, it is preferable that $R^{18}$ be linked to $R^{14}$ bonded to the carbon atom to which $A_2$ is bonded, so as to form a ring. As the ring to be formed, an indole ring, a pyran ring, a thiopyran ring, a benzoxazole ring, or a benzimidazole ring is preferable, and an indole ring is more preferable from the viewpoint of improving visibility of exposed portions. These rings may further have a substituent.

It is preferable that $R^{16}$ and $R^{18}$ in Formula 1-1 be the same group. In a case where $R^{16}$ and $R^{18}$ each form a ring, it is preferable that the formed rings have the same structure except for $A_1^+$ and $A_2$.

It is preferable that $R^{15}$ and $R^{17}$ in Formula 1-1 be the same group. Furthermore, $R^{15}$ and $R^{17}$ are preferably $-R^a$ (that is, a hydrocarbon group), more preferably an alkyl group, and even more preferably a substituted alkyl group.

From the viewpoint of improving water solubility, $R^{15}$ and $R^{17}$ in the compound represented by Formula 1-1 are preferably a substituted alkyl group.

Examples of the substituted alkyl group represented by $R^{15}$ or $R^{17}$ include a group represented by any of Formula (a1) to Formula (a4).

$$-W\left(R^{W0}-O\right)_{n_{W1}}R^{W1} \qquad (a1)$$

$-R^{W2}-CO_2M$ (a2)

$-R^{W3}-PO_3M_2$ (a3)

$-R^{W4}-SO_3M$ (a4)

In Formula (a1) to Formula (a4), $R^{W0}$ represents an alkylene group having 2 to 6 carbon atoms, W represents a single bond or an oxygen atom, and $n_{w1}$ represents an integer of 1 to 45, $R^{W1}$ represents an alkyl group having 1 to 12 carbon atoms or $-C(=O)-R^{W5}$, $R^{W5}$ represents an alkyl group having 1 to 12 carbon atoms, $R^{W2}$ to $R^{W4}$ each independently represent a single bond or an alkylene group having 1 to 12 carbon atoms, and M represents a hydrogen atom, a sodium atom, a potassium atom, or an onium group.

Specific examples of the alkylene group represented by $R^{W0}$ in Formula (a1) include an ethylene group, a n-propylene group, an isopropylene group, a n-butylene group, an isobutylene group, a n-pentylene group, an isopentylene group, a n-hexyl group, an isohexyl group, and the like. Among these, an ethylene group, a n-propylene group, an isopropylene group, or a n-butylene group is preferable, and a n-propylene group is particularly preferable.

$n_{w1}$ is preferably 1 to 10, more preferably 1 to 5, and particularly preferably 1 to 3.

Specific examples of the alkyl group represented by $R^{W1}$ include a methyl group, an ethyl group, a n-propyl group, an isopropyl group, a n-butyl group, an isobutyl group, a tert-butyl group, a n-pentyl group, an isopentyl group, a neopentyl group, a n-hexyl group, a n-octyl group, a n-dodecyl group, and the like. Among these, a methyl group, an ethyl group,a n-propyl group, an isopropyl group, a n-butyl group, or a tert-butyl group is preferable, a methyl group or an ethyl group is more preferable, and a methyl group is particularly preferable.

The alkyl group represented by $R^{W5}$ is the same as the alkyl group represented by $R^{W1}$. Preferred aspects of the alkyl group represented by $R^{W5}$ are the same as preferred aspects of the alkyl group represented by $R^{W1}$.

Specific examples of the group represented by Formula (a1) will be shown below. However, the present disclosure is not limited thereto. In the following structural formulas, Me represents a methyl group, Et represents an ethyl group, and * represents a binding site.

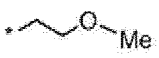
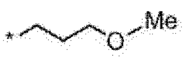
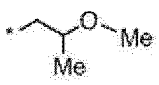
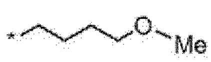
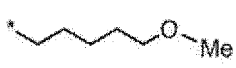

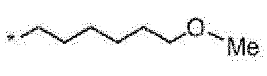
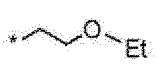
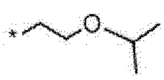
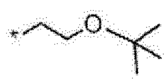

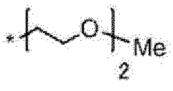
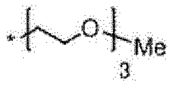
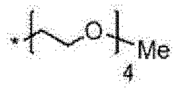
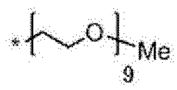
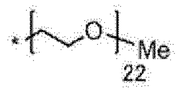

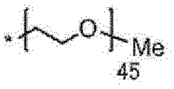 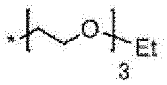 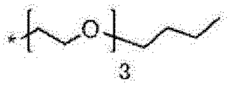 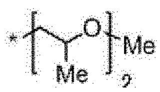 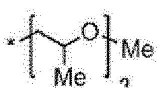

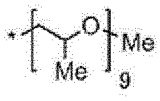 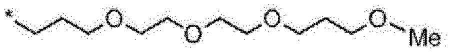

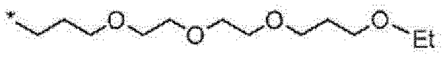 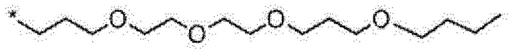

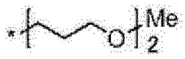 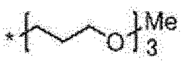 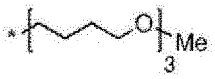

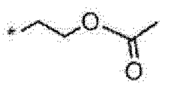 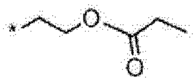 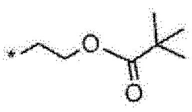 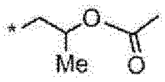 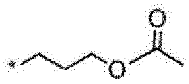

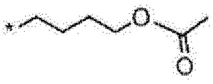 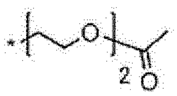 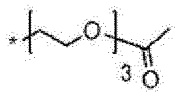 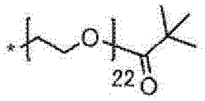

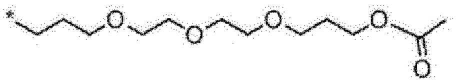

Specific examples of the alkylene group represented by $R^{W2}$ to $R^{W4}$ in Formula (a2) to Formula (a4) include a methylene group, an ethylene group, a n-propylene group, an isopropylene group, a n-butylene group, an isobutylene group, a n-pentylene group, an isopentylene group, a n-hexyl group, an isohexyl group, a n-octylene group, a n-dodecylene group, and the like. Among these, an ethylene group, a n-propylene group, an isopropylene group, or a n-butylene group is preferable, and an ethylene group or a n-propylene group is particularly preferable.

In Formula (a3), two Ms may be the same as or different from each other.

Examples of the onium group represented by M in Formula (a2) to Formula (a4) include an ammonium group, an iodonium group, a phosphonium group, a sulfonium group, and the like.

All of $CO_2M$ in Formula (a2), $PO_3M_2$ in Formula (a2), and $SO_3M$ in Formula (a4) may have an anion structure from which M is dissociated. The countercation of the anion structure may be $A_1^+$ or a cation that can be contained in $R^1$-L in Formula 1-1.

Among the groups represented by Formula (a1) to Formula (a4), the group represented by Formula (a1), Formula (a2), or Formula (a4) is preferable.

$n_{11}$ and $n_{12}$ in Formula 1-1 are preferably the same as each other, and preferably both represent an integer of 1 to 5, more preferably both represent an integer of 1 to 3, even more preferably both represent 1 or 2, and particularly preferably both represent 2.

$A_1$ and $A_2$ in Formula 1-1 each independently represent an oxygen atom, a sulfur atom, or a nitrogen atom. Among these, a nitrogen atom is preferable.

$A_1$ and $A_2$ in Formula 1-1 are preferably the same atoms.

Za in Formula 1-1 represents a counterion that neutralizes charge.

In a case where all of $R^{11}$ to $R^{18}$ and $R^1$-L are groups having a neutral charge, Za is a monovalent counteranion. Here, $R^{11}$ to $R^{18}$ and $R^1$-L may have an anion structure or a cation structure. For example, in a case where two or more among $R^{11}$ to $R^{18}$ and $R^1$-L have an anion structure, Za can also be a countercation.

In a case where the cyanine dye represented by Formula 1-1 has such a structure that the overall charge of the compound is neutral except for Za, Za is unnecessary.

In a case where Za is a counteranion, examples thereof include a sulfonate ion, a carboxylate ion, a tetrafluoroborate ion, a hexafluorophosphate ion, a p-toluenesulfonate ion, a perchlorate ion, and the like. Among these, a tetrafluoroborate ion is preferable.

In a case where Za is a countercation, examples thereof include an alkali metal ion, an alkaline earth metal ion, an ammonium ion, a pyridinium ion, sulfonium ion, and the like. Among these, a sodium ion, a potassium ion, an ammonium ion, a pyridinium ion or a sulfonium ion is preferable, and a sodium ion, a potassium ion, or an ammonium ion is more preferable.

From the viewpoint of improving visibility of exposed portions, the decomposable compound is more preferably a compound represented by Formula 1-2 (that is, a cyanine dye).

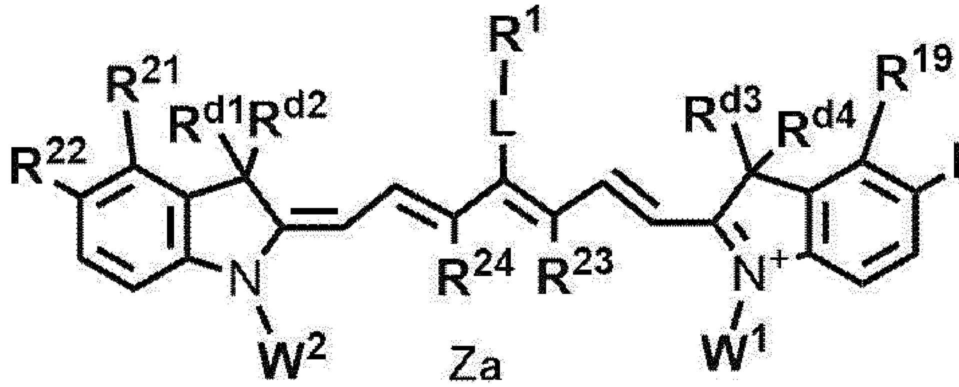

Formula 1-2

In Formula 1-2, $R^1$ represents a group represented by any of Formula 2 to Formula 4, $R^{19}$ to $R^{22}$ each independently represent a hydrogen atom, a halogen atom, $-R^a$, $-OR^b$, -CN, $-SR^c$, or $-NR^dR^e$, $R^{23}$ and $R^{24}$ each independently represent a hydrogen atom or $-R^a$, $R^a$ to $R^e$ each independently represent a hydrocarbon group, $R^{19}$ and $R^{20}$, $R^{21}$ and $R^{22}$, or $R^{23}$ and $R^{24}$ may be linked to each other to form a monocyclic or polycyclic ring, L represents an oxygen atom, a sulfur atom, or $-NR^{10}-$, $R^{10}$ represents a hydrogen atom, an alkyl group, or an aryl group, $R^{d1}$ to $R^{d4}$, $W^1$, and $W^2$ each independently represent an alkyl group which may have a substituent, and Za represents a counterion that neutralizes charge.

$R^1$ in Formula 1-2 has the same definition as $R^1$ in Formula 1-1, and preferred aspects thereof are also the same.

In Formula 1-2, $R^{19}$ to $R^{22}$ preferably each independently represent a hydrogen atom, a halogen atom, $-R^a$, $-OR^b$, or -CN.

More specifically, $R^{19}$ and $R^{21}$ are preferably a hydrogen atom or $-R^a$.

Furthermore, $R^{20}$ and $R^{22}$ are preferably a hydrogen atom, $-R^a$, $-OR^b$, or -CN.

$-R^a$ represented by $R^{19}$ to $R^{22}$ is preferably an alkyl group or an alkenyl group.

In a case where all of $R^{19}$ to $R^{22}$ are $-R^a$, it is preferable that $R^{19}$ and $R^{20}$ and $R^{21}$ and $R^{22}$ be linked to each other to form a monocyclic or polycyclic ring.

Examples of the ring formed of $R^{19}$ and $R^{20}$ or $R^{21}$ and $R^{22}$ linked to each other include a benzene ring, a naphthalene ring, and the like.

$R^{23}$ and $R^{24}$ in Formula 1-2 are preferably linked to each other to form a monocyclic or polycyclic ring.

The ring formed of $R^{23}$ and $R^{24}$ linked to each other may be a monocyclic or polycyclic ring. Specific examples of the ring to be formed include a monocyclic ring such as a cyclopentene ring, a cyclopentadiene ring, a cyclohexene ring, or a cyclohexadiene ring, and a polycyclic ring such as an indene ring.

$R^{d1}$ to $R^{d4}$ in Formula 1-2 are preferably an unsubstituted alkyl group. Furthermore, all of $R^{d1}$ to $R^{d4}$ are preferably the same group.

Examples of the unsubstituted alkyl group include unsubstituted alkyl groups having 1 to 4 carbon atoms. Among these, a methyl group is preferable.

From the viewpoint of improving water solubility of the compound represented by Formula 1-2, $W^1$ and $W^2$ in Formula 1-2 preferably each independently represent a substituted alkyl group.

Examples of the substituted alkyl group represented by $W^1$ and $W^2$ include a group represented by any of Formula (a1) to Formula (a4) in Formula 1-1, and preferred aspects thereof are also the same.

From the viewpoint of on-press developability, $W^1$ and $W^2$ preferably each independently represent an alkyl group having a substituent. The alkyl group preferably has at least $-(OCH_2CH_2)-$, a sulfo group, a salt of a sulfo group, a carboxy group, or a salt of a carboxy group, as the substituent.

Za represents a counterion that neutralizes charge in the molecule.

In a case where all of $R^{19}$ to $R^{22}$, $R^{23}$ and $R^{24}$, $R^{d1}$ to $R^{d4}$, $W^1$, $W^2$, and $R^1$-L are groups having a neutral charge, Za is a monovalent counteranion. Here, $R^{19}$ to $R^{22}$, $R^{23}$ and $R^{24}$, $R^{d1}$ to $R^{d4}$, $W^1$, $W^2$, and $R^1$-L may have an anion

structure or a cation structure. For example, in a case where two among $R^{19}$ to $R^{22}$, $R^{23}$ and $R^{24}$, $R^{d1}$ to $R^{d4}$, $W^1$, $W^2$, and $R^1$-L have an anion structure, Za can be a countercation.

In a case where the compound represented by Formula 1-2 has such a structure that the overall charge of the compound is neutral except for Za, Za is unnecessary.

Examples of the case where Za is a counteranion are the same as such examples of Za in Formula 1-1, and preferred aspects thereof are also the same. Furthermore, examples of the case where Za is a countercation are the same as such examples of Za in Formula 1-1, and preferred aspects thereof are also the same.

From the viewpoint of decomposition properties and color developability, the cyanine dye as a decomposable compound is even more preferably a compound represented by any of Formula 1-3 to Formula 1-7.

Particularly, from the viewpoint of decomposition properties and color developability, the cyanine dye is preferably a compound represented by any of Formula 1-3, Formula 1-5, and Formula 1-6.

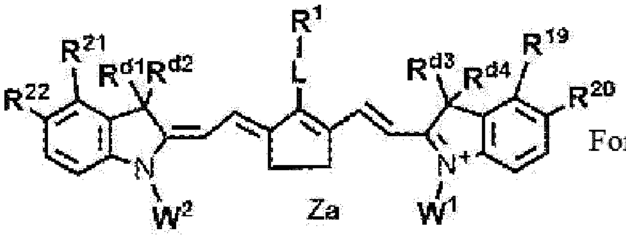
Formula 1-3

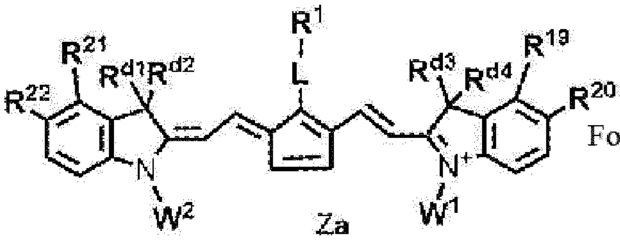
Formula 1-4

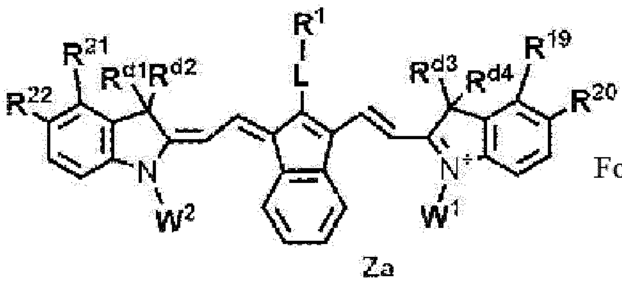
Formula 1-5

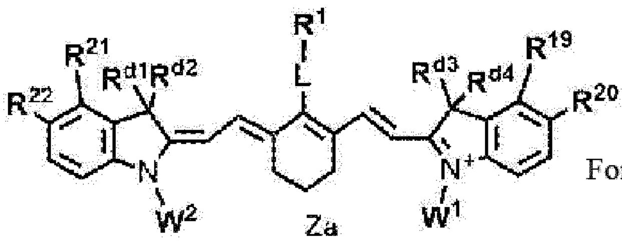
Formula 1-6

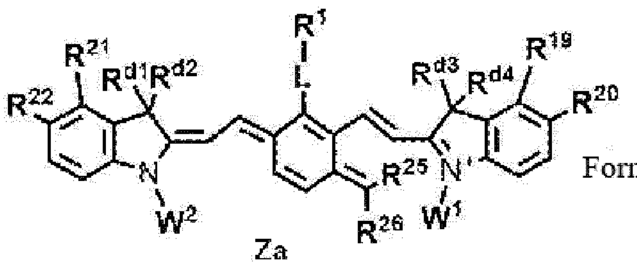
Formula 1-7

In Formula 1-3 to Formula 1-7, $R^1$ represents a group represented by any of Formula 2 to Formula 4, and $R^{19}$ to $R^{22}$ each independently represent a hydrogen atom, a halogen atom, $-R^a$, $-OR^b$, -CN, $-SR^c$, or $-NR^dR^e$, and $R^{25}$ and $R^{26}$ each independently represent a hydrogen atom, a halogen atom, or $-R^a$, and $R^a$ to $R^e$ each independently represent a hydrocarbon group, $R^{19}$ and $R^{20}$, $R^{21}$ and $R^{22}$, or $R^{25}$ and $R^{26}$ may be linked to each other to form a monocyclic or polycyclic ring, L represents an oxygen atom, a sulfur atom, or $-NR^{10}-$, $R^{10}$ represents a hydrogen atom, an alkyl group, or an aryl group, and $R^{d1}$ to $R^{d4}$, $W^1$, and $W^2$ each independently represent an alkyl group which may have a substituent, and Za represents a counterion that neutralizes charge.

$R^1$, $R^{19}$ to $R^{22}$, $R^{d1}$ to $R^{d4}$, $W^1$, $W^2$, and L in Formula 1-3 to Formula 1-7 have the same definitions as $R^1$, $R^{19}$ to $R^{22}$, $R^{d1}$ to $R^{d4}$, $W^1$, $W^2$, and L in Formula 1-2, and preferred aspects thereof are also the same.

$R^{25}$ and $R^{26}$ in Formula 1-7 preferably each independently represent a hydrogen atom or an alkyl group, more preferably each independently represent an alkyl group, and particularly preferably each independently represent a methyl group.

Specific examples of the cyanine dye as a decomposable compound will be shown below. However, the present disclosure is not limited thereto.

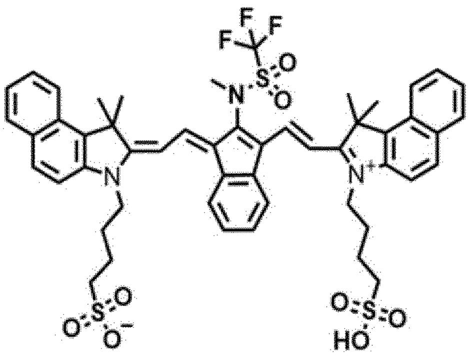

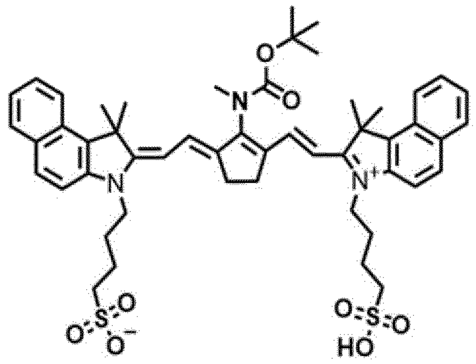

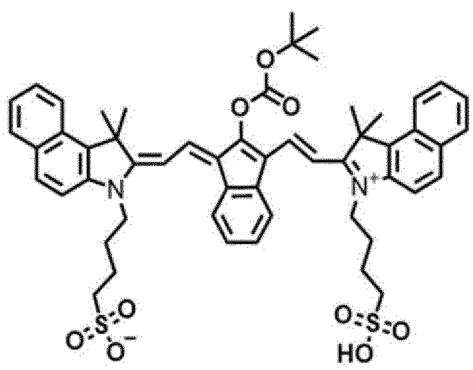

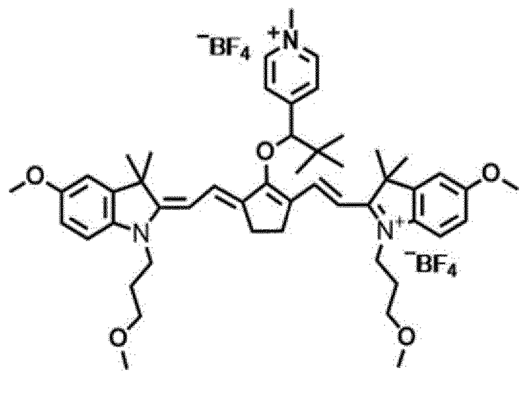

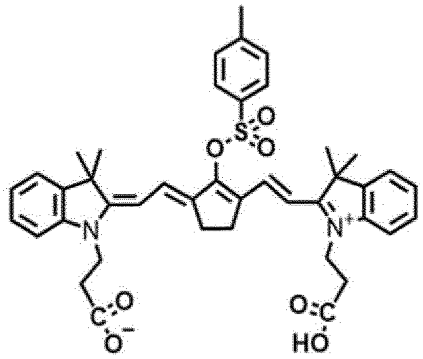

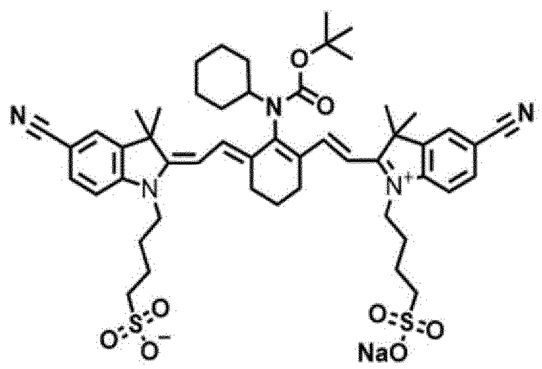

Furthermore, as the cyanine dye which is a decomposable compound, the infrared absorbing compound described in WO2019/219560A can be suitably used.

As the discoloring compound, an acid color-developing agent may also be used.

As the acid color-developing agent, it is possible to use the compounds described as acid color-developing agents in the image-recording layer, and preferred aspects thereof are also the same.

One kind of discoloring compound may be used alone, or two or more kinds of components may be combined and used as the discoloring compound.

As the discoloring compound, the acid color-developing agent described above and an acid generating agent that will be described later may be used in combination.

From the viewpoint of color developability, the content of the discoloring compound in the overcoat layer with respect to the total mass of the overcoat layer is preferably 0.10% by mass to 50% by mass, more preferably 0.50% by mass to 30% by mass, and even more preferably 1.0% by mass to 20% by mass.

From the viewpoint of color developability, $M^X/M^Y$ which is a ratio of a content $M^X$ of the discoloring compound in the overcoat layer to a content $M^Y$ of the infrared absorber in the image-recording layer is preferably 0.1 or more, more preferably 0.2 or more, and particularly preferably 0.3 or more and 3.0 or less.

The overcoat layer may contain known additives such as a plasticizer for imparting flexibility, a surfactant for improving coating properties, and inorganic particles for controlling surface slipperiness. In addition, the oil sensitizing agent described above regarding the image-recording layer may be incorporated into the overcoat layer.

The method for forming the overcoat layer is not particularly limited, and the overcoat layer can be formed by a known method. The coating amount of the overcoat layer (solid content) is preferably 0.01 g/m$^2$ to 10 g/m$^2$, more preferably 0.02 g/m$^2$ to 3 g/m$^2$, and particularly preferably 0.02 g/m$^2$ to 1 g/m$^2$.

The film thickness of the overcoat layer in the lithographic printing plate precursor according to the present disclosure is preferably 0.8 μm to 3 μm, and more preferably 1 μm to 2 μm.

Furthermore, from the viewpoint of UV printing durability and on-press developability, the thickness of the overcoat layer is preferably greater than the thickness of the image-recording layer described above.

-Film thickness ratio-

From the viewpoint of UV printing durability and on-press developability, in the lithographic printing plate precursor according to the present disclosure, a ratio of film thickness of the overcoat layer/film thickness of the image-recording layer is preferably 0.5 to 5, more preferably 1.1 to 4, even more preferably 1.1 to 3, and particularly preferably 1.1 to 2.

The film thickness of each of the overcoat layer and the image-recording layer is determined by staining the lithographic printing plate precursor with osmium, then observing a cross section of the lithographic printing plate precursor with a scanning electron microscope (SEM), and calculating the average of film thickness of each layer at randomly extracted 20 points.

<Aluminum support>

The aluminum support of the lithographic printing plate precursor according to the present disclosure to be used can be appropriately selected from known aluminum supports for a lithographic printing plate precursor. Hereinafter, the aluminum support will be also simply called "support".

As the aluminum support, an aluminum support having a hydrophilic surface (hereinafter, also called "hydrophilic aluminum support") is preferable.

For the aluminum support in the lithographic printing plate precursor according to the present disclosure, from the viewpoint of suppressing scratches and contamination, a water contact angle on a surface of the aluminum support on the image-recording layer side that is determined by an airborne water droplet method is preferably 110° or less, more preferably 90° or less, even more preferably 80° or less, still more preferably 50° or less, particularly preferably 30° or less, more particularly preferably 20° or less, and most preferably 10° or less.

In the present disclosure, the water contact angle on a surface of the aluminum support on the image-recording layer side that is determined by an airborne water droplet method is measured by the following method.

The lithographic printing plate precursor is immersed in a solvent capable of removing the image-recording layer (for example, a solvent used in a coating solution for an image-recording layer), and the image-recording layer is scraped off with at least one of sponge or cotton or dissolved in a solvent, so that the surface of the aluminum support is exposed.

The water contact angle on a surface of the exposed aluminum support on the image-recording layer side is measured using a measurement device, a fully automatic contact angle meter (for example, DM-501 manufactured by Kyowa Interface Science Co., Ltd.), as a water droplet contact angle on the surface at 25°C (after 0.2 seconds).

As the aluminum support in the present disclosure, an aluminum plate is preferable which has been roughened using a known method and has undergone an anodic oxidation treatment. That is, the aluminum support in the present disclosure preferably has an aluminum plate and an aluminum anodic oxide film disposed on the aluminum plate.

[Preferred aspect of support]

One of the examples of preferred aspects of the aluminum support used in the present disclosure (the aluminum support according to this example is also called "support (1)") is as below.
That is, the support (1) has an aluminum plate and an anodic oxide film of aluminum disposed on the aluminum plate, the anodic oxide film is at a position closer to a side of the image-recording layer than the aluminum plate and has micropores extending in a depth direction from the surface of the anodic oxide film on the side of the image-recording layer, the average diameter of the micropores within the surface of the anodic oxide film is more than 10 nm and 100 nm or less, and a value of brightness L* of the surface of the anodic oxide film on the side of the image-recording layer is 70 to 100 in the L*a*b* color space.
Fig. 1 is a schematic cross-sectional view of an embodiment of an aluminum support 12a.
The aluminum support 12a has a laminated structure in which an aluminum plate 18 and an anodic oxide film 20a of aluminum (hereinafter, also simply called "anodic oxide film 20a") are laminated in this order. The anodic oxide film 20a in the aluminum support 12a is positioned so that the anodic oxide film 20a is closer to the image-recording layer side than the aluminum plate 18. That is, it is preferable that the lithographic printing plate precursor according to the present disclosure have at least an anodic oxide film, an image-recording layer, and an overcoat layer (that is, a water-soluble resin layer) in this order on an aluminum plate.

-Anodic oxide film-

Hereinafter, preferred aspects of the anodic oxide film 20a will be described.
The anodic oxide film 20a is a film prepared on a surface of the aluminum plate 18 by an anodic oxidation treatment. This film has uniformly distributed ultrafine micropores 22a approximately perpendicular to the surface of the film. The micropores 22a extend from a surface of the anodic oxide film 20a on the image-recording layer side (a surface of the anodic oxide film 20a opposite to the aluminum plate 18) along the thickness direction (toward the aluminum plate 18).
Within the surface of the anodic oxide film, the average diameter (average opening diameter) of the micropores 22a in the anodic oxide film 20a is preferably more than 10 nm and 100 nm or less. Particularly, from the viewpoint of balance between printing durability, antifouling properties, and image visibility, the average diameter of the micropores 22a is more preferably 15 nm to 60 nm, even more preferably 20 nm to 50 nm, and particularly preferably 25 to 40 nm. The internal diameter of the pores may be larger or smaller than the pore diameter within the surface layer.
In a case where the average diameter is more than 10 nm, printing durability and image visibility are further improved. Furthermore, in a case where the average diameter is 100 nm or less, printing durability is further improved.
The average diameter of the micropores 22a is determined by observing the surface of the anodic oxide film 20a with a field emission scanning electron microscope (FE-SEM) at 150,000X magnification (N = 4), measuring the size (diameter) of 50 micropores existing in a range of 400 $\times$ 600 $nm^2$ in the obtained 4 images, and calculating the arithmetic mean thereof.
In a case where the shape of the micropores 22a is not circular, the equivalent circular diameter is used. "Equivalent circular diameter" is a diameter determined on an assumption that the opening portion is in the form of a circle having the same projected area as the projected area of the opening portion.
The depth of the micropores 22a is not particularly limited, but is preferably 10 nm to 3,000 nm, more preferably 50 nm to 2,000 nm, and even more preferably 300 nm to 1,600 nm.
The depth is a value obtained by taking a photograph (150,000X magnification) of a cross section of the anodic oxide film 20a, measuring the depths of 25 or more micropores 22a, and calculating the average thereof.
The shape of the micropores 22a is not particularly limited. In Fig. 2, the micropores 22a have a substantially straight tubular shape (substantially cylindrical shape). However, the micropores 22a may have a conical shape that tapers along the depth direction (thickness direction). The shape of the bottom portion of the micropores 22a is not particularly limited, and may be a curved (convex) or flat surface shape.
In the L*a*b* color space, the value of brightness L* of the surface of the aluminum support 12a on the image-recording layer side (surface of the anodic oxide film 20a on the image-recording layer side) is preferably 70 to 100. Especially, the value of brightness L* is preferably 75 to 100 and more preferably 75 to 90, because printing durability and image visibility are better balanced in this range.
The brightness L* is measured using a color difference meter Spectro Eye manufactured by X-Rite, Incorporated.
For example, an aspect is also preferable in which the micropores in the support (1) are each constituted with

a large diameter portion that extends to a position at a depth of 10 nm to 1,000 nm from the surface of the anodic oxide film and a small diameter portion that is in communication with the bottom portion of the large diameter portion and extends to a position at a depth of 20 nm to 2,000 nm from a communication position, an average diameter of the large diameter portion within the surface of the anodic oxide film is 15 nm to 150 nm, and an average diameter of the small diameter portion at a communication position is 13 nm or less (hereinafter, the support according to this aspect will be also called "support (2)").

Fig. 2 is a schematic cross-sectional view of an embodiment of the aluminum support 12a that is different from what is shown in Fig. 1. A support B is an aspect of the aluminum support 12a shown in Fig. 2.

In Fig. 2, an aluminum support 12b includes an aluminum plate 18 and an anodic oxide film 20b having micropores 22b each composed of a large diameter portion 24 and a small diameter portion 26.

The micropores 22b in the anodic oxide film 20b are each composed of the large diameter portion 24 that extends to a position at a depth of 10 nm to 1,000 nm (depth D: see Fig. 2) from the surface of the anodic oxide film and the small diameter portion 26 that is in communication with the bottom portion of the large diameter portion 24 and further extends from the communication position to a position at a depth of 20 nm to 2,000 nm.

Hereinafter, the large diameter portion 24 and the small diameter portion 26 will be specifically described.

The average diameter of the large diameter portion 24 within the surface of the anodic oxide film 20b is the same as the average diameter of the micropores 22a in the aforementioned anodic oxide film 20a within the surface of the anodic oxide film, which is more than 10 nm and 100 nm or less. The suitable range thereof is also the same.

The method for measuring the average diameter of the large diameter portion 24 within the surface of the anodic oxide film 20b is the same as the method for measuring the average diameter of the micropores 22a in the anodic oxide film 20a within the surface of the anodic oxide film.

The bottom portion of the large diameter portion 24 is in a position at a depth of 10 nm to 1,000 nm (hereinafter, also called depth D) from the surface of the anodic oxide film. That is, the large diameter portion 24 is a pore portion extending to a position at a depth of 10 nm to 1,000 nm from the surface of the anodic oxide film in the depth direction (thickness direction). The depth is preferably 10 nm to 200 nm.

The depth is a value obtained by taking a photograph (150,000X magnification) of a cross section of the anodic oxide film 20b, measuring the depths of 25 or more large diameter portions 24, and calculating the average thereof.

The shape of the large diameter portion 24 is not particularly limited. Examples of the shape of the large diameter portion 24 include a substantially straight tubular shape (substantially cylindrical shape) and a conical shape that tapers along the depth direction (thickness direction). Among these, a substantially straight tubular shape is preferable.

As shown in Fig. 2, the small diameter portion 26 is a pore portion that is in communication with the bottom portion of the large diameter portion 24 and further extends from the communication position in the depth direction (thickness direction).

The average diameter of the small diameter portion 26 at the communication position is preferably 13 nm or less. Particularly, the average diameter is preferably 11 nm or less, and more preferably 10 nm or less. The lower limit thereof is not particularly limited, but is 5 nm or more in many cases.

The average diameter of the small diameter portion 26 is obtained by observing the surface of the anodic oxide film 20a with FE-SEM at 150,000X magnification (N = 4), measuring the size (diameter) of the micropores (small diameter portion) existing in a range of 400 nm $\times$ 600 nm in the obtained 4 images, and calculating the arithmetic mean thereof. In a case where the large diameter portion is deep, if necessary, the upper portion of the anodic oxide film 20b (region where the large diameter portion is located) may be cut (for example, by using argon gas), then the surface of the anodic oxide film 20b may be observed with FE-SEM described above, and the average diameter of the small diameter portion may be determined.

In a case where the shape of the small diameter portion 26 is not circular, the equivalent circular diameter is used. "Equivalent circular diameter" is a diameter determined on an assumption that the opening portion is in the form of a circle having the same projected area as the projected area of the opening portion.

The bottom portion of the small diameter portion 26 is in a position 20 nm to 2,000 nm distant from the communication position with the large diameter portion 24 in the depth direction. In other words, the small diameter portion 26 is a pore portion that extends further from the communication position with the large diameter portion 24 in the depth direction (thickness direction), and the depth of the small diameter portion 26 is 20 nm to 2,000 nm. The depth is preferably 500 nm to 1,500 nm.

The depth is a value determined by taking a photograph (50,000X magnification) of a cross section of the anodic oxide film 20b, measuring the depths of 25 or more small diameter portions, and calculating the average thereof.

The shape of the small diameter portion 26 is not particularly limited. Examples of the shape of the small diameter portion 26 include a substantially straight tubular shape (substantially cylindrical shape) and a conical shape that tapers along the depth direction. Among these, a substantially straight tubular shape is preferable.

[Method for manufacturing aluminum support]

As a method for manufacturing the aluminum support in the present disclosure, for example, a manufacturing method is preferable in which the following steps are sequentially performed.

- Roughening treatment step: step of performing roughening treatment on aluminum plate
- Anodic oxidation treatment step: step of subjecting aluminum plate having undergone roughening treatment to anodic oxidation
- Pore widening treatment step: step of bringing aluminum plate having anodic oxide film obtained by anodic oxidation treatment step into contact with aqueous acid solution or aqueous alkali solution so that diameter of micropores in anodic oxide film increases

Hereinafter, the procedure of each step will be specifically described.

(Roughening treatment step)

The roughening treatment step is a step of performing a roughening treatment including an electrochemical roughening treatment on the surface of the aluminum plate. This step is preferably performed before the anodic oxidation treatment step which will be described later. However, in a case where the surface of the aluminum plate already has a preferable shape, the roughening treatment step may not be performed.
As the roughening treatment, only an electrochemical roughening treatment may be performed, or an electrochemical roughening treatment and mechanical roughening treatment and/or a chemical roughening treatment may be performed in combination.
In a case where the mechanical roughening treatment and the electrochemical roughening treatment are combined, it is preferable to perform the electrochemical roughening treatment after the mechanical roughening treatment.
It is preferable to perform the electrochemical roughening treatment by using direct current or alternating current in an aqueous solution containing nitric acid or hydrochloric acid as a main component.
The method of the mechanical roughening treatment is not particularly limited. Examples thereof include the method described in JP1975-40047B (JP-S50-40047B).
Furthermore, the chemical roughening treatment is not particularly limited, and examples thereof include known methods.
After the mechanical roughening treatment, it is preferable to perform the following chemical etching treatment.
By the chemical etching treatment performed after the mechanical roughening treatment, the edge portion of surface irregularities of the aluminum plate smoothed, so that ink clotting that may occur during printing is prevented, the antifouling properties of the printing plate are improved, and unnecessary substances such as abrasive particles remaining on the surface are removed.
Examples of the chemical etching treatment include etching with an acid and etching with an alkali. One of the examples of particularly efficient etching methods is a chemical etching treatment using an aqueous alkali solution (hereinafter, also called "alkaline etching treatment").
The alkaline agent used in the aqueous alkali solution is not particularly limited. Examples thereof include caustic soda, caustic potash, sodium metasilicate, sodium carbonate, sodium aluminate, and sodium gluconate.
The aqueous alkali solution may contain aluminum ions.
The concentration of the alkaline agent in the aqueous alkali solution is preferably 0.01% by mass or more, and more preferably 3% by mass or more. Furthermore, the concentration of the alkaline agent is preferably 30% by mass or less.
In a case where the alkaline etching treatment is performed, in order to remove products generated by the alkaline etching treatment, it is preferable to perform the chemical etching treatment by using a low-temperature aqueous acidic solution (hereinafter, also called "desmutting treatment").
The acid used in the aqueous acidic solution is not particularly limited, and examples thereof include sulfuric acid, nitric acid, and hydrochloric acid. The temperature of the aqueous acidic solution is preferably 20°C to 80°C.
As the roughening treatment step, a method is preferable in which the treatments described in an aspect A or an aspect B are performed in the following order.

-Aspect A-

(2) Chemical etching treatment using aqueous alkali solution (first alkaline etching treatment)

(3) Chemical etching treatment using aqueous acidic solution (first desmutting treatment)
(4) Electrochemical roughening treatment using aqueous solution containing nitric acid as main component (first electrochemical roughening treatment)
(5) Chemical etching treatment using aqueous alkali solution (second alkaline etching treatment)
(6) Chemical etching treatment using aqueous acidic solution (second desmutting treatment)
(7) Electrochemical roughening treatment in aqueous solution containing hydrochloric acid as main component (second electrochemical roughening treatment)
(8) Chemical etching treatment using aqueous alkali solution (third alkaline etching treatment)
(9) Chemical etching treatment using aqueous acidic solution (third desmutting treatment)

-Aspect B-

(10) Chemical etching treatment using aqueous alkali solution (fourth alkaline etching treatment)
(11) Chemical etching treatment using aqueous acidic solution (fourth desmutting treatment)
(12) Electrochemical roughening treatment using aqueous solution containing hydrochloric acid as main component (third electrochemical roughening treatment)
(13) Chemical etching treatment using aqueous alkali solution (fifth alkaline etching treatment)
(14) Chemical etching treatment using aqueous acidic solution (fifth desmutting treatment)

If necessary, (1) mechanical roughening treatment may be performed before the treatment (2) of the aspect A or before the treatment (10) of the aspect B.

The amount of the aluminum plate dissolved by the first alkaline etching treatment and the fourth alkaline etching treatment is preferably 0.5 $g/m^2$ to 30 $g/m^2$, and more preferably 1.0 $g/m^2$ to 20 $g/m^2$.

Examples of the aqueous solution containing nitric acid as a main component used in the first electrochemical roughening treatment of the aspect A include aqueous solutions used in an electrochemical roughening treatment using direct current or alternating current. Examples thereof include an aqueous solution obtained by adding aluminum nitrate, sodium nitrate, ammonium nitrate, or the like to a 1 to 100 g/L aqueous nitric acid solution.

Examples of the aqueous solution containing hydrochloric acid as a main component used in the second electrochemical roughening treatment of the aspect A and in the third electrochemical roughening treatment of the aspect B include aqueous solutions used in the general electrochemical roughening treatment using direct current or alternating current. Examples thereof include an aqueous solution obtained by adding 0 g/L to 30 g/L of sulfuric acid to a 1 g/L to 100 g/L aqueous hydrochloric acid solution. Nitrate ions such as aluminum nitrate, sodium nitrate, and ammonium nitrate; hydrochloric acid ions such as aluminum chloride, sodium chloride, and ammonium chloride may be further added to this solution.

As the waveform of an alternating current power source for the electrochemical roughening treatment, a sine wave, a square wave, a trapezoidal wave, a triangular wave, and the like can be used. The frequency is preferably 0.1 Hz to 250 Hz.

Fig. 3 is is an example of a waveform graph of alternating current used for an electrochemical roughening treatment.

In Fig. 3, ta represents an anodic reaction time, tc represents a cathodic reaction time, tp represents the time taken for current to reach a peak from 0, Ia represents the peak current on the anodic cycle side, Ic represents the peak current on the cathodic cycle side, AA represents current for an anodic reaction of an aluminum plate, and CA represents current for a cathodic reaction of an aluminum plate. For a trapezoidal wave, the time tp taken for current to reach a peak from 0 is preferably 1 ms to 10 ms. Regarding the conditions of one cycle of alternating current used for the electrochemical roughening, a ratio tc/ta of the cathodic reaction time tc to the anodic reaction time ta of the aluminum plate is preferably within a range of 1 to 20, a ratio Qc/Qa of an electricity quantity Qc during the cathodic reaction to an electricity quantity Qa during the anodic reaction of the aluminum plate is preferably within a range of 0.3 to 20, and the anodic reaction time ta is preferably within a range of 5 ms to 1,000 ms. The peak current density of the trapezoidal wave is preferably 10 $A/dm^2$ to 200 $A/dm^2$ at both the anodic cycle side Ia and the cathodic cycle side Ic of the current. Ic/Ia is preferably 0.3 to 20. At a point time when the electrochemical roughening has ended, the total quantity of electricity that participates in the anodic reaction of the aluminum plate is preferably 25 $C/dm^2$ to 1,000 $C/dm^2$.

The electrochemical roughening using alternating current can be performed using the device shown in Fig. 4.

Fig. 4 is a lateral view showing an example of a radial cell in an electrochemical roughening treatment using alternating current.

In Fig. 4, 50 represents a main electrolytic cell, 51 represents an alternating current power source, 52 represents a radial drum roller, 53a and 53b represent main poles, 54 represents an electrolytic solution supply port, 55 represents

an electrolytic solution, 56 represents a slit, 57 represents an electrolytic solution path, 58 represents an auxiliary anode, 60 represents an auxiliary anode tank, and W represents an aluminum plate. In Fig. 4, the arrow A1 represents a supply direction of an electrolytic solution, and the arrow A2 represents a discharge direction of the electrolytic solution. In a case where two or more electrolytic cells are used, the electrolysis conditions may be the same as or different from each other.

The aluminum plate W is wound around the radial drum roller 52 immersed and disposed in the main electrolytic cell 50. While being transported, the aluminum plate W is electrolyzed by the main poles 53a and 53b connected to the alternating current power source 51. From the electrolytic solution supply port 54, the electrolytic solution 55 is supplied to the electrolytic solution path 57 between the radial drum roller 52 and the main poles 53a and 53b through the slit 56. The aluminum plate W treated in the main electrolytic cell 50 is then electrolyzed in the auxiliary anode tank 60. In the auxiliary anode tank 60, the auxiliary anode 58 is disposed to face the aluminum plate W. The electrolytic solution 55 is supplied to flow in the space between the auxiliary anode 58 and the aluminum plate W.

In view of easily manufacturing a predetermined printing plate precursor, the amount of the aluminum plate dissolved by the second alkaline etching treatment is preferably 1.0 $g/m^2$ or more, and more preferably 2.0 $g/m^2$ to 10 $g/m^2$.

In view of easily manufacturing a predetermined printing plate precursor, the amount of the aluminum plate dissolved by the third alkaline etching treatment and the fourth alkaline etching treatment is preferably 0.01 $g/m^2$ to 0.8 $g/m^2$, and more preferably 0.05 $g/m^2$ to 0.3 $g/m^2$.

In the chemical etching treatment (first to fifth desmutting treatments) using an aqueous acidic solution, an aqueous acidic solution containing phosphoric acid, nitric acid, sulfuric acid, chromic acid, hydrochloric acid, or a mixed acid consisting of two or more of these acids is suitably used.

The concentration of the acid in the aqueous acidic solution is preferably 0.5% by mass to 60% by mass.

(Anodic oxidation treatment step)

The procedure of the anodic oxidation treatment step is not particularly limited as long as the aforementioned micropores can be obtained. Examples thereof include known methods.

In the anodic oxidation treatment step, an aqueous solution of sulfuric acid, phosphoric acid, oxalic acid, or the like can be used as an electrolytic cell. For example, the concentration of sulfuric acid is 100 g/L to 300 g/L.

The conditions of the anodic oxidation treatment are appropriately set depending on the electrolytic solution used. For example, the liquid temperature is 5°C to 70°C (preferably 10°C to 60°C), the current density is 0.5 $A/dm^2$ to 60 $A/dm^2$ (preferably 5 $A/dm^2$ to 60 $A/dm^2$), the voltage is 1 V to 100 V (preferably 5 V to 50 V), the electrolysis time is 1 second to 100 seconds (preferably 5 seconds to 60 seconds), and the film amount is 0.1 $g/m^2$ to 5 $g/m^2$ (preferably 0.2 $g/m^2$ to 3 $g/m^2$).

(Pore widening treatment)

The pore widening treatment is a treatment of enlarging the diameter of micropores (pore diameter) present in the anodic oxide film formed by the aforementioned anodic oxidation treatment step (pore diameter enlarging treatment).

The pore widening treatment can be carried out by bringing the aluminum plate obtained by the anodic oxidation treatment step into contact with an aqueous acid solution or an aqueous alkali solution. The contact method is not particularly limited, and examples thereof include a dipping method and a spraying method.

<Undercoat layer>

The lithographic printing plate precursor according to the present disclosure preferably has an undercoat layer (called interlayer in some cases) between the image-recording layer and the support. The undercoat layer enhances the adhesiveness between the support and the image-recording layer in an exposed portion, and enables the image-recording layer to be easily peeled from the support in a non-exposed portion. Therefore, the undercoat layer contributes to the improvement of developability without deteriorating printing durability. Furthermore, in the case of exposure to infrared laser, the undercoat layer functions as a heat insulating layer and thus brings about an effect of preventing sensitivity reduction resulting from the diffusion of heat generated by exposure to the support.

Examples of compounds that are used in the undercoat layer include polymers having adsorbent groups that can be adsorbed onto the surface of the support and hydrophilic groups. In order to improve adhesiveness to the image-recording layer, polymers having adsorbent groups and hydrophilic groups plus crosslinking groups are preferable. The compounds that are used in the undercoat layer may be low-molecular-weight compounds or polymers. If necessary, as the compounds that are used in the undercoat layer, two or more kinds of compounds may be used as a mixture.

In a case where the compounds that are used in the undercoat layer are polymers, copolymers of monomers having adsorbent groups, monomers having hydrophilic groups, and monomers having crosslinking groups are preferable.

As the adsorbent groups that can be adsorbed onto the surface of the support, a phenolic hydroxyl group, a carboxy group, $-PO_3H_2$, $-OPO_3H_2$, $-CONHSO_2-$, $-SO_2NHSO_2-$, and $-COCH_2COCH_3$ are preferable. As the hydrophilic groups, a sulfo group or salts thereof and salts of a carboxy group are preferable. As the crosslinking groups, an acryloyl group, a methacryloyl group, an acrylamide group, a methacrylamide group, an allyl group, and the like are preferable.

The polymer may have a crosslinking group introduced by the formation of a salt of a polar substituent of the polymer and a compound that has a substituent having charge opposite to that of the polar substituent and an ethylenically unsaturated bond, or may be further copolymerized with monomers other than the monomers described above and preferably with hydrophilic monomers.

Specifically, for example, silane coupling agents having addition polymerizable ethylenic double bond reactive groups described in JP1998-282679A (JP-H10-282679A) and phosphorus compounds having ethylenic double bond reactive groups described in JP1990-304441A (JP-H02-304441A) are suitable. The low-molecular-weight compounds or polymer compounds having crosslinking groups (preferably ethylenically unsaturated bonding groups), functional groups that interact with the surface of the support, and hydrophilic groups described in JP2005-238816A, JP2005-125749A, JP2006-239867A, and JP2006-215263A are also preferably used.

For example, the high-molecular-weight polymers having adsorbent groups that can be adsorbed onto the surface of the support, hydrophilic groups, and crosslinking groups described in JP2005-125749A and JP2006-188038A are more preferable.

The content of ethylenically unsaturated bonding group in the polymer used in the undercoat layer is preferably 0.1 mmol to 10.0 mmol per gram of the polymer, and more preferably 0.2 mmol to 5.5 mmol per gram of the polymer.

The weight-average molecular weight (Mw) of the polymer used in the undercoat layer is preferably 5,000 or more, and more preferably 10,000 to 300,000.

«Hydrophilic compound»

From the viewpoint of developability, it is preferable that the undercoat layer contain a hydrophilic compound.

The hydrophilic compound is not particularly limited, and known hydrophilic compounds used for the undercoat layer can be used.

Preferable examples of hydrophilic compounds include phosphonic acids having an amino group such as carboxymethyl cellulose and dextrin, an organic phosphonic acid, an organic phosphoric acid, an organic phosphinic acid, an amino acid, a hydrochloride of amine having a hydroxyl group, and the like.

In addition, examples of preferable hydrophilic compounds include a compound having an amino group or a functional group capable of inhibiting polymerization and a group that interacts with the surface of the support (for example, 1,4-diazabicyclo[2.2.2]octane (DABCO), 2,3,5,6-tetrahydroxy-p-quinone, chloranil, sulfophthalic acid, ethylenediaminetetraacetic acid (EDTA) or a salt thereof, hydroxyethyl ethylenediaminetriacetic acid or a salt thereof, dihydroxyethyl ethylenediaminediacetic acid or a salt thereof, hydroxyethyl iminodiacetic acid or a salt thereof, and the like).

From the viewpoint of suppressing scratches and contamination, it is preferable that the hydrophilic compound include hydroxycarboxylic acid or a salt thereof.

Furthermore, from the viewpoint of suppressing scratches and contamination, it is preferable that the hydrophilic compound (preferably hydroxycarboxylic acid or a salt thereof) be contained not only in the undercoat layer but also in a layer on the aluminum support. In addition, the layer on the aluminum support is preferably a layer on the side where the image-recording layer is formed or a layer in contact with the aluminum support.

Preferable examples of the layer on the aluminum support include a layer in contact with the aluminum support, such as the undercoat layer or the image-recording layer. Furthermore, a layer other than the layer in contact with the aluminum support, for example, the protective layer or the image-recording layer may contain a hydrophilic compound (preferably hydroxycarboxylic acid or a salt thereof).

In the lithographic printing plate precursor according to the present disclosure, from the viewpoint of suppressing scratches and contamination, it is preferable that the image-recording layer contain hydroxycarboxylic acid or a salt thereof.

Moreover, regarding the lithographic printing plate precursor according to the present disclosure, for example, an aspect is also preferable in which the surface of the aluminum support on the image-recording layer side is treated with a composition (for example, an aqueous solution or the like) containing at least hydroxycarboxylic acid or a salt thereof. In a case where the above aspect is adopted, at least some of the hydroxycarboxylic acid or a salt thereof used for treatment can be detected in a state of being contained in the layer on the image-recording layer side (for example, the image-recording layer or the undercoat layer) that is in contact with the aluminum support.

In a case where the layer on the image-recording layer side that is in contact with the aluminum support, such as the undercoat layer, contains hydroxycarboxylic acid or a salt thereof, the surface of the aluminum support on the image-recording layer side can be hydrophilized, and it is easy for the surface of the aluminum support on the image-recording layer side to have a water contact angle of 110° or less measured by an airborne water droplet method. Therefore, scratches and contamination are excellently suppressed.

"Hydroxycarboxylic acid" is the generic term for organic compounds having one or more carboxy groups and one or more hydroxyl groups in one molecule. These compounds are also called hydroxy acid, oxy acid, oxycarboxylic acid, or alcoholic acid (see Iwanami Dictionary of Physics and Chemistry, 5th Edition, published by Iwanami Shoten, Publishers. (1998)).

The hydroxycarboxylic acid or a salt thereof is preferably represented by Formula (HC).

$$R^{HC}(OH)_{mhc}(COOM^{HC})_{nhc} \qquad \text{Formula (HC)}$$

In Formula (HC), $R^{HC}$ represents an (mhc + nhc)-valent organic group, $M^{HC}$ each independently represents a hydrogen atom, an alkali metal, or an onium, and mhc and nhc each independently represent an integer of 1 or more. In a case where n is 2 or more, Ms may be the same or different from each other.

Examples of the (mhc + nhc)-valent organic group represented by $R^{HC}$ in Formula (HC) include an (mhc + nhc)-valent hydrocarbon group and the like. The hydrocarbon group may have a substituent and/or a linking group.

Examples of the hydrocarbon group include an (mhc + nhc)-valent group derived from aliphatic hydrocarbon, such as an alkylene group, an alkanetriyl group, an alkanetetrayl group, an alkanepentayl group, an alkenylene group, an alkenetriyl group, an alkenetetrayl group, and alkenepentayl group, an alkynylene group, an alkynetriyl group, alkynetetrayl group, or an alkynepentayl group, an (mhc + nhc)-valent group derived from aromatic hydrocarbon, such as an arylene group, an arenetriyl group, an arenetetrayl group, or an arenepentayl group, and the like. Examples of the substituent other than a hydroxyl group and a carboxy group include an alkyl group, an alkenyl group, an alkynyl group, an aralkyl group, an aryl group, and the like. Specific examples of the substituent include a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, eicosyl group, isopropyl group, isobutyl group, s-butyl group, t-butyl group, isopentyl group, a neopentyl group, a 1-methylbutyl group, an isohexyl group, a 2-ethylhexyl group, a 2-methylhexyl group, a cyclohexyl group, a cyclopentyl group, a 2-norbornyl group, a methoxymethyl group, a methoxyethoxyethyl group, an allyloxymethyl group, a phenoxymethyl group, an acetyloxymethyl group, a benzoyloxymethyl group, a benzyl group, a phenethyl group, an $\alpha$-methylbenzyl group, a 1-methyl-1-phenylethyl group, a p-methylbenzyl group, a cinnamyl group, an allyl group, a 1-propenylmethyl group, a 2-butenyl group, a 2-methylallyl group, a 2-methylpropenylmethyl group, a 2-propynyl group, a 2-butynyl group, a 3-butynyl group, a phenyl group, a biphenyl group, a naphthyl group, a tolyl group, a xylyl group, a mesityl group, a cumenyl group, a methoxyphenyl group, an ethoxyphenyl group, a phenoxyphenyl group, an acetoxyphenyl group, a benzoyloxyphenyl group, a methoxycarbonylphenyl group, an ethoxycarbonylphenyl group, a phenoxycarbonylphenyl group, and the like. Furthermore, the linking group is composed of at least one atom selected from the group consisting of a hydrogen atom, a carbon atom, an oxygen atom, a nitrogen atom, a sulfur atom, and a halogen atom, and the number of atoms is preferably 1 to 50. Specific examples thereof include an alkylene group, a substituted alkylene group, an arylene group, a substituted arylene group, and the like. The linking group may have a structure in which a plurality of these divalent groups are linked through any of an amide bond, an ether bond, a urethane bond, a urea bond, and an ester bond.

Examples of the alkali metal represented by $M^{HC}$ include lithium, sodium, potassium, and the like. Among these, sodium is particularly preferable. Examples of the onium include ammonium, phosphonium, sulfonium, and the like. Among these, ammonium is particularly preferable.

From the viewpoint of suppressing scratches and contamination, $M^{HC}$ is preferably an alkali metal or an onium, and more preferably an alkali metal.

The total number of mhc and nhc is preferably 3 or more, more preferably 3 to 8, and even more preferably 4 to 6.

The molecular weight of the hydroxycarboxylic acid or a salt thereof is preferably 600 or less, more preferably 500 or less, and particularly preferably 300 or less. The molecular weight is preferably 76 or more.

Specifically, examples of the hydroxycarboxylic acid constituting the hydroxycarboxylic acid or a salt of the hydroxycarboxylic acid include gluconic acid, glycolic acid, lactic acid, tartronic acid, hydroxybutyrate (such as 2-hydroxybutyrate, 3-hydroxybutyrate, or $\gamma$-hydroxybutyrate), malic acid, tartaric acid, citramalic acid, citric acid, isocitric acid, leucine acid, mevalonic acid, pantoic acid, ricinoleic acid, ricineraidic acid, cerebronic acid, quinic acid, shikimic acid, a monohydroxybenzoic acid derivative (such as salicylic acid, creosotic acid (homosalicylic acid, hydroxy(methyl) benzoate), vanillic acid, or syringic acid), a dihydroxybenzoic acid derivative (such as pyrocatechuic acid, resorcylic acid, protocatechuic acid, gentisic acid, or orsellinic acid), a trihydroxybenzoic acid derivative (such as gallic acid), a phenyl acetate derivative (such as mandelic acid, benzilic acid, or atrolactic acid), a hydrocinnamic acid derivative (such as melilotic acid, phloretic acid, coumaric acid, umbellic acid, caffeic acid, ferulic acid, sinapic acid, cerebronic acid, or carminic acid), and the like.

Among these, as the aforementioned hydroxycarboxylic acid or a hydroxycarboxylic acid constituting a salt of the hydroxycarboxylic acid, from the viewpoint of suppressing scratches and contamination, a compound having 2 or

more hydroxyl groups is preferable, a compound having 3 or more hydroxyl groups is more preferable, a compound having 5 or more hydroxyl groups is even more preferable, and a compound having 5 to 8 hydroxyl groups is particularly preferable.

Furthermore, as a hydroxycarboxylic acid having one carboxy group and two or more hydroxyl groups, gluconic acid or shikimic acid is preferable.

As hydroxycarboxylic acid having two or more carboxy groups and one hydroxyl group, citric acid or malic acid is preferable.

As hydroxycarboxylic acid having two or more carboxy groups and two or more hydroxyl groups, tartaric acid is preferable.

Among these, gluconic acid is particularly preferable as the aforementioned hydroxycarboxylic acid.

One kind of hydrophilic compound may be used alone, or two or more kinds of hydrophilic compounds may be used in combination.

In a case where the undercoat layer contains a hydrophilic compound which is preferably hydroxycarboxylic acid or a salt thereof, the content of the hydrophilic compound, preferably the content of hydroxycarboxylic acid and a salt thereof, with respect to the total mass of the undercoat layer is preferably 0.01% by mass to 50% by mass, more preferably 0.01% by mass to 30% by mass, even more preferably 0.1% by mass to 40% by mass, and particularly preferably 1.0% by mass to 30% by mass.

In order to prevent contamination over time, the undercoat layer may contain a chelating agent, a secondary or tertiary amine, a polymerization inhibitor, and the like, in addition to the following compounds for the undercoat layer described above.

The undercoat layer is formed by known coating methods. The coating amount (solid content) of the undercoat layer is preferably 0.1 $mg/m^2$ to 100 $mg/m^2$, and more preferably 1 $mg/m^2$ to 30 $mg/m^2$.

(Method for preparing lithographic printing plate and lithographic printing method)

It is possible to prepare a lithographic printing plate by performing image exposure and a development treatment on the lithographic printing plate precursor according to the present disclosure.

The method for preparing a lithographic printing plate according to the present disclosure preferably includes a step of exposing the lithographic printing plate precursor according to the present disclosure in the shape of an image (hereinafter, this step will be also called "exposure step") and a step of removing the image-recording layer in a non-image area on a printer by supplying at least one material selected from the group consisting of printing ink and dampening water (hereinafter, this step will be also called "on-press development step").

The lithographic printing method according to the present disclosure preferably includes a step of exposing the lithographic printing plate precursor according to the present disclosure in the shape of an image (exposure step), a step of removing the image-recording layer in a non-image area on a printer by supplying at least one material selected from the group consisting of printing ink and dampening water so that a lithographic printing plate is prepared (on-press development step), and a step of performing printing by using the obtained lithographic printing plate (printing step).

Hereinafter, regarding the method for preparing a lithographic printing plate according to the present disclosure and the lithographic printing method according to the present disclosure, preferred aspects of each step will be described in order. Note that the lithographic printing plate precursor according to the present disclosure can also be developed using a developer.

Hereinafter, the exposure step and the on-press development step in the method for preparing a lithographic printing plate will be described. The exposure step in the method for preparing a lithographic printing plate according to the present disclosure is the same step as the exposure step in the lithographic printing method according to the present disclosure. Furthermore, the on-press development step in the method for preparing a lithographic printing plate according to the present disclosure is the same step as the on-press development step in the lithographic printing method according to the present disclosure.

<Exposure step>

The method for preparing a lithographic printing plate according to the present disclosure preferably includes an exposure step of exposing the lithographic printing plate precursor according to the present disclosure in the shape of an image so that an exposed portion and a non-exposed portion are formed. The lithographic printing plate precursor according to the present disclosure is preferably exposed to a laser through a transparent original picture having a linear image, a halftone dot image, or the like or exposed in the shape of an image by laser light scanning according to digital data or the like.

The wavelength of a light source to be used is preferably 750 nm to 1,400 nm. As the light source of 750 nm to 1,400 nm, a solid-state laser or a semiconductor laser that radiates infrared is suitable. In a case where an infrared

laser is used, the output is preferably 100 mW or higher, the exposure time per pixel is preferably 20 microseconds or less, and the amount of irradiation energy is preferably 10 mJ/cm$^2$ to 300 mJ/cm$^2$. In addition, in order to shorten the exposure time, a multibeam laser device is preferably used. The exposure mechanism may be any one of an in-plane drum method, an external surface drum method, a flat head method, or the like.

The image exposure can be carried out by a common method using a platesetter or the like. In the case of on-press development, image exposure may be carried out on a printer after the lithographic printing plate precursor is mounted on the printer.

<On-press development step>

The method for preparing a lithographic printing plate according to the present disclosure preferably includes an on-press development step of removing the image-recording layer in a non-image area on a printer by supplying at least one selected from the group consisting of printing ink and dampening water.

Hereinafter, the on-press development method will be described.

[On-press development method]

In the on-press development method, the lithographic printing plate precursor having undergone image exposure is preferably supplied with an oil-based ink and an aqueous component on a printer, so that the image-recording layer in a non-image area is removed and a lithographic printing plate is prepared.

That is, in a case where the lithographic printing plate precursor is subjected to image exposure and then directly mounted on a printer without being subjected to any development treatment, or in a case where the lithographic printing plate precursor is mounted on a printer, then subjected to image exposure on the printer, and then supplied with an oil-based ink and an aqueous component for printing, at the initial stage in the middle of printing, in a non-image area, a non-cured image-recording layer is removed by either or both of the supplied oil-based ink and the aqueous component by means of dissolution or dispersion, and the hydrophilic surface is exposed in the non-image area. On the other hand, in an exposed portion, the image-recording layer cured by exposure forms an oil-based ink-receiving portion having a lipophilic surface. Any of the oil-based ink and the aqueous component may be supplied first to the surface of the plate. However, in view of preventing the plate from being contaminated by the components of the image-recording layer from which aqueous components are removed, it is preferable that the oil-based ink be supplied first. In the manner described above, the lithographic printing plate precursor is subjected to on-press development on a printer and used as it is for printing a number of sheets. As the oil-based ink and the aqueous component, ordinary printing ink and ordinary dampening water for lithographic printing are suitably used.

As the laser used for performing image exposure on the lithographic printing plate precursor according to the present disclosure, a light source having a wavelength of 300 nm to 450 nm or 750 nm to 1,400 nm is preferably used. A light source of 300 nm to 450 nm is preferable for a lithographic printing plate precursor including an image-recording layer containing sensitizing dye having maximum absorption in such a wavelength range. The light source of 750 nm to 1,400 nm is preferable for the aforementioned lithographic printing plate precursor. As the light source of 300 nm to 450 nm, a semiconductor laser is suitable.

<Development step using developer>

The method for preparing a lithographic printing plate according to the present disclosure may be a method including a step of exposing the lithographic printing plate precursor according to the present disclosure in the shape of an image and a step of preparing a lithographic printing plate by removing the image-recording layer in a non-image area by using a developer (also called "development step using a developer)".

Furthermore, the lithographic printing method according to the present disclosure may be a method including a step of exposing the lithographic printing plate precursor according to the present disclosure in the shape of an image, a step of preparing a lithographic printing plate by removing the image-recording layer in a non-image area by using a developer, and a step of performing printing by using the obtained lithographic printing plate.

As the developer, known developers can be used.

The pH of the developer is not particularly limited, and the developer may be a strongly alkaline developer. Preferable examples of the developer include a developer having a pH of 2 to 11. Preferable examples of the developer having a pH of 2 to 11 include a developer containing at least one kind of component among surfactants and water-soluble polymer compounds.

Examples of the development treatment using a strongly alkaline developer include a method of removing the protective layer by a pre-rinsing step, then performing development using an alkali, rinsing and removing the alkali by a post-rinsing step, performing a gum solution treatment, and performing drying by a drying step.

In a case where the aforementioned developer containing a surfactant or a water-soluble polymer compound is used, development and the gum solution treatment can be simultaneously performed. As a result, the post-rinsing step is unnecessary, and it is possible to perform both the development and gum solution treatment by using one solution and to subsequently perform the drying step. Furthermore, because the removal of the protective layer can be performed simultaneously with the development and the gum solution treatment, the pre-rinsing step is unnecessary as well. After the development treatment, it is preferable to remove an excess of developer by using a squeeze roller or the like and to subsequently perform drying.

<Printing step>

The lithographic printing method according to the present disclosure includes a printing step of printing a recording medium by supplying printing ink to the lithographic printing plate.
The printing ink is not particularly limited, and various known inks can be used as desired. In addition, as the printing ink, for example, oil-based ink or ultraviolet-curable ink (UV ink) is preferable.
In the printing step, if necessary, dampening water may be supplied.
Furthermore, the printing step may be successively carried out after the on-press development step or the development step using a developer, without stopping the printer.
The recording medium is not particularly limited, and known recording media can be used as desired.
In the method for preparing a lithographic printing plate from the lithographic printing plate precursor according to the present disclosure and in the lithographic printing method according to the present disclosure, if necessary, the entire surface of the lithographic printing plate precursor may be heated as necessary before exposure, in the middle of exposure, or during a period of time from exposure to development. In a case where the lithographic printing plate precursor is heated as above, an image-forming reaction in the image-recording layer is accelerated, which can result in advantages such as improvement of sensitivity and printing durability, stabilization of sensitivity, and the like. Heating before development is preferably carried out under a mild condition of 150°C or lower. In a case where this aspect is adopted, it is possible to prevent problems such as curing of a non-image area. For heating after development, it is preferable to use an extremely severe condition which is preferably in a range of 100°C to 500°C. In a case where this aspect is adopted, a sufficient image-strengthening action is obtained, and it is possible to inhibit problems such as the deterioration of the support or the thermal decomposition of the image area.

Examples

Hereinafter, the present disclosure will be specifically described based on examples, but the present disclosure is not limited thereto. In the present examples, unless otherwise specified, "%" and "part" mean "% by mass" and "part by mass" respectively. Unless otherwise described, the molecular weight of a polymer compound is a weight-average molecular weight (Mw), and the ratio of repeating constitutional units of a polymer compound is expressed as molar percentage. The weight-average molecular weight (Mw) is a value measured by gel permeation chromatography (GPC) and expressed in terms of polystyrene. In addition, unless otherwise specified, the average particle diameter means a volume average particle diameter. The average particle diameter was measured by a laser diffraction/scattering type particle size distribution analyzer LA-920 (manufactured by HORIBA, Ltd.).

[Synthesis of polymer particles]

«Synthesis of R-1>>

B-1 shown in the following Table 1 (n = 45, 10.0 g), 85.0 g of distilled water, and 240.0 g of n-propanol were added to a 1,000 ml four-neck flask, and the mixture was heated and stirred at 70°C in a nitrogen atmosphere.
Then, a mixture of styrene: (A-1) 20.0 g, acrylonitrile: (A-2) 70.0 g, and 0.7 g of 2,2'-azobisisobutyronitrile mixed together in advance was added dropwise thereto for 2 hours. After the dropwise addition ended, the reaction continued for 5 hours, then 0.5 g of 2,2'-azobisisobutyronitrile was added thereto, and the solution was heated to 80°C. The reaction was performed for a total of 19 hours by adding 0.4 g of 2,2'-azobisisobutyronitrile every 6 hours.
The reaction solution was left to cool to room temperature (25°C), thereby obtaining a dispersion of particles R-1 (solid content: 23% by mass). The average particle diameter of the particles R-1 was 150 nm.

«Synthesis of R-6»

2-Butanone (20 g) was weighed out, put in a three-neck flask, and heated to 70°C under a nitrogen stream. A mixed solution consisting of 2-methacryloyloxyethyl isocyanate (KARENZ-MOI, manufactured by SHOWA DENKO K.K.):

12.6 g, styrene: (A-1) 15 g, acrylonitrile: (A-2) 15.0 g, B-1 (n = 45): 10 g, methacrylic acid: 4 g, 2,2'-azobis(2,4-dimethylvaleronitrile) (trade name: V-65, manufactured by FUJIFILM Wako Pure Chemical Corporation): 0.6 g, and 2-butanone: 44 g was added dropwise to the reaction container for 2 hours.

After dropwise addition ended, the reaction was continued for 2 more hours. After 2 hours, V-65: 0.1 g was added thereto, the temperature was raised to 80°C, and the reaction was continued for 2 hours.

After the reaction ended, the reaction solution was cooled to room temperature, and then 2-butanone: 30 g, tetramethylpiperidin N-oxide: 0.1 g, dipentaerythritol pentaacrylate (trade name: SR-399, manufactured by Sartomer Company Inc.): 43 g, bismuth (III) tris(2-ethylhexanoate) (trade name: NEOSTANN U-600 (manufactured by NITTO KASEI CO., LTD.): 0.2 g were added to the reaction solution, thoroughly stirred, and heated at 70°C. After 6 hours, the reaction polymer solution was cooled to room temperature.

Water (400 ml) was added to a 1 L stainless steel beaker and stirred with a mechanical stirrer, and in this state, the entirety of the aforementioned reaction polymer solution was added thereto at a rate of 1 ml/min. The supernatant was removed except for the obtained white precipitate, the precipitate was repeatedly rinsed with water twice, 200 ml of a 0.1 N (mol/L) aqueous NaOH solution and 100 ml of pure water were added to the stainless steel beaker without performing a drying step, and the obtained solution was stirred, thereby obtaining a white dispersion. The obtained dispersion was emulsified at 18,000 rpm for 12 minutes by using a homogenizer, thereby obtaining an aqueous particle solution R-6. The particle diameter was 140 nm, and the solid content was 21% by mass.

«Synthesis of R-2 to R-5, R-7, and R-8»

Particles R-2 to R-5, R-7, and R-8 were prepared in the same manner as in the synthesis of the particles R-1, except that the used monomers were changed as shown in Table 1.

[Table 1]

| | Polymer particles | | | | | |
|---|---|---|---|---|---|---|
| | Unit A | | Unit B | | Unit C | |
| | Type | Amount (part by mass) | Type | Amount (part by mass) | Type | Amount (part by mass) |
| R-1 | A-1/A-2 | 20/70 | B-1(n-45) | 10 | - | - |
| R-2 | A-1/A-2 | 50/20 | B-1(n-45) | 10 | C-1 | 20 |
| R-3 | A-2 | 75 | B-2 | 5 | C-2 | 20 |
| R-4 | A-1 | 20 | B-1(n-45) | 10 | C-3 | 80 |
| R-5 | A-2 | 20 | B-1(n-45) | 10 | C-3 | 50 |
| R-6 | A-1/A-2 | 15/15 | B-1(n-45) | 10 | C-4/C-5 | 5/55 |
| R-7 | A-1/A-2 | 20/70 | B-3 | 10 | - | - |
| R-8 | A-1/A-2 | 20/70 | B-3/B-1(n-45) | 5/5 | - | - |

Details of the abbreviations in Table 1 are as follows. The type of each unit composition is described as monomers, and the type of polymer (addition polymerization-type resin) in the prepared particles is described as the corresponding constitutional unit (the constitutional unit described above). Furthermore, the unit of amount of each unit is part by mass, which is the amount of a constitutional unit.

Unit A: A constitutional unit formed of an aromatic vinyl compound and a constitutional unit formed of an acrylonitrile compound
Unit B: A hydrophilic group-containing constitutional unit
Unit C: A constitutional unit other than unit A and unit B

A-1 and A-2: The following compounds

Unit A

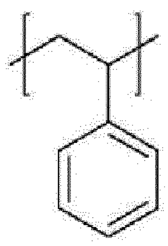

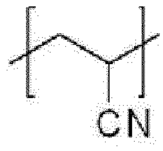

A-2

A-1

B-1 and B-2: The following compounds

Unit B

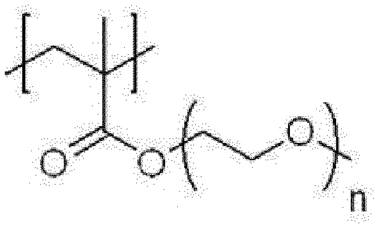

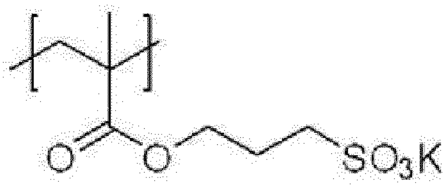

B-1

B-2

B-3: The following compound: BLEMMER (registered trademark) AP-550 (manufactured by NOF CORPORATION)

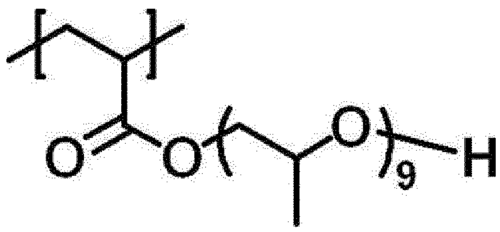

B-3

C-1 to C-5: The following compounds. The following C-5 is a monomer obtained by reacting a OH group of dipentaerythritol pentaacrylate used in the synthesis of R-6 with an NCO group of 2-methacryloyloxyethyl isocyanate.

Unit C

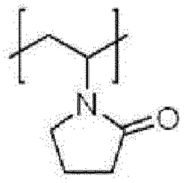

C-1

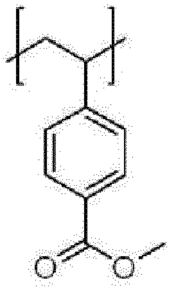

C-2

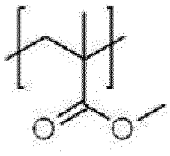

C-3

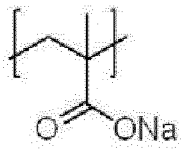

C-4

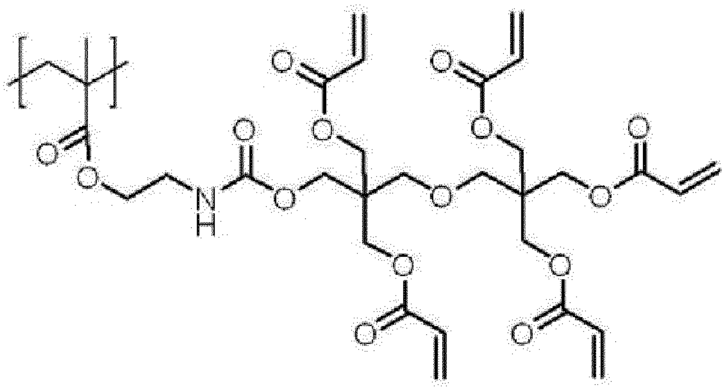

C-5

(Preparation of support A)

<Treatment (A)>

(A-a) Alkaline etching treatment

An aqueous solution of caustic soda having a caustic soda concentration of 26% by mass and an aluminum ion concentration of 6.5% by mass was sprayed onto an aluminum plate having a thickness of 0.3 mm at a temperature of 70°C, thereby performing an etching treatment. Then, rinsing was performed by means of spraying. The amount of dissolved aluminum within the surface to be subjected to the electrochemical roughening treatment later was 5 $g/m^2$.

(A-b) Desmutting treatment using aqueous acidic solution (first desmutting treatment)

Next, a desmutting treatment was performed using an aqueous acidic solution. In the desmutting treatment, a 150 g/L aqueous sulfuric acid solution was used as the aqueous acidic solution. The liquid temperature was 30°C. The desmutting treatment was performed for 3 seconds by spraying the aqueous acidic solution onto the aluminum plate. Then, a rinsing treatment was performed.

(A-c) Electrochemical roughening treatment

Next, an electrochemical roughening treatment was performed using alternating current and an electrolytic solution having a hydrochloric acid concentration of 14 g/L, an aluminum ion concentration of 13 g/L, and a sulfuric acid concentration of 3 g/L. The liquid temperature of the electrolytic solution was 30°C. The aluminum ion concentration was adjusted by adding aluminum chloride.
The waveform of the alternating current was a sine wave in which positive and negative waveforms are symmetrical, the frequency was 50 Hz, the ratio of the anodic reaction time and the cathodic reaction time in one cycle of the alternating current was 1:1, and the current density was 75 $A/dm^2$ in terms of the peak current value of the alternating

current waveform. In addition, the quantity of electricity was 450 C/dm$^2$ which was the total quantity of electricity used for the aluminum plate to have an anodic reaction, and the electrolysis treatment was performed 4 times by conducting electricity of 112.5 C/dm$^2$ for 4 seconds at each treatment session. A carbon electrode was used as the counter electrode of the aluminum plate. Then, a rinsing treatment was performed.

(A-d) Alkaline etching treatment

An aqueous solution of caustic soda having a caustic soda concentration of 5% by mass and an aluminum ion concentration of 0.5% by mass was sprayed onto the aluminum plate having undergone the electrochemical roughening treatment at a temperature of 45°C, thereby performing an etching treatment. The amount of dissolved aluminum within the surface having undergone the electrochemical roughening treatment was 0.2 g/m$^2$. Then, a rinsing treatment was performed.

(A-e) Desmutting treatment using aqueous acidic solution

Next, a desmutting treatment was performed using an aqueous acidic solution. Specifically, the desmutting treatment was performed for 3 seconds by spraying the aqueous acidic solution onto the aluminum plate. In the desmutting treatment, an aqueous solution having a sulfuric acid concentration of 170 g/L and an aluminum ion concentration of 5 g/L was used as aqueous acidic solution. The liquid temperature was 30°C.

(A-f) Anodic oxidation treatment

By using the anodic oxidation device for direct current electrolysis having the structure shown in Fig. 5, an anodic oxidation treatment was performed. The anodic oxidation treatment was performed using an electrolytic solution having a sulfuric acid concentration 170 g/L under the conditions of a temperature of 50°C and a current density of 30 A/dm, thereby forming an anodic oxide film having a film amount of 2.4 g/m$^3$.

In the anodic oxidation treatment device 610, an aluminum plate 616 is transported as indicated by the arrow in Fig. 5. In a power supply tank 612 containing an electrolytic solution 618, the aluminum plate 616 is positively (+) charged by a power supply electrode 620. Then, the aluminum plate 616 is transported upwards by a roller 622 in the power supply tank 612, makes a turn downwards by a nip roller 624, then transported toward an electrolytic treatment tank 614 containing an electrolytic solution 626, and makes a turn by a roller 628 so as to move in the horizontal direction. Subsequently, the aluminum plate 616 is negatively (-) charged by an electrolysis electrode 630. As a result, an anodic oxide film is formed on the surface of the aluminum plate 616. The aluminum plate 616 exits from the electrolytic treatment tank 614 and is then transported for the next step. In the anodic oxidation treatment device 610, the roller 622, the nip roller 624, and the roller 628 constitute a direction change unit. Furthermore, in the inter-tank portion between the power supply tank 612 and the electrolytic treatment tank 614, the aluminum plate 616 is transported in a ridge shape and an inverted U shape by the roller 622 and the nip rollers 624 and 628. The power supply electrode 620 and the electrolysis electrode 630 are connected to a direct current power source 634.

(A-g) Pore widening treatment

The aluminum plate having undergone the above anodic oxidation treatment was immersed in an aqueous solution of caustic soda at a temperature of 40°C and having a caustic soda concentration of 5% by mass and an aluminum ion concentration of 0.5% by mass for 3 seconds, thereby performing a pore widening treatment. Then, the aluminum plate was rinsed with water by a spray, thereby obtaining an aluminum support A.

The values of physical properties of the support A are as below.

Average diameter of micropores within surface of anodic oxide film: 12 nm
Value of brightness L * of surface of anodic oxide film on the image-recording layer side in the L*a*b* color space: 81

(Preparation of support B)

An aluminum alloy plate made of a material 1S having a thickness of 0.3 mm was subjected to (A-a) Mechanical roughening treatment (brush grain method) and (A-i) Desmutting treatment in aqueous acidic solution described in paragraphs "0126" to "0134" of JP2012-158022A.

Then, the treatment conditions of (A-j) First-stage anodic oxidation treatment to (A-m) Third-stage anodic oxidation treatment described in paragraphs "0135" to "0138" of JP2012-158022A were appropriately adjusted, and an anodic oxide film was formed which had a large diameter portion having an average diameter of 35 nm and a

depth of 100 nm and a small diameter portion having an average diameter of 10 nm and a depth of 1,000 nm, and in which a ratio of the depth of the large diameter portion to the average diameter of the large diameter portion is 2.9. The obtained film was adopted as an aluminum support B.

A rinsing treatment was performed between all the treatment steps. After the rinsing treatment, water was drained using a nip roller.

The values of physical properties of the support B are as below.

Value of brightness L * of surface of anodic oxide film on the image-recording layer side in the L*a*b* color space: 83

The average diameter of micropores in each support prepared as above was determined by observing the surface of the support with a field emission scanning electron microscope (FE-SEM) at 150,000X magnification (N = 4), measuring the size (diameter) of 50 micropores existing in a range of 400 $nm^2 \times 600$ $nm^2$ in the obtained 4 images, and calculating the average thereof.

In a case where the shape of the micropores is not circular, the equivalent circular diameter is used. "Equivalent circular diameter" is a diameter determined on an assumption that the opening portion is in the form of a circle having the same projected area as the projected area of the opening portion.

The average diameter of the micropores (average diameter of the large diameter portion and the small diameter portion) is a value obtained by observing the surface of the large diameter portion and the surface of the small diameter portion with FE-SEM at 150,000X magnification (N= 4), and measuring the diameters of 50 micropores (large diameter portion and small diameter portion) in a range of 400 $nm^2 \times 600$ $nm^2$ in the obtained 4 images, and calculating the average thereof. In a case where the large diameter portion was deep, and it was difficult to measure the diameter of the small diameter portion, the upper portion of the anodic oxide film was cut, and then various diameters were calculated.

The depth of the micropores (depth of the large diameter portion and the small diameter portion) is a value obtained by observing the cross section of the support (anodic oxide film) with FE-SEM (observation of the depth of the large diameter portion: 150,000X magnification, observation of depth of small diameter portion: 50,000X magnification), measuring the depths of 25 random micropores in the obtained image, and calculating the average thereof.

Furthermore, the value of the brightness L* of the surface of the anodic oxide film (surface of the anodic oxide film opposite to the aluminum plate side) in the obtained aluminum support in the L*a*b* color space was measured using a color difference meter Spectcro Eye manufactured by X-Rite, Incorporated.

(Examples 1 to 23 and Comparative Examples 1 to 6)

<Preparation of lithographic printing plate precursor>

The lithographic printing plate precursors of Examples 1 to 23 and Comparative Examples 1 to 6 were prepared by the following method.

«Formation of undercoat layer»

Each of the supports described in Table 2 to Table 4 was coated with a coating solution (1) for an undercoat layer having the following composition so that the dry coating amount was 20 $mg/m^2$. In this way, an undercoat layer was formed.

-Coating solution (1) for undercoat-

- Polymer (P-1) [the following structure]: 0.18 parts
- Hydroxyethyl iminodiacetic acid: 0.10 parts
- Water: 61.4 parts

(P-1)

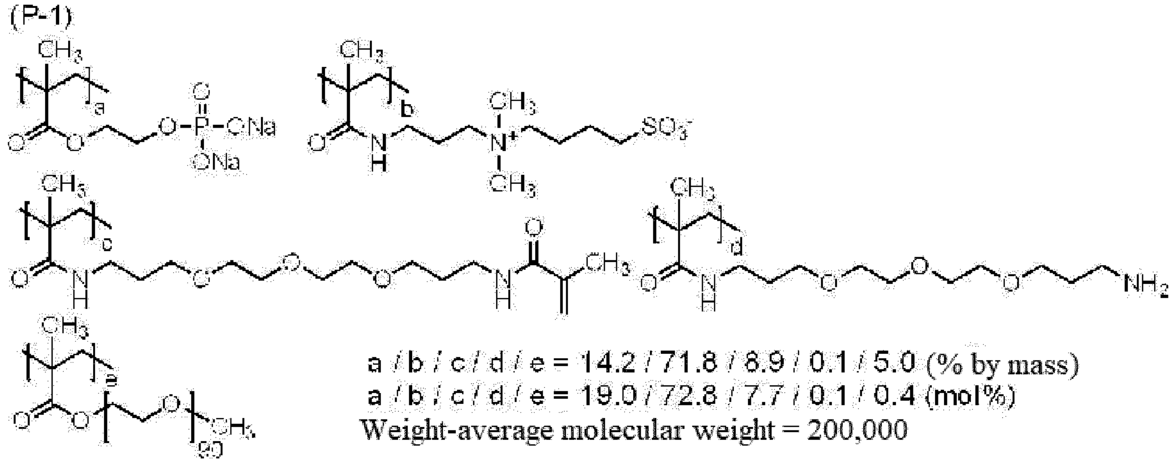

a / b / c / d / e = 14.2 / 71.8 / 8.9 / 0.1 / 5.0 (% by mass)
a / b / c / d / e = 19.0 / 72.8 / 7.7 / 0.1 / 0.4 (mol%)
Weight-average molecular weight = 200,000

-Synthesis of polymer (P-1)-

<<Purification of monomer UM-1>>

LIGHT ESTER P-1M (2-methacryloyloxyethyl acid phosphate, manufactured by KYOEISHA CHEMICAL Co., LTD.) (420 parts), 1,050 parts of diethylene glycol dibutyl ether, and 1,050 parts of distilled water were added to a separatory funnel, vigorously stirred, and then left to stand. The upper layer was discarded, 1,050 parts of diethylene glycol dibutyl ether was then added thereto, the solution was vigorously stirred, and then left to stand. The upper layer was discarded, thereby obtaining 1,300 parts of an aqueous solution of a monomer UM-1 (10.5% by mass in terms of solid contents).

<<Synthesis of polymer (P-1)>>

Distilled water (53.73 parts) and 3.66 parts of the following monomer UM-2 were added to a three-neck flask, and heated to 55°C in a nitrogen atmosphere. Then, the following dripping liquid 1 was added dropwise thereto for 2 hours, the obtained solution was stirred for 30 minutes, and 0.386 parts of VA-046B (manufactured by FUJIFILM Wako Pure Chemical Corporation) was added thereto. The solution was heated to 80°C and stirred for 1.5 hours. The reaction solution was returned to room temperature (25°C), a 30% by mass aqueous sodium hydroxide solution was added thereto so that the pH was adjusted to 8.0, and then 0.005 parts of 4-hydroxy-2,2,6,6-tetramethylpiperidin-1-oxyl (4-OH-TEMPO) was added thereto. By the above operation, 180 parts of an aqueous solution of the polymer (P-1) was obtained. The weight-average molecular weight (Mw) thereof was 200,000 that was measured by gel permeation chromatography (GPC) and expressed in terms of polyethylene glycol.

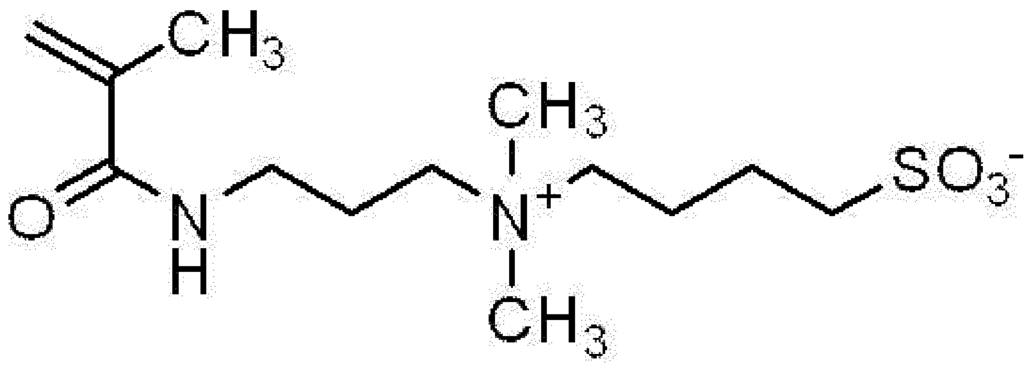

Monomer UM-2

«Composition of dripping liquid 1>>

- Aqueous solution of the monomer UM-1: 87.59 parts
- The above monomer UM-2: 14.63 parts
- VA-046B (2,2'-azobis[2-(2-imidazolin-2-yl)propane] disulfate dihydrate, manufactured by FUJIFILM Wako Pure Chemical Corporation): 0.386 parts
- Distilled water: 20.95 parts

<<Formation of image-recording layer>>

The undercoat layer was bar-coated with each coating solution for an image-recording layer for forming an image-recording layer having the composition described in Table 2 to Table 4, so that the coating amount described in Table 2 to Table 4 was achieved, followed by drying in oven at 120°C for 40 seconds, thereby forming an image-recording layer.

<<Formation of overcoat layer (OC layer)>>

The image-recording layer was bar-coated with each coating solution for an overcoat layer for forming an overcoat layer having the composition described in Table 2 and Table 3, so that the coating amount described in Table 2 and Table 3 was achieved, followed by drying in an oven at 120°C for 60 seconds, thereby forming an overcoat layer.
Details of the compounds used in the coating solutions for an overcoat layer in Table 2 and Table 3 will be shown below.

[Water-soluble polymer]

WP-1: Cellulose (Shin-Etsu Chemical Co., Ltd., trade name: 60SH-15)
WP-2: PVA (NIHON GOSEI KAKO Co., Ltd., trade name: 6 GOHSERAN CKS-50)
WP-3: Vinylpyrrolidone (manufactured by BASF SE, trade name: LUBISKOL K-17)
WP-4: PEG (ADEKA Corporation, trade name: PLURONIC L-44)

In the following table, the water-soluble polymer is written as hydrophilic polymer.

[Surfactant]

RAPISOL A-80 (manufactured by NOF CORPORATION)

For obtaining the film thickness of the image-recording layer and the overcoat layer, after the coating with the coating solution for an image-recording layer and the coating solution for an overcoat layer, the lithographic printing plate precursor was stained with osmium, a cross section of the lithographic printing plate precursor was observed with SEM, and the average of the film thickness of each layer at randomly extracted 20 points was determined as the film thickness of the image-recording layer or the overcoat layer. Furthermore, a ratio of the film thickness of the overcoat layer to the film thickness of the image-recording layer (OC layer/image-recording layer) was calculated.

(Evaluation of lithographic printing plate precursor)

[UV printing durability]

By using Magnus 800 Quantum manufactured by Kodak Japan Ltd. that was equipped with an infrared semiconductor laser, the lithographic printing plate precursor prepared as above was exposed under the conditions of output of 27 W, an outer drum rotation speed of 450 rpm, and a resolution of 2,400 dpi (dots per inch, 1 inch is equal to 2.54 cm) (irradiation energy equivalent to 110 $mJ/cm^2$). The exposure image included a solid image and an amplitude modulated screening (AM screening) as a 3% halftone dot chart.
The obtained exposed precursor was mounted on a Kikuban-sized cylinder of a printer SX-74 manufactured by Heidelberger Druckmaschinen AG without being developed. This printer was connected to a 100 L-capacity dampening water circulation tank having a non-woven fabric filter and a temperature control device. A circulation device was filled with dampening water (80 L) containing 2.0% dampening water S-Z1 (manufactured by FUJIFILM Corporation), and T&K UV OFS K-HS black GE-M (manufactured by T&K TOKA CO., LTD.) was used as printing ink. The dampening water and ink were supplied by a standard automatic printing start method, and then printing was performed on TOKUBISHI art paper (manufactured by MITSUBISHI PAPER MILLS LIMITED., ream weight: 76.5 kg) at a printing rate of 10,000 sheets/hour.

As the number of sheets of printed matter increased, the image area gradually wore out, and thus the ink density on the printed matter decreased. For the AM screen 3% halftone dots in the printed matter, the area ratio of the halftone dots was measured using a Gretag density meter (manufactured by GretagMacbeth). When the measured area ratio was 1% lower than the area ratio measured after 500 sheets were printed, the number of prints at that point in time was adopted as the number of sheets of completely printed paper and used for evaluating printing durability. The evaluation was based on relative printing durability to 100 which represents the printing durability of a lithographic printing plate precursor capable of printing 50,000 sheets. The larger the number of printed sheets, the better the UV printing durability. Relative printing durability = (number of sheets of printed matter obtained from subject lithographic printing plate precursor)/50,000 $\times$ 100

[On-press developability]

In Luxel PLATESETTER T-6000III manufactured by FUJIFILM Corporation that was equipped with an infrared semiconductor laser, each of the obtained lithographic printing plate precursors was exposed under the conditions of an outer drum rotation speed of 1,000 rpm, a laser output of 70%, and resolution of 2,400 dpi. The exposure image included a solid image, a 50% halftone dot chart of a 20 $\mu$m dot FM screen, and a non-image area.

The obtained precursor having undergone exposure was mounted on a plate cylinder of a printer LITHRONE26 manufactured by KOMORI Corporation, without being subjected to a development treatment. By using dampening water containing Ecolity-2 (manufactured by FUJIFILM Corporation)/tap water = 2/98 (volume ratio)) and SPACE COLOR FUSION G yellow ink (manufactured by DIC Graphics Corporation), on-press development was performed by supplying the dampening water and ink according to the standard automatic printing start method of a printer LITHRONE26 manufactured by KOMORI Corporation. Thereafter, printing was performed on 500 sheets of TOKUBISHI art paper (manufactured by MITSUBISHI PAPER MILLS LIMITED., ream weight: 76.5 kg) at a printing rate of 10,000 sheets/hour.

The number of sheets of printing paper used until no ink was transferred to a non-image area after the on-press development of the non-exposed portion of the image-recording layer on the printer was finished was counted as on-press developability. It can be said that the smaller the number of printing papers, the better the on-press developability.

[Visibility (color developability)]

In Trendsetter 3244VX manufactured by CREO CO., LTD. that was equipped with a water cooling-type 40 W infrared semiconductor laser, each of the obtained lithographic printing plate precursors was exposed under the conditions of an output of 11.7 W, an outer drum rotation speed of 250 rpm, and a resolution of 2,400 dpi (dot per inch, 1 inch = 25.4 mm). The exposure was carried out in an environment of 25°C and 50% RH.

Immediately after exposure, the color development of the lithographic printing plate precursor was measured. The measurement was performed by the specular component excluded (SCE) method by using a spectrocolorimeter CM2600d and operation software CM-SI00W manufactured by Konica Minolt, Inc. The color developability was evaluated by a difference $\Delta L$ between an L* value (brightness) of the exposed portion and an L* value of the non-exposed portion by using L* values of the L*a*b* color space.

The numerical values of $\Delta L$ are described in Table 2 and Table 3. The higher the value of $\Delta L$, the better the color developability. Color developability is an indicator of visibility. In addition, it can be said that a lithographic printing plate having excellent color developability is also excellent in plate inspectability.

[Suppression of plate missing]

By using Magnus 800 Quantum manufactured by Kodak Japan Ltd. that was equipped with an infrared semiconductor laser, the lithographic printing plate precursor prepared as above was exposed under the conditions of output of 27 W, an outer drum rotation speed of 450 rpm, and a resolution of 2,400 dpi (dots per inch, 1 inch is equal to 2.54 cm) (irradiation energy equivalent to 110 $mJ/cm^2$). The exposure image included a solid image and an amplitude modulated screening (AM screening) as a 3% halftone dot chart.

A piano wire (ESCO CORPORATION) having a diameter of 0.4 mm was attached to the halftone dot portion of the exposed precursor in the direction perpendicular to the rotation direction of the plate cylinder, and the precursor was mounted on the Kikuban-sized cylinder of printer SX-74 manufactured by Heidelberger Druckmaschinen AG without being subjected to a development treatment. This printer was connected to a 100 L-capacity dampening water circulation tank having a non-woven fabric filter and a temperature control device. A circulation device was filled with dampening water (80 L) containing 2.0% dampening water S-Z1 (manufactured by FUJIFILM Corporation), and T&K UV OFS K-HS black GE-M (manufactured by T&K TOKA CO., LTD.) was used as printing ink. The dampening water and ink were

supplied by a standard automatic printing start method, and then printing was performed on TOKUBISHI art paper (manufactured by MITSUBISHI PAPER MILLS LIMITED., ream weight: 76.5 kg) at a printing rate of 10,000 sheets/hour.

When the number of printed sheets reached 2,000, the piano wire was removed from the plate, the plate was set in the printer again, and printing was started. For the 100th printed matter after the resumption of printing and the image area corresponding to the position of the piano wire were checked observed. Furthermore, whether defective sticking occurred was visually checked using 50X magnifying glass. For every 2,000th printed matter, the image area was checked in the same manner as described above, and the evaluation ended at the stage where defective sticking occurred.

It can be said that the larger the number of sheets printed until defective sticking occurs, the better the "suppression of plate missing".

-Evaluation standard-

A: The number of sheets printed until defective sticking occurs is 20,000 or more.
B: The number of sheets printed until defective sticking occurs is 4,000 or more and less than 20,000.
C: The number of sheets printed until defective sticking occurs is less than 4,000.

[Suppression of residues of on-press development]

Printing was performed to evaluate UV printing durability described above, and then the state where the removed residues adhered to the dampening roller was evaluated. In this way, the development residues generated during on-press development were evaluated.

The indicators are as follows. The larger the value, the further the development residues are suppressed.

5: No residue is found on the dampening roller.
4: Few residues are found on the dampening roller.
3: Residues are found on the dampening roller.
2: Many residues are found on the dampening roller.
1: There are so many residues found on the dampening roller.

[Table 2]

| | | | Example | | | | | | | | | | | | |
|---|---|---|---|---|---|---|---|---|---|---|---|---|---|---|---|
| | | | 1 | 2 | 3 | 4 | 5 | 6 | 7 | 8 | 9 | 10 | 11 | 12 | 13 |
| Support | | Type | A | A | A | A | A | B | A | B | A | A | A | A | A |
| | Electron-accepting polymerization initiator | I-1 | 120 | 120 | 120 | 120 | 120 | - | 188 | - | - | - | 128 | - | - |
| | | 1-2 | - | - | - | - | - | 139 | - | 167 | - | 223 | - | - | 169 |
| | | 1-3 | - | - | - | - | - | - | - | - | 60 | - | - | 121 | - |
| | | $I^1$-1 | | | | | | | | | | | | | |
| | Cationic polymethine colorant | D-1 | 30 | 30 | 30 | 30 | 30 | - | - | 57 | - | - | - | - | - |
| | | D-2 | - | - | - | - | - | 34 | 27 | - | - | - | - | - | 30 |
| | | D-3 | - | - | - | - | - | - | - | - | - | 40 | - | - | - |
| | | D-4 | - | - | - | - | - | - | - | - | - | - | 29 | - | - |
| | | D-5 | - | - | - | - | - | - | - | - | 27 | - | - | - | - |
| | | D-6 | - | - | - | - | - | - | - | - | - | - | - | - | - |
| | | D-7 | - | - | - | - | - | - | - | - | - | - | - | 34 | - |
| | | D-8 | - | - | - | - | - | - | - | - | - | - | - | - | - |
| | Electron-donating polymerization initiator | B-1 | 20 | 20 | 20 | 20 | 20 | - | - | - | - | 24 | 13 | - | - |
| | | B-2 | - | - | - | - | - | 28 | - | - | - | - | - | - | - |
| | | B-3 | - | - | - | - | - | - | 37 | - | 98 | - | - | - | - |
| | | B-4 | - | - | - | - | - | - | - | 28 | - | - | - | 13 | - |
| | | B-5 | - | - | - | - | - | - | - | - | | | | - | |
| | Polymerizable compound | M-1 | - | - | - | - | - | - | - | 225 | - | - | - | 290 | - |
| | | M-2 | - | - | - | - | - | - | 100 | - | 253 | - | - | - | 146 |
| | | M-3 | 100 | 100 | 100 | 100 | 100 | - | - | - | - | 209 | - | - | - |
| | | M-4 | - | - | - | - | - | 167 | - | - | - | - | 279 | - | - |

(continued)

| | | | Example | | | | | | | | | | | | |
|---|---|---|---|---|---|---|---|---|---|---|---|---|---|---|---|
| | | | 1 | 2 | 3 | 4 | 5 | 6 | 7 | 8 | 9 | 10 | 11 | 12 | 13 |
| Support | | Type | A | A | A | A | A | B | A | B | A | A | A | A | A |
| Image-recording layer | Polymer particles | R-1 | 300 | 300 | 300 | 300 | 300 | - | - | - | - | 116 | - | - | - |
| | | R-2 | - | - | - | - | - | 207 | 247 | - | 146 | - | 154 | 174 | - |
| | | R-3 | - | - | - | - | - | - | - | 105 | - | - | - | - | 192 |
| | | R-4 | - | - | - | - | - | - | - | - | - | - | - | - | - |
| | | R-5 | - | - | - | - | - | - | - | - | - | - | - | - | - |
| | | R-6 | - | - | - | - | - | - | - | 100 | - | - | - | - | - |
| | | MG-1 | - | - | - | - | - | - | - | - | - | - | - | - | - |
| | Binder polymer | P-1 | - | - | - | - | - | - | - | - | - | - | - | - | 24 |
| | | P-2 | - | - | - | - | - | - | - | - | - | 30 | - | - | - |
| | Color developing agent | S-15 | 35 | 35 | 35 | 35 | 35 | - | - | - | - | - | - | - | - |
| | | S-16 | - | - | - | - | - | 33 | 56 | 33 | - | 56 | - | - | 13 |
| | | S-14 | - | - | - | - | - | - | - | - | 59 | - | 44 | 22 | - |
| | Hydrophilic compound | T-1 | - | - | - | - | - | 21 | - | - | - | 68 | - | 12 | - |
| | | T-2 | - | - | - | - | - | - | 48 | - | 12 | - | - | 12 | 5 |
| | | T-3 | 12 | 12 | 12 | 12 | 12 | - | - | 46 | - | - | - | 12 | - |
| | Hydrophobic compound | C-1 | - | - | - | - | - | - | - | 45 | - | - | 17 | - | - |
| | | C-2 | - | - | - | - | - | - | 17 | - | 17 | - | - | - | 17 |
| | | C-3 | - | - | - | - | - | - | - | - | - | - | - | - | - |
| | Surfactant | | 4 | 4 | 4 | 4 | 4 | 4 | 4 | 3 | 4 | 4 | 4 | 4 | 4 |
| | ΔHOMO | | 0.57 | 0.57 | 0.57 | 0.57 | 0.57 | 0.32 | 0.46 | 0.61 | 0.58 | 0.49 | 0.40 | 0.69 | - |
| | Coating amount of image-recording layer (mg/$m^2$) | | 621 | 621 | 621 | 621 | 621 | 633 | 724 | 809 | 676 | 770 | 668 | 694 | 600 |

(continued)

| | | | Example | | | | | | | | | | | | |
|---|---|---|---|---|---|---|---|---|---|---|---|---|---|---|---|
| | | | 1 | 2 | 3 | 4 | 5 | 6 | 7 | 8 | 9 | 10 | 11 | 12 | 13 |
| Support | | Type | A | A | A | A | A | B | A | B | A | A | A | A | A |
| OC layer | Hydrophilic polymer | WP-1 | - | - | - | - | - | 800 | - | - | - | - | - | - | 990 |
| | | WP-2 | 130 | 250 | 500 | 750 | 900 | - | 900 | 1,000 | - | - | - | - | - |
| | | WP-3 | - | - | - | - | - | - | - | - | 800 | 950 | 880 | 920 | - |
| | | WP-4 | - | - | - | - | - | - | - | - | - | - | - | - | - |
| | Surfactant | | 1 | 1 | 1 | 1 | 1 | 1 | 1 | 1 | 1 | 1 | 1 | 2 | 1 |
| | Coating amount of OC layer (mg/$m^2$) | | 131 | 251 | 501 | 751 | 901 | 801 | 901 | 1,001 | 801 | 951 | 881 | 922 | 991 |
| Film thickness ratio (OC layer/image-recording layer) | | | 0.2 | 0.4 | 0.8 | 1.2 | 1.5 | 1.3 | 1.2 | 1.2 | 1.2 | 1.2 | 1.3 | 1.3 | 1.7 |
| Evaluation | UV printing durability | | 180 | 190 | 202 | 240 | 252 | 234 | 229 | 243 | 230 | 178 | 169 | 140 | 155 |
| | On-press developability | | 8 | 9 | 22 | 26 | 25 | 27 | 16 | 12 | 24 | 20 | 26 | 15 | 12 |
| | Visibility ($\Delta$L) | | 5.2 | 5.5 | 4.9 | 5.2 | 5.3 | 5.7 | 5.1 | 5.5 | 5.5 | 4.5 | 4.3 | 3.1 | 2.9 |
| | Suppression of plate missing | | B | B | B | A | A | A | A | A | A | B | B | B | B |

[Table 3]

| | | | Example | | | | | | | | Comparative example | | | | | |
|---|---|---|---|---|---|---|---|---|---|---|---|---|---|---|---|---|
| | | | 14 | 15 | 16 | 17 | 18 | 19 | 20 | 21 | 1 | 2 | 3 | 4 | 5 | 6 |
| Support | | Type | A | A | A | A | B | A | A | B | A | A | A | A | B | A |
| Image-recording layer | Electron-accepting polymerization initiator | I-1 | - | - | - | 132 | 132 | 120 | - | - | 120 | 120 | 120 | 120 | - | 120 |
| | | 1-2 | 102 | - | - | - | - | - | - | - | - | - | - | - | - | - |
| | | 1-3 | - | - | 121 | - | - | - | - | 100 | - | - | - | - | 100 | - |
| | | $I^1$-1 | - | 120 | - | - | - | - | 98 | - | - | - | - | - | - | - |
| | Cationic polymethine colorant | D-1 | - | - | 44 | 26 | 26 | 30 | - | - | 30 | 30 | 30 | 30 | - | - |
| | | D-2 | - | - | - | - | - | - | - | - | - | - | - | - | - | - |
| | | D-3 | - | - | - | - | - | - | - | 40 | - | - | - | - | 40 | - |
| | | D-4 | - | - | - | - | - | - | - | - | - | - | - | - | - | - |
| | | D-5 | - | 23 | - | - | - | - | - | - | - | - | - | - | - | - |
| | | D-6 | 43 | - | - | - | - | - | - | - | - | - | - | - | - | - |
| | | D-7 | - | - | - | - | - | - | 33 | - | - | - | - | - | - | - |
| | | D-8 | - | - | - | - | - | - | - | - | - | - | - | - | - | 30 |
| | Electron-donating polymerization initiator | B-1 | 35 | 24 | - | 50 | 50 | - | 30 | 20 | 20 | 20 | 20 | 20 | 20 | 20 |
| | | B-2 | - | - | - | - | - | - | - | - | - | - | - | - | - | - |
| | | B-3 | - | - | - | - | - | - | - | - | - | - | - | - | - | - |
| | | B-4 | - | - | 13 | - | - | - | - | - | - | - | - | - | - | - |
| | | B-5 | - | - | - | - | - | 24 | - | - | - | - | - | - | - | - |
| | Polymerizable compound | M-1 | - | 148 | 290 | - | - | - | 120 | - | - | - | - | - | - | - |
| | | M-2 | - | - | - | - | - | - | - | - | - | - | - | - | - | - |
| | | M-3 | - | - | - | 153 | 153 | 100 | 120 | 200 | 100 | 100 | 100 | 100 | 200 | 100 |
| | | M-4 | 105 | - | - | 17 | 17 | - | - | - | - | - | - | - | - | - |

(continued)

| | | | Example | | | | | | | | Comparative example | | | | | |
|---|---|---|---|---|---|---|---|---|---|---|---|---|---|---|---|---|
| | | | 14 | 15 | 16 | 17 | 18 | 19 | 20 | 21 | 1 | 2 | 3 | 4 | 5 | 6 |
| Support | | Type | A | A | A | A | B | A | A | B | A | A | A | A | B | A |
| | Polymer particles | R-1 | - | - | - | - | - | 300 | - | 350 | 300 | - | - | - | 350 | 300 |
| | | R-2 | - | 233 | 174 | - | - | - | 200 | - | - | - | - | - | - | - |
| | | R-3 | - | - | - | - | - | - | - | - | - | - | - | - | - | - |
| | | R-4 | - | - | - | - | - | - | - | - | - | 300 | - | - | - | - |
| | | R-5 | - | - | - | - | - | - | - | - | - | - | 300 | - | - | - |
| | | R-6 | 107 | - | - | 100 | 100 | - | - | - | - | - | - | - | - | - |
| | | MG-1 | 45 | - | - | 300 | 300 | - | - | - | - | - | - | 300 | - | - |
| | Binder polymer | P-1 | - | - | - | - | - | - | - | - | - | - | - | - | - | - |
| | | P-2 | - | - | - | - | - | - | - | - | - | - | - | - | - | - |
| | Color developing agent | S-15 | - | - | - | | | 35 | - | - | 35 | 35 | 35 | 35 | - | 35 |
| | | S-16 | - | - | - | - | - | - | 25 | 40 | - | - | - | - | 40 | - |
| | | S-1 | - | - | - | 60 | - | - | - | - | - | - | - | - | - | - |
| | | S-4 | - | - | - | - | 60 | - | - | - | - | - | - | - | - | - |
| | | S-11 | 39 | - | - | - | - | - | - | - | - | - | - | - | - | - |
| | | S-10 | - | 24 | - | - | - | - | - | - | - | - | - | - | - | - |
| | | S-14 | - | - | 22 | - | - | - | - | - | - | - | - | - | - | - |
| | Hydrophilic compound | T-1 | - | 26 | 12 | - | - | - | - | - | - | - | - | - | - | - |
| | | T-2 | - | - | 12 | 6 | 6 | - | - | - | - | - | - | - | - | - |
| | | T-3 | 34 | - | 12 | - | - | 12 | - | 20 | 12 | 12 | 12 | 12 | 20 | 12 |
| | Hydrophobic compound | C-1 | - | - | - | - | - | - | - | - | - | - | - | - | - | - |
| | | C-2 | 17 | 17 | - | - | - | - | - | - | - | - | - | - | - | - |
| | | C-3 | - | - | - | - | - | - | - | - | - | - | - | - | - | - |
| | Surfactant | | 4 | 5 | 2 | 4 | 4 | 4 | 4 | 4 | 4 | 4 | 4 | 4 | 4 | 4 |

(continued)

| | | | Example | | | | | | | | Comparative example | | | | | |
|---|---|---|---|---|---|---|---|---|---|---|---|---|---|---|---|---|
| | | | 14 | 15 | 16 | 17 | 18 | 19 | 20 | 21 | 1 | 2 | 3 | 4 | 5 | 6 |
| Support | | Type | A | A | A | A | B | A | A | B | A | A | A | A | B | A |
| | ΔHOMO | | 0.65 | 0.59 | 0.61 | 0.57 | 0.57 | 0.77 | 0.65 | 0.49 | 0.57 | 0.57 | 0.57 | 0.57 | 0.49 | 0.79 |
| | Coating amount of image-recording layer ($mg/m^2$) | | 531 | 620 | 702 | 848 | 848 | 625 | 630 | 774 | 621 | 621 | 621 | 621 | 774 | 621 |
| OC layer | Hydrophilic polymer | WP-1 | - | - | - | - | - | - | - | - | - | - | - | - | - | - |
| | | WP-2 | - | - | - | - | - | 900 | 800 | 900 | - | 750 | 750 | 750 | - | 750 |
| | | WP-3 | 600 | - | - | - | - | - | - | - | - | - | - | - | - | - |
| | | WP-4 | - | 700 | 1,300 | 900 | 1,000 | - | - | - | - | - | - | - | - | - |
| | Surfactant | | 1 | 1 | 2 | 1 | 1 | 1 | 1 | 1 | 0 | 1 | 1 | 1 | 0 | 1 |
| | Coating amount of OC layer ($mg/m^2$) | | 601 | 701 | 1,302 | 901 | 1,001 | 901 | 801 | 901 | 0 | 751 | 751 | 751 | 0 | 751 |
| Film thickness ratio (OC layer/image-recording layer) | | | 1.1 | 1.1 | 1.9 | 1.1 | 1.2 | 1.4 | 1.3 | 1.2 | 0.0 | 1.2 | 1.2 | 1.2 | 0.0 | 1.2 |
| Evaluation | UV printing durability | | 231 | 229 | 253 | 251 | 268 | 180 | 148 | 184 | 95 | 190 | 178 | 101 | 78 | 60 |
| | On-press developability | | 36 | 34 | 11 | 12 | 14 | 17 | 39 | 22 | 51 | 24 | 27 | 15 | 57 | 20 |
| | Visibility (ΔL) | | 7.4 | 6.5 | 5.5 | 12 | 8.1 | 2.4 | 3.2 | 4.4 | 4.6 | 5.1 | 4.9 | 5.3 | 4.7 | 1.9 |
| | Suppression of plate missing | | A | A | B | A | A | A | B | A | C | C | C | C | C | C |

[Table 4]

| | | | Image-recording layer | | | | | | | | | | | | OC layer | | | Film thickness ratio (OC layer/ image-recording layer) | Evaluation |
|---|---|---|---|---|---|---|---|---|---|---|---|---|---|---|---|---|---|---|---|
| | | support | Electron-accepting polymerization initiator | Cationic polymethine colorant | Electron-donating polymerization initiator | Polymerizable compound | Polymer particles | | | Color developing agent | Hydrophilic compound | Surfactant | ΔHOMO | Coating amount of image-recording layer (mg/m2) | Hydrophilic polymer | Surfactant | Coating amount of OC layer (mg/m2) | | Suppression of residues of on-press development |
| | | Type | I-1 | D-1 | B-1 | M-3 | R-1 | R-7 | R-8 | S-15 | T-3 | | | | WP-2 | | | | |
| Example | 4 | A | 120 | 30 | 20 | 100 | 300 | - | - | 35 | 12 | 4 | 0.57 | 621 | 750 | 1 | 751 | 1.2 | 4 |
| | 22 | A | 120 | 30 | 20 | 100 | - | 300 | - | 35 | 12 | 4 | 0.57 | 621 | 750 | 1 | 751 | 1.2 | 5 |
| | 23 | A | 120 | 30 | 20 | 100 | - | - | 300 | 35 | 12 | 4 | 0.57 | 621 | 750 | 1 | 751 | 1.2 | 5 |

In Table 2 to Table 4, the unit of the numerical value in each column of component is part by mass which represents the amount of solid content. In Table 2 to Table 4, "-" means that the example does not contain the corresponding component. In Table 2, "-" in the column of ΔHOMO for Example 13 means that the value is a negative number. In Table 2 to Table 4, "ΔHOMO" means a value obtained by subtracting the value of HOMO of the electron-donating polymerization initiator from the value of HOMO of the polymethine colorant.

The details of each compound in Table 2 to Table 4 other than the compounds described above are as below.

[Cationic polymethine colorant]

D-1 to D-8: Compounds having the following structures

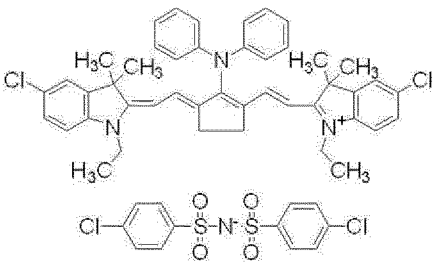

D-1 HOMO = -5.35 eV

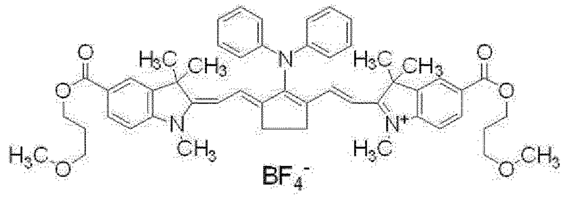

D-2 HOMO = -5.45 eV

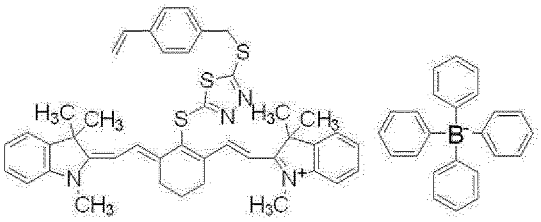

D-3 HOMO = -5.43 eV

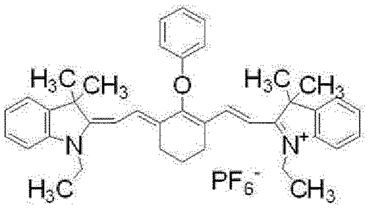

D-4 HOMO = -5.52 eV

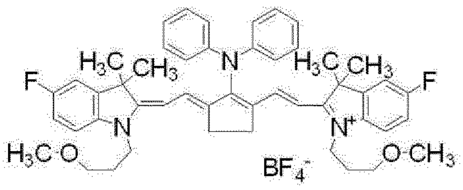

D-5 HOMO = -5.33 eV

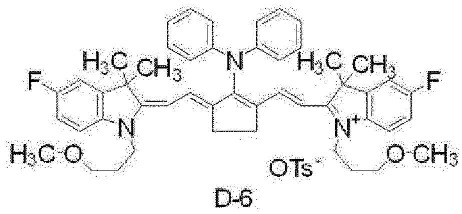

D-6 HOMO = -5.33 eV

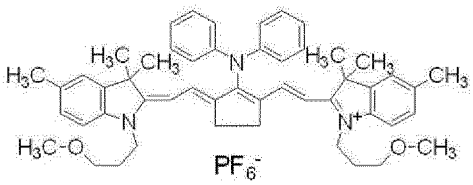

D-7 HOMO = -5.27 eV

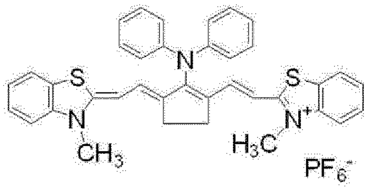

D-8 HOMO = -5.13 eV

[Electron-accepting polymerization initiator]

1-1 to 1-4: Compounds having the following structures

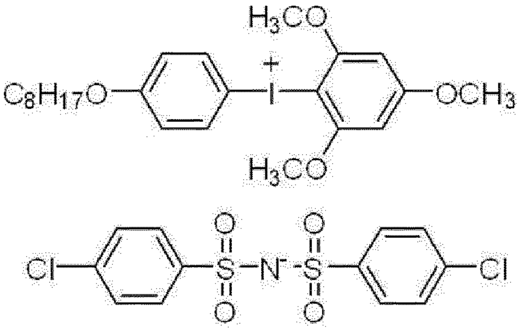

I - 1

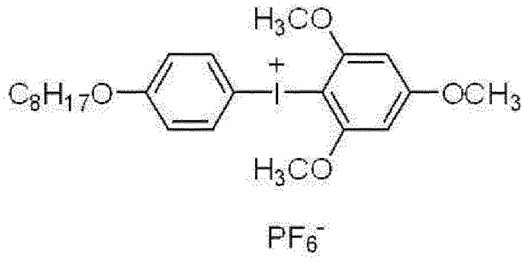

I - 2

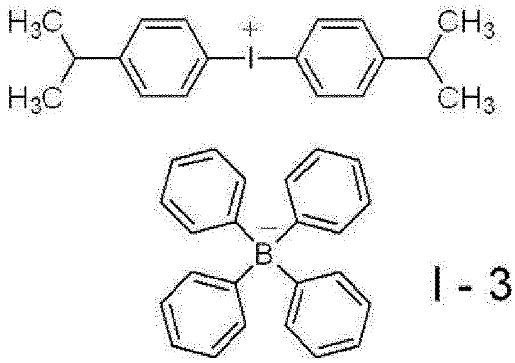

I - 3

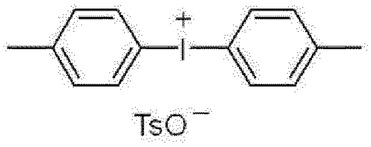

I - 4

In the above structure, $TsO^-$ represents a tosylate anion.

[Electron-donating polymerization initiator (polymerization aid)]

B-1 to B-5: Compounds having the following structures

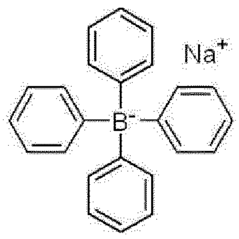

(B-1)

HOMO = -5.92 eV

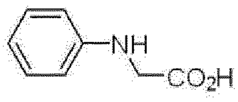

(B-3)

HOMO = -5.91 eV

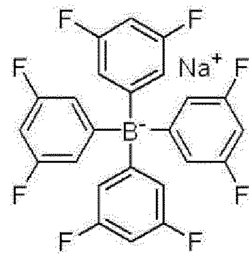

(B-5)

HOMO = -6.12 eV

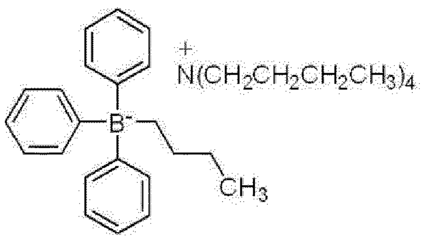

(B-2)

HOMO = -5.77 eV

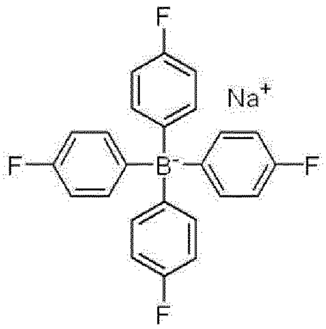

(B-4)

HOMO = -5.96 eV

[Color developing agent (acid color-developing agent)]

S-14: Red-40 (manufactured by Yamamoto Chemicals, Inc.)
S-15: S-205 (manufactured by Fukui Yamada Chemical Co., Ltd.)
S-16: Black-XV (manufactured by Yamamoto Chemicals, Inc.)
S-1, S-4, S-10, S-11, and S-14 are the same compounds as S-1, S-4, S-10, S-11, and S-14 described above.

[Polymerizable compound (monomer)]

M-1: Tris(acryloyloxyethyl)isocyanurate, NK ester A-9300, manufactured by SHIN-NAKAMURA CHEMICAL CO, LTD.
M-2: Dipentaerythritol pentaacrylate, SR-399, manufactured by Sartomer Company Inc.
M-3: Dipentaerythritol hexaacrylate, A-DPH manufactured by SHIN-NAKAMURA CHEMICAL CO, LTD.
M-4: Dipentaerythritol pentaacrylate hexamethylene diisocyanate urethane prepolymer, UA-510H manufactured by KYOEISHA CHEMICAL Co., LTD.

[Binder polymer]

Binder polymer P-1 (the following structure, Mw: 60,000, n = 2 (number of EO units))
Binder polymer P-2 (the following structure, Mw: 35,000, n = 2 (number of EO units))

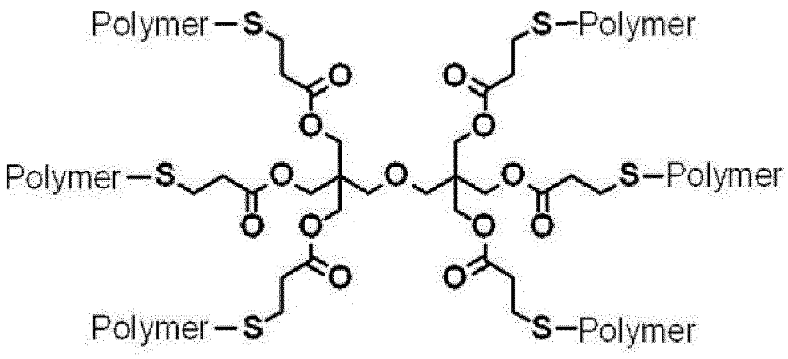

Polymer moiety

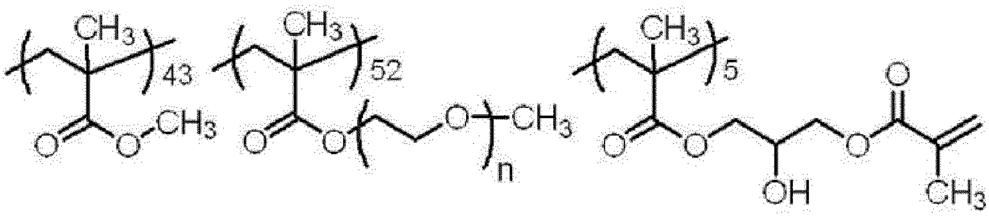

a=43, b=52, c=5 (mol%)
a=28 , b=64, c=8 (wt%)

P-1

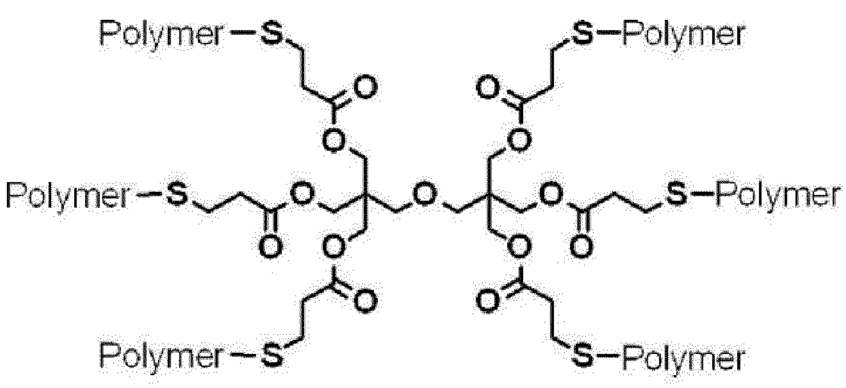

Polymer moiety

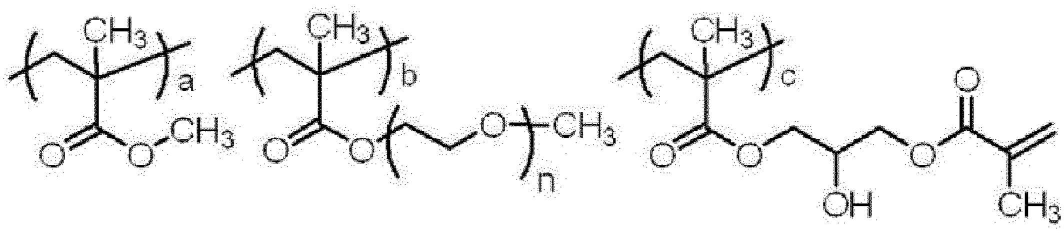

a=33, b=42, c=25 (mol%)
a=19 , b=46 , c=33 (wt%)

P-2

[Polymer particles]

R-1 to R-8: Polymer particles having the same structure as R-1 to R-8 described above.

A composition obtained by mixing together the components described in Table 3 other than the following microgel solution and the following microgel solution were mixed and stirred together immediately before coating so that the composition described in Table 3 was obtained, thereby preparing a coating solution for an image-recording layer containing MG-1: C=C valence 4.0 mmol/g, the following microgel (1), and polymer particles G-1 (microgel (1)).

-Preparation of microgel solution-

- Microgel (1) (polymer particles G-1): 2.640 parts
- Distilled water: 2.425 parts

Microgel (1) used in the aforementioned microgel solution was prepared by the following method.

-Preparation of polyvalent isocyanate compound (1)-

Bismuth tris(2-ethylhexanoate) (NEOSTANN U-600, manufactured by NITTO KASEI CO., LTD., 43 mg) was added to an ethyl acetate (25.31 g) suspension solution of 17.78 g (80 mmol) of isophorone diisocyanate and 7.35 g (20 mmol) of the following polyhydric phenol compound (1), and the obtained solution was stirred. The reaction temperature was set to 50°C at a point in time when heat release subsided, and the solution was stirred for 3 hours, thereby obtaining an ethyl acetate solution of the polyvalent isocyanate compound (1) (50% by mass).

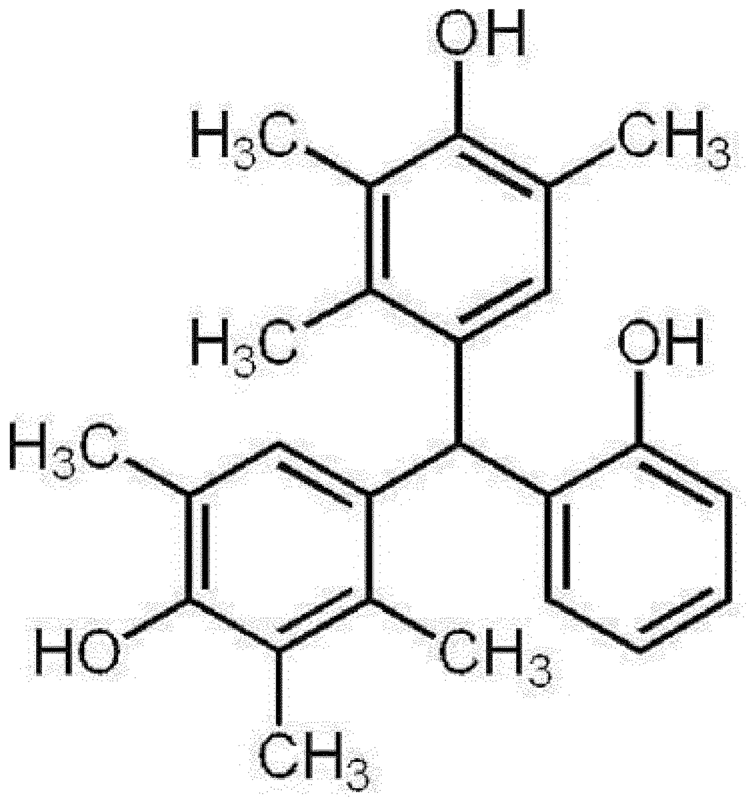

Polyhydric phenol compound (1)

-Preparation of microgel (1)-

The following oil-phase components and water-phase components were mixed together and emulsified at 12,000 rpm for 10 minutes by using a homogenizer. The obtained emulsion was stirred at 45°C for 4 hours, a 10% by mass aqueous solution of 5.20 g of 1,8-diazabicyclo[5.4.0]undec-7-ene-octylate (U-CAT SA102, manufactured by San-Apro Ltd.) was added thereto, and the solution was stirred at room temperature for 30 minutes and left to stand at 45°C for 24 hours. Distilled water was added thereto so that the concentration of solid contents was adjusted to 20% by mass, thereby obtaining an aqueous dispersion of microgel (1). The average particle diameter thereof measured by a light scattering method was 0.28 μm.

-Oil-phase components-

(Component 1) ethyl acetate: 12.0 parts
(Component 2) an adduct obtained by addition of trimethylolpropane (6 molar equivalents), xylene diisocyanate (18 molar equivalents), and polyoxyethylene having one methylated terminal (1 molar equivalent, the number of repeating oxyethylene units: 90) (50% by mass ethyl acetate solution, manufactured by Mitsui Chemicals, Inc.): 3.76 parts
(Component 3) polyvalent isocyanate compound (1) (as 50% by mass ethyl acetate solution): 15.0 parts
(Component 4) 65% by mass ethyl acetate solution of dipentaerythritol pentaacrylate (SR-399, manufactured by Sartomer Company Inc.): 11.54 parts
(Component 5) 10% ethyl acetate solution of sulfonate type surfactant (PIONINE A-41-C, manufactured by TAKEMOTO OIL & FAT Co., Ltd.): 4.42 parts

-Water-phase component-

Distilled water: 46.87 parts

[Hydrophilic compound]

T-1: Tris(2-hydroxyethyl) isocyanurate
T-3: Hydroxypropyl cellulose, Klucel M, manufactured by Hercules Incorporated

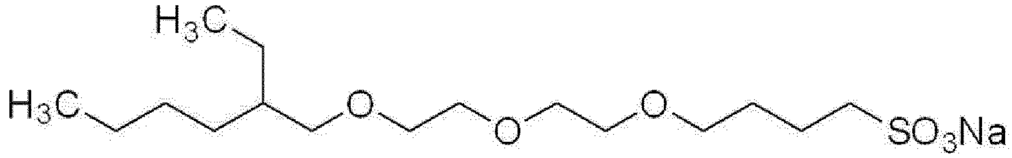

T - 2

[Hydrophobic compound (oil sensitizing agent)]

C-1: Compound having the following structure
C-2: Benzyldimethyloctylammonium·$PF_6$ salt
C-3: Compound having the following structure

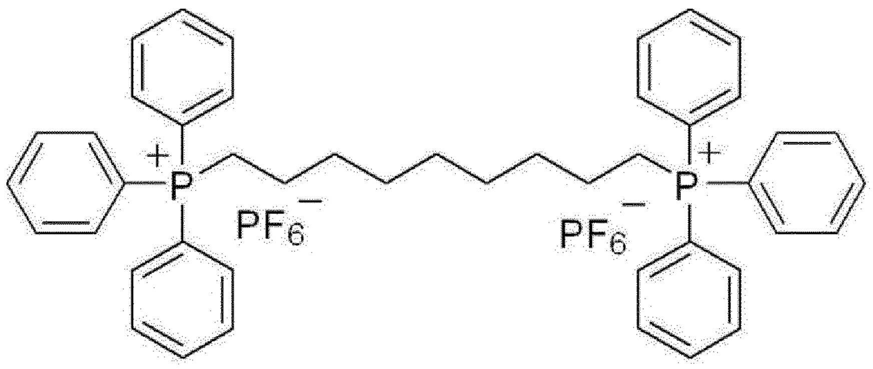

CL - 1

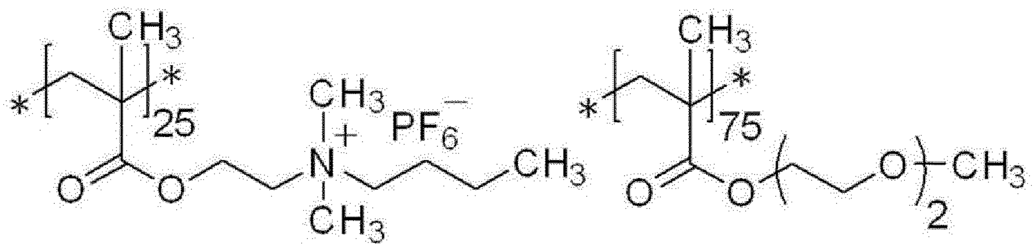

CL - 3

[Surfactant]

F-781F: Fluorine-based surfactant, manufactured by DIC Corporation

As is evident from the results shown in Table 2 and Table 3, the lithographic printing plate precursors according to the present disclosure shown in examples have better UV printing durability and better on-press developability, compared to the lithographic printing plate precursors of comparative examples.

Furthermore, as is evident from the results shown in Table 2 and Table 3, the lithographic printing plate precursors according to the present disclosure in examples also have excellent visibility.

As is evident from the results shown in Table 4, the lithographic printing plate precursors according to the present disclosure in Examples 2, 22, and 24 excellently suppress development residues during on-press development.

(Examples 24 to 29)

<Preparation of coating solutions (2) and (3) for undercoat layer>

Coating solutions (2) and (3) for an undercoat layer having the following compositions were prepared.

-Composition of coating solution (2) for undercoat layer-

- Polymer (P-1) [the above structure]: 0.18 parts
- Surfactant (EMALEX 710, manufactured by NIHON EMULSION Co., Ltd.): 0.03 parts by mass
- Water: 28.0 parts by mass

-Composition of coating solution (3) for undercoat layer-

- Polymer (P-1) [the above structure]: 0.18 parts by mass
- Surfactant (EMALEX 710, manufactured by NIHON EMULSION Co., Ltd.): 0.03 parts by mass
- Hydrophilic compound: amounts listed in Table 5.
- Water: 28.0 parts by mass

<Preparation of image-recording layer>

The support A was coated with the coating solution for an undercoat layer described in the following Table 5 so that the dry coating amount was 20 $mg/m^2$. In this way, an undercoat layer was formed.
The undercoat layer was bar-coated with each coating solution for an image-recording layer for forming an image-recording layer having the composition described in Table 5, followed by drying in oven at 120°C for 40 seconds, thereby forming an image-recording layer having a dry coating amount of 1.0 $g/m^2$.
The coating solution for an image-recording layer was prepared by mixing in and stirring the polymer particles immediately before coating.
Then, the image-recording layer was bar-coated with each coating solution for an overcoat layer for forming an overcoat layer having the composition described in Table 5, so that the coating amount described in Table 5 was achieved, followed by drying in an oven at 120°C for 60 seconds, thereby forming an overcoat layer.

<Evaluation of suppression of scratches and contamination>

In Luxel PLATESETTER T-6000III manufactured by FUJIFILM Corporation that was equipped with an infrared semiconductor laser, each of the obtained lithographic printing plate precursors was exposed under the conditions of outer drum rotation speed of 1,000 rpm (revolutions per minute), a laser output of 70%, and resolution of 2,400 dpi. After the exposure treatment, the lithographic printing plate obtained in an environment of a temperature of 25°C and a humidity of 70% was scratched by a scratch tester.
As the scratch tester, HEIDON scratching Intensity TESTER HEIDON-18 was used. In addition, a sapphire needle having a diameter of 0.1 mm was used, and the scratch load was set to 50 (g). Without being subjected to a development treatment, the scratched plate was mounted on the plate cylinder of DIA IF2 printer manufactured by Mitsubishi Heavy Industries, Ltd. By using dampening water containing IF102 (manufactured by FUJIFILM Corporation)/tap water = 3/97 (volume ratio) and Values-G(N) black ink (manufactured by DIC Corporation), on-press development was performed by supplying the dampening water and the ink according to the standard automatic printing start method of DIA IF2. Then, printing was performed using TOKUBISHI art paper (ream weight: 76.5 kg) at a printing rate of 10,000 sheets/hour, and whether the scratched portion turned into a printing stain was evaluated. In addition, regarding the intermediate points such as 9 points and 7 points, in a case where the scratches and contamination of an example is in the intermediate level of the evaluation standard of upper limit, the intermediate points were given to the example. The evaluation standards of 10 to 6 points are preferable. The results are shown in Table 5.

-Evaluation standard-

10 points: The scratched portion does not turn into a printing stain.
8 points: Slight printing stains that cannot be visually identified are observed on the scratched portion.
6 points: Slight printing stains are visually observed on the scratched portion.
4 points: Printing stains are visually observed on the scratched portion.
2 points: Clear printing stains are observed on the scratched portion.

[Table 5]

| | | Support | | Layer on support | | | Image-recording layer | | | | | | | | | | OC layer | | | Film thickness ratio (OC layer/ image-recording layer) | Evaluation |
|---|---|---|---|---|---|---|---|---|---|---|---|---|---|---|---|---|---|---|---|---|---|
| | | | | Coating amount of undercoat layer | Hydrophilic compound | | Electron-accepting polymerization initiator | Cationic polymethine colorant | Electron-donating polymerization initiator | Polymerizable compound | Polymer particles | Color developing agent | Hydrophilic compound | Surfactant | ΔHOMO | Coating amount of image-recording layer (mg/m$^2$) | Hydrophilic polymer | Surfactant | Coating amount of OC layer (mg/m$^2$) | | Suppression of scratches and contamination |
| | | Type | ΔContact angle | Type | Type | Part by mass | I-1 | D-1 | B-1 | M-3 | R-7 | S-15 | T-3 | | | | WP-2 | | | | |
| Example | 24 | A | 80 | (2) | | | 120 | 30 | 20 | 100 | 300 | 35 | 12 | 4 | 0.6 | 621 | 750 | 1 | 751 | 1.2 | 5 |
| | 25 | A | 60 | (3) | Ethylenediaminetetraacetic acid 4Na | 0.01 | 120 | 30 | 20 | 100 | 300 | 35 | 12 | 4 | 0.6 | 621 | 750 | 1 | 751 | 1.2 | 6 |
| | 26 | A | 20 | (3) | Ethylenediaminetetraacetic acid 4Na | 0.03 | 120 | 30 | 20 | 100 | 300 | 35 | 12 | 4 | 0.6 | 621 | 750 | 1 | 751 | 1.2 | 7 |
| | 27 | A | 9 | (3) | Tartaric acid 2K | 0.08 | 120 | 30 | 20 | 100 | 300 | 35 | 12 | 4 | 0.6 | 621 | 750 | 1 | 751 | 1.2 | 10 |
| | 28 | A | 8 | (3) | Shikimic acid Na | 0.06 | 120 | 30 | 20 | 100 | 300 | 35 | 12 | 4 | 0.6 | 621 | 750 | 1 | 751 | 1.2 | 10 |
| | 29 | A | 6 | (3) | Gluconic acid Na | 0.07 | 120 | 30 | 20 | 100 | 300 | 35 | 12 | 4 | 0.6 | 621 | 750 | 1 | 751 | 1.2 | 10 |

"Surface contact angle" shown in Table 5 represents a water contact angle on a surface of the aluminum support on the image-recording layer side that is measured by an airborne water droplet method. The contact angle was measured by the method described above. In Table 5, "ΔHOMO" means a value obtained by subtracting the value of HOMO of the electron donating group from the value of HOMO of the polymethine colorant.

The details of the compound used in the image-recording layer and the overcoat layer (OC layer) described in Table 5 are as below.

Furthermore, the details of the hydrophilic compounds used in the undercoat layer described in Table 5 are as below.

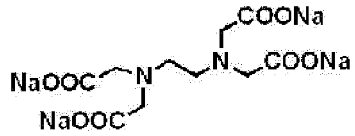

Ethylenediaminetetraacetic acid 4Na

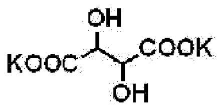

Tartaric acid 2K

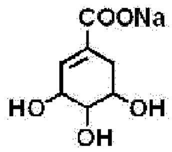

Shikimic acid Na

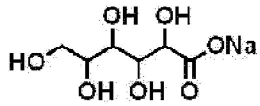

Gluconic acid Na

(Examples 30 to 36)

<Preparation of lithographic printing plate precursor>

The lithographic printing plate precursors of Examples 30 to 36 were prepared by the following method.

(Preparation of support X)

(X-a) Alkaline etching treatment

From a spray tube, an aqueous solution of caustic soda having a caustic soda (sodium hydroxide) concentration of 26% by mass and an aluminum ion concentration of 6.5% by mass was sprayed onto the aluminum plate at a temperature of 70°C, thereby performing an etching treatment. Then, rinsing was performed by means of spraying. The amount of dissolved aluminum within the surface to be subjected to the electrochemical roughening treatment later was 1.0 g/$m^2$.

(X-b) Desmutting treatment in aqueous acidic solution (first desmutting treatment)

Next, a desmutting treatment was performed in an aqueous acidic solution. In the desmutting treatment, a 150 g/L aqueous sulfuric acid solution was used as the aqueous acidic solution. The liquid temperature was 30°C. The desmutting treatment was performed for 3 seconds by spraying the desmutting liquid. Then, a rinsing treatment was performed.

(X-c) Electrochemical roughening treatment in aqueous hydrochloric acid solution

Next, an electrolytic roughening treatment was performed using alternating current and an electrolytic solution having a hydrochloric acid concentration of 14 g/L, an aluminum ion concentration of 13 g/L, and a sulfuric acid concentration of 3 g/L. The liquid temperature of the electrolytic solution was 30°C. The aluminum ion concentration was adjusted by adding aluminum chloride. The waveform of the alternating current was a sine wave in which positive and negative waveforms are symmetrical, the frequency was 50 Hz, the ratio of the anodic reaction time and the cathodic reaction time in one cycle of the alternating current was 1:1, and the current density was 75 A/$dm^2$ in terms of the peak current value of the alternating current waveform. In addition, the quantity of electricity was 450 C/$dm^2$ which is the total quantity of electricity used for the aluminum plate to have an anodic reaction, and the electrolysis treatment was performed 4 times by conducting electricity of 125 C/$dm^2$ for 4 seconds at each treatment session. A carbon electrode was used as the counter electrode of the aluminum plate. Then, a rinsing treatment was performed.

(X-d) Alkaline etching treatment

From a spray tube, an aqueous solution of caustic soda having a caustic soda concentration of 5% by mass and an aluminum ion concentration of 0.5% by mass was sprayed onto the aluminum plate having undergone the electrochemical roughening treatment at a temperature of 45°C, thereby performing an etching treatment. The amount

of dissolved aluminum within the surface having undergone the electrochemical roughening treatment was 0.2 $g/m^2$. Then, a rinsing treatment was performed.

(X-e) Desmutting treatment in aqueous acidic solution

Next, a desmutting treatment was performed in an aqueous acidic solution. In the desmutting treatment, a waste liquid generated in the anodic oxidation treatment step (170 g/L aqueous sulfuric acid solution containing dissolved aluminum ions at 5.0 g/L) was used as an aqueous acidic solution. The liquid temperature was 30°C. The desmutting treatment was performed for 3 seconds by spraying the desmutting liquid.

(X-f) First-stage anodic oxidation treatment

By using the anodic oxidation treatment device for direct current electrolysis having the structure shown in Fig. 5, a first-stage anodic oxidation treatment was performed. Specifically, the anodic oxidation treatment was performed under the conditions described in the column of "First anodic oxidation treatment" shown in the following Table 6, thereby forming an anodic oxide film having a predetermined film amount.

(X-g) Pore widening treatment

The aluminum plate having undergone the above anodic oxidation treatment was immersed in an aqueous solution of caustic soda at a temperature of 35°C and having a caustic soda concentration of 5% by mass and an aluminum ion concentration of 0.5% by mass under the conditions shown in the following Table 6, thereby performing a pore widening treatment. Then, rinsing was performed by means of spraying.

(X-h) Second-stage anodic oxidation treatment

By using the anodic oxidation treatment device for direct current electrolysis having the structure shown in Fig. 5, a second-stage anodic oxidation treatment was performed. Specifically, the anodic oxidation treatment was performed under the conditions described in the column of "Second anodic oxidation treatment" shown in the following Table 6, thereby forming an anodic oxide film having a predetermined film amount.

Through the above treatments, a support X was obtained.

For the obtained support X, Table 7 shows the brightness L* of the micropores within the surface of the anodic oxide film in the L*a*b* color space, the average diameter of the large diameter portion within the surface of the anodic oxide film having micropores, the average diameter (nm) of the small diameter portion at a communication position, the depth (nm) of the large diameter portion and the small diameter portion, the pit density (micropore density, unit; number of micropores/$\mu m^2$), and the film amount (nm) of the anodic oxide film from the bottom portion of the small diameter portion to the surface of the aluminum plate.

In the support X, the average diameter of the micropores (average diameter of the large diameter portion and the small diameter portion) is a value obtained by observing the surface of the large diameter portion and the surface of the small diameter portion with FE-SEM at a 150,000X magnification (N= 4), and measuring the diameters of the micropores (large diameter portion and small diameter portion) in a range of 400 nm × 600 nm in the obtained 4 images, and calculating the average thereof. In a case where the large diameter portion was deep, it was difficult to measure the diameter of the small diameter portion, and the diameter of an enlarged portion in the small diameter portion needed to be measured, the upper portion of the anodic oxide film was cut, and then various diameters were calculated.

The depth of the micropores (depth of the large diameter portion and the small diameter portion) is a value obtained by observing the cross section of the support (anodic oxide film) with FE-SEM (observation of the depth of the large diameter portion: 150,000X magnification, observation of depth of small diameter portion: 50,000X magnification), measuring the depths of 25 random micropores in the obtained image, and calculating the average thereof.

In Table 6, the film amount in the column of "First anodic oxidation treatment" and the film amount in the column of "Second anodic oxidation treatment" represent thefilm amount obtained by each treatment. As electrolytic solutions, the aqueous solutions containing the liquid components in Table 6 were used.

[Table 6]

| Support X | First anodic oxidation treatment | | | | | | |
|---|---|---|---|---|---|---|---|
| | Liquid type | Liquid component | Component concentration (g/L) | Temperature (°C) | Current density (Å /dm$^3$) | Time (s) | Filmamount (g/m$^2$) |
| | Sulfuric acid | $H_2SO_4$/Al | 170/5 | 40 | 8 | 4 | 0.25 |
| | Pore widening treatment | | | | | | |
| | Liquid component | | Temperature (°C) | Time (s) | | | |
| | NaOH 5%/A1 0.5% | | 35 | 3 | | | |
| | Second anodic oxidation treatment | | | | | | |
| | Liquid type | Liquid component | Component concentration (g/L) | Temperature (°C) | Current density (Å /dm$^3$) | Time (s) | Filmamount (g/m$^2$) |
| | Sulfuric acid | $H_2SO_4$/Al | 170/5 | 50 | 13 | 25 | 3.35 |

[Table 7]

| Support X | Large diameter portion | | | Small diameter portion | | | Density of micropores (number/$\mu m^2$) | Film thickness (nm) | Brightness $L^*$ |
|---|---|---|---|---|---|---|---|---|---|
| | Average diameter (nm) | Shape | Depth (nm) | Average diameter of communication position (nm) | Shape | Depth (nm) | | | |
| | 26 | Straight tubular | 100 | 10 | Straight tubular | 1,400 | 1,080 | 1,500 | 78 |

(Preparation of support Y)

-Alkaline etching treatment-

An aqueous solution of caustic soda having a caustic soda concentration of 26% by mass and an aluminum ion concentration of 6.5% by mass was sprayed onto the aluminum plate at a temperature of 55°C, thereby performing an etching treatment. Then, rinsing was performed by means of spraying. The amount of dissolved aluminum within the surface to be subjected to the electrochemical roughening treatment later was 3 g/$m^2$.

-Desmutting treatment using aqueous acidic solution (first desmutting treatment)-

Next, a desmutting treatment was performed using an aqueous acidic solution. In the desmutting treatment, a 170 g/L aqueous sulfuric acid solution was used as the aqueous acidic solution. The liquid temperature was 30°C. The desmutting treatment was performed for 3 seconds by spraying the aqueous acidic solution onto the aluminum plate. Then, a rinsing treatment was performed.

-Electrochemical roughening treatment-

Next, an electrochemical roughening treatment was performed using an electrolytic solution at a hydrochloric acid concentration and alternating current. The liquid temperature of the electrolytic solution was 40°C. The waveform of the alternating current was a sine wave in which the positive and negative waveforms are symmetrical, and the frequency was 50 Hz. The quantity of electricity was 300 C/$dm^2$, which is the total quantity of electricity that the aluminum plate stores during the anodic reaction. A carbon electrode was used as the counter electrode of the aluminum plate. Then, a rinsing treatment was performed.

-Alkaline etching treatment-

An aqueous solution of caustic soda having a caustic soda concentration of 5% by mass and an aluminum ion concentration of 0.5% by mass was sprayed onto the aluminum plate having undergone the electrochemical roughening treatment at a temperature of 35°C so that an etching amount was 0.1 g/$m^2$ or less, thereby performing an etching treatment. Then, a rinsing treatment was performed.

-Desmutting treatment using aqueous acidic solution-

Next, a desmutting treatment was performed using an aqueous acidic solution. In the desmutting treatment, a 170 g/L aqueous sulfuric acid solution was used as the aqueous acidic solution. The liquid temperature was 30°C. The desmutting treatment was performed for 3 seconds by spraying the aqueous acidic solution onto the aluminum plate. Then, a rinsing treatment was performed.

-Anodic oxidation treatment-

An anodic oxidation treatment was performed using 170 g/L of a sulfuric acid solution and direct current at a liquid temperature of 40°C so that the amount of the anodic oxide film was 3 g/$m^2$.

Through the above treatments, a support Y was obtained.

(Formation of undercoat layer)

The support described in Table 8 was coated with any of the coating solution A or B for an undercoat layer described in Table 8 so that a dry coating amount of 20 mg/$m^2$ was obtained, and the support was dried in an oven at 100°C for 30 seconds, thereby forming an undercoat layer.

-Composition of coating solution A for undercoat layer-

- Polymer (P-1) [the above structure]: 0.14 parts
- CHELEST 400 (EDTA·4Na·4$H_2O$, manufactured by CHELEST CORPORATION): 0.035 parts

- CHELEST 3EAF (N- (2-Hydroxyethyl)iminodiacetic Acid (CAS 93-62-9), manufactured by CHELEST CORPORATION): 0.035 parts
- Surfactant (EMALEX 710, manufactured by NIHON EMULSION Co., Ltd.): 0.0016 parts
- Preservative (BIOHOPE L, manufactured by K·I Chemical Industry Co., LTD.): 0.0015 parts
- Water: 3.29 parts

-Composition of coating solution B for undercoat layer-

The coating solution B has the same composition as the aforementioned coating solution (1) for an undercoat layer.

(Formation of image-recording layer)

The undercoat layer was bar-coated with each coating solution for an image-recording layer for forming an image-recording layer having the composition described in Table 8, so that the dry coating amount described in Table 8 was achieved, followed by drying in oven at 120°C for 40 seconds, thereby forming an image-recording layer.

Each component used in the image-recording layer will be shown below.

[Cationic polymethine colorant]

D'-1: Compound having the following structure, (HOMO = -5.35 eV)
D'-2: Compound having the following structure, (HOMO = -5.31 eV)
D'-3: Compound having the following structure, (HOMO = -5.32 eV)

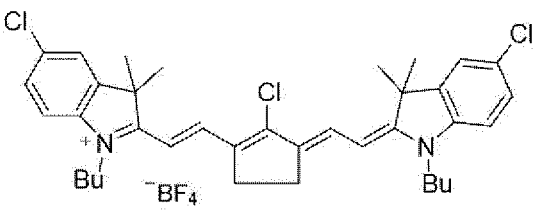

D'-1

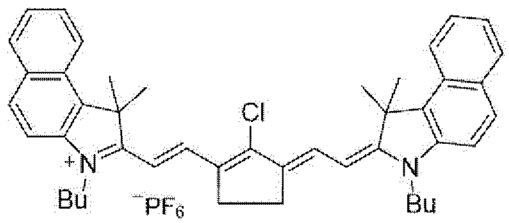

D'-2

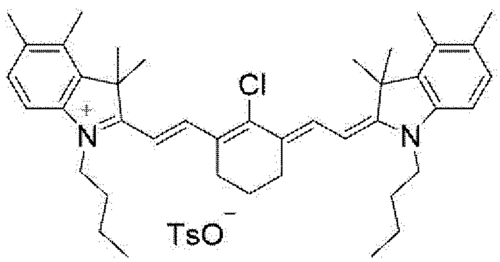

D'-3

In the above structure, $TsO^-$ represents a tosylate anion.

[Electron-accepting polymerization initiator]

I'-1: Compound having the following structure
I'-2: Compound having the following structure

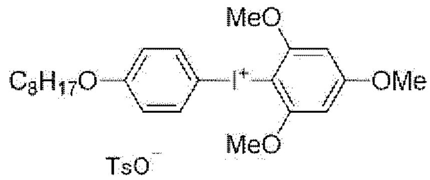

I'-1

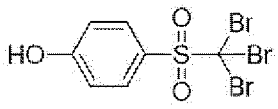

I'-2

[Color developing agent (acid color-developing agent)]

S'-I: Compound having the following structure
S'-2: Compound having the following structure

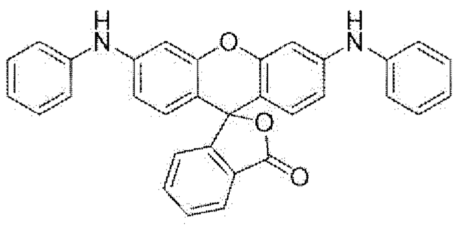

S'-1

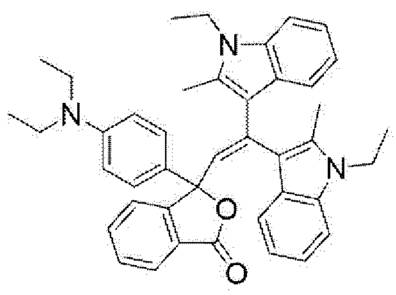

S'-2

[Electron-donating polymerization initiator (polymerization aid)]

B'-I: Electron-donating polymerization initiator B-1 having the above structure (HOMO: -5.92 eV)

[Polymerizable compound (monomer)]

M'-1: Compound synthesized by the following method (C=C valence: 6.8 mmol/g, weight-average molecular weight: 150,000, C=C equivalent: 147 g/mol)

-Synthesis of M'-1-

A mixed solution of TAKENATE (registered trademark) D-116N (manufactured by Mitsui Chemicals, Inc., 4.7 parts by mass) as polyisocyanate, ARONIX (registered trademark) M-403 (manufactured by TOAGOSEI CO., LTD.) as a hydroxyl group-containing polyfunctional acrylate in such an amount that the ratio of the NCO value of polyisocyanate to the hydroxyl number of hydroxyl group-containing polyfunctional acrylate is 1:1, 0.02 parts by mass of t-butylbenzoquinone, and 11.5 parts by mass of methyl ethyl ketone was heated at 65°C. NEOSTANN U-600 (bismuth-based polycondensation catalyst, manufactured by NITTO KASEI CO., LTD., 0.11 parts by mass) was added to the reaction solution, and the reaction solution was heated at the same temperature for 4 hours. The reaction solution was cooled to room temperature (25°C), and methyl ethyl ketone was added thereto, thereby synthesizing a urethane acrylate solution having a solid content of 50% by mass.

Subsequently, by using recycling GPC (instrument: LC908-C60, column: JAIGEL-1H-40 and 2H-40 (manufactured by Japan Analytical Industry Co., Ltd.)) and tetrahydrofuran (THF) as an eluent, molecular weight fractionation of the urethane acrylate solution was performed.

In this way, a compound M'-1 was obtained which has a weight-average molecular weight: 150,000 and an ethylenically unsaturated bond valence of 6.8 mmol/g.

The weight-average molecular weight of the compound M'-1 was measured by the following measurement instruments and methods.

GPC measurement instrument: TOSOH HLC-8320 GPC, GPC mobile phase: THF
Inspector: Differential Refractometer (RI), flow rate: 0.35 mL/min
Columns: TSKgel SuperHZM-M, TSKgel SuperHZ4000, TSKgel SuperHZ3000, and TSKgel SuperHZ2000 were connected and used.
Column temperature: 40°C
Standard sample for molecular weight calibration curve: polystyrene (PS)

The ethylenically unsaturated bond valence (C=C valence) of the compound M'-1 was calculated based on the structure of the compound (model) obtained by the structural analysis performed by 1H-NMR spectroscopy.

M'-2: Ethoxylated isocyanuric acid triacrylate, A-9300 manufactured by SHIN-NAKAMURA CHEMICAL CO, LTD., C=C valence: 7.09 mmol/g
M'-3: Compound having the following structure (C=C valence: 4.25 mmol/g)
M'-4: Compound having the following structure (C=C valence: 4.42 mmol/g)

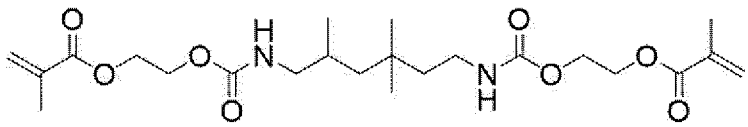

M' - 3

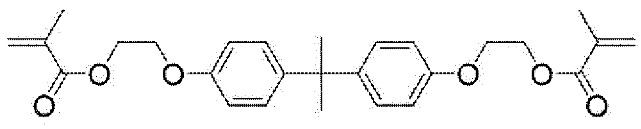

M' - 4

[Polymer particles]

R'-1: Polymer particles having the same structure as R-1 described above.

R'-2: Polymer particles having the same structure as R-2 described above.

[Binder polymer]

P'-1: S-LEC BL-10, partially acetylated polyvinyl butyral, manufactured by SEKISUI CHEMICAL CO., LTD.

[Hydrophilic compound]

T'-2: Hydrophilic compound T-1 having the above structure

[Additive]

O'-1: Compound having the following structure (chain transfer agent)

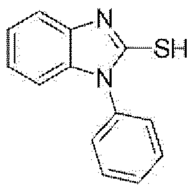

O'-1

[Surfactant]

U'-1: Compound having the following structure

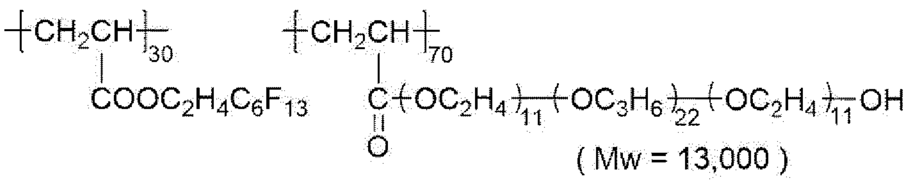

U'-1

U'-2: Compound having the following structure

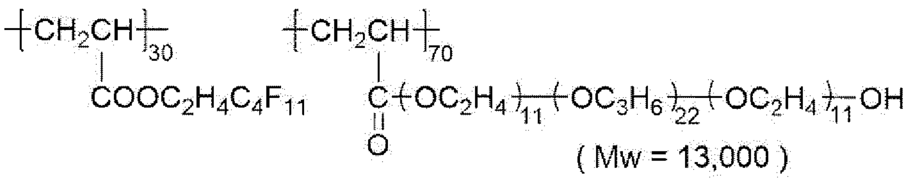

U'-2

(Formation of overcoat layer (OC layer))

The image-recording layer was bar-coated with each coating solution for an overcoat layer for forming an overcoat layer having the composition described in Table 8, so that the coating amount described in Table 8 was achieved, followed by drying in an oven at 120°C for 60 seconds, thereby forming an overcoat layer. Details of the compounds used in the coating solutions for an overcoat layer in Table 8 will be shown below.

Each component used in the overcoat layer will be shown below.

[Water-soluble polymer]

WP'-1: Polyvinyl alcohol (GOHSENOL (registered trademark) L-3266 manufactured by Mitsubishi Chemical Corporation., saponification degree of 86 to 88 mol%)
WP'-2: Polyvinyl alcohol (Mowiol (registered trademark) 4-88, manufactured by Sigma-Aldrich Co. LLC., saponification degree 88 mol%)
WP'-3: Polyvinyl alcohol (Mowiol (registered trademark) 8-88, manufactured by Sigma-Aldrich Co. LLC., saponification degree 88 mol%)

[Hydrophobic polymer particles]

WR'-1: Styrene-acrylic resin particles (FINESPHERE (registered trademark) FS-102, manufactured by Nipponpaint Industrial Coatings Co., LTD., Tg = 103°C)
WR'-2: aqueous polyvinylidene chloride dispersion (Diofan (registered trademark) A50 manufactured by Solvin S.A.)

[Surfactant]

V'-1: EMALEX 710 (manufactured by NIHON EMULSION Co., Ltd.)

[Discoloring compound]

wIR'-1: Infrared absorber having the following structure

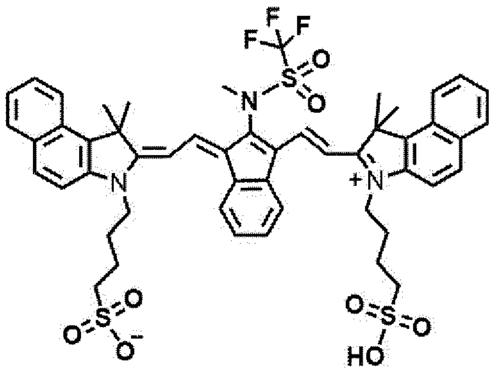

wIR' - 1

For the obtained lithographic printing plate precursors, UV printing durability, on-press developability, visibility (ΔL), and suppression of plate missing were evaluated in the same manner as in Example 1.
The results are shown in Table 8.

[Table 8]

| | | Example | | | | | | |
|---|---|---|---|---|---|---|---|---|
| | | 30 | 31 | 32 | 33 | 34 | 35 | 36 |
| Support | Type | X | X | X | X | Y | Y | X |
| Undercoat layer | Type | A | A | A | A | B | B | A |

(continued)

| | | | Example | | | | | | |
|---|---|---|---|---|---|---|---|---|---|
| | | | 30 | 31 | 32 | 33 | 34 | 35 | 36 |
| Image-recording layer | Cationic polymethine colorant | D'-1 | 20 | 20 | 18 | - | - | - | 20 |
| | | D'-2 | - | - | - | 20 | - | - | - |
| | | D'-3 | - | - | - | - | 26 | 20 | - |
| | Electron-accepting polymerization initiator | I'-1 | 109 | 109 | 120 | 109 | - | 60 | 109 |
| | | I'-2 | - | - | - | - | 60 | - | - |
| | Leuco colorant | S'-1 | 25 | 25 | 25 | 25 | - | - | 25 |
| | | S'-2 | - | - | - | - | 30 | 30 | |
| | Electron-donating polymerization initiator | B'-1 | 25 | 25 | 25 | 25 | 50 | 50 | 25 |
| | Polymerizable compound | M'-1 | 175 | 200 | 100 | 175 | - | 100 | 175 |
| | | M'-2 | 100 | - | 100 | 100 | - | | 100 |
| | | M'-3 | - | - | - | - | 250 | 100 | - |
| | | M'-4 | - | - | - | - | 250 | 100 | - |
| | Polymer particles | R'-1 | 400 | 400 | 300 | - | - | - | 400 |
| | | R'-2 | - | - | - | 500 | 100 | 100 | - |
| | Binder polymer | P'-1 | - | - | - | - | 150 | 150 | - |
| | Hydrophilic compound | T'-1 | 12 | 12 | 12 | 12 | - | - | 12 |
| | Additive | O'-1 | 40 | 40 | 40 | 40 | - | - | 40 |
| | Surfactant | U'-1 | 4 | 4 | 4 | 4 | - | - | - |
| | | U'-2 | - | - | - | - | - | - | 4 |
| | ΔHOMO | | 0.57 | 0.57 | 0.57 | 0.61 | 0.60 | 0.60 | 0.57 |
| | Dry coating amount mg/$m^2$ | | 910 | 835 | 744 | 1010 | 916 | 710 | 910 |
| OC layer | Hydrophilic polymer | WP'-1 | 1000 | 900 | 900 | 1100 | - | 300 | 1000 |
| | | WP'-2 | - | - | 200 | - | 400 | - | - |
| | | WP'-3 | - | - | - | - | 300 | 300 | - |
| | Hydrophobic resin particle s | WR'-1 | 17 | 17 | 17 | 17 | - | - | 17 |
| | | WR'-2 | - | - | - | - | 300 | 300 | |
| | Surfactant | V'-1 | 3.5 | 3.5 | 3.5 | 3.5 | - | - | 3.5 |
| | Discoloring compound | wIR'-1 | - | - | - | - | 20 | 20 | - |
| | Dry coating amount mg/$m^2$ | | 1021 | 921 | 1121 | 1121 | 1020 | 920 | 1021 |
| Film thickness ratio (OC layer/image-recording layer) | | | 1.1 | 1.1 | 1.5 | 1.1 | 1.1 | 1.3 | 1.1 |
| Evaluation | UV printing durability | | 230 | 228 | 240 | 260 | 250 | 240 | 230 |
| | On-press developability [sheets] | | 15 | 16 | 20 | 18 | 16 | 18 | 16 |
| | Visibility (ΔL) | | 11.5 | 12.0 | 11.8 | 11.2 | 4.1 | 4.0 | 11.7 |
| | Suppression of plate missing | | A | A | A | A | A | A | A |

In Table 8, the unit of the numerical value in each column of component is part by mass which represents the amount of solid content. In Table 8, "-" means that the example does not contain the corresponding component. In Table

8, "ΔHOMO" means a value obtained by subtracting the value of HOMO of the electron-donating polymerization initiator from the value of HOMO of the polymethine colorant.

As is evident from the results shown in Table 8, the lithographic printing plate precursors according to the present disclosure shown in examples are also excellent in all of the UV printing durability, on-press developability, visibility (ΔL), and suppression of plate missing.

(Explanation of References)

18: aluminum plate, 12a, 12b: aluminum support, 20a, 20b: anodic oxide film, 22a, 22b: micropore, 24: large diameter portion, 26: small diameter portion, D: depth of large diameter portion, ta: anodic reaction time, tc: cathodic reaction time, tp: time taken for current to reach peak from 0, Ia: peak current on anodic cycle side, Ic: peak current on cathodic cycle side, AA: current of anodic reaction of aluminum plate, CA: current of cathodic reaction of aluminum plate, 50: main electrolytic cell, 51: alternating current power source, 52: radial drum roller, 53a, 53b: main pole, 54: electrolytic solution supply port, 55: electrolytic solution, 56: slit, 57: electrolytic solution path, 58: auxiliary anode, 60: auxiliary anode tank, A1: electrolytic solution supply direction, A2: electrolytic solution discharge direction, W: aluminum plate, 610: anodic oxidation treatment device, 616: aluminum plate, 618: electrolytic solution, 612: power supply tank, 614: electrolytic treatment tank, 616: aluminum plate, 620: power supply electrode, 622: roller, 624: nip roller, 626: electrolytic solution, 628: roller, 630: electrolysis electrode, 634: direct current power source

The entirety of the disclosure of Japanese Patent Application No. 2019-122490 filed on June 28, 2019, disclosure of Japanese Patent Application No. 2019-158806 filed on August 30, 2019, and disclosure of Japanese Patent Application No. 2019-169798 filed on September 18, 2019 is incorporated into the present specification by reference.

All of documents, patent applications, and technical standards described in the present specification are incorporated into the present specification by reference to approximately the same extent as a case where it is specifically and respectively described that the respective documents, patent applications, and technical standards are incorporated by reference.

## Claims

1. A lithographic printing plate precursor comprising, in the following order:

   an aluminum support;
   an image-recording layer; and
   a water-soluble overcoat layer,
   wherein the image-recording layer contains an infrared-absorbing polymethine colorant having HOMO of -5.2 eV or less, a polymerization initiator, a polymerizable compound, and a polymer, and
   the polymer has a constitutional unit formed of an aromatic vinyl compound and a constitutional unit formed of an acrylonitrile compound.

2. The lithographic printing plate precursor according to claim 1,
   wherein the polymethine colorant includes a cyanine dye that has an electron-withdrawing group or a heavy atom-containing group in at least one of aromatic rings at both terminals.

3. The lithographic printing plate precursor according to claim 1 or 2,
   wherein the HOMO of the polymethine colorant is -5.3 eV or less.

4. The lithographic printing plate precursor according to any one of claims 1 to 3,
   wherein a thickness of the water-soluble overcoat layer is larger than a thickness of the image-recording layer.

5. The lithographic printing plate precursor according to any one of claims 1 to 4,
   wherein the polymer in the image-recording layer includes polymer particles.

6. The lithographic printing plate precursor according to claim 5,
   wherein the polymer particles include polymer particles having a hydrophilic group.

7. The lithographic printing plate precursor according to claim 6,
   wherein the polymer particles have a group represented by Formula Z as the hydrophilic group,

*-Q-W-Y Formula Z

in Formula Z, Q represents a divalent linking group, W represents a divalent group having a hydrophilic structure or a divalent group having a hydrophobic structure, Y represents a monovalent group having a hydrophilic structure or a monovalent group having a hydrophobic structure, either W or Y has a hydrophilic structure, and * represents a binding site with other structures.

**8.** The lithographic printing plate precursor according to claim 6 or 7,
wherein the polymer particles have a polyalkylene oxide structure as the hydrophilic group.

**9.** The lithographic printing plate precursor according to claim 8,
wherein the polyalkylene oxide structure includes a polypropylene oxide structure.

**10.** The lithographic printing plate precursor according to claim 8 or 9,
wherein the polyalkylene oxide structure includes a polyethylene oxide structure and a polypropylene oxide structure.

**11.** The lithographic printing plate precursor according to any one of claims 1 to 10,
wherein a water contact angle on a surface of the aluminum support on a side of the image-recording layer that is determined by an airborne water droplet method is 110° or less.

**12.** The lithographic printing plate precursor according to claim 11,
wherein the water contact angle on the surface of the aluminum support on the side of the image-recording layer that is determined by the airborne water droplet method is 80° or less.

**13.** The lithographic printing plate precursor according to claim 12,
wherein the water contact angle on the surface of the aluminum support on the side of the image-recording layer that is determined by the airborne water droplet method is 50° or less.

**14.** The lithographic printing plate precursor according to any one of claims 1 to 13,
wherein a layer on the aluminum support contains a hydroxycarboxylic acid or a salt thereof.

**15.** The lithographic printing plate precursor according to claim 14,
wherein the hydroxycarboxylic acid or a salt thereof includes a compound having two or more hydroxyl groups.

**16.** The lithographic printing plate precursor according to claim 14 or 15,
wherein the hydroxycarboxylic acid or a salt thereof includes a compound having three or more hydroxyl groups.

**17.** The lithographic printing plate precursor according to any one of claims 1 to 16,
wherein the image-recording layer contains an electron-donating polymerization initiator as the polymerization initiator.

**18.** The lithographic printing plate precursor according to claim 17,
wherein HOMO of the polymethine colorant - HOMO of the electron-donating polymerization initiator is 0.70 eV or less.

**19.** The lithographic printing plate precursor according to any one of claims 1 to 18,
wherein the image-recording layer further contains a color developing agent.

**20.** The lithographic printing plate precursor according to claim 19,
wherein the color developing agent is an acid color-developing agent.

**21.** The lithographic printing plate precursor according to claim 20,
wherein the acid color-developing agent is a leuco colorant.

**22.** The lithographic printing plate precursor according to claim 21,
wherein the leuco colorant is a leuco colorant having a phthalide structure or a fluoran structure.

**23.** The lithographic printing plate precursor according to claim 22,
wherein the leuco colorant having a phthalide structure or a fluoran structure is a compound represented by any of

Formula (Le-1) to Formula (Le-3),

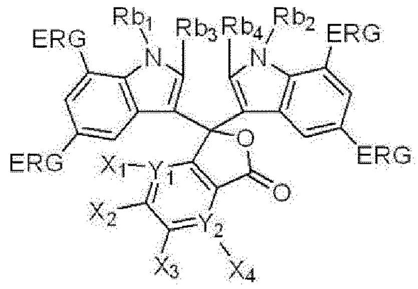

(Le - 1)

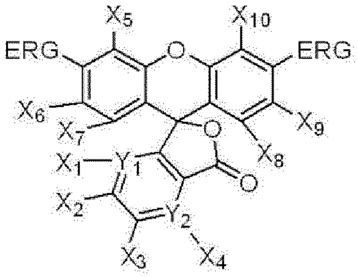

(Le - 2)

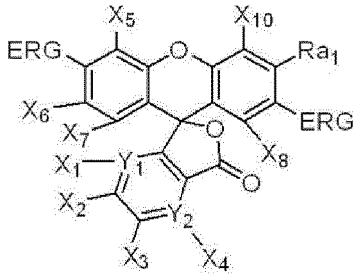

(Le - 3)

in Formula (Le-1) to Formula (Le-3), ERG each independently represents an electron donating group, $X_1$ to $X_4$ each independently represent a hydrogen atom, a halogen atom, or dialkylanilino group, $X_5$ to $X_{10}$ each independently represent a hydrogen atom, a halogen atom, or a monovalent organic group, $Y_1$ and $Y_2$ each independently represent C or N, $X_1$ does not exist in a case where $Y_1$ is N, $X_4$ does not exist in a case where $Y_2$ is N, $Ra_1$ represents a hydrogen atom, an alkyl group, or an alkoxy group, and Rbi to $Rb_4$ each independently represent an alkyl group or an aryl group.

**24.** The lithographic printing plate precursor according to claim 22 or 23,
wherein the leuco colorant having a phthalide structure or a fluoran structure is a compound represented by any of Formula (Le-4) to Formula (Le-6),

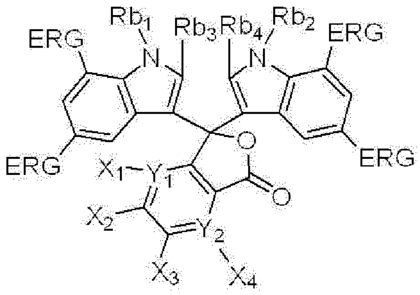

(Le - 4)

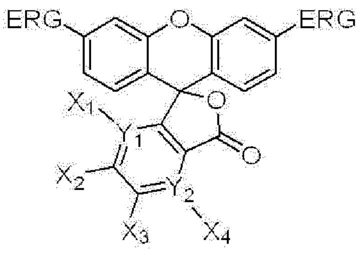

(Le - 5)

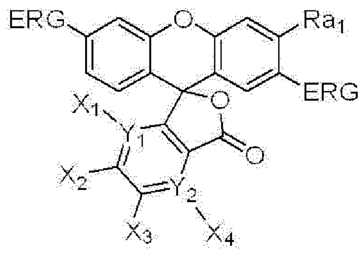

(Le - 6)

in Formula (Le-4) to Formula (Le-6), ERG each independently represents an electron donating group, $X_1$ to $X_4$ each independently represent a hydrogen atom, a halogen atom, or a dialkylanilino group, $Y_1$ and $Y_2$ each independently represent C or N, $X_1$ does not exist in a case where $Y_1$ is N, $X_4$ does not exist in a case where $Y_2$ is N, $Ra_1$ represents a hydrogen atom, an alkyl group, or an alkoxy group, and Rbi to $Rb_4$ each independently represent an alkyl group or an aryl group.

**25.** The lithographic printing plate precursor according to any one of claims 22 to 24,
wherein the leuco colorant having a phthalide structure or a fluoran structure is a compound represented by any of Formula (Le-7) to Formula (Le-9),

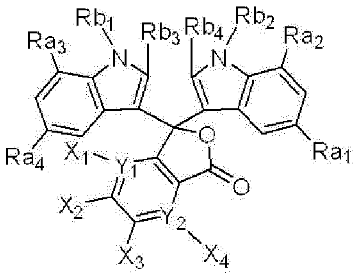
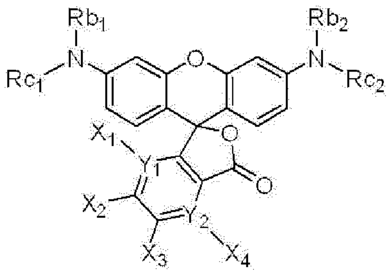
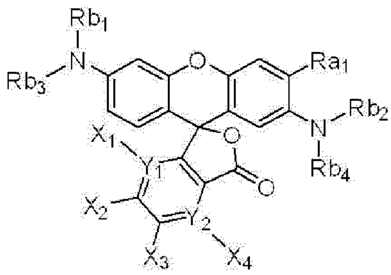

(Le-7) (Le-8) (Le-9)

in Formula (Le-7) to Formula (Le-9), $X_1$ to $X_4$ each independently represent a hydrogen atom, a halogen atom, or a dialkylanilino group, $Y_1$ and $Y_2$ each independently represent C or N, $X_1$ does not exist in a case where $Y_1$ is N, $X_4$ does not exist in a case where $Y_2$ is N, $Ra_1$ to $Ra_4$ each independently represent a hydrogen atom, an alkyl group, or an alkoxy group, Rbi to $Rb_4$ each independently represent an alkyl group or an aryl group, and $Rc_1$ and $Rc_2$ each independently represent an aryl group.

**26.** The lithographic printing plate precursor according to claim 25,
wherein $Ra_1$ to $Ra_4$ each independently represent an alkoxy group.

**27.** The lithographic printing plate precursor according to claim 25 or 26,
wherein the leuco colorant having a phthalide structure or a fluoran structure is a compound represented by Formula (Le-5).

**28.** The lithographic printing plate precursor according to claim 27,

wherein $X_1$ to $X_4$ each represent a hydrogen atom, and
$Y_1$ and $Y_2$ each represent C.

**29.** The lithographic printing plate precursor according to claim 27 or 28,
wherein Rbi and $Rb_2$ each independently represent an alkyl group.

**30.** The lithographic printing plate precursor according to any one of claims 1 to 29,
wherein the polymethine colorant has an organic anion that satisfies $8d \geq 16$, $16 \leq \delta p \leq 32$, and $\delta h \leq \delta p \times 0.6$ in the Hansen solubility parameters.

**31.** The lithographic printing plate precursor according to any one of claims 1 to 30,

wherein the image-recording layer contains an electron-accepting polymerization initiator, and
the electron-accepting polymerization initiator has an organic anion that satisfies $8d \geq 16$, $16 \leq \delta p \leq 32$, and $\delta h \leq \delta p \times 0.6$ in the Hansen solubility parameters.

**32.** The lithographic printing plate precursor according to any one of claims 1 to 31,

wherein the polymerization initiator includes an electron-accepting polymerization initiator, and
the electron-accepting polymerization initiator includes a compound represented by Formula (I),

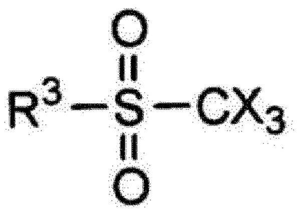 (I)

in Formula (I), X represents a halogen atom, and $R^3$ represents an aryl group.

**33.** The lithographic printing plate precursor according to any one of claims 1 to 32,
wherein the polymerizable compound includes a compound having an ethylenically unsaturated bond valence of 5.0 mmol/g or more.

**34.** The lithographic printing plate precursor according to claim 33,
wherein the compound having an ethylenically unsaturated bond valence of 5.0 mmol/g or more is a compound represented by Formula (II),

Formula (II): $X\text{-}(Y)_n$

in Formula (II), X represents an n-valent organic group having a hydrogen bonding group, Y represents a monovalent group having 2 or more ethylenically unsaturated groups, n represents an integer of 2 or more, and molecular weight of X/(molecular weight of Y $\times$ n) is 1 or less.

**35.** The lithographic printing plate precursor according to claim 33 or 34,
wherein the compound having an ethylenically unsaturated bond valence of 5.0 mmol/g or more has at least one kind of structure selected from the group consisting of an adduct structure, a biuret structure, and an isocyanurate structure.

**36.** The lithographic printing plate precursor according to any one of claims 1 to 35,
wherein the polymerizable compound includes a compound having one or two ethylenically unsaturated groups.

**37.** The lithographic printing plate precursor according to any one of claims 1 to 36,
wherein the image-recording layer further contains a polyvinyl acetal resin as a binder polymer.

**38.** The lithographic printing plate precursor according to any one of claims 1 to 37,
wherein the image-recording layer further contains a fluoroaliphatic group-containing copolymer.

**39.** The lithographic printing plate precursor according to claim 38,
wherein the fluoroaliphatic group-containing copolymer has a constitutional unit formed of a compound represented by any of Formula (F1) or Formula (F2),

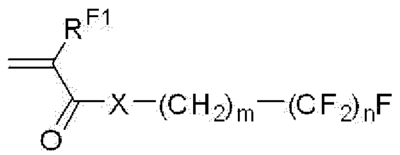

(F1)

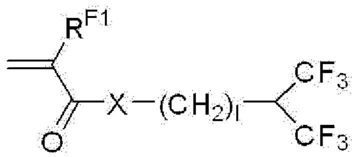

(F2)

in Formula (F1) and Formula (F2), $R^{F1}$ each independently represents a hydrogen atom or a methyl group, X each independently represents an oxygen atom, a sulfur atom, or -N($R^{F2}$)-, m represents an integer of 1 to 6, n represents an integer of 1 to 10, 1 represents an integer of 0 to 10, and $R^{F2}$ represents a hydrogen atom or an alkyl group having 1 to 4 carbon atoms.

**40.** The lithographic printing plate precursor according to claim 39,
wherein the fluoroaliphatic group-containing copolymer further has a constitutional unit formed of at least one kind of compound selected from the group consisting of poly(oxyalkylene) acrylate and poly(oxyalkylene) methacrylate.

**41.** The lithographic printing plate precursor according to any one of claims 1 to 40,
wherein the water-soluble overcoat layer contains a hydrophobic polymer.

**42.** The lithographic printing plate precursor according to any one of claims 1 to 41,
wherein the water-soluble overcoat layer contains a discoloring compound.

**43.** The lithographic printing plate precursor according to claim 42,
wherein the discoloring compound is an infrared absorber.

**44.** The lithographic printing plate precursor according to claim 42 or 43,
wherein the discoloring compound includes a decomposable compound that decomposes due to exposure to infrared.

**45.** The lithographic printing plate precursor according to any one of claims 1 to 44,

wherein the aluminum support has an aluminum plate and an anodic oxide film of aluminum disposed on the aluminum plate,
the anodic oxide film is at a position closer to a side of the image-recording layer than the aluminum plate and has micropores extending in a depth direction from a surface of the anodic oxide film on the side of the image-recording layer,
an average diameter of the micropores within the surface of the anodic oxide film is more than 10 nm and 100 nm or less, and
in the L*a*b* color space, a value of brightness L* of the surface of the anodic oxide film on the side of the image-recording layer is 70 to 100.

**46.** The lithographic printing plate precursor according to claim 45,

wherein the micropores are each composed of a large diameter portion that extends to a position at a depth of 10 nm to 1,000 nm from the surface of the anodic oxide film and a small diameter portion that is in communication with a bottom portion of the large diameter portion and extends to a position at a depth of 20 nm to 2,000 nm from a communication position,
an average diameter of the large diameter portion within the surface of the anodic oxide film is 15 nm to 100 nm, and
an average diameter of the small diameter portion at the communication position is 13 nm or less.

**47.** The lithographic printing plate precursor according to any one of claims 1 to 46, which is a lithographic printing plate precursor for on-press development.

**48.** A method for preparing a lithographic printing plate, comprising:

a step of exposing the lithographic printing plate precursor according to any one of claims 1 to 47 in the shape of an image; and
a step of supplying at least one material selected from the group consisting of a printing ink and dampening water on a printer so as to remove an image-recording layer in a non-image area.

**49.** A lithographic printing method, comprising:

a step of exposing the lithographic printing plate precursor according to any one of claims 1 to 47 in the shape of an image;
a step of supplying at least one material selected from the group consisting of a printing ink and dampening water on a printer so as to remove the image-recording layer in a non-image area and to prepare a lithographic printing plate; and
a step of performing printing by using the obtained lithographic printing plate.

FIG. 1

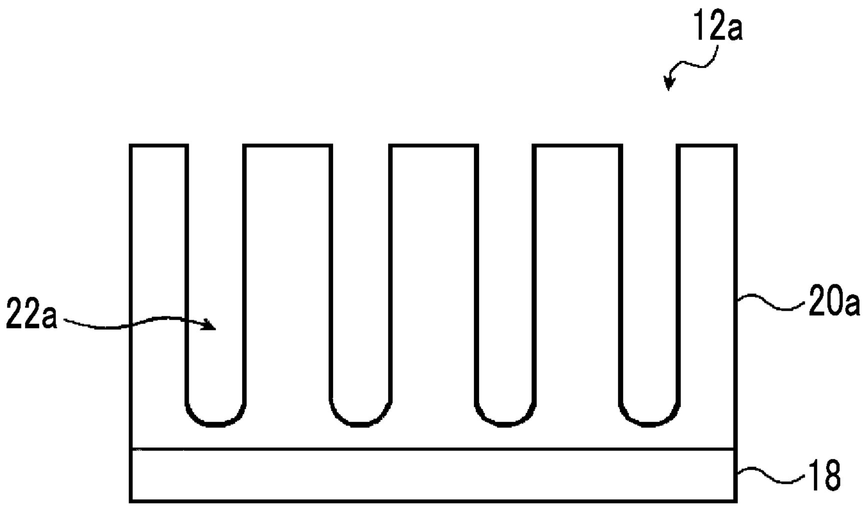


FIG. 2

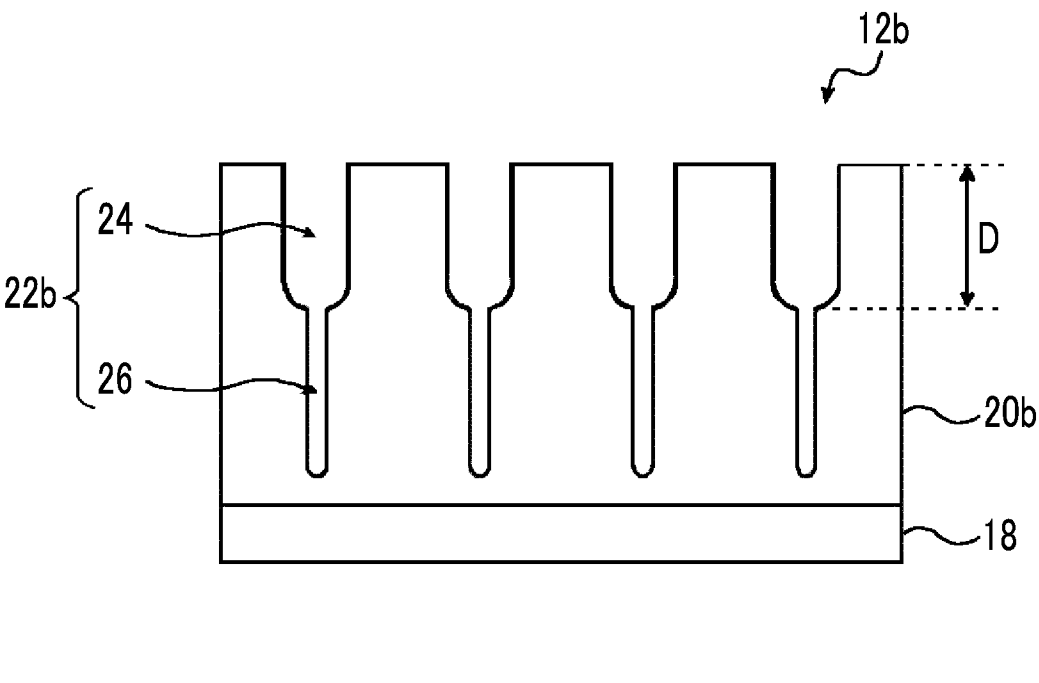

FIG. 3

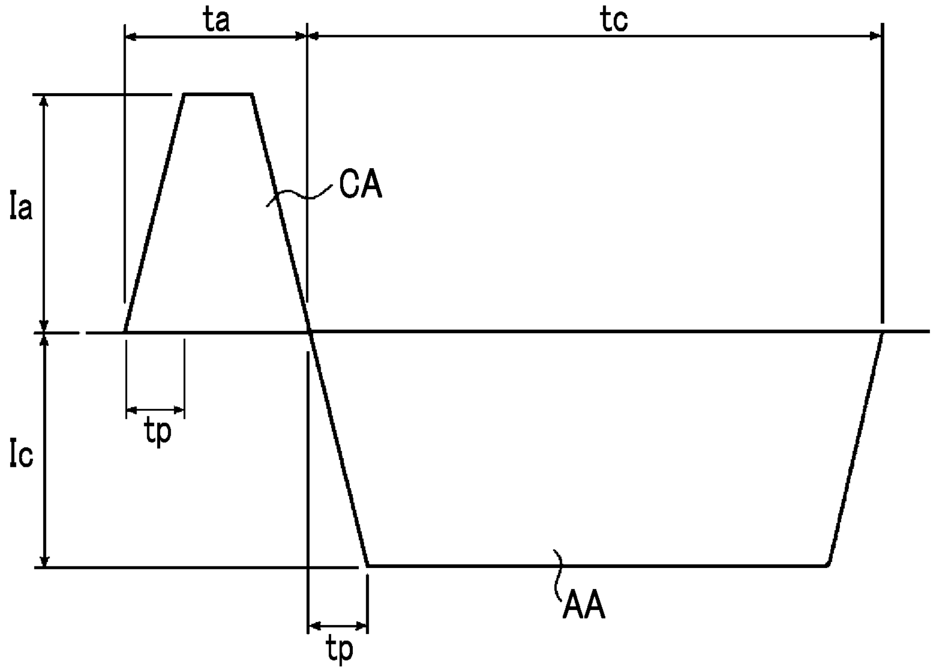


FIG. 4

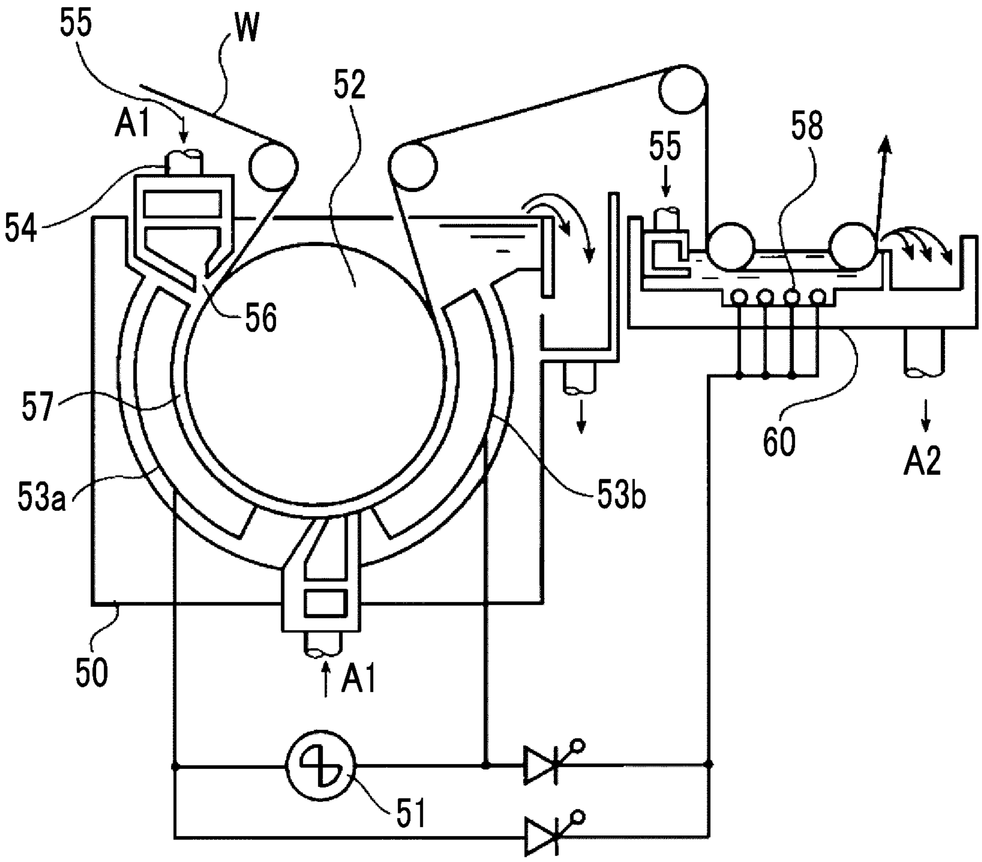

FIG. 5

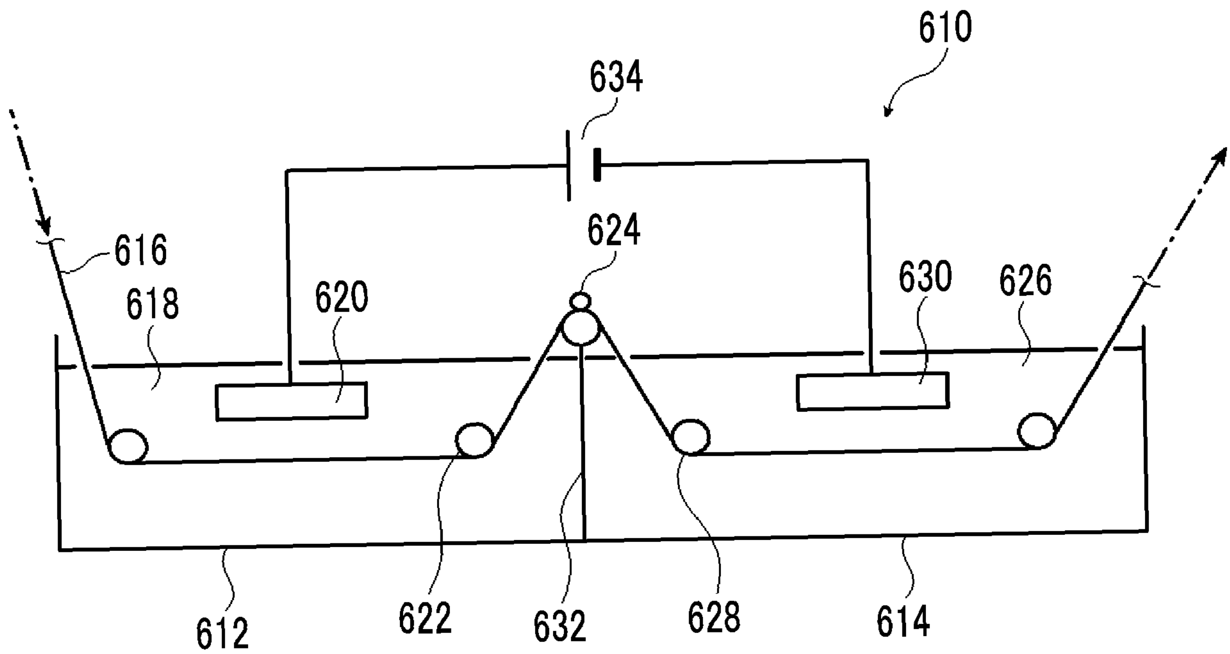

**INTERNATIONAL SEARCH REPORT**

International application No.
PCT/JP2020/025407

A. CLASSIFICATION OF SUBJECT MATTER
Int.Cl. B41N1/14(2006.01)i, B41C1/10(2006.01)i, B41M1/06(2006.01)i, B41N1/08(2006.01)i, B41N3/03(2006.01)i, G03F7/00(2006.01)i, G03F7/004(2006.01)i, G03F7/028(2006.01)i, G03F7/029(2006.01)i, G03F7/033(2006.01)i, G03F7/09(2006.01)i, G03F7/11(2006.01)i
FI: B41N1/14, B41N1/08, B41N3/03, G03F7/00503, G03F7/004505, G03F7/033, G03F7/11501, G03F7/028, G03F7/004507, G03F7/09501, B41M1/06, B41C1/10, G03F7/029, G03F7/004501
According to International Patent Classification (IPC) or to both national classification and IPC

B. FIELDS SEARCHED
Minimum documentation searched (classification system followed by classification symbols)
Int.Cl. B41N1/14, B41C1/10, B41M1/06, B41N1/08, B41N3/03, G03F7/00, G03F7/004, G03F7/028, G03F7/029, G03F7/033, G03F7/09, G03F7/11

Documentation searched other than minimum documentation to the extent that such documents are included in the fields searched

| | |
|---|---|
| Published examined utility model applications of Japan | 1922-1996 |
| Published unexamined utility model applications of Japan | 1971-2020 |
| Registered utility model specifications of Japan | 1996-2020 |
| Published registered utility model applications of Japan | 1994-2020 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2005-254638 A (FUJI PHOTO FILM CO., LTD.) 22.09.2005 (2005-09-22), claims, paragraphs [0015], [0117], [0132]-[0135], [0149]-[0151], [0186], [0205] | 1-49 |
| Y | WO 2019/013268 A1 (FUJIFILM CORPORATION) 17.01.2019 (2019-01-17), paragraphs [0012], [0017], [0061], [0048]-[0052], [0073], [0082]-[0087], [0100]-[0116], [0140]-[0151], [0162]-[0165], [0187] | 1-49 |
| Y<br>A | WO 2018/221133 A1 (FUJIFILM CORPORATION) 06.12.2018 (2018-12-06), claims, paragraph [0030] | 5-49<br>1-4 |

☒ Further documents are listed in the continuation of Box C. ☒ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 14.09.2020 | 24.09.2020 |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**

International application No. PCT/JP2020/025407

C (Continuation). DOCUMENTS CONSIDERED TO BE RELEVANT

| Category* | Citation of document, with indication, where appropriate, of the relevant passages | Relevant to claim No. |
|---|---|---|
| Y<br>A | JP 63-202497 A (FUJI PHOTO FILM CO., LTD.) 22.08.1988 (1988-08-22), page 2, upper left column, lines 1-7, lower left column, lines 5-8 | 16-49<br>1-15 |
| Y<br>A | JP 6461447 B1 (FUJIFILM CORPORATION) 30.01.2019 (2019-01-30), paragraphs [0048]-[0059] | 21-49<br>1-20 |
| Y<br>A | WO 2018/159640 A1 (FUJIFILM CORPORATION) 07.09.2018 (2018-09-07), paragraphs [0001]-[0056] | 30-49<br>1-29 |
| Y<br>A | JP 2000-171974 A (FUJI PHOTO FILM CO., LTD.) 23.06.2000 (2000-06-23), paragraphs [0001]-[0004], [0131]-[0135] | 32-49<br>1-31 |
| Y<br>A | JP 2013-504084 A (EASTMAN KODAK COMPANY) 04.02.2013 (2013-02-04), paragraphs [0012], [0013], [0023], [0037], [0074] | 32-49<br>1-31 |
| Y<br>A | JP 2014-79960 A (EASTMAN KODAK COMPANY) 08.05.2014 (2014-05-08), paragraphs [0008]-[0026] | 38-49<br>1-37 |
| Y<br>A | WO 2016/027886 A1 (FUJIFILM CORPORATION) 25.02.2016 (2016-02-25), claim 16, paragraphs [0035], [0069]-[0080], examples | 41-49<br>1-40 |
| Y<br>A | JP 2019-64269 A (FUJIFILM CORPORATION) 25.04.2019 (2019-04-25), paragraphs [0060]-[0081], fig. 1, 2 | 45-49<br>1-44 |
| A | US 2018/0207925 A1 (AGFA NV) 26.07.2018 (2018-07-26), entire text, all drawings | 1-49 |

Form PCT/ISA/210 (second sheet) (January 2015)

**INTERNATIONAL SEARCH REPORT**
Information on patent family members

International application No.
PCT/JP2020/025407

| | | |
|---|---|---|
| JP 2005-254638 A | 22.09.2005 | (Family: none) |
| WO 2019/013268 A1 | 17.01.2019 | US 2012/0152139 A1<br>paragraphs [0028]-[0030], [0039]-[0043], [0119], [0121], [0122], [0162], [0163], [0185]-[0194], [0211]-[0249], [0290]-[0312], [0382]-[0396]<br>EP 3594009 A1 |
| WO 2018/221133 A1 | 06.12.2018 | CN 110678335 A<br>claims, paragraphs [0122], [0123] |
| JP 63-202497 A | 22.08.1988 | (Family: none) |
| JP 6461447 B1 | 30.01.2019 | US 2019/0232703 A1<br>paragraphs [0175]-[0197]<br>EP 3511174 A1 |
| WO 2018/159640 A1 | 07.09.2018 | US 2019/0369495 A1<br>paragraphs [0001]-[0091]<br>EP 3590975 A1 |
| JP 2000-171974 A | 23.06.2000 | (Family: none) |
| JP 2013-504084 A | 04.02.2013 | US 2012/0152139 A1<br>paragraphs [0011]-[0019], [0028], [0043], [0082]-[0088]<br>EP 2293144 A1 |
| JP 2014-79960 A | 08.05.2014 | US 2015/0198884 A1<br>paragraphs [0008]-[0026]<br>EP 2909676 A1 |
| WO 2016/027886 A1 | 25.02.2016 | US 2017/0123315 A1<br>claim 16, paragraphs [0059]-[0062], [0119], examples<br>EP 3184590 A1 |
| JP 2019-64269 A | 25.04.2019 | US 2019/0217651 A1<br>paragraphs [0194]-[0245], fig. 1, 2<br>EP 3511172 A1 |
| US 2018/0207925 A1 | 26.07.2018 | EP 3121008 A1<br>entire text, all drawings |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2005103968 A
- JP 2006001144 A
- JP 2001133969 A
- JP 2002023360 A
- JP 2002040638 A
- JP 2002278057 A
- JP 2008195018 A
- JP 2007090850 A
- JP 2012206495 A
- JP 5005005 A
- JP H055005 A
- JP 2001222101 A
- JP 2008544322 A
- WO 2016027886 A
- WO 2017141882 A
- WO 2018043259 A
- JP 8108621 A
- JP H08108621 A
- JP 61166544 A
- JP S61166544 A
- JP 2002328465 A
- JP 2006508380 A
- JP 2002287344 A
- JP 2008256850 A
- JP 2001342222 A
- JP 9179296 A
- JP H09179296 A
- JP 9179297 A
- JP H09179297 A
- JP 9179298 A
- JP H09179298 A
- JP 2004294935 A
- JP 2006243493 A
- JP 2002275129 A
- JP 2003064130 A
- JP 2003280187 A
- JP 10333321 A
- JP H10333321 A
- JP 48041708 B
- JP S48041708 B
- JP 51037193 A
- JP S5137193 A
- JP 2032293 B
- JP H0232293 B
- JP 2016765 B
- JP H0216765 B
- JP 2003344997 A
- JP 2006065210 A
- JP 58049860 B
- JP S5849860 B
- JP 56017654 B
- JP S5617654 B
- JP 62039417 B
- JP S6239417 B
- JP 62039418 B
- JP S6239418 B
- JP 2000250211 A
- JP 2007094138 A
- US 7153632 B
- JP 8505958 A
- JP H08505958 A
- JP 2007293221 A
- JP 2007293223 A
- JP 9123387 A
- JP H09123387 A
- JP 9131850 A
- JP H09131850 A
- JP 9171249 A
- JP H09171249 A
- JP 9171250 A
- JP H09171250 A
- EP 931647 B
- JP 2001277740 A
- JP 2001277742 A
- JP 2008503365 A
- JP 2012148555 A
- JP 2007276454 A
- JP 2009154525 A
- JP 2006297907 A
- JP 2007050660 A
- JP 2008284858 A
- JP 2009090645 A
- JP 2009208458 A
- JP 2008284817 A
- US 3458311 A
- JP 55049729 B
- JP S5549729 B
- JP 2005250216 A
- JP 2006259137 A
- WO 2019219560 A
- JP 50040047 B
- JP S5040047 B
- JP 10282679 A
- JP H10282679 A
- JP 2304441 A
- JP H02304441 A
- JP 2005238816 A

- JP 2005125749 A
- JP 2006239867 A
- JP 2006215263 A
- JP 2006188038 A
- JP 2012158022 A
- JP 2019122490 A
- JP 2019158806 A
- JP 2019169798 A


**Non-patent literature cited in the description**


- Hansen Solubility Parameters. **CHARLES M. HANSEN.** A Users Handbook. CRC Press, 2007
- *Research Disclosure,* January 1992, (33303
- **IWANAMI.** Dictionary of Physics and Chemistry. Iwanami Shoten, Publishers, 1998
- *CHEMICAL ABSTRACTS,* 93-62-9